# EUROPEAN PATENT APPLICATION

(11) **EP 2 600 430 A1**
(43) Date of publication of application: **05.06.2013**
(21) Application number: 11811504.7
(22) Date of filing: 25.07.2011
(51) Int. Cl.: H01L 51/50, C07D 209/86, C07D 405/04, C09K 11/06

(54) **ORGANIC ELECTROLUMINESCENCE ELEMENT**

(30) Priority: 26.07.2010 JP 2010167319
(71) Applicant: Idemitsu Kosan Co., Ltd., Chiyoda-ku Tokyo 100-8321 (JP)
(72) Inventor: NISHIMURA Kazuki, Sodegaura-shi Chiba 299-0293 (JP); ITO Mitsunori, Sodegaura-shi Chiba 299-0293 (JP); HIBINO Kumiko, Sodegaura-shi Chiba 299-0293 (JP); YOSHIDA Kei, Sodegaura-shi Chiba 299-0293 (JP)
(74) Representative: Prop, Gerrit
(86) International application number: PCT/JP2011/066852
(87) International publication number: WO 2012/014841

(57) **Abstract**

An organic electroluminescence device includes an anode, a cathode, and an organic thin-film layer interposed between the anode and the cathode, in which the organic thin-film layer includes an emitting layer at least containing a first host, a second host and a luminous dopant, the first host is a compound having one or more carbazolyl groups and one or more nitrogen-containing heterocyclic groups in a molecule, and the second host is a compound represented by the following formula (1) or (2).

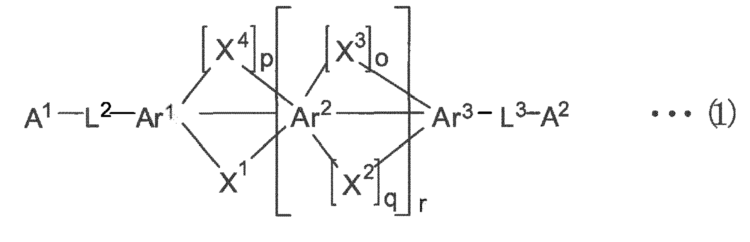

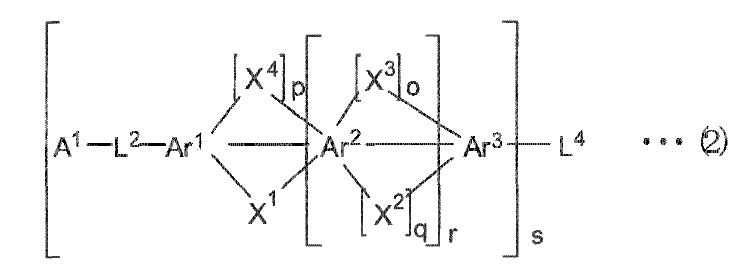

## Description

### TECHNICAL FIELD

The present invention relates to an organic electroluminescence device.

### BACKGROUND ART

An organic electroluminescence device (hereinafter, occasionally abbreviated as organic EL device) is a self-emitting device based on the principle that, when an electrical field is applied, a fluorescent material emits light using energy generated by a recombination of holes injected from an anode with electrons injected from a cathode. Studies on an organic EL device formed of an organic material have been vigorously carried out since a layered organic EL device driven at low voltage was reported by C. W. Tang et al. of Eastman Kodak Company.
Moreover, a phosphorescent organic EL device using a phosphorescent organic material in an emitting layer has been proposed. In the organic EL device, a singlet state and a triplet state of excited states of the phosphorescent organic material are used to achieve a high luminous efficiency. When electrons and holes are recombined in the organic EL device, it is presumed that a singlet exciton and a triplet exciton are produced at a rate of 1:3 due to difference in spin multiplicity. Accordingly, luminous efficiency of the device using a phosphorescent material can reach three to four times as much as that of the device only using a fluorescent material.

In order to improve luminous efficiency and prolong a lifetime of the organic EL device using phosphorescent materials, various studies have been made.
As one of such studies, an organic EL device provided by mixing a plurality of materials in the emitting layer is proposed (for instance, Patent Literatures 1 to 10).

Patent Literature 1 discloses an organic EL device including: a hole transporting zone formed of a hole transporting material; an electron transporting zone formed of an electron transporting material; and a mixture zone that is provided between the hole transporting zone and the electron transporting zone and contains both the hole transporting material and the electron transporting zone and a phosphorescent material.
Patent Literatures 2 and 3 disclose an organic EL device containing two or more kinds of host materials in the same emitting layer.
Patent Literature 4 discloses an organic EL device using a first host material and a second host material in combination in the same emitting layer, in which an Ip value (ionization potential) of the first host material is larger than an Ip value of the second host material and a hole mobility of the first host material is larger than a hole mobility of the second host material.

Patent Literature 5 discloses an organic EL device containing a first host compound (a hole transporting material) and a second host compound (a phosphorescent metal complex) in the same emitting layer.
Patent Literature 6 discloses an organic EL device using a hole transporting compound and an electron transporting compound in the same emitting layer.
Patent Literature 7 discloses an organic EL device containing at least two kinds of hole transporting materials and an electron transporting host material in the same emitting layer. Patent Literature 8 discloses an organic EL device containing at least two kinds of electron transporting materials and a hole transporting host material in the same emitting layer.
Patent Literature 9 discloses an organic EL device using at least one electron injecting compound and at least one hole injecting compound as a host material in the same emitting layer.
Patent Literature 10 discloses an organic EL device containing a hole transporting compound and an aluminum complex compound in the same emitting layer.

### CITATION LIST

### PATENT LITERATURES

Patent Literature 1: JP-A-2002-305085
Patent Literature 2: JP-A-2007-110102
Patent Literature 3: JP-A-2007-134677
Patent Literature 4: JP-A-2008-227462
Patent Literature 5: JP-A-2008-288344
Patent Literature 6: JP-A-2009-152578
Patent Literature 7: JP-A-2009-32987
Patent Literature 8: JP-A-2009-32989
Patent Literature 9: JP-A-2010-34573
Patent Literature 10: JP-T-2008-514002

### SUMMARY OF THE INVENTION

### PROBLEMS TO BE SOLVED BY THE INVENTION

In the invention disclosed in Patent Literature 1, since the material used in the emitting layer is limited to the materials used in the hole transporting zone and the electron transporting zone, a host material exhibiting the most appropriate performance cannot be selected, which leads to limitations on efficiency, drive voltage and lifetime Moreover, a luminescent material is limited to a red emitting material. It is not mentioned whether the luminescent material is applicable to green emission.
In the inventions disclosed in Patent Literatures 2 and 3, it is essential that a layer adjacent to the emitting layer only contains the host material without a luminescent material. This arrangement adds a step to an evaporation process for producing the organic EL device, which may complicate a manufacturing device of the organic EL device.
The combination of the host materials disclosed in Patent Literature 4 is not a combination of compounds having a skeleton exhibiting excellent electron injecting capability and electron transporting capability.
In the invention disclosed in Patent Literature 5, a compound having an amine structure is used as the hole transporting material, which is considered to entail disadvantages on electron tolerance. Moreover, only red emission is disclosed and effect on green emission is not mentioned.

In the invention disclosed in Patent Literature 6, since a ligand of an organic metal complex used as a phosphorescent material is limited to a quinoxaline skeleton, only red emission is provided, which narrows applicability of the organic EL device.
In the inventions disclosed in Patent Literatures 7 and 8, it is essential that a total concentration of the two kinds of hole transporting materials or a total concentration of the two kinds of the electron transporting materials is decreased toward the cathode from the anode. This arrangement complicates a manufacturing device of the organic EL device, which may cause the manufactured organic EL device to exhibit unstable performance.
The combination of the host materials disclosed in Patent Literature 9 is not a combination of compounds having a skeleton exhibiting excellent electron injecting capability and electron transporting capability.
In the invention disclosed in Patent Literature 10, since the aluminum complex compound having a small electron mobility is used, drive voltage is extremely high.

An object of the invention is to provide a highly efficient and long-life organic EL device capable of green emission.

### MEANS FOR SOLVING THE PROBLEMS

As a result of intense study for achieving the above object, the inventors found that the object is achievable when, in an organic electroluminescence device including an anode, a cathode, and an organic thin-film layer interposed between the anode and the cathode, the organic thin-film layer includes an emitting layer at least containing a first host, a second host and a luminous dopant, and the first host and the second host each are a specific compound. Consequently, the inventors completed the invention.

Specifically, an organic electroluminescence device according to an aspect of the invention includes an anode, a cathode and an organic thin-film layer provided between the anode and the cathode, in which the organic thin-film layer includes an emitting layer that at least includes a first host, a second host and a luminous dopant, the first host is a compound including one or more carbazolyl groups and one or more nitrogen-containing heterocyclic groups in a molecule, and the second host is compound represented by a formula (1) or (2). A blending ratio of the first and second hosts is subject to no limitation. Herein, "hydrogen" is meant to also include deuterium.

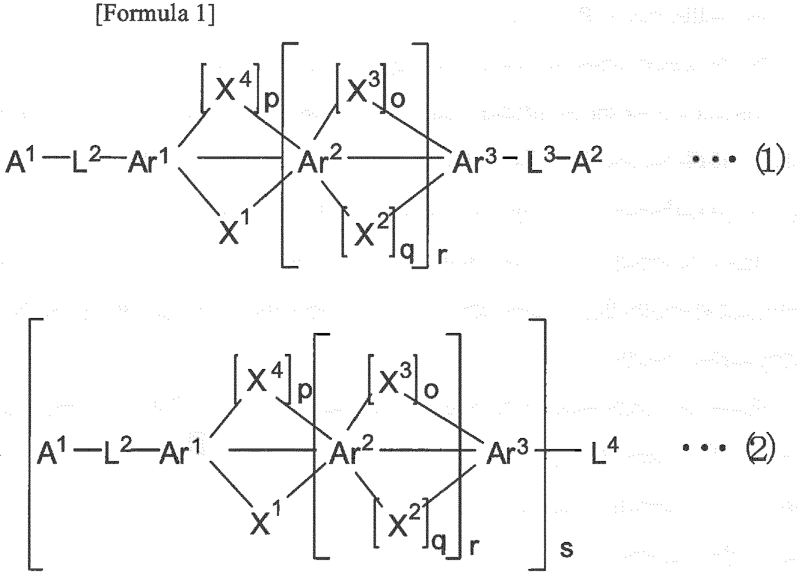

In the above formulae (1) and (2), Ar¹, Ar² and Ar³ each independently represent a substituted or unsubstituted aromatic hydrocarbon group having 6 carbon atoms forming a ring (hereinafter referred to as ring carbon atoms) or a substituted or unsubstituted aromatic heterocyclic group having 6 atoms forming a ring (hereinafter referred to as ring atoms).
Ar¹, Ar² and Ar³ may have one or more substituents Y. A plurality of Y may be mutually different.
Y represents an alkyl group having 1 to 20 carbon atoms, a substituted or unsubstituted cycloalkyl group having 3 to 20 ring carbon atoms, an alkoxy group having 1 to 20 carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.
In the formulae (1) and (2), X¹, X², X³ and X⁴ each independently represent oxygen (O), sulfur (S), N-R¹ or CR²R³.
R¹, R² and R³ each independently represent an alkyl group having 1 to 20 carbon atoms, a substituted or unsubstituted cycloalkyl group having 3 to 20 ring carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.
However, when both of X₁ and X₂ represent N-R¹, o and p are 0, and q is 1, or when both of X₁ and X₃ represent N-R¹, p and q are 0, and o is 1, at least one R¹ represents a substituted or unsubstituted monovalent fused aromatic heterocyclic group having 8 to 24 ring atoms.
In the formulae (1) and (2), o, p and q represent 0 or 1. s represents 1, 2, 3 or 4, which respectively mean a monomer, a dimer, a trimer and a tetramer, each of which uses L⁴ as a linking group. r represents 1, 2, 3 or 4.
L² represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted monovalent or divalent aromatic heterocyclic group or fused aromatic heterocyclic group having 3 to 24 ring carbon atoms.
In the formula (1), L³ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring carbon atoms.
In the formula (2), when s is 2, L⁴ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring carbon atoms.
When s is 3, L⁴ represents a trivalent saturated hydrocarbon group having 1 to 20 carbon atoms, a substituted or unsubstituted trivalent saturated cyclic hydrocarbon group having 3 to 20 ring carbon atoms, a trivalent silyl group, a trivalent substituted-silyl group having 1 to 20 carbon atoms, a substituted or unsubstituted trivalent aromatic hydrocarbon group or fused aromatic hydrocarbon group having 6 to 24 ring carbon atoms, or a substituted or unsubstituted trivalent aromatic heterocyclic group or fused aromatic heterocyclic group having 3 to 24 ring carbon atoms.
When s is 4, L⁴ represents a tetravalent saturated hydrocarbon group having 1 to 20 carbon atoms, a substituted or unsubstituted tetravalent saturated cyclic hydrocarbon group having 3 to 20 ring carbon atoms, a silicon atom, a substituted or unsubstituted tetravalent aromatic hydrocarbon group or fused aromatic hydrocarbon group having 6 to 24 ring carbon atoms, or a substituted or unsubstituted tetravalent aromatic heterocyclic group or fused aromatic heterocyclic group having 3 to 24 ring carbon atoms.
In the formulae (1) and (2), A¹ represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.
In the formula (1), A² represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.

In the above aspect of the invention, it is preferred that one of X¹ and X⁴ is an oxygen atom or one of X² and X³ is an oxygen atom in the formulae (1) and (2), and the compounds represented by the formulae (1) and (2) each have a dibenzofuran structure in a molecule.
In the above aspect of the invention, it is further preferred that one of X¹ and X⁴ is an oxygen atom and one of X² and X³ is an oxygen atom in the formulae (1) and (2), and the compounds represented by the formulae (1) and (2) each have a benzofurano dibenzofuran structure.

In the above aspect of the invention, it is preferred that the first host is represented by any one of formulae (3) to (5) below.

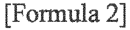

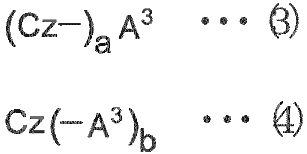

In the formulae (3) and (4), Cz represents a substituted or unsubstituted arylcarbazolyl group or carbazolylaryl group; A³ represents a group represented by a formula (A) below; and a and b each represent an integer of 1 to 3.

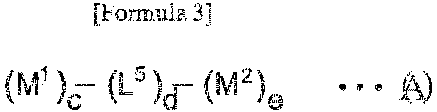

In the formula (A), M¹ and M² each independently represent a substituted or unsubstituted nitrogen-containing aromatic heterocyclic ring or nitrogen-containing fused aromatic heterocyclic ring having 2 to 40 ring carbon atoms; and M¹ and M² may be the same or different; L⁵ represents a single bond, a substituted or unsubstituted aromatic hydrocarbon group or fused aromatic hydrocarbon group having 6 to 30 carbon atoms, a substituted or unsubstituted cycloalkylene group having 5 to 30 carbon atoms, or a substituted or unsubstituted aromatic heterocyclic group or fused aromatic heterocyclic group having 2 to 30 carbon atoms; and c represents an integer of 0 to 2; d represents an integer of 1 or 2; and e represents an integer of 0 to 2, provided that c+e is 1 or more.

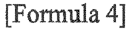

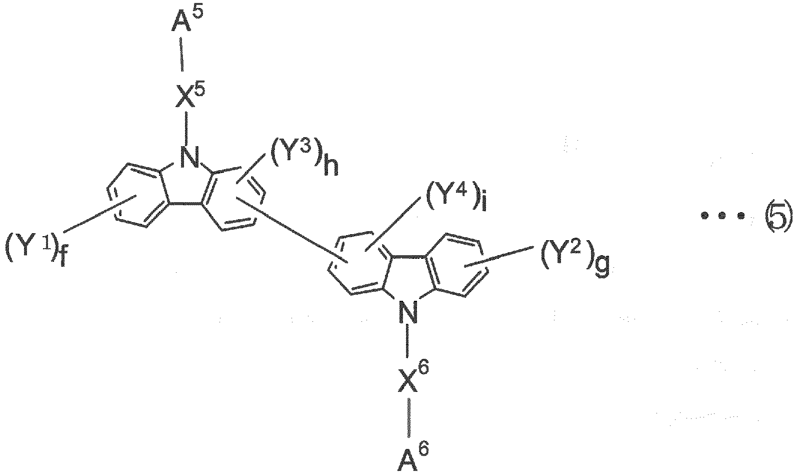

In the above formula (5), Ar⁵ represents a substituted or unsubstituted nitrogen-containing heterocyclic group having 1 to 30 ring carbon atoms (excluding a substituted or unsubstituted carbazolyl group and a substituted or unsubstituted indolyl group). A⁶ represents a substituted or unsubstituted aromatic hydrocarbon group or fused aromatic hydrocarbon group having 6 to 30 ring carbon atoms, or a substituted or unsubstituted nitrogen-containing heterocyclic group having 1 to 30 ring carbon atoms. X⁵ and X⁶ each are a linking group and independently represent a single bond, a substituted or unsubstituted aromatic hydrocarbon group having 6 to 30 ring carbon atoms, a substituted or unsubstituted fused aromatic hydrocarbon group having 6 to 30 ring carbon atoms, a substituted or unsubstituted aromatic heterocyclic group having 2 to 30 ring carbon atoms, or a substituted or unsubstituted fused aromatic heterocyclic group having 2 to 30 ring carbon atoms. Y¹ to Y⁴ independently represent a hydrogen atom, a fluorine atom, a cyano group, a substituted or unsubstituted alkyl group having 1 to 20 carbon atoms, a substituted or unsubstituted alkoxy group having 1 to 20 carbon atoms, a substituted or unsubstituted haloalkyl group having 1 to 20 carbon atoms, a substituted or unsubstituted haloalkoxy group having 1 to 20 carbon atoms, a substituted or unsubstituted alkylsilyl having 1 to 10 carbon atoms, a substituted or unsubstituted arylsilyl group having 6 to 30 carbon atoms, a substituted or unsubstituted aromatic hydrocarbon group having 6 to 30 ring carbon atoms, a substituted or unsubstituted fused aromatic hydrocarbon group having 6 to 30 ring carbon atoms, a substituted or unsubstituted aromatic heterocyclic group having 2 to 30 ring carbon atoms, or a substituted or unsubstituted fused aromatic heterocyclic group having 2 to 30 ring carbon atoms. Adjacent ones of Y¹ to Y⁴ are allowed to be bonded to each other to form a ring structure. f and g represent an integer of 1 to 4, and h and i represent an integer of 1 to 3. When f and g are an integer of 2 to 4 and h and i are an integer of 2 or 3, a plurality of Y¹ to Y⁴ may be the same or different.

In the above aspect of the invention, it is preferred that Cz in the formulae (3) and (4) is a substituted or unsubstituted arylcarbazolyl group.
In the above aspect of the invention, it is preferred that Cz is substituted or unsubstituted phenylcarbozolyl group.
In the above aspect of the invention, it is preferred that an aryl portion of the arylcarbazolyl group is substituted by a carbazolyl group.
In the above aspect of the invention, it is preferred that the formula (5) is represented by a formula (6) below.

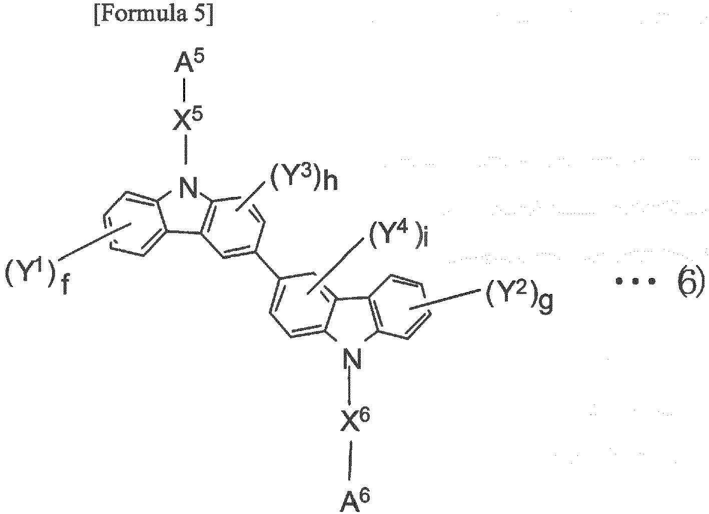

In the formula (6), A⁵, A⁶, X⁵, X⁶, Y¹ to Y⁴, f, g, h and i represent the same as those in the formula (5).

In the above aspect of the invention, it is preferred that A⁵ is selected from the group consisting of a substituted or unsubstituted pyridine ring, pyrimidine ring and triazine ring.
Particularly preferably, A⁵ is a substituted or unsubstituted pyrimidine ring.

In the above aspect of the invention, it is preferred that emitting layer contains a phosphorescent material as the dopant.
In the above aspect of the invention, it is preferred that the phosphorescent material is an ortho-metalated complex of a metal atom selected from iridium (Ir), osmium (Os) and platinum (Pt).
In the above aspect of the invention, it is preferred that an electron injecting layer is provided between the cathode and the emitting layer, the electron injecting layer containing a nitrogen-containing cyclic derivative.
In the above aspect of the invention, it is preferred that a reduction-causing dopant is added in an interfacial region between the cathode and the organic thin-film layer.

According to the invention, a highly efficient and long-life organic EL device capable of green emission can be provided.

### BRIEF DESCRIPTION OF DRAWING

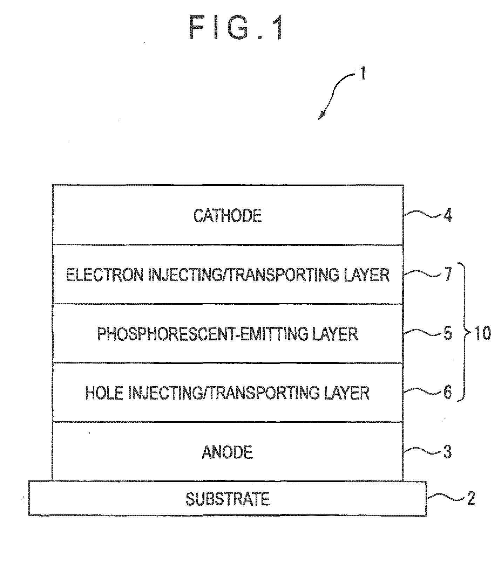

Fig. 1 schematically shows an exemplary structure of an organic electroluminescence device according to an exemplary embodiment of the invention.

### DESCRIPTION OF EXEMPLARY EMBODIMENT

### Description will be made below on an exemplary embodiment(s) of the invention.

### Arrangement of Organic EL Device

Firstly, structure(s) of an organic EL device will be described below.
The following are representative structure examples of an organic EL device:
(1) anode / emitting layer / cathode;
(2) anode / hole injecting layer / emitting layer / cathode;
(3) anode / emitting layer / electron injecting-transporting layer / cathode;
(4) anode / hole injecting layer / emitting layer / electron injecting-transporting layer /cathode;
(5) anode / organic semiconductor layer / emitting layer / cathode;
(6) anode / organic semiconductor layer / electron blocking layer / emitting layer / cathode;
(7) anode / organic semiconductor layer / emitting layer / adhesion improving layer / cathode;
(8) anode / hole injecting-transporting layer / emitting layer / electron injecting-transporting layer / cathode;
(9) anode / insulating layer / emitting layer / insulating layer / cathode;
(10) anode / inorganic semiconductor layer / insulating layer / emitting layer / insulating layer / cathode;
(11) anode / organic semiconductor layer / insulating layer / emitting layer / insulating layer / cathode;
(12) anode / insulating layer / hole injecting-transporting layer / emitting layer / insulating layer / cathode; and
(13) anode / insulating layer / hole injecting·transporting layer / emitting layer / electron injecting-transporting layer / cathode.
The arrangement (8) is suitably used among the above, but the arrangement of the invention is not limited to the above arrangements.

Fig. 1 schematically shows an exemplary structure of an organic EL device according to an exemplary embodiment of the invention.
The organic EL device 1 includes a transparent substrate 2, an anode 3, a cathode 4 and an organic thin-film layer 10 positioned between the anode 3 and the cathode 4.
The organic thin-film layer 10 includes a phosphorescent-emitting layer 5 containing a phosphorescent host (a host material) and a phosphorescent dopant (a phosphorescent material). A layer such as a hole injecting/transporting layer 6 may be provided between the phosphorescent-emitting layer 5 and the anode 3 while a layer such as an electron injecting/transporting layer 7 may be provided between the phosphorescent-emitting layer 5 and the cathode 4. In addition, an electron blocking layer may be provided to the phosphorescent-emitting layer 5 adjacent to the anode 3 while a hole blocking layer may be provided to the phosphorescent-emitting layer 5 adjacent to the cathode 4.
With this arrangement, electrons and holes can be trapped in the phosphorescent-emitting layer 5, thereby enhancing probability of exciton generation in the phosphorescent-emitting layer 5.

It should be noted that a "fluorescent host" and a "phosphorescent host" herein respectively mean a host combined with a fluorescent dopant and a host combined with a phosphorescent dopant, and that a distinction between the fluorescent host and phosphorescent host is not unambiguously derived only from a molecular structure of the host in a limited manner.
In other words, the fluorescent host herein means a material for forming a fluorescent-emitting layer containing a fluorescent dopant, and does not mean a host that is only usable as a host of a fluorescent material.
Likewise, the phosphorescent host herein means a material for forming a phosphorescent-emitting layer containing a phosphorescent dopant, and does not mean a host that is only usable as a host of a phosphorescent material.

It should be noted that the "hole injecting/transporting layer" herein means "at least either one of a hole injecting layer and a hole transporting layer" while the "electron injecting/transporting layer" herein means "at least either one of an electron injecting layer and an electron transporting layer."

### Light-Transmissive Substrate

The organic EL device according to this exemplary embodiment of the invention is formed on a light-transmissive substrate. The light-transmissive plate, which supports the organic EL device, is preferably a smooth substrate that transmits 50% or more of light in a visible region of 400 nm to 700 nm.
The substrate 10 is exemplarily a glass plate, a polymer plate or the like.
For the glass plate, materials such as soda-lime glass, barium/strontium-containing glass, lead glass, aluminosilicate glass, borosilicate glass, barium borosilicate glass and quartz can be used.
For the polymer plate, materials such as polycarbonate, acryl, polyethylene terephthalate, polyether sulfide and polysulfone can be used.

### Anode and Cathode

The anode of the organic EL device is used for injecting holes into the hole injecting layer, the hole transporting layer or the emitting layer. It is effective that the anode has a work function of 4.5 eV or more.
Exemplary materials for the anode are alloys of indium-tin oxide (ITO), tin oxide (NESA), indium zinc oxide, gold, silver, platinum and copper.
The anode may be made by forming a thin film from the above electrode materials through methods such as vapor deposition and sputtering.
When light from the emitting layer is to be emitted through the anode as in this embodiment, the anode preferably transmits more than 10% of the light in the visible region. Sheet resistance of the anode is preferably several hundreds Ω/sq. or lower. Although depending on the material of the anode, the thickness of the anode is typically in a range of 10 nm to 1 µm and preferably in a range of 10 nm to 200 nm.

The cathode is preferably formed of a material with smaller work function in order to inject electrons into the electron injecting layer, the electron transporting layer and the emitting layer.
Although a material for the cathode is subject to no specific limitation, examples of the material are indium, aluminum, magnesium, alloy of magnesium and indium, alloy of magnesium and aluminum, alloy of aluminum and lithium, alloy of aluminum, scandium and lithium, alloy of magnesium and silver and the like.
Like the anode, the cathode may be made by forming a thin film from the above materials through a method such as vapor deposition or sputtering. In addition, the light may be emitted through the cathode.

### Emitting Layer

The emitting layer of the organic EL device has functions as follows, namely:
(1) injecting function: a function for accepting, when an electrical field is applied, the holes injected by the anode or the hole injecting layer, or the electrons injected by the cathode or the electron injecting layer;
(2) transporting function: a function for transporting injected electric charges (the electrons and the holes) by the force of the electrical field; and
(3) emitting function: a function for providing a condition for recombination of the electrons and the holes to emit light.

Injectability of the holes may differ from that of the electrons and transporting capabilities of the hole and the electrons (represented by mobilities of the holes and the electrons) may differ from each other.
As a method of forming the emitting layer, known methods such as vapor deposition, spin coating and an LB method may be employed.

The emitting layer is preferably a molecular deposit film.
The molecular deposit film means a thin film formed by depositing a material compound in gas phase or a film formed by solidifying a material compound in a solution state or in liquid phase. The molecular deposit film is typically distinguished from a thin film formed by the LB method (molecular accumulation film) by differences in aggregation structures, higher order structures and functional differences arising therefrom.
As disclosed in JP-A-57-51781, the emitting layer can be formed from a thin film formed by spin coating or the like, the thin film being formed from a solution prepared by dissolving a binder (e.g. a resin) and a material compound in a solvent.

According to the exemplary embodiment of the invention, an organic EL device includes: a cathode; an anode; and a single-layered or multilayered organic thin-film layer provided between the cathode and the anode and including at least one emitting layer, in which the at least one emitting layer contains at least one phosphorescent material and later-described first and second hosts.

### First Host

The organic EL device according to this exemplary embodiment contains a compound represented by any one of formulae (7) to (9) below as the first host.

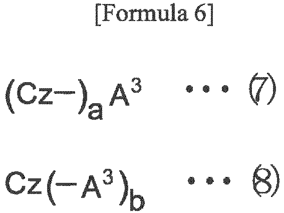

In the formulae (7) and (8), Cz represents a substituted or unsubstituted arylcarbazolyl group or carbazolylaryl group. A³ represents a group represented by a formula (A) below. a and b each represent an integer of 1 to 3.

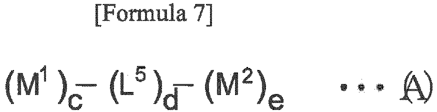

In the formula (A), M¹ and M² each independently represent a substituted or unsubstituted nitrogen-containing aromatic heterocyclic ring or nitrogen-containing fused aromatic heterocyclic ring having 2 to 40 ring carbon atoms; M¹ and M² may be the same or different.
L⁵ represents a single bond, a substituted or unsubstituted aromatic hydrocarbon group or fused aromatic hydrocarbon group having 6 to 30 carbon atoms, a substituted or unsubstituted cycloalkylene group having 5 to 30 carbon atoms, or a substituted or unsubstituted aromatic heterocyclic group or fused aromatic heterocyclic group having 2 to 30 carbon atoms.
c represents an integer of 0 to 2; d represents an integer of 1 or 2; and e represents an integer of 0 to 2, provided that c+e is 1 or more.

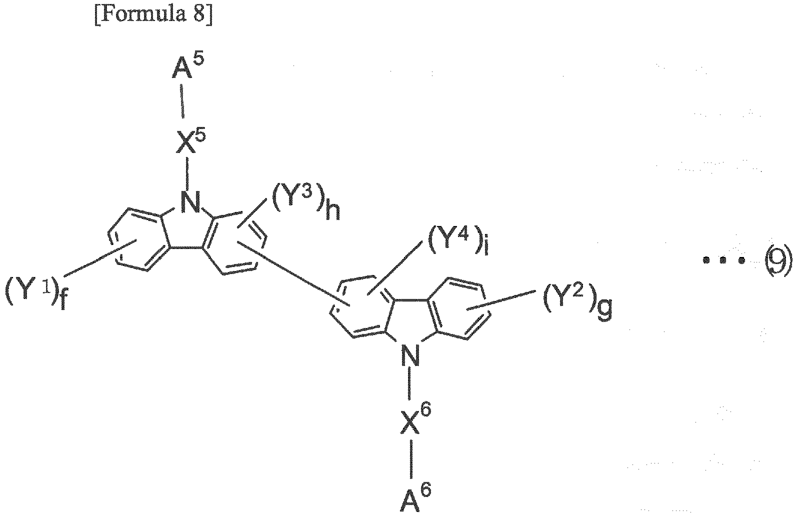

In the above formula (9), Ar⁵ represents a substituted or unsubstituted nitrogen-containing heterocyclic group having 1 to 30 ring carbon atoms (excluding a substituted or unsubstituted carbazolyl group and a substituted or unsubstituted indolyl group).
A⁶ represents a substituted or unsubstituted aromatic hydrocarbon group or fused aromatic hydrocarbon group having 6 to 30 ring carbon atoms, or a substituted or unsubstituted nitrogen-containing heterocyclic group having 1 to 30 ring carbon atoms. X⁵ and X⁶ each are a linking group and independently represent a single bond, a substituted or unsubstituted aromatic hydrocarbon group having 6 to 30 ring carbon atoms, a substituted or unsubstituted fused aromatic hydrocarbon group having 6 to 30 ring carbon atoms, a substituted or unsubstituted aromatic heterocyclic group having 2 to 30 ring carbon atoms, or a substituted or unsubstituted fused aromatic heterocyclic group having 2 to 30 ring carbon atoms.
Y¹ to Y⁴ independently represent a hydrogen atom, a fluorine atom, a cyano group, a substituted or unsubstituted alkyl group having 1 to 20 carbon atoms, a substituted or unsubstituted alkoxy group having 1 to 20 carbon atoms, a substituted or unsubstituted haloalkyl group having 1 to 20 carbon atoms, a substituted or unsubstituted haloalkoxy group having 1 to 20 carbon atoms, a substituted or unsubstituted alkylsilyl having 1 to 10 carbon atoms, a substituted or unsubstituted arylsilyl group having 6 to 30 carbon atoms, a substituted or unsubstituted aromatic hydrocarbon group having 6 to 30 ring carbon atoms, a substituted or unsubstituted fused aromatic hydrocarbon group having 6 to 30 ring carbon atoms, a substituted or unsubstituted aromatic heterocyclic group having 2 to 30 ring carbon atoms, or a substituted or unsubstituted fused aromatic heterocyclic group having 2 to 30 ring carbon atoms.
Adjacent ones of Y¹ to Y⁴ may be bonded to each other to form a cyclic structure.
f and g represent an integer of 1 to 4; and h and i represent an integer of 1 to 3. When f and g are an integer of 2 to 4 and h and i are an integer of 2 or 3, a plurality of Y¹ to Y⁴ may be the same or different.

Next, compounds represented by the formulae (7) to (9) will be described in detail.

### Compounds Represented by Formulae (7) and (8)

Cz is a substituted or unsubstituted arylcarbazolyl group or a substituted or unsubstituted carbazolylaryl group.
An arylcarbazolyl group means a carbazolyl group having at least one aryl group or heteroaryl group as a substituent, in which a position where the aryl group or the heteroaryl group is substituted does not matter.
Specific examples are as follows. In the following chemical formulae, Ar represents an aryl group or heteroaryl group. * represents a position where another group is bonded.

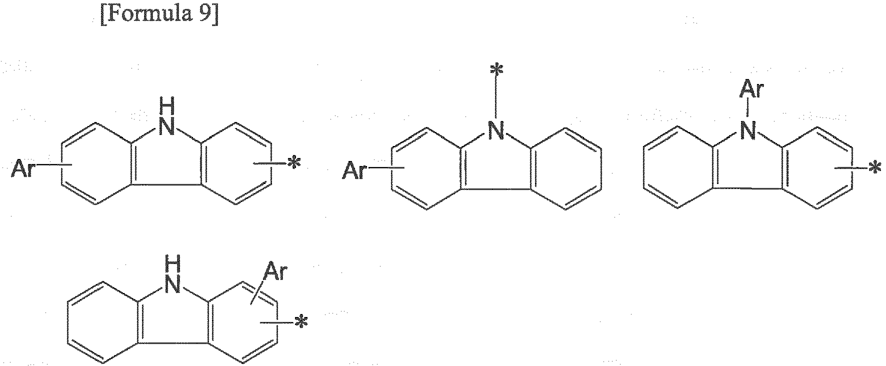

A carbazolylaryl group means an aryl group having at least one carbazolyl group as a substituent, in which a position where the aryl group is substituted does not matter.
Specific examples are as follows. In the following chemical formulae, Ar represents an aryl group. * represents a position where another group is bonded.

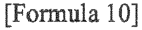

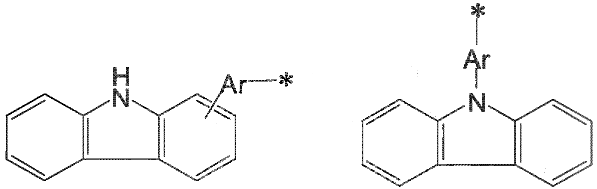

A substituted arylcarbazolyl group means the arylcarbazolyl group having at least one substituent irrespective of a substitution position. A substituted carbazolylaryl group means the carbazolylaryl group having at least one substituent irrespective of a substitution position.

In the formulae (7) and (8), a and b each represent an integer of 1 to 3.
An aryl group in the arylcarbazolyl group or the carbazolylaryl group preferably has 6 to 30 carbon atoms. Examples of the aryl group are a phenyl group, a naphthyl group, an anthryl group, a phenanthryl group, a naphthacenyl group, a pyrenyl group, a fluorenyl group, a biphenyl group and a terphenyl group, among of which a phenyl group, a naphthyl group, a biphenyl group and a terphenyl group are preferable.
Examples of the heteroaryl group in the arylcarbazolyl group are groups formed based on rings of pyridine, pyrimidine, pyrazine, triazine, aziridine, azaindolizine, indolizine, imidazoles, indole, isoindole, indazole, purine, pteridine, β-carboline, naphthyridine, quinoxaline, terpyridine, bipyridine, acridine, phenanthroline, phenazine and imidazopyridine, among which rings of pyridine, terpyridine, pyrimidine, imidazopyridine and triazine are preferable.
A in the formulae (7) and (8) is a group represented by the formula (A).

In the formula (A), M¹ and M² each independently represent a substituted or unsubstituted nitrogen-containing heterocyclic group having 2 to 40 ring carbon atoms. M¹ and M² may be the same or different.
Examples of the nitrogen-containing heterocyclic ring in the arylcarbazolyl group are groups formed based on rings of pyridine, pyrimidine, pyrazine, triazine, aziridine, azaindolizine, indolizine, imidazoles, indole, isoindole, indazole, purine, pteridine, β-carboline, naphthyridine, quinoxaline, terpyridine, bipyridine, acridine, phenanthroline, phenazine and imidazopyridine, among which rings of pyridine, terpyridine, pyrimidine, imidazopyridine and triazine are preferable.
L⁵ represents a single bond, a substituted or unsubstituted aromatic hydrocarbon group or fused aromatic hydrocarbon group having 6 to 30 carbon atoms, a substituted or unsubstituted cycloalkylene group having 5 to 30 carbon atoms, or a substituted or unsubstituted aromatic heterocyclic group or fused aromatic heterocyclic group having 2 to 30 carbon atoms.
c represents an integer of 0 to 2; d represents an integer of 1 or 2; and e represents an integer of 0 to 2, provided that c+e is 1 or more.

Examples of the aromatic hydrocarbon group or fused aromatic hydrocarbon group having 6 to 30 carbon atoms are a phenyl group, a biphenyl group, a terphenyl group, a naphthyl group, an anthranil group, a phenanthryl group, a pyrenyl group, a crycenyl group, a fluoranthenyl group and a perfluoroaryl group, among which a phenyl group, a biphenyl group, a terphenyl group and a perfluoroaryl group are preferable.
Examples of the cycloalkylene group having 5 to 30 carbon atoms are a cyclopentyl group, a cyclohexylene group, and a cyclohepthylene group, among which a cyclohexylene group is preferable.

Examples of the aromatic heterocyclic group or fused aromatic heterocyclic group having 2 to 30 carbon atoms are a 1-pyrrolyl group, a 2-pyrrolyl group, a 3-pyrrolyl group, a pyrazinyl group, a 2-pyridinyl group, a 3-pyridinyl group, a 4-pyridinyl group, a 1-indolyl group, a 2-indolyl group, a 3-indolyl group, a 4-indolyl group, a 5-indolyl group, a 6-indolyl group, a 7-indolyl group, a 1-isoindolyl group, a 2-isoindolyl group, a 3-isoindolyl group, a 4-isoindolyl group, a 5-isoindolyl group, a 6-isoindolyl group, a 7-isoindolyl group, a 2-furyl group, a 3-furyl group, a 2-benzofuranyl group, a 3-benzofuranyl group, a 4-benzofuranyl group, a 5-benzofuranyl group, a 6-benzofuranyl group, a 7-benzofuranyl group, a 1-isobenzofuranyl group, a 3-isobenzofuranyl group, a 4-isobenzofuranyl group, a 5-isobenzofuranyl group, a 6-isobenzofuranyl group, a 7-isobenzofuranyl group, a 2-quinolyl group, a 3-quinolyl group, a 4-quinolyl group, a 5-quinolyl group, a 6-quinolyl group, a 7-quinolyl group, an 8-quinolyl group, a 1-isoquinolyl group, a 3-isoquinolyl group, a 4-isoquinolyl group, a 5-isoquinolyl group, a 6-isoquinolyl group, a 7-isoquinolyl group, an 8-isoquinolyl group, a 2-quinoxalinyl group, a 5-quinoxalinyl group, a 6-quinoxalinyl group, a 1-carbazolyl group, a 2-carbazolyl group, a 3-carbazolyl group, a 4-carbazolyl group, a 9-carbazolyl group, a 1-phenanthridinyl group, a 2-phenanthridinyl group, a 3-phenanthridinyl group, a 4-phenanthridinyl group, a 6-phenanthridinyl group, a 7-phenanthridinyl group, an 8-phenanthridinyl group, a 9-phenanthridinyl group, a 10-phenanthridinyl group, a 1-acridinyl group, a 2-acridinyl group, a 3-acridinyl group, a 4-acridinyl group, a 9-acridinyl group, a 1,7-phenanthrolin-2-yl group, a 1,7-phenanthrolin-3-yl group, a 1,7-phenanthrolin-4-yl group, a 1,7-phenanthrolin-5-yl group, a 1,7-phenanthrolin-6-yl group, a 1,7-phenanthrolin-8-yl group, a 1,7-phenanthrolin-9-yl group, a 1,7-phenanthrolin-10-yl group, a 1,8-phenanthrolin-2-yl group, a 1,8-phenanthrolin-3-yl group, a 1,8-phenanthrolin-4-yl group, a 1,8-phenanthrolin-5-yl group, a 1,8-phenanthrolin-6-yl group, a 1,8-phenanthrolin-7-yl group, a 1,8-phenanthrolin-9-yl group, a 1,8-phenanthrolin-10-yl group, a 1,9-phenanthrolin-2-yl group, a 1,9-phenanthrolin-3-yl group, a 1,9-phenanthrolin-4-yl group, a 1,9-phenanthrolin-5-yl group, a 1,9-phenanthrolin-6-yl group, a 1,9-phenanthrolin-7-yl group, a 1,9-phenanthrolin-8-yl group, a 1,9-phenanthrolin-10-yl group, a 1,10-phenanthrolin-2-yl group, a 1,10-phenanthrolin-3-yl group, a 1,10-phenanthrolin-4-yl group, a 1,10-phenanthirolin-5-yl group, a 2,9-phenanthrolin-1-yl group, a 2,9-phenanthrolin-3-yl group, a 2,9-phenanthrolin-4-yl group, a 2,9-phenanthrolin-5-yl group, a 2,9-phenanthrolin-6-yl group, a 2,9-phenanthrolin-7-yl group, a 2,9-phenanthrolin-8-yl group, a 2,9-phenanthrolin-10-yl group, a 2,8-phenanthrolin-1-yl group, a 2,8-phenanthrolin-3-yl group, a 2,8-phenanthrolin-4-yl group, a 2,8-phenanthrolin-5-yl group, a 2,8-phenanthrolin-6-yl group, a 2,8-phenanthrolin-7-yl group, a 2,8-phenanthrolin-9-yl group, a 2,8-phenanthrolin-10-yl group, a 2,7-phenanthrolin-1-yl group, a 2,7-phenanthrolin-3-yl group, a 2,7-phenanthrolin-4-yl group, a 2,7-phenanthrolin-5-yl group, a 2,7-phenanthrolin-6-yl group, a 2,7-phenanthrolin-8-yl group, a 2,7-phenanthrolin-9-yl group, a 2,7-phenanthrolin-10-yl group, a 1-phenazinyl group, a 2-phenazinyl group, a 1-phenothiazinyl group, a 2-phenothiazinyl group, a 3-phenothiazinyl group, a 4-phenothiazinyl group, a 10-phenothiazinyl group, a 1-phenoxazinyl group, a 2-phenoxazinyl group, a 3-phenoxazinyl group, a 4-phenoxazinyl group, a 10-phenoxazinyl group, a 2-oxazolyl group, a 4-oxazolyl group, a 5-oxazolyl group, a 2-oxadiazolyl group, a 5-oxadiazolyl group, a 3-furazanyl group, a 2-thienyl group, a 3-thienyl group, a 2-methylpyrrol-1-yl group, a 2-methylpyrrol-3-yl group, a 2-methylpyrrol-4-yl group, a 2-methylpyrrol-5-yl group, a 3-methylpyrrol-1-yl group, a 3-methylpyrrol-2-yl group, a 3-methylpyrrol-4-yl group, a 3-methylpyrrol-5-yl group, a 2-t-butylpyrrol-4-yl group, a 3-(2-phenylpropyl)pyrrol-1-yl group, a 2-methyl-1-indolyl group, a 4-methyl-1-indolyl group, a 2-methyl-3-indolyl group, a 4-methyl-3-indolyl group, a 2-t-butyl-1-indolyl group, a 4-t-butyl-1-indolyl group, a 2-t-butyl-3-indolyl group, and a 4-t-butyl-3-indolyl group, among which a pyridinyl group and a quinolyl group are preferable.

Examples of the substituents for Cz, M¹ and M² in the formulae (7), (8) and (A) are a halogen atom such as chlorine, bromine and fluorine, a carbazole group, a hydroxyl group, a substituted or unsubstituted amino group, a nitro group, a cyano group, a silyl group, a trifluoromethyl group, a carbonyl group, a carboxyl group, a substituted or unsubstituted alkyl group, substituted or unsubstituted alkenyl group, substituted or unsubstituted arylalkyl group, a substituted or unsubstituted aromatic hydrocarbon group or fused aromatic hydrocarbon group, a substituted or unsubstituted aromatic heterocyclic group or fused aromatic heterocyclic group, a substituted or unsubstituted aralkyl group, substituted or unsubstituted aryloxy group, and a substituted or unsubstituted alkyloxy group. Among these, a fluorine atom, a methyl group, a perfluorophenylene group, a phenyl group, a naphthyl group, a pyridyl group, a pyrazil group, a pyrimidyl group, an adamantyl group, a benzyl group, a cyano group and a silyl group are preferable.

Bonding patterns of the compound represented by the formula (7) or (8) are shown in Table 1 below in accordance with values of a and b.

**Table 1**

| **a = b = 1** | **a = 2** | **a=3** | **b = 2** | **b = 3** |
|---|---|---|---|---|
| **Cz-A³** | **Cz-A³-Cz** | 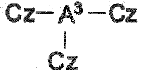 | **A³-Cz-A³** | 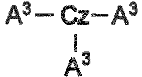 |

Bonding patterns of the compound represented by the formula (A) are shown in Tables 2 and 3 below in accordance with values of c, d and e.

**Table 2**

| No | c | d | e | bonding pattern |
|---|---|---|---|---|
| [1] | 0 | 1 | 1 | L⁵ - M² |
| [2] | 0 | 1 | 2 | L⁵ - M² - M², M²-L⁵-M² |
| [3] | 0 | 2 | 1 | L⁵-L⁵-M² L⁵-M²-L⁶ |
| [4] | 0 | 2 | 2 | 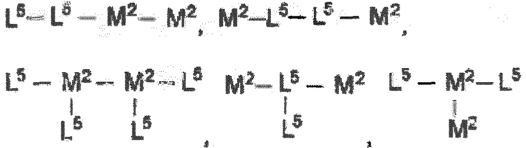 |
| [5] | 1 | 1 | 0 | the same as [1] (M² is replaced by M¹) |
| [6] | 1 | J | 1 | M¹-L⁵-M² |
| [7] | 1 | 1 | 2 | 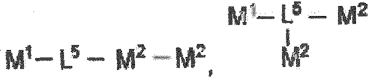 |
| [8] | 1 | 2 | 0 | the same as [3] (M² is replaced by M¹) |
| [9] | 1 | 2 | 1 | M¹-L⁵-L⁵-M², L⁵-M¹-L⁵-M², L⁵-M¹-L⁵-M² |
| [10] | 1 | 2 | 2 | 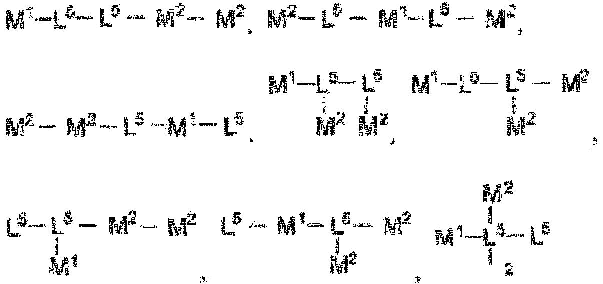 |
| (11) | 2 | 1 | 0 | the same as [2] (M² is replaced by M¹) |
| [12] | 2 | 1 | 1 | the same as [7] (M² is replaced by M¹) |
| [13] | 2 | 1 | 2 | 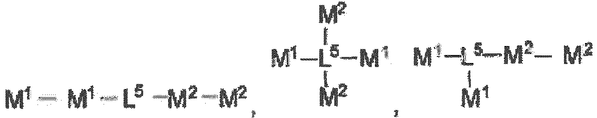 |

**Table 3**

| **No** | **c** | **d** | **e** | bonding pattern |
|---|---|---|---|---|
| **[14]** | **2** | **2** | **0** | the same as [4] (M² is replaced by M¹) |
| **[15]** | **2** | **2** | **1** | the same as [10] (M² is replaced by M¹) |
| **[16]** | **2** | **2** | **2** | 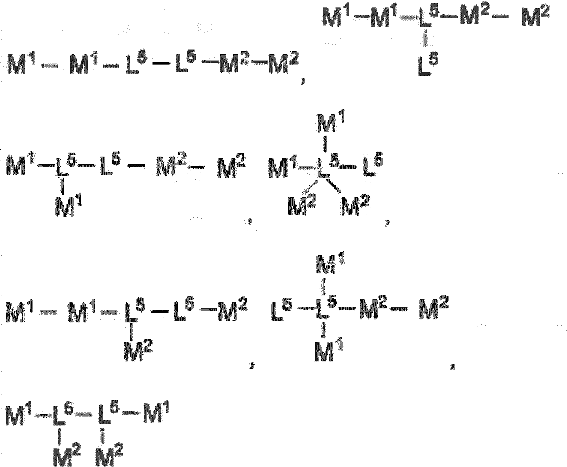 |

Cz bonded to A may be bonded to any one of M, L and M' of the formula (A) representing A.
For instance, when a=b=1 and Cz-A³-Cz are given in the formula (7) or (8) and [6] (c=d=e=1) of Table 2 is given in the formula (A), three bonding patterns of Cz-M¹-L²-M², M¹-L⁵(Cz)-M², and M¹-L⁵-M²-Cz are listed.
Moreover, for instance, when a=2 and Cz-A³-Cz are given in the formula (7) and [7] (c=d=1,e=2) Table 2 is given in the formula (A), the following bonding patterns are listed.

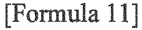

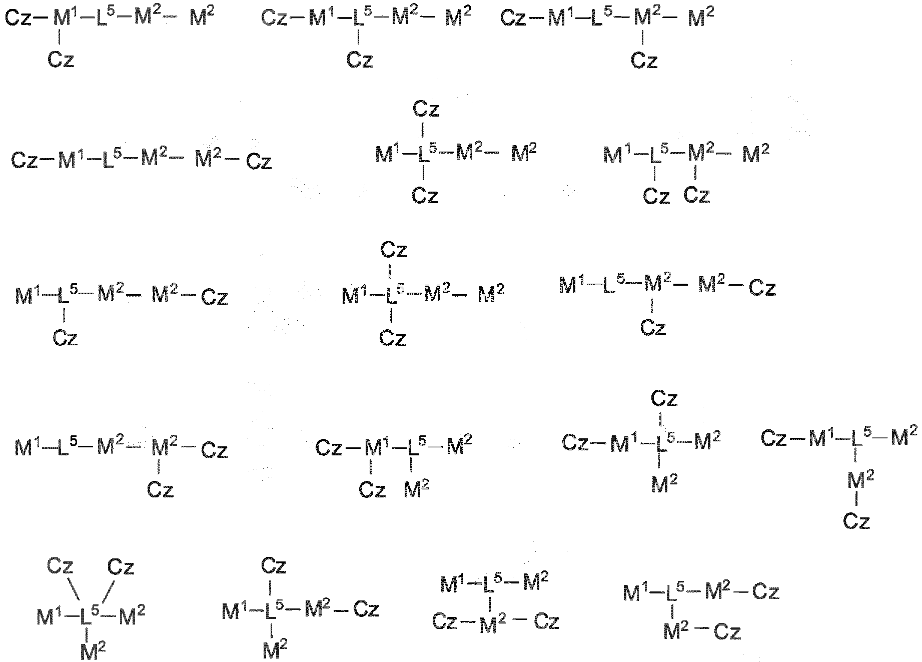

In the bonding patterns of the formulae (7), (8) and (A) and exemplary combinations of the groups as described above, compounds represented by [1] to [4] below are preferable.
[1] a=1 is given in the formula (7) and c=1 and d=0 are given in the formula (A).
In the formula (7), Cz is a substituted or unsubstituted arylcarbazolyl group or a substituted or unsubstituted carbazolylaryl group.
In the formula (A): M¹ is a substituted or unsubstituted nitrogen-containing six-membered or seven-membered hetero ring having 4 to 5 ring carbon atoms, a substituted or unsubstituted nitrogen-containing five-membered hetero ring having 2 to 4 ring carbon atoms, a substituted or unsubstituted nitrogen-containing hetero ring having 8 to 11 ring carbon atoms, or a substituted or unsubstituted imidazopyridinyl ring; and L⁵ is a substituted or unsubstituted aryl group, aromatic hydrocarbon group or fused aromatic hydrocarbon group having 6 to 30 carbon atoms, or a substituted or unsubstituted aromatic heterocyclic group or fused aromatic heterocyclic group having 2 to 30 carbon atoms.
[2] a=2 is given in the formula (7) and c=1 and e=0 are given in the formula (A).
In the formula (7), Cz is a substituted or unsubstituted arylcarbazolyl group or a substituted or unsubstituted carbazolylaryl group.
In the formula (A): M¹ is a substituted or unsubstituted nitrogen-containing six-membered or seven-membered hetero ring having 4 to 5 ring carbon atoms, a substituted or unsubstituted nitrogen-containing five-membered hetero ring having 2 to 4 ring carbon atoms, a substituted or unsubstituted nitrogen-containing hetero ring having 8 to 11 ring carbon atoms, or a substituted or unsubstituted imidazopyridinyl ring; and L⁵ is a substituted or unsubstituted aryl group, aromatic hydrocarbon group or fused aromatic hydrocarbon group having 6 to 30 carbon atoms, or a substituted or unsubstituted aromatic heterocyclic group or fused aromatic heterocyclic group having 2 to 30 carbon atoms.

[3] a=1 is given in the formula (7) and c=2 and e=0 are given in the formula (A).
In the formula (7), Cz is a substituted or unsubstituted arylcarbazolyl group or a substituted or unsubstituted carbazolylaryl group.
In the formula (A): M¹ is a substituted or unsubstituted nitrogen-containing six-membered or seven-membered hetero ring having 4 to 5 ring carbon atoms, a substituted or unsubstituted nitrogen-containing five-membered hetero ring having 2 to 4 ring carbon atoms, a substituted or unsubstituted nitrogen-containing hetero ring having 8 to 11 ring carbon atoms, or a substituted or unsubstituted imidazopyridinyl ring; and L⁵ is a substituted or unsubstituted aryl group, aromatic hydrocarbon group or fused aromatic hydrocarbon group having 6 to 30 carbon atoms, or a substituted or unsubstituted aromatic heterocyclic group or fused aromatic heterocyclic group having 2 to 30 carbon atoms.
[4] b=2 is given in the formula (8) and c=d=1 is given in the formula (A).
In the formula (8), Cz is a substituted or unsubstituted arylcarbazolyl group or a substituted or unsubstituted carbazolylaryl group.
In the formula (A): M¹ is a substituted or unsubstituted nitrogen-containing six-membered or seven-membered hetero ring having 4 to 5 ring carbon atoms, a substituted or unsubstituted nitrogen-containing five-membered hetero ring having 2 to 4 ring carbon atoms, a substituted or unsubstituted nitrogen-containing hetero ring having 8 to 11 ring carbon atoms, or a substituted or unsubstituted imidazopyridinyl ring; and L⁵ is a substituted or unsubstituted aryl group, aromatic hydrocarbon group or fused aromatic hydrocarbon group having 6 to 30 carbon atoms, or a substituted or unsubstituted aromatic heterocyclic group or fused aromatic heterocyclic group having 2 to 30 carbon atoms.

In the formulae (7) and (8), Cz is preferably a substituted or unsubstituted arylcarbazolyl group, more preferably a phenylcarbozolyl group. Moreover, an aryl site of the arylcarbazolyl group is preferably substituted by a carbazolyl group.
Specific examples of the compound represented by the formula (7) according to this exemplary embodiment are shown below, but the compound represented by the formula (6) is not limited thereto.

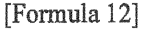

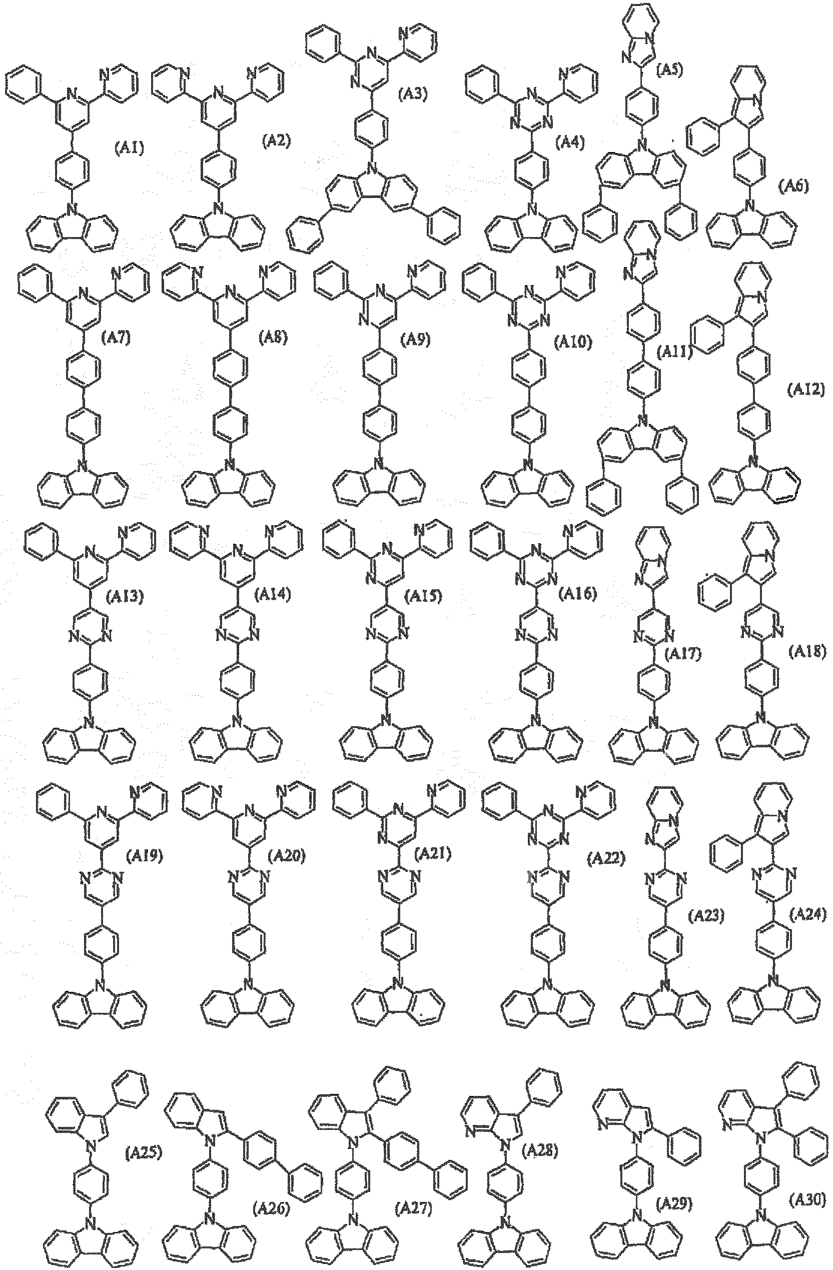

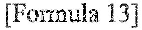

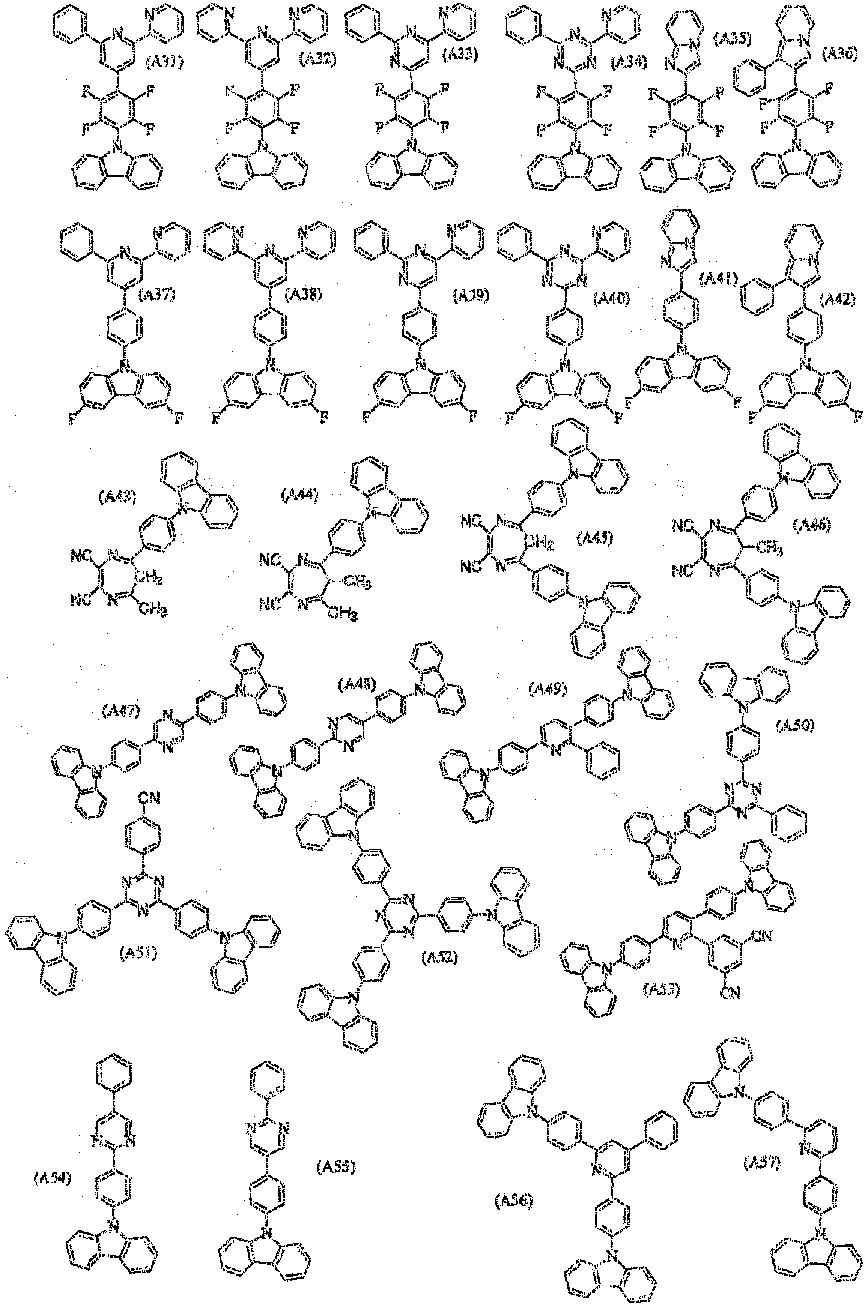

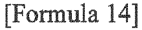

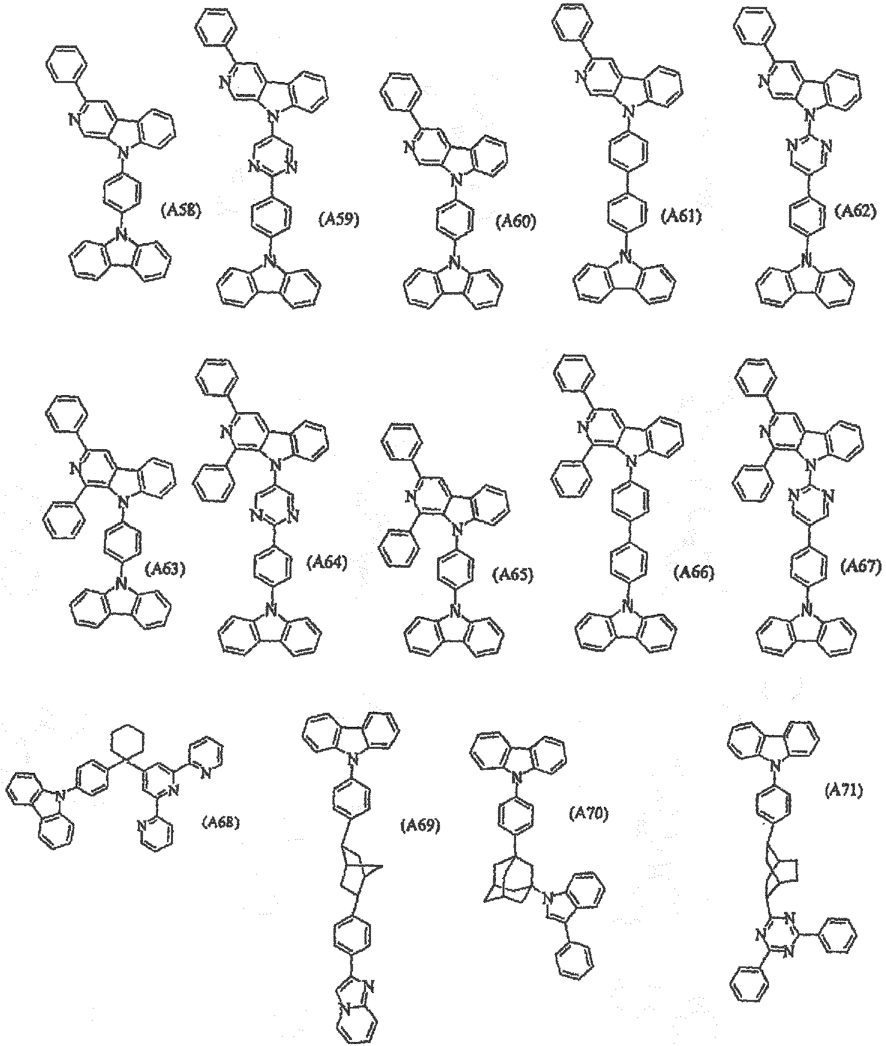

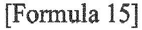

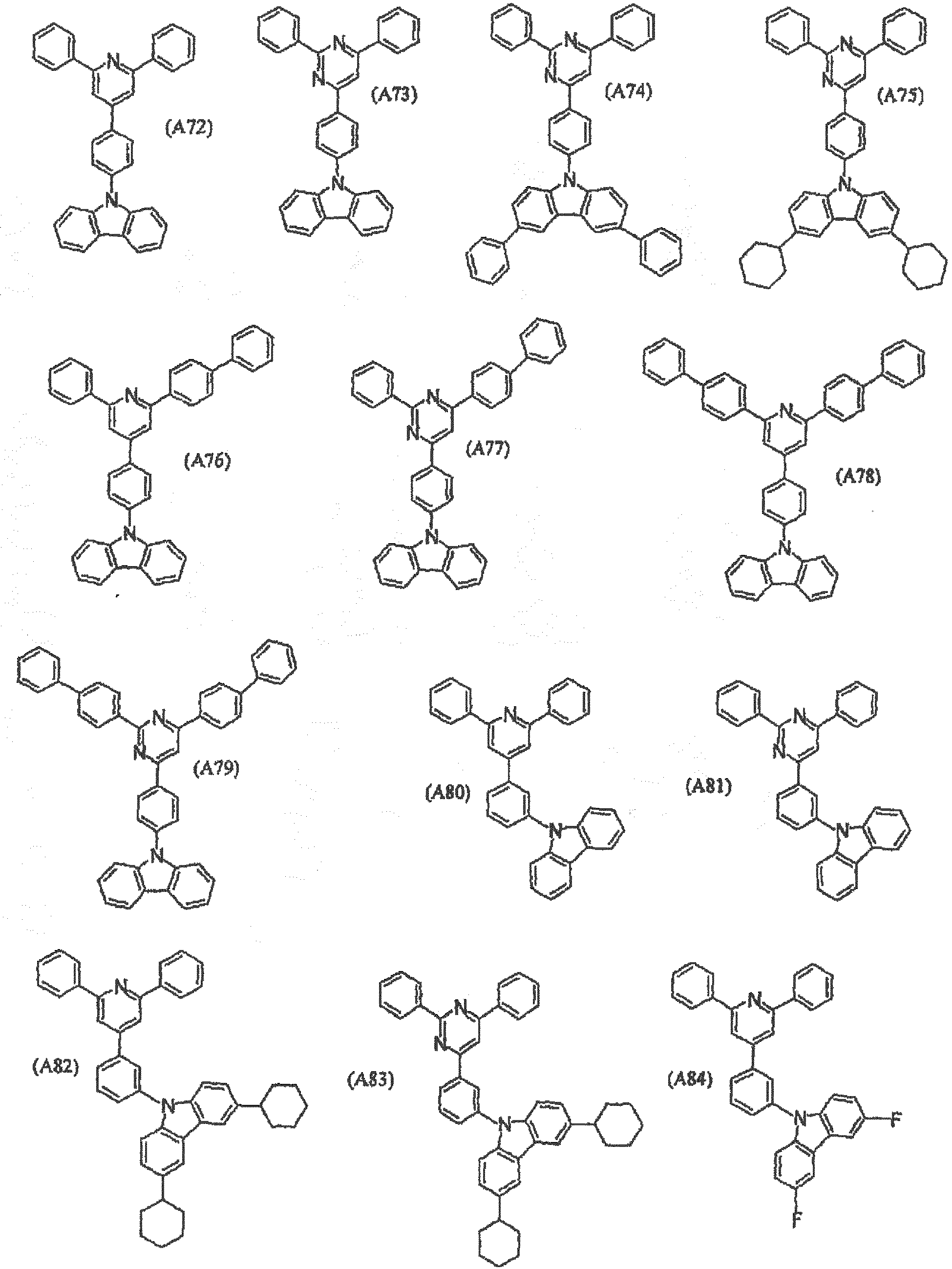

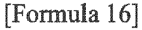

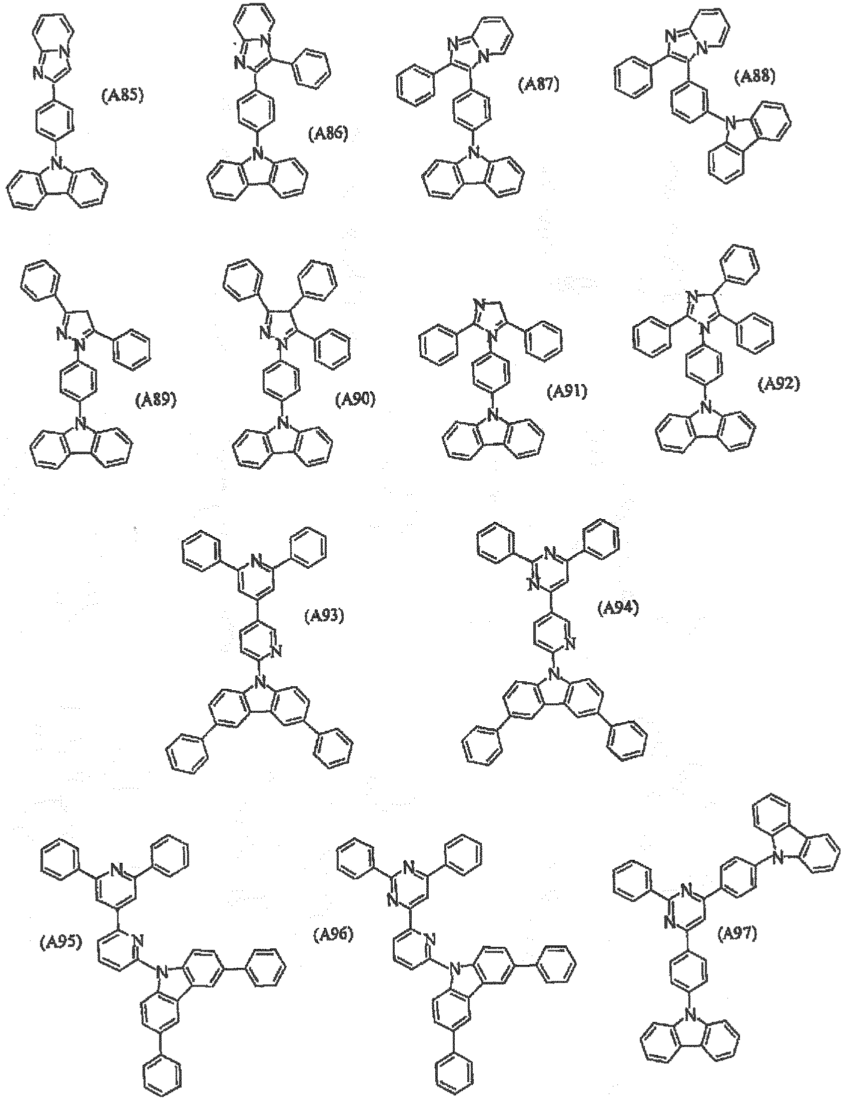

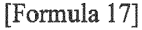

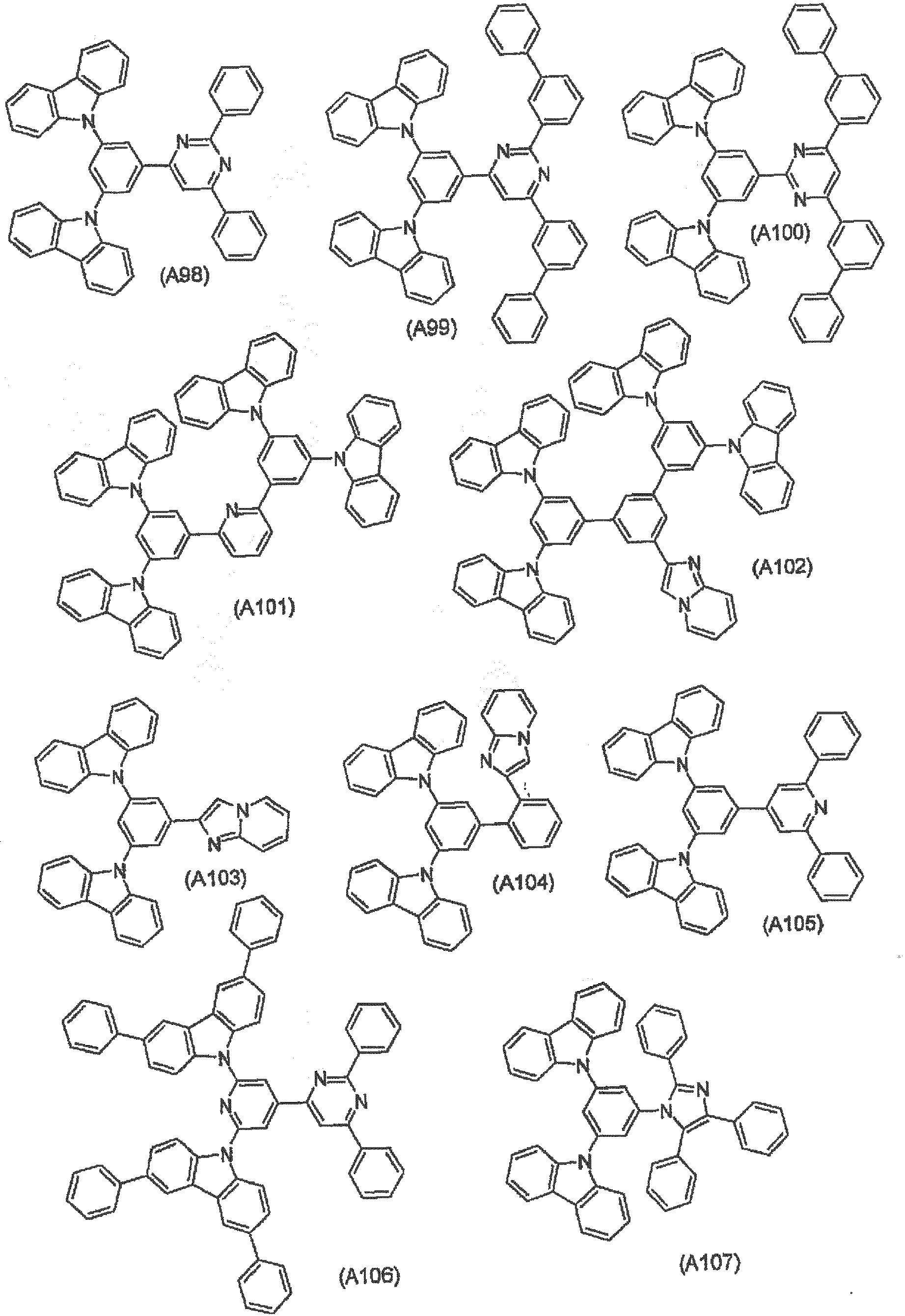

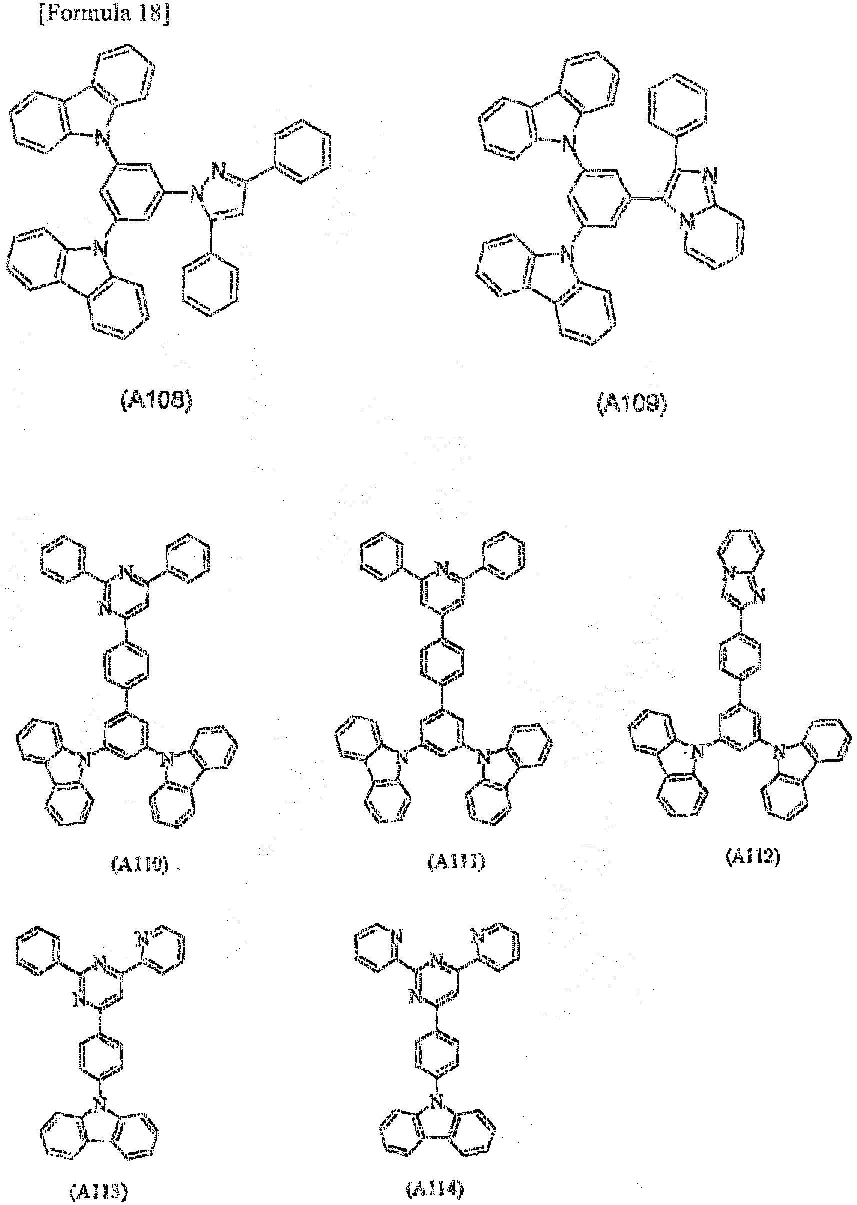

Specific examples of the compound represented by the formula (8) are shown below, but the compound represented by the formula (8) is not limited thereto.

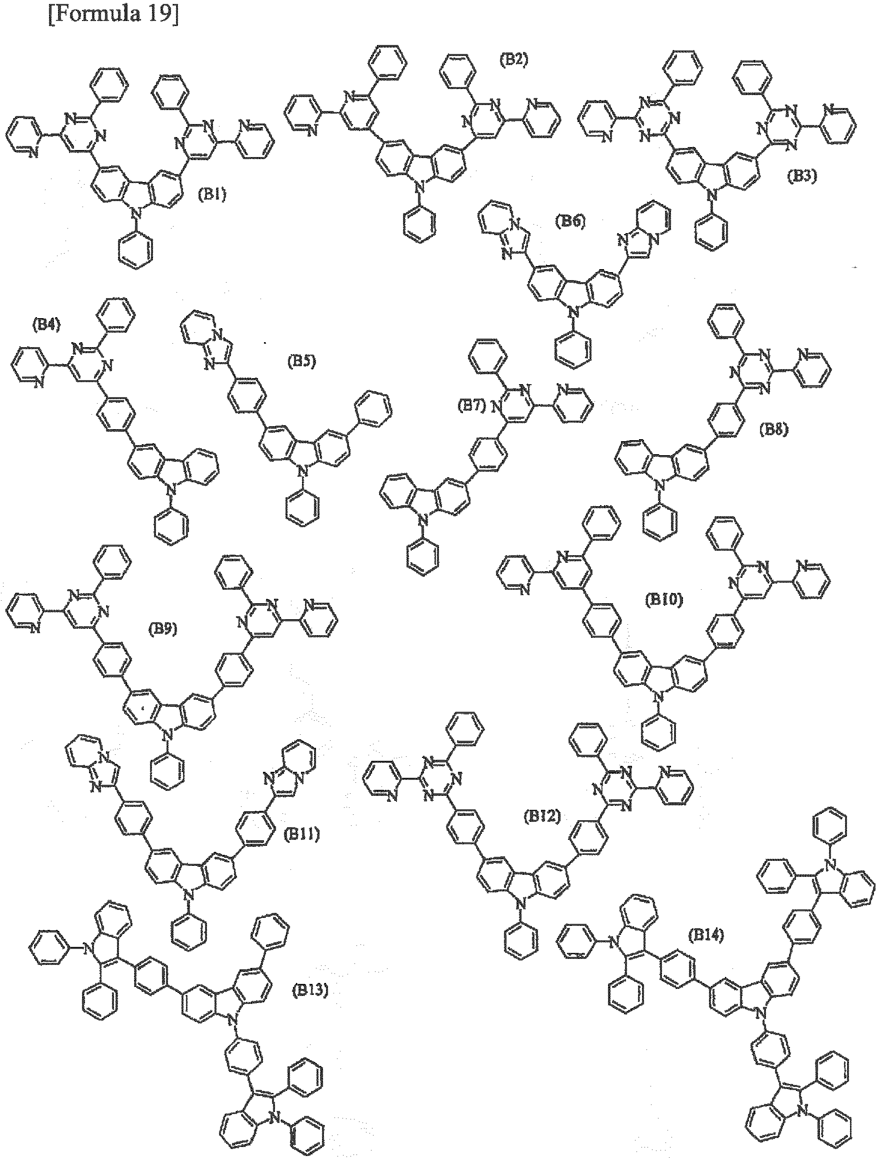

The compound represented by the formula (7) or (8) in this exemplary embodiment has triplet energy gap of 2.5 eV to 3.3 eV, preferably 2.5 eV to 3.2 eV.
The compound represented by the formula (7) or (8) in this exemplary embodiment has singlet energy gap of 2.8 eV to 3.8 eV, preferably 2.9 eV to 3.7 eV.

### Compound Represented by Formula (9)

The biscarbazole derivative represented by the formula (9) is more preferably represented by a formula (10) below.

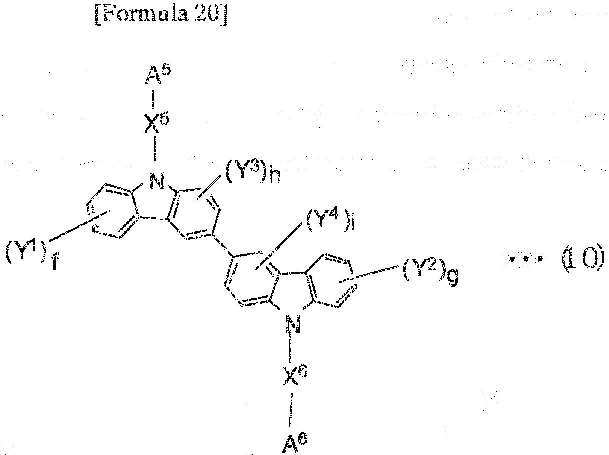

In the formula (10), A⁵, A⁶, X⁵, X⁶, Y¹ to Y⁴, f, g, h and i are the same as those in the formula (9).

Further, in the formula (10), A⁵ is preferably selected from the group consisting of a substituted or unsubstituted pyridine ring, pyrimidine ring and triazine ring. A⁵ is particularly preferably a substituted or unsubstituted pyrimidine ring.

In the formulae (9) and (10), X⁵ is preferably a single bond, or a substituted or unsubstituted divalent aromatic hydrocarbon group or fused aromatic hydrocarbon group having 6 to 30 ring carbon atoms, particularly preferably a benzene ring.
When X⁵ is a substituted or unsubstituted benzene ring in the formulae (9) and (10), A⁵ and the carbazolyl group, which are bonded to X¹, are preferably at meta-positions or para-positions. Particularly preferably, X⁵ is unsubstituted para-phenylene.

In the formula (9) or (10), the pyridine ring, the pyrimidine ring and the triazine ring are more preferably represented by the following formulae. In the formulae, Y and Y' represent a substituent. Examples of the substituent are the same groups as those represented by Y¹ to Y⁴ as described above. Y and Y' may be the same or different. Preferred examples thereof are the substituted or unsubstituted aromatic hydrocarbon group or fused aromatic hydrocarbon group having 6 to 30 ring carbon atoms, and the substituted or unsubstituted aromatic heterocyclic group or fused aromatic heterocyclic group having 2 to 30 ring carbon atoms. In the following formulae, * represents a bonding position to X⁵ or X⁶.

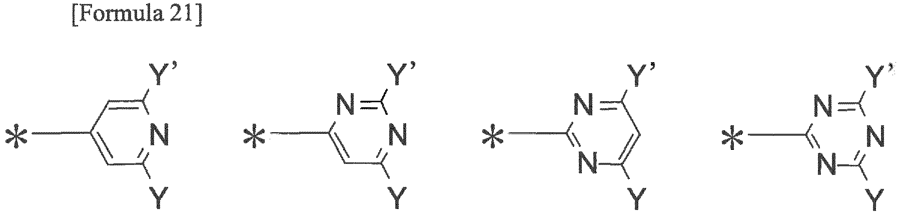

In the formulae (9) and (10), the alkyl group, the alkoxy group, the haloalkyl group, the haloalkoxy group and the alkylsilyl group, which are represented by Y¹ to Y⁴, may be linear, branched or cyclic.

In the formulae (9) and (10), examples of the alkyl group having 1 to 20 carbon atoms are a methyl group, an ethyl group, a propyl group, an isopropyl group, an n-butyl group, a s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neo-pentyl group, a 1-methylpentyl group, a 2-methylpentyl group, a 1-pentylhexyl group, a 1-butylpentyl group, a 1-heptyloctyl group, a 3-methylpentyl group, a cyclopentyl group, a cyclohexyl group, a cyclooctyl group and a 3,5-tetramethylcyclohexyl group.

As the alkoxy group having 1 to 20 carbon atoms, an alkoxy group having 1 to 6 carbon atoms is preferable and specific examples thereof are a methoxy group, an ethoxy group, a propoxy group, a butoxy group, a pentyloxy group, and a hexyloxy group.

The haloalkyl group having 1 to 20 carbon atoms is exemplified by a haloalkyl group provided by substituting the alkyl group having 1 to 20 carbon atoms with one or more halogen groups.
The haloalkoxy group having 1 to 20 carbon atoms is exemplified by a haloalkoxy group provided by substituting the alkoxy group having 1 to 20 carbon atoms by one or more halogen groups.

Examples of the alkylsilyl group having 1 to 10 carbon atoms are a trimethylsilyl group, a triethylsilyl group, a tributylsilyl group, a dimethylethylsilyl group, dimethylisopropylsilyl group, a dimethylpropylsilyl group, a dimethylbutylsilyl group, dimethyl-tertiary-butylsilyl group and a diethylisopropylsilyl group.

Examples of the arylsilyl group having 6 to 30 carbon atoms are a phenyldimethylsilyl group, a diphenylmethylsilyl group, a diphenyl-tertiary-butylsilyl group and a triphenylsilyl group.

Examples of the aromatic heterocyclic group or fused aromatic heterocyclic group having 2 to 30 ring carbon atoms are a pyroryl group, a pyrazinyl group, a pyridinyl group, an indolyl group, an isoindolyl group, a furyl group, a benzofuranyl group, an isobenzofuranyl group, a dibenzofuranyl group, a dibenzothiophenyl group, a quinolyl group, an isoquinolyl group, a quinoxalinyl group, a carbazolyl group, a phenantridinyl group, an acridinyl group, a phenanthrolinyl group, a thienyl group and a group formed from a pyridine ring, a pyrazine ring, a pyrimidine ring, a pyridazine ring, a triazine ring, an indol ring, a quinoline ring, an acridine ring, a pirrolidine ring, a dioxane ring, a piperidine ring, a morpholine ring, a piperadine ring, a carbazole ring, a furan ring, a thiophene ring, an oxazole ring, an oxadiazole ring, a benzooxazole ring, a thiazole ring, a thiadiazole ring, a benzothiazole ring, a triazole ring, an imidazole ring, a benzoimidazole ring, a pyrane ring and a dibenzofuran ring.

Examples of the aromatic hydrocarbon group or fused aromatic hydrocarbon group having 6 to 30 ring carbon atoms are a phenyl group, a naphthyl group, a phenanthryl group, a biphenyl group, a terphenyl group, a quarterphenyl group, a fluoranthenyl group, a triphenylenyl group and a phenanthrenyl group.

When A⁵, A⁶, X⁵, X⁶ and Y¹ to Y⁴ of the formulae (9) and (10) each have one or more substituents, the substituents are preferably a linear, branched or cyclic alkyl group having 1 to 20 carbon atoms; a linear, branched or cyclic alkoxy group having 1 to 20 carbon atoms; a linear, branched or cyclic haloalkyl group having 1 to 20 carbon atoms; a linear, branched or cyclic alkylsilyl group having 1 to 10 carbon atoms; an arylsilyl group having 6 to 30 ring carbon atoms; a cyano group; a halogen atom; an aromatic hydrocarbon group or fused aromatic hydrocarbon group having 6 to 30 ring carbon atoms; or an aromatic heterocyclic group or fused aromatic heterocyclic group having 2 to 30 ring carbon atoms.

Examples of the linear, branched or cyclic alkyl group having 1 to 20 carbon atoms; a linear, branched or cyclic alkoxy group having 1 to 20 carbon atoms; a linear, branched or cyclic haloalkyl group having 1 to 20 carbon atoms; a linear, branched or cyclic alkylsilyl group having 1 to 10 carbon atoms; an arylsilyl group having 6 to 30 ring carbon atoms; an aromatic hydrocarbon group or fused aromatic hydrocarbon group having 6 to 30 ring carbon atoms; and an aromatic heterocyclic group or fused aromatic heterocyclic group having 2 to 30 ring carbon atoms are the above-described groups. The halogen atom is exemplified by a fluorine atom.

Examples of compounds represented by the formulae (9) and (10) are as follows.

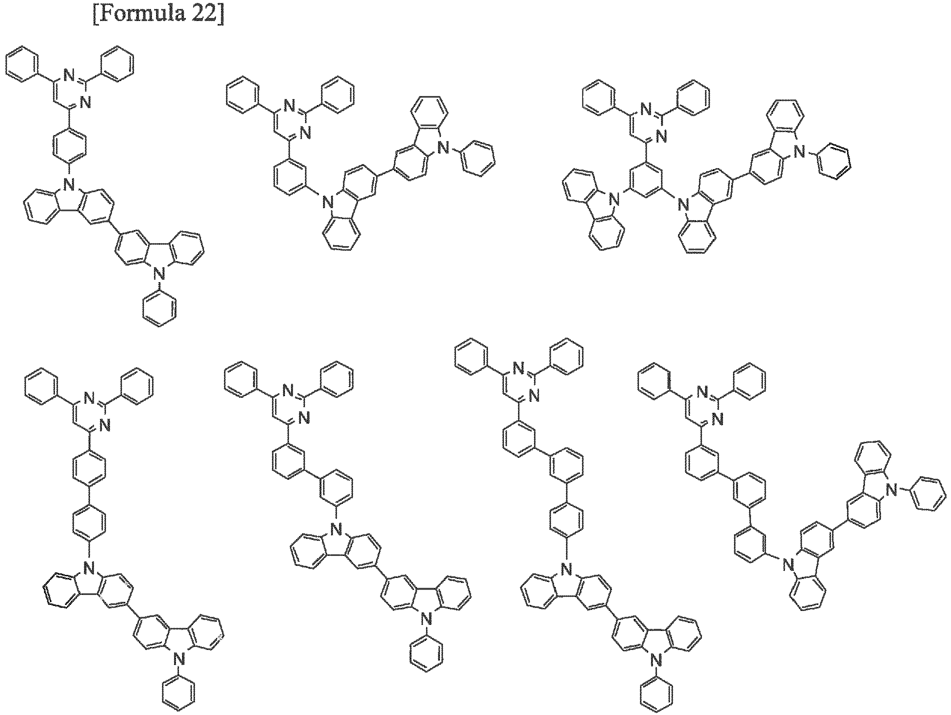

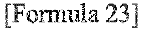

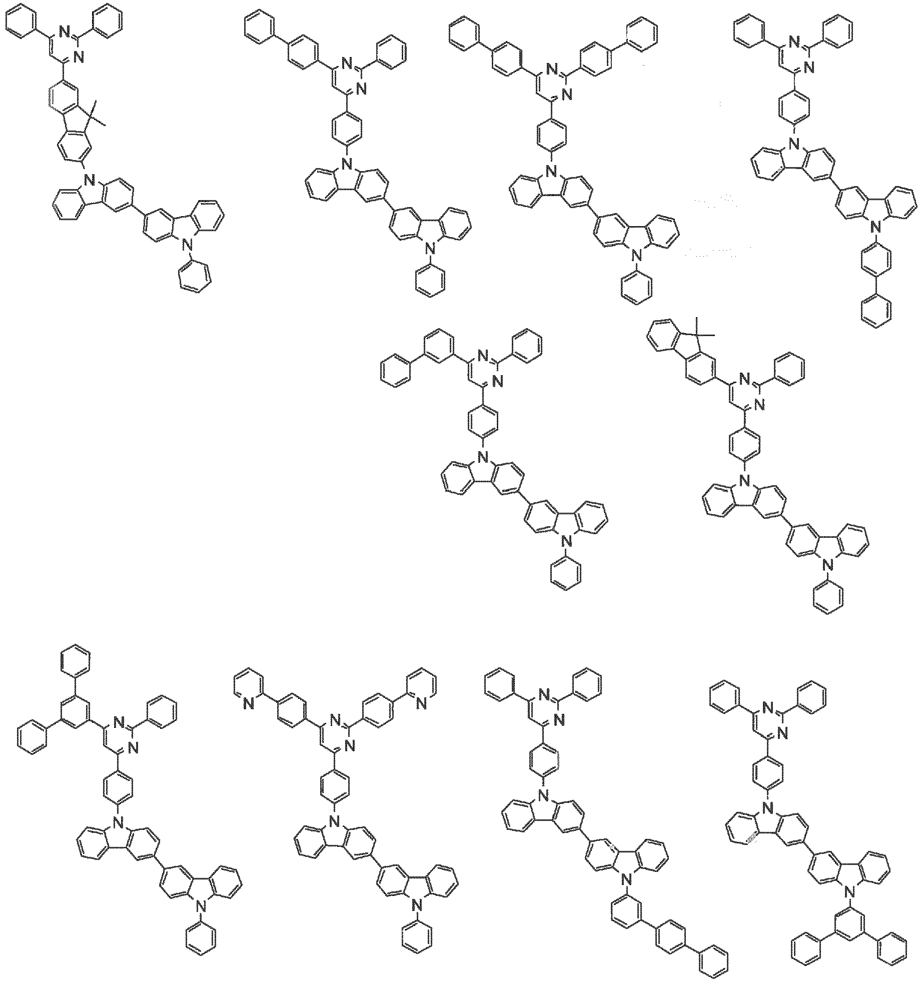

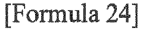

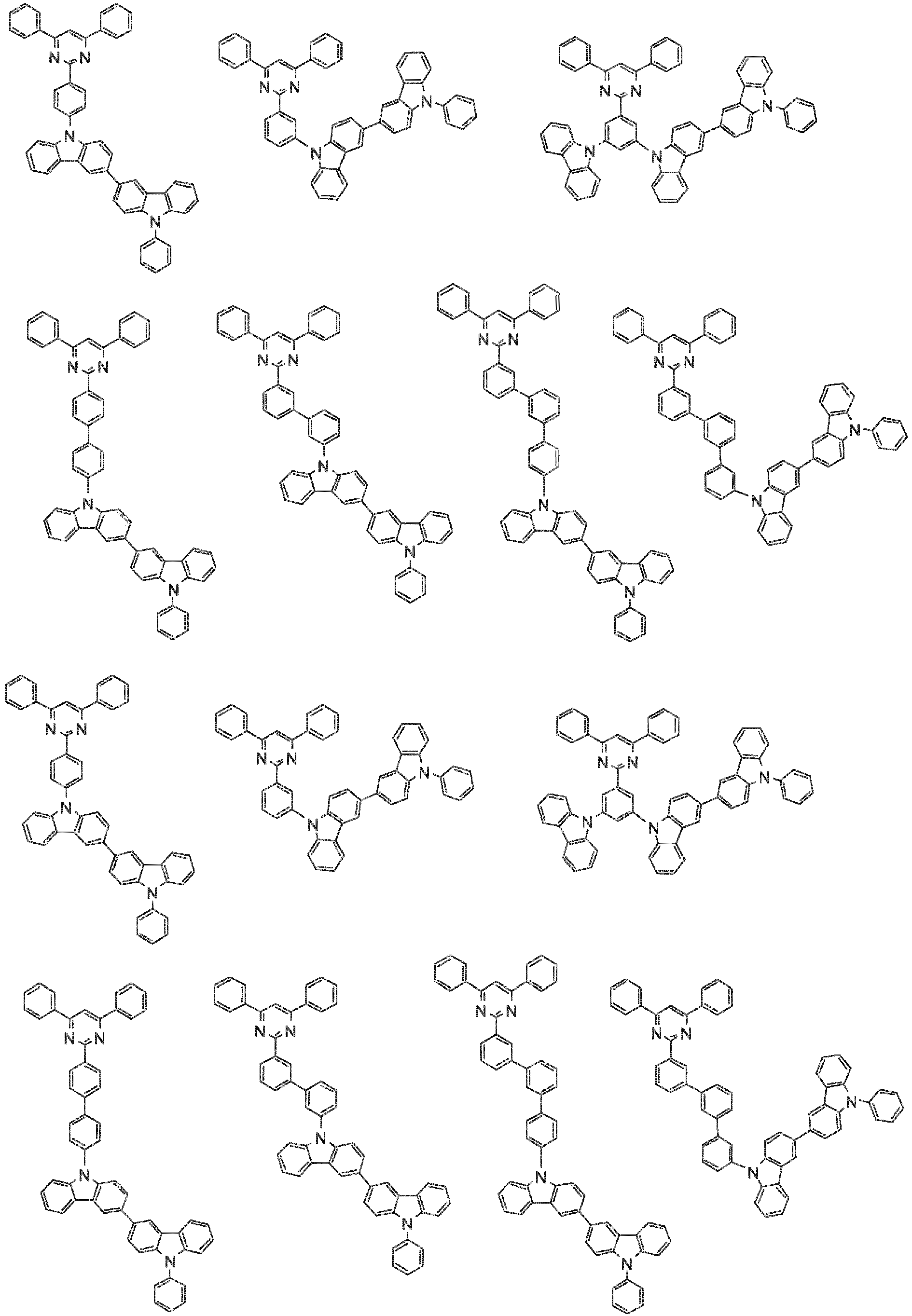

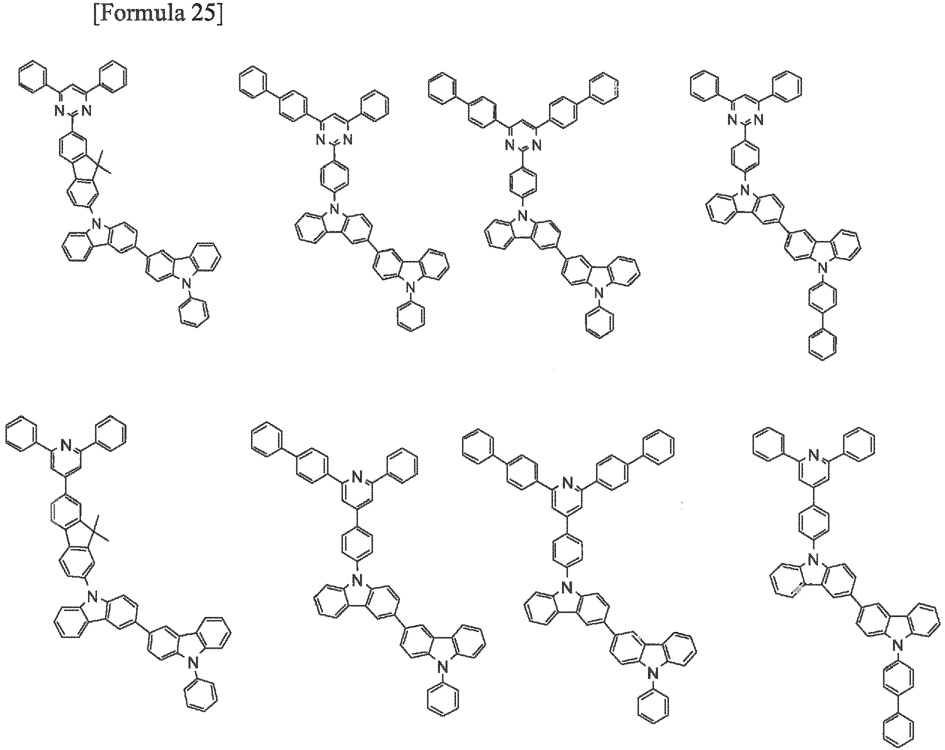

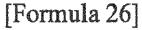

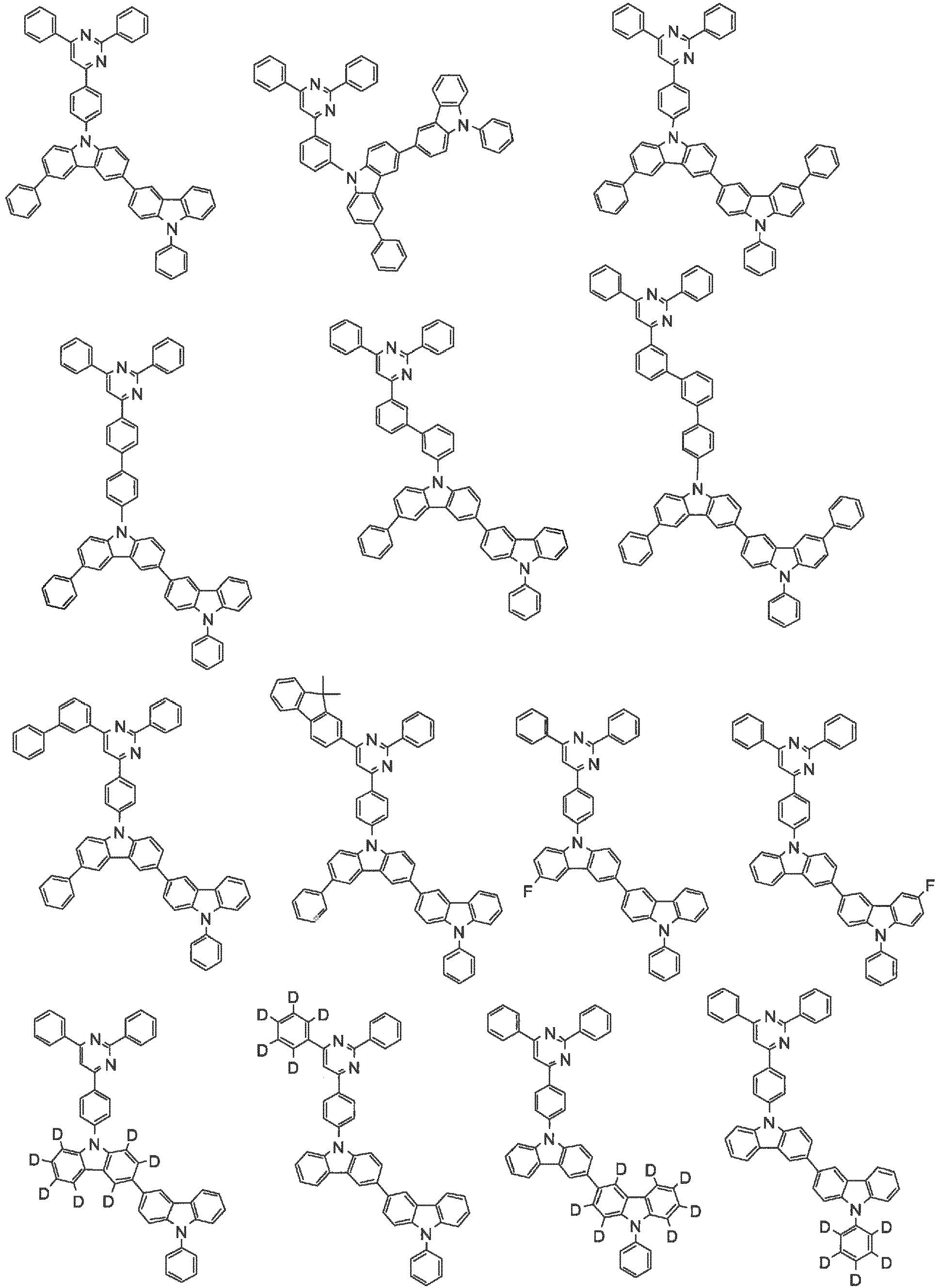

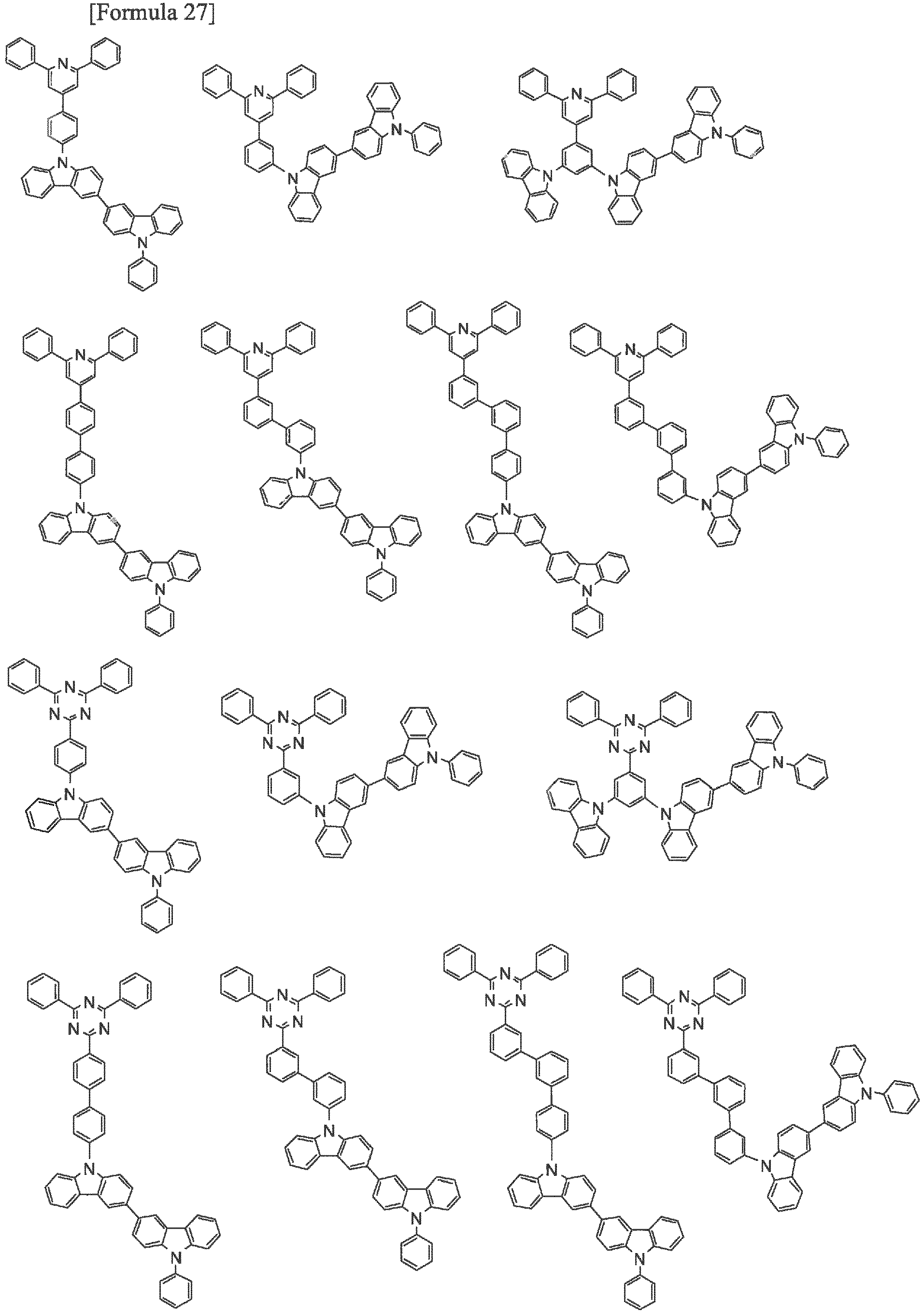

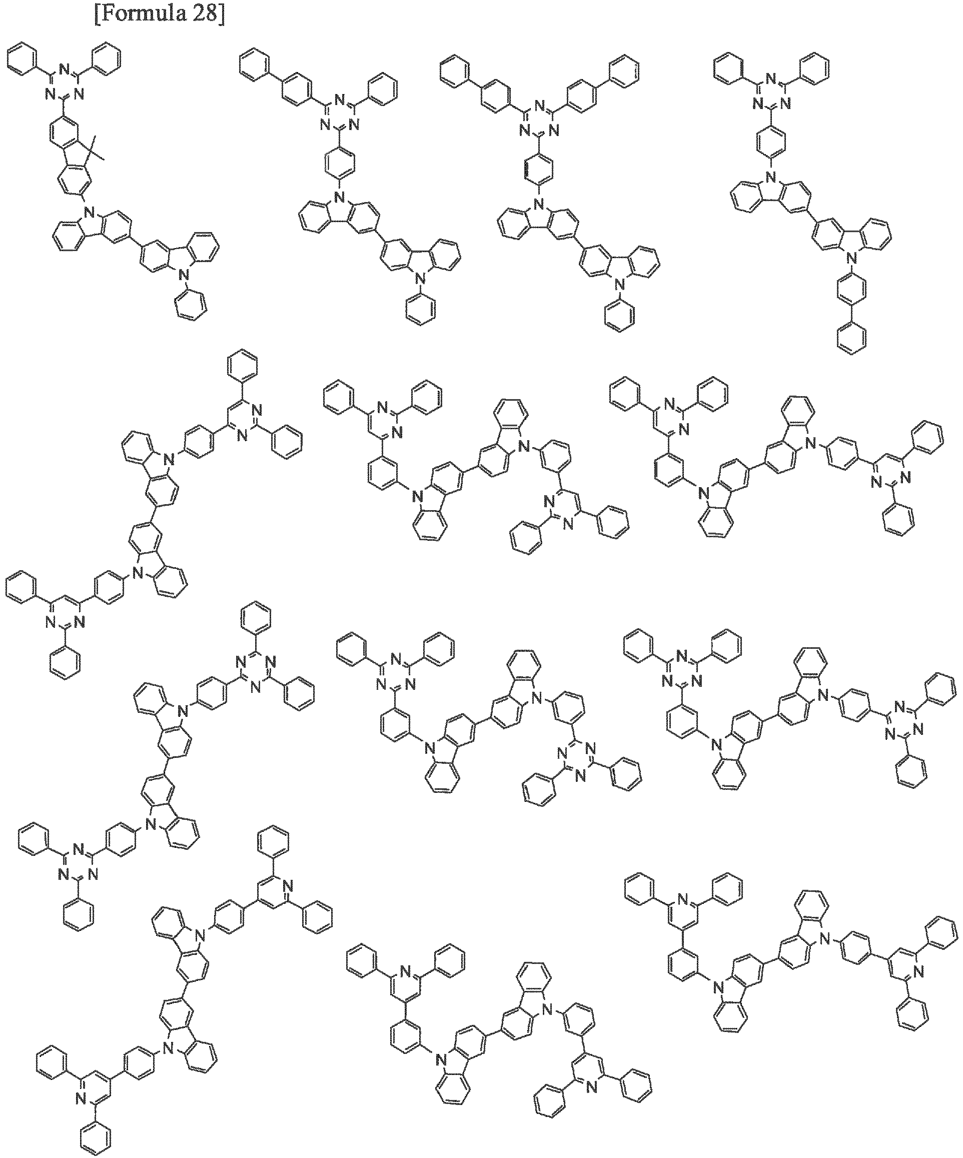

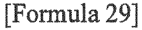

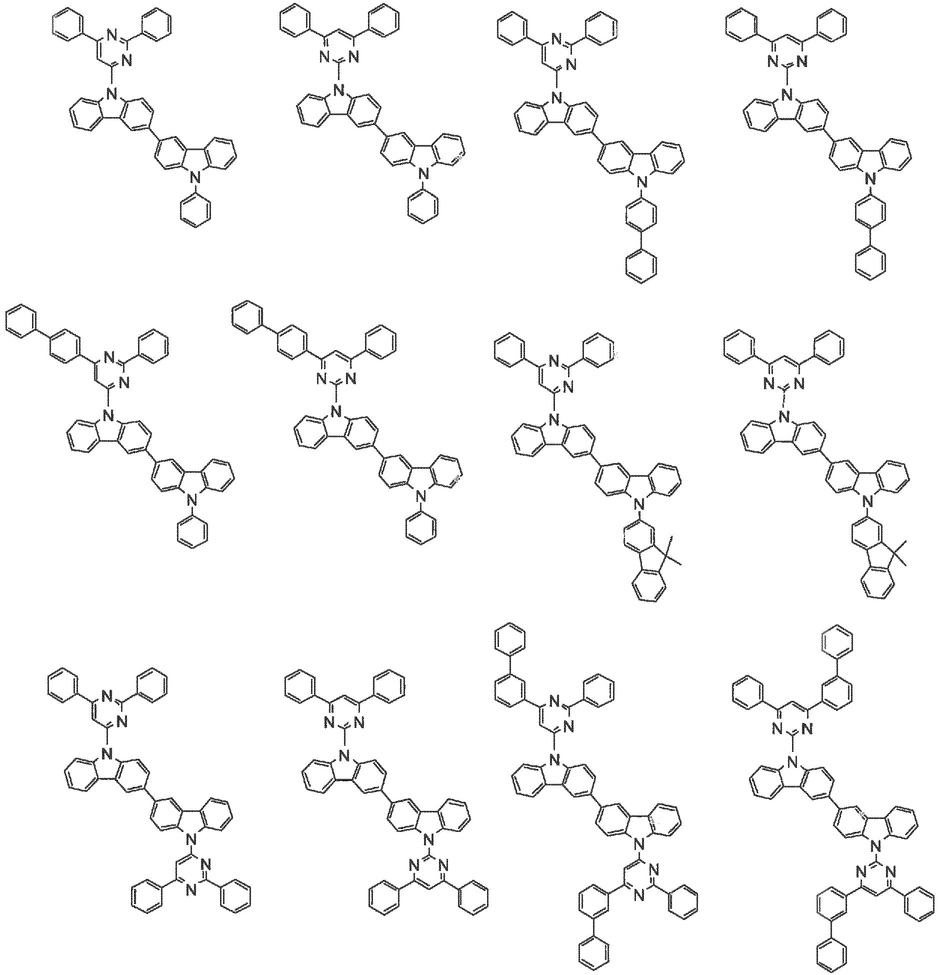

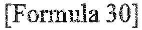

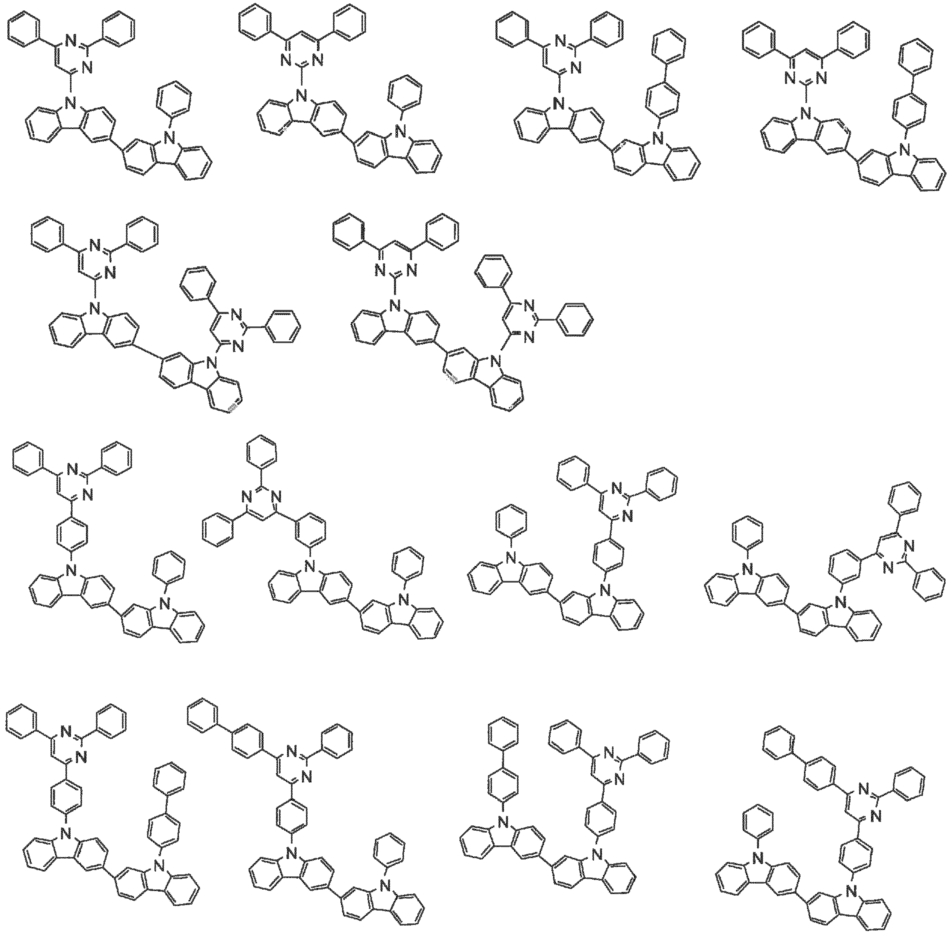

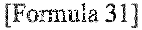

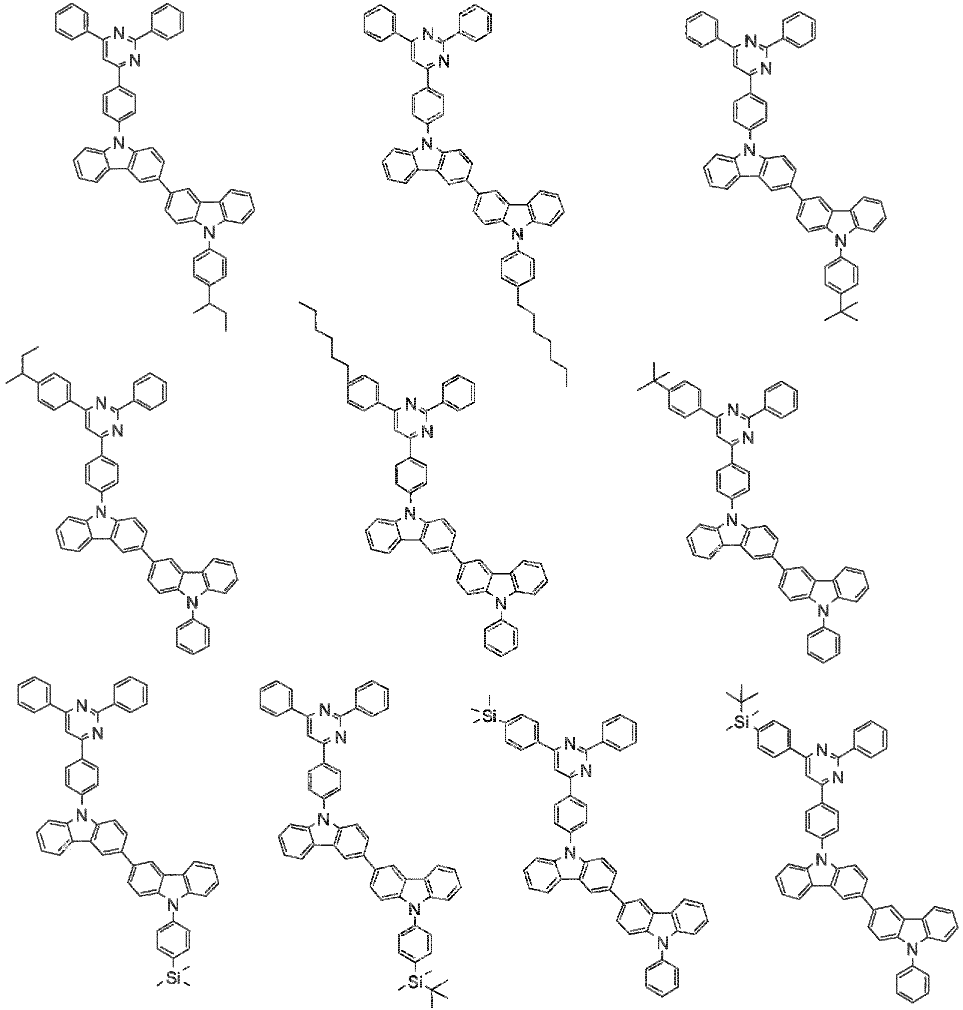

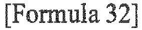

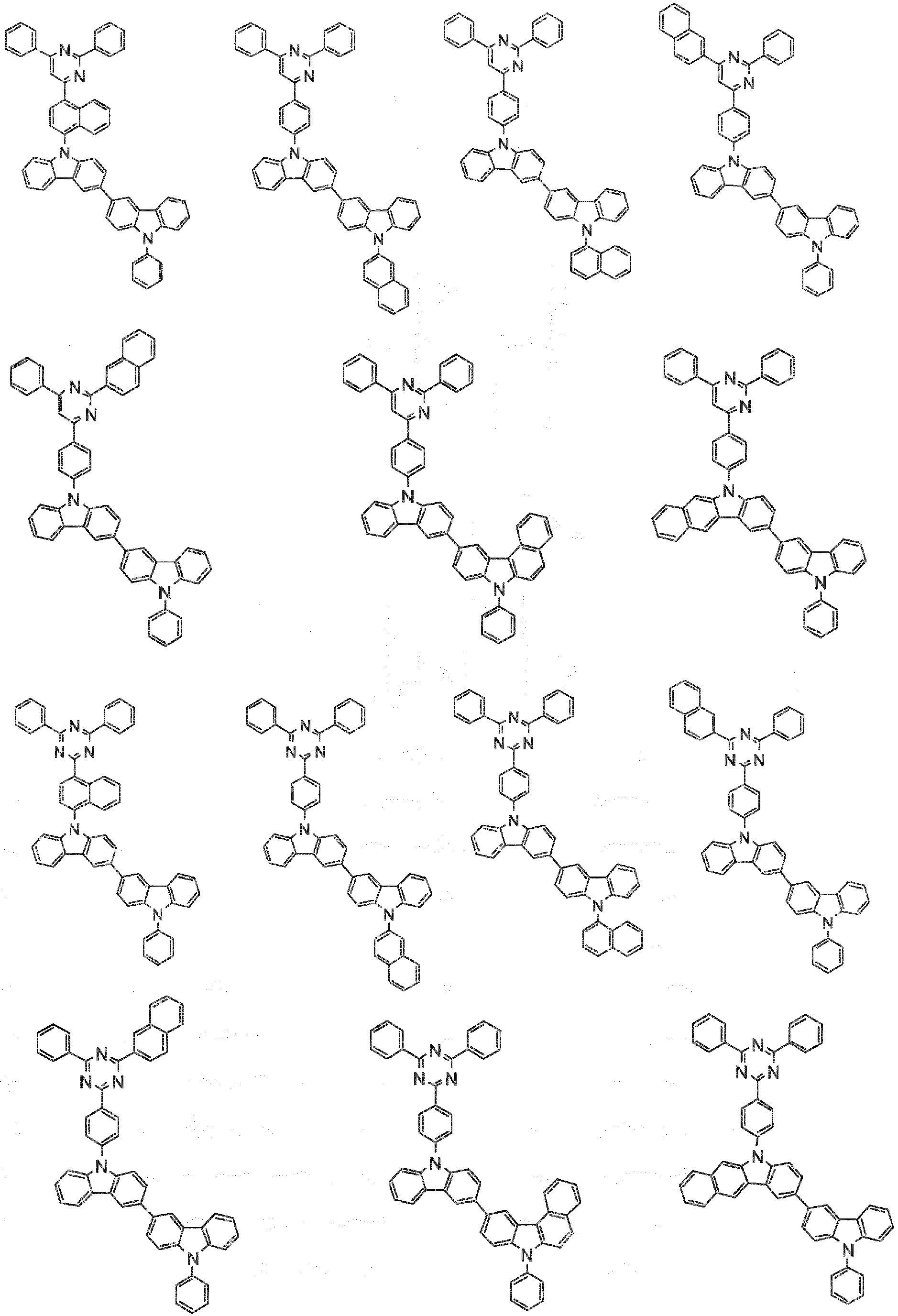

### Second Host

The organic electroluminescence device according to this exemplary embodiment contains a compound represented by a formula (11) or (12) below as the second host. 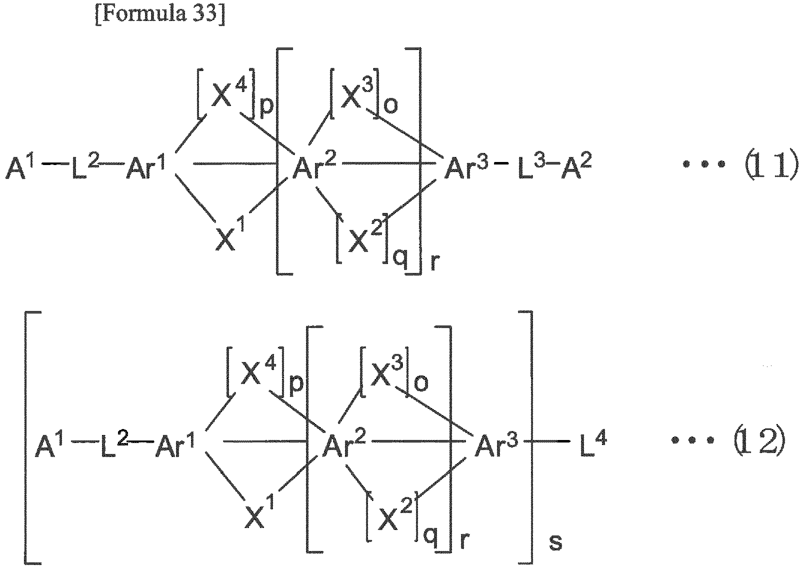 In the above formulae (11) and (12), Ar¹, Ar² and Ar³ each independently represent a substituted or unsubstituted aromatic hydrocarbon group having 6 ring carbon atoms or a substituted or unsubstituted aromatic heterocyclic group having 6 ring atoms.
Ar¹, Ar² and Ar³ may have one or more substituents Y. A plurality of Y may be mutually different.
Y represents an alkyl group having 1 to 20 carbon atoms, a substituted or unsubstituted cycloalkyl group having 3 to 20 ring carbon atoms, an alkoxy group having 1 to 20 carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.
In the formulae (1) and (2), X¹, X², X³ and X⁴ independently represent oxygen (O), sulfur (S), N-R¹ or CR²R³.
R¹, R² and R³ each independently represent an alkyl group having 1 to 20 carbon atoms, a substituted or unsubstituted cycloalkyl group having 3 to 20 ring carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.
However, when both of X₁ and X₂ represent N-R¹, o and p are 0, and q is 1, or when both of X₁ and X³ represent N-R¹, p and q are 0, and o is 1, at least one R¹ represents a substituted or unsubstituted monovalent fused aromatic heterocyclic group having 8 to 24 ring atoms.
In the formulae (1) and (2), o, p and q represent 0 or 1. s represents 1, 2, 3 or 4, which respectively mean a monomer, a dimer, a trimer and a tetramer, each of which uses L⁴ as a linking group. r represents 1, 2, 3 or 4.
In the formulae (1) and (2), L² represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted monovalent or divalent aromatic heterocyclic group or fused aromatic heterocyclic group having 3 to 24 ring carbon atoms.
In the formula (1), L³ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring carbon atoms.
In the formula (2), when s is 2, L⁴ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring carbon atoms.
When s is 3, L⁴ represents a trivalent saturated hydrocarbon group having 1 to 20 carbon atoms, a substituted or unsubstituted trivalent saturated cyclic hydrocarbon group having 3 to 20 ring carbon atoms, a trivalent silyl group, a trivalent substituted-silyl group having 1 to 20 carbon atoms, a substituted or unsubstituted trivalent aromatic hydrocarbon group or fused aromatic hydrocarbon group having 6 to 24 ring carbon atoms, or a substituted or unsubstituted trivalent aromatic heterocyclic group or fused aromatic heterocyclic group having 3 to 24 ring carbon atoms.
When s is 4, L⁴ represents a tetravalent saturated hydrocarbon group having 1 to 20 carbon atoms, a substituted or unsubstituted tetravalent saturated cyclic hydrocarbon group having 3 to 20 ring carbon atoms, a silicon atom, a substituted or unsubstituted tetravalent aromatic hydrocarbon group or fused aromatic hydrocarbon group having 6 to 24 ring carbon atoms, or a substituted or unsubstituted tetravalent aromatic heterocyclic group or fused aromatic heterocyclic group having 3 to 24 ring carbon atoms.
In the formulae (1) and (2), A¹ represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.
In the formula (1), A² represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.

In this exemplary embodiment, it is preferable that the compound represented by the formula (1) is represented by a formula (13) or (15) below and the compound represented by the formula (2) is represented by a formula (14) or (16) below.

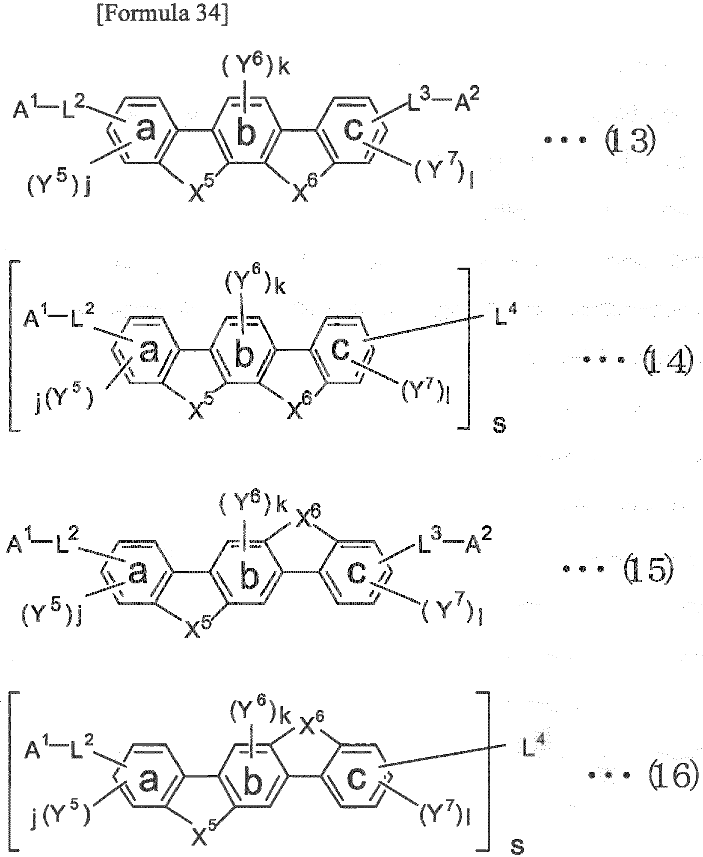

In the formulae (13) to (16), X⁵ and X⁶ each independently represent oxygen (O), sulfur (S), N-R¹ or CR²R³.
R¹, R² and R³ independently represent an alkyl group having 1 to 20 carbon atoms, a substituted or unsubstituted cycloalkyl group having 3 to 20 ring carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms. However, when X⁵ and X⁶ are both N-R¹, at least one R¹ is a substituted or unsubstituted monovalent fused aromatic heterocyclic group having 8 to 24 ring atoms.
In the formulae (14) and (16), s represents 2, 3 or 4, which respectively mean a dimer, a trimer and a tetramer each of which uses L⁴ as the bonding group.
In the formulae (13) to (16), L² represents a single bond, an alkylene group having 1 to 20 carbon atoms, a substituted or unsubstituted cycloalkylene group having 3 to 20 ring carbon atoms, a divalent silyl group, a divalent silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring carbon atoms with a benzene ring (a).
In the formulae (13) and (15), L³ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring carbon atoms that links to a benzene ring (c).
In the formulae (14) and (16), when s is 2, L⁴ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused hydrocarbon group having 6 to 24 ring carbon atoms, or a substituted or unsubstituted divalent aromatic heterocyclic group or fused aromatic heterocyclic group having 3 to 24 ring carbon atoms with the benzene ring (c). When s is 3, L⁴ represents a trivalent saturated hydrocarbon group having 1 to 20 carbon atoms, a substituted or unsubstituted trivalent saturated cyclic hydrocarbon group having 3 to 20 ring carbon atoms, a trivalent silyl group or trivalent substituted-silyl group having 1 to 20 carbon atoms, a substituted or unsubstituted trivalent aromatic hydrocarbon group or fused aromatic hydrocarbon group having 6 to 24 ring carbon atoms, or a substituted or unsubstituted trivalent aromatic heterocyclic group or fused aromatic heterocyclic group having 3 to 24 ring atoms with the benzene ring (c). When s is 4, L⁴ represents a tetravalent saturated hydrocarbon group having 1 to 20 carbon atoms, a substituted or unsubstituted tetravalent saturated cyclic hydrocarbon group having 3 to 20 ring carbon atoms, a silicon atom, a substituted or unsubstituted tetravalent aromatic hydrocarbon group or fused aromatic hydrocarbon group having 6 to 24 ring carbon atoms, or a substituted or unsubstituted tetravalent aromatic heterocyclic group or fused aromatic heterocyclic group having 3 to 24 ring atoms with the benzene ring (c).
In the formulae (13) to (16), A¹ represents a hydrogen atom, a substituted or unsubstituted cycloalkyl group having 3 to 20 ring carbon atoms, a silyl group having 3 to 20 carbon atoms, a substituted or unsubstituted aromatic hydrocarbon group or fused aromatic hydrocarbon group having 6 to 24 ring carbon atoms, or an aromatic heterocyclic group or fused aromatic heterocyclic group having 3 to 24 ring carbon atoms that links to L².
In the formulae (13) and (15), A² represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or an aromatic heterocyclic group or fused aromatic heterocyclic group having 3 to 24 ring carbon atoms that links to L³.
In the formulae (13) to (16), Y⁵, Y⁶ and Y⁷ represent an alkyl group having 1 to 20 carbon atoms, a substituted or unsubstituted cycloalkyl group having 3 to 20 ring carbon atoms, an alkoxy group having 1 to 20 carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms with the benzene rings (a), (b) and (c). j and 1 each are 0, 1, 2 or 3. k is 0, 1 or 2.
In the formulae (13) to (16), A¹, A², L², L³ and L⁴ do not contain any carbonyl groups.

The compounds represented by the formulae (13) to (16) are preferably represented by any one of formulae (17) to (20) below.

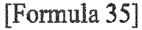

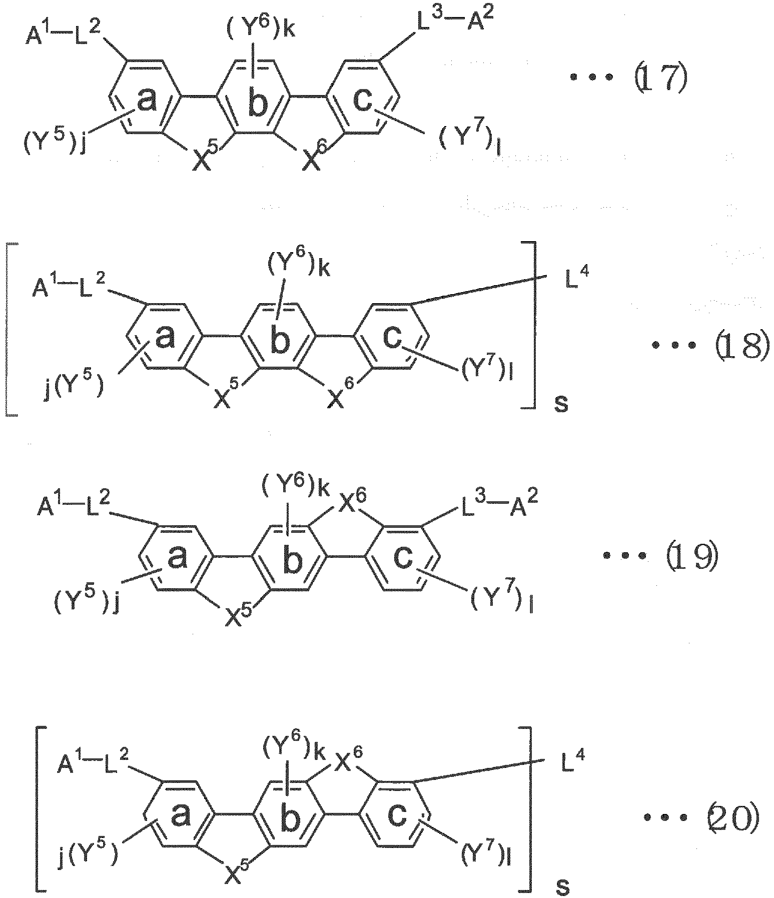

In the formulae (17) to (20), A¹, A², L² to L⁴, X⁵, X⁶, Y⁵ to Y⁷, s and j to 1 represent the same as those of the formulae (13) to (16).

In the exemplary embodiment, it is preferable that at least one of X⁵ and X⁶ in the formulae (17) to (20) is an oxygen atom and the compound represented by any one of the formulae (17) to (20) has a benzofuran structure.
Further, it is more preferable that both X⁵ and X⁶ in the formulae (17) to (20) are oxygen atoms and the compound represented by any one of the formulae (17) to (20) has a benzofurano dibenzofuran structure.
Particularly preferably, each of the compounds represented by the formulae (17) and (19) has a benzofurano dibenzofurano structure.

In the exemplary embodiment, the compound represented by the formula (1) or (2) is preferably represented by formulae (21) to (28) below.

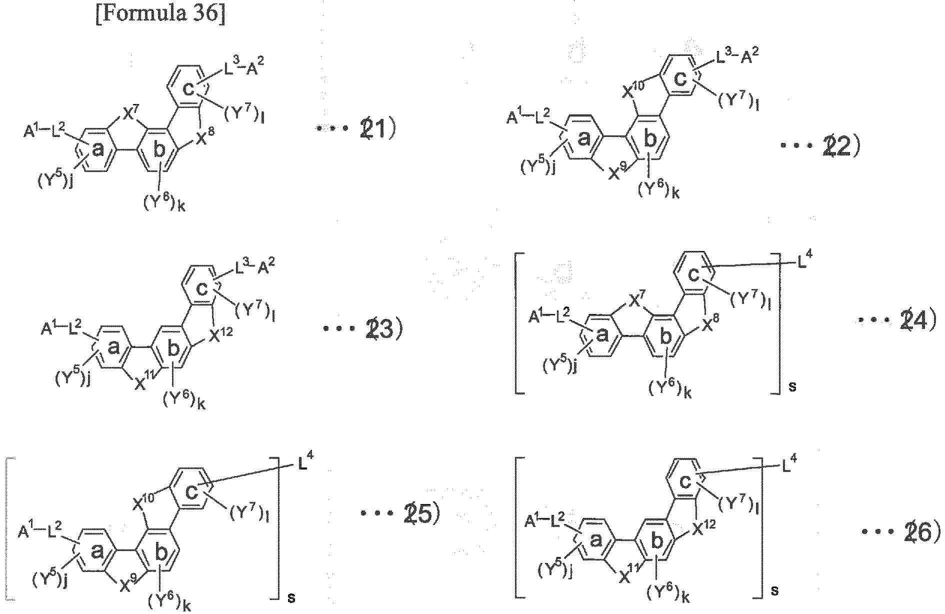

In the formulae (21) to (26), X⁷, X⁸, X⁹, X¹⁰, X¹¹ and X¹² each independently represent oxygen (O), sulfur (S), N-R¹ or CR²R³.
R¹, R² and R³ independently represent an alkyl group having 1 to 20 carbon atoms, a substituted or unsubstituted cycloalkyl group having 3 to 20 ring carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring atoms. When both of X⁷ and X⁸, X⁹ and X¹⁰ or X¹¹ and X¹² are N-R¹, at least one R¹ is a substituted or unsubstituted monovalent fused aromatic heterocyclic group or fused aromatic heterocyclic group having 8 to 24 ring atoms.
In the formulae (24) to (26), s represents 2, 3 or 4, which respectively mean a dimer, a trimer and a tetramer each of which uses L⁴ as the linking group.
In the formulae (21) to (26), L² represents a single bond, an alkylene group having 1 to 20 carbon atoms, a substituted or unsubstituted cycloalkylene group having 3 to 20 ring carbon atoms, a divalent silyl group, a divalent silyl group having 2 to 20 carbon atoms, a substituted or unsubstituted divalent aromatic hydrocarbon group or fused aromatic hydrocarbon group having 6 to 24 ring carbon atoms, or a substituted or unsubstituted monovalent or divalent aromatic heterocyclic group or fused aromatic heterocyclic group having 3 to 24 ring atoms that links to the benzene ring (a) in carbon-carbon bonding.
In the formulae (21) to (23), L³ represents a single bond, an alkylene group having 1 to 20 carbon atoms, a substituted or unsubstituted cycloalkylene group having 3 to 20 ring carbon atoms, a divalent silyl group, a divalent silyl group having 2 to 20 carbon atoms, a substituted or unsubstituted monovalent or divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring atoms that links to the benzene ring (c) in carbon-carbon bonding. When both of X⁷ and X⁸, X⁹ and X¹⁰ or X¹¹ and X¹² are CR²R³, and L² and L³ both are a substituted or unsubstituted monovalent or divalent aromatic hydrocarbon group or fused aromatic hydrocarbon group having 6 to 24 ring carbon atoms, L² and L³ do not link to the benzene ring (b) at para-positions at the same time.
In the formulae (24) to (26), when s is 2, L⁴ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused hydrocarbon group having 6 to 24 ring carbon atoms, or a substituted or unsubstituted divalent aromatic heterocyclic group or fused aromatic heterocyclic group having 3 to 24 ring atoms that links to the benzene ring (c) in carbon-carbon bonding.
When s is 3, L⁴ represents a trivalent saturated hydrocarbon group having 1 to 20 carbon atoms, a substituted or unsubstituted trivalent saturated cyclic hydrocarbon group having 3 to 20 ring carbon atoms, a trivalent silyl group, a trivalent substituted-silyl group having 1 to 20 carbon atoms, a substituted or unsubstituted trivalent aromatic hydrocarbon group having 6 to 24 ring carbon atoms, or a substituted or unsubstituted trivalent aromatic heterocyclic group or fused aromatic heterocyclic group having 3 to 24 ring atoms that links to the benzene ring (c) in carbon-carbon bonding. When s is 4, L⁴ represents a tetravalent saturated hydrocarbon group having 1 to 20 carbon atoms, a substituted or unsubstituted tetravalent saturated cyclic hydrocarbon group having 3 to 20 ring carbon atoms, a silicon atom, a substituted or unsubstituted tetravalent aromatic hydrocarbon group or fused aromatic hydrocarbon group having 6 to 24 ring carbon atoms, or a substituted or unsubstituted tetravalent aromatic heterocyclic group or fused aromatic heterocyclic group having 3 to 24 ring atoms that links to the benzene ring (c) in carbon-carbon bonding. However, when both of X⁷ and X⁸, X⁹ and X¹⁰ or X¹¹ and X¹² are CR²R³, and L² and L⁴ both are a substituted or unsubstituted divalent, trivalent or tetravalent aromatic hydrocarbon group or fused aromatic hydrocarbon group having 6 to 24 ring carbon atoms, L² and L⁴ do not link to the benzene ring (b) at para-positions at the same time.
In the formulae (21) to (26), A¹ represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or an aromatic heterocyclic group or fused aromatic heterocyclic group having 3 to 24 ring atoms that links to L² in carbon-carbon bonding. However, when L² is an alkylene group having 1 to 20 carbon atoms, A¹ is not a hydrogen atom.
In the formulae (21) to (23), A² represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or an aromatic heterocyclic group or fused aromatic heterocyclic group having 3 to 24 ring atoms that links to L³ in carbon-carbon bonding. However, when L³ is an alkylene group having 1 to 20 carbon atoms, A² is not a hydrogen atom.
In the formulae (21) to (26), Y⁵, Y⁶ and Y⁷ represent an alkyl group having 1 to 20 carbon atoms, a substituted or unsubstituted cycloalkyl group having 3 to 20 ring carbon atoms, an alkoxy group having 1 to 20 carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring atoms that links to the benzene rings (a), (b) and (c) in carbon-carbon bonding. j and 1 each are 0, 1, 2 or 3. k is 0, 1 or 2. However, when X⁷ and X⁸, X⁹ and X¹⁰ or X¹¹ and X¹² are oxygen (O), sulfur (S) or CR²R³, L² and L³ both are single bonds, and A¹ and A² both are hydrogen atoms, the benzene ring (b) has one or two Y⁶ that is neither a methyl group nor an unsubstituted phenyl group.
In the formulae (21) to (26), A¹, A², L², L³ and L⁴ do not contain any carbonyl groups.

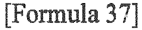

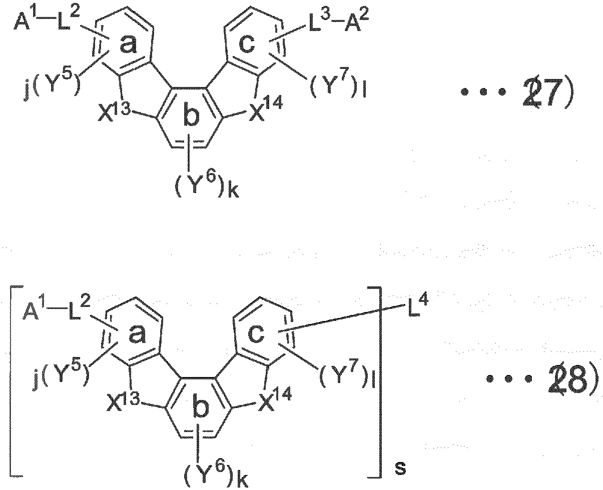

In the formulae (27) and (28), X¹³ and X¹⁴ each independently represent oxygen (O), sulfur (S), N-R₁ or CR₂R₃.
R¹, R² and R³ independently represent an alkyl group having 1 to 20 carbon atoms, a substituted or unsubstituted cycloalkyl group having 3 to 20 ring carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or substituted or unsubstituted aromatic heterocyclic group or fused aromatic heterocyclic group having 3 to 24 ring atoms. When X¹³ and X¹⁴ are both N-R¹, at least one R¹ is a substituted or unsubstituted monovalent fused aromatic heterocyclic group and fused aromatic heterocyclic group having 8 to 24 ring atoms.
In the formula (28), s represents 2, 3 or 4, which respectively mean a dimer, a trimer and a tetramer each of which uses L⁴ as the linking group.
In the formulae (27) and (28), L² represents a single bond, an alkylene group having 1 to 20 carbon atoms, a substituted or unsubstituted cycloalkylene group having 3 to 20 ring carbon atoms, a divalent silyl group, a divalent silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring atoms that links to the benzene ring (a) in carbon-carbon bonding.
In the formula (27), L³ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring atoms that links to the benzene ring (c) in carbon-carbon bonding. When X¹³ and X¹⁴ both are CR²R³, and L² and L³ both are a substituted or unsubstituted divalent aromatic hydrocarbon group or fused aromatic hydrocarbon group having 6 to 24 ring carbon atoms, L² and L³ do not link to the benzene ring (b) at para-positions at the same time.
In the formula (28), when s is 2, L⁴ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused hydrocarbon group having 6 to 24 ring carbon atoms, or a substituted or unsubstituted divalent aromatic heterocyclic group or fused aromatic heterocyclic group having 3 to 24 ring atoms that links to the benzene ring (c) in carbon-carbon bonding. When s is 3, L⁴ represents a trivalent saturated hydrocarbon group having 1 to 20 carbon atoms, a substituted or unsubstituted trivalent saturated cyclic hydrocarbon group having 3 to 20 ring carbon atoms, a trivalent silyl group, a trivalent substituted-silyl group having 1 to 20 carbon atoms, a substituted or unsubstituted trivalent aromatic hydrocarbon group having 6 to 24 ring carbon atoms, or a substituted or unsubstituted trivalent aromatic heterocyclic group or fused aromatic heterocyclic group having 3 to 24 ring atoms that links to the benzene ring (c) in carbon-carbon bonding. When s is 4, L⁴ represents a tetravalent saturated hydrocarbon group having 1 to 20 carbon atoms, a substituted or unsubstituted tetravalent saturated cyclic hydrocarbon group having 3 to 20 ring carbon atoms, a silicon atom, a substituted or unsubstituted tetravalent aromatic hydrocarbon group or fused aromatic hydrocarbon group having 6 to 24 ring carbon atoms, or a substituted or unsubstituted tetravalent aromatic heterocyclic group or fused aromatic heterocyclic group having 3 to 24 ring atoms that links to the benzene ring (c) in carbon-carbon bonding. However, when X¹³ and X¹⁴ are both CR²R³, and L² and L⁴ both are a substituted or unsubstituted divalent, trivalent or tetravalent aromatic hydrocarbon group or fused aromatic hydrocarbon group having 6 to 24 ring carbon atoms, L² and L⁴ do not link to the benzene ring (b) at para-positions at the same time.
In the formulae (27) and (28), A¹ represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a aromatic heterocyclic group or fused aromatic heterocyclic group having 3 to 24 ring atoms that links to L² in carbon-carbon bonding. However, when L² is an alkylene group having 1 to 20 carbon atoms, A¹ is not a hydrogen atom.
In the formula (27), A² represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or an aromatic heterocyclic group or fused aromatic heterocyclic group having 3 to 24 ring atoms that links to L³ in carbon-carbon bonding. However, when L³ is an alkylene group having 1 to 20 carbon atoms, A² is not a hydrogen atom.
In the formulae (27) and (28), Y⁵, Y⁶ and Y⁷ represent an alkyl group having 1 to 20 carbon atoms, a substituted or unsubstituted cycloalkyl group having 3 to 20 ring carbon atoms, an alkoxy group having 1 to 20 carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring atoms that links to the benzene rings (a), (b) and (c) in carbon-carbon bonding. j and 1 each are 0, 1, 2 or 3. k is 0, 1 or 2. When X¹³ and X¹⁴ are oxygen (O), sulfur (S) or CR²R³, L² and L³ both are single bonds, and A¹ and A² both are hydrogen atoms, the benzene ring (b) has one or two Y⁶ that is neither a methyl group nor an unsubstituted phenyl group.
In the formulae (27) and (28), A¹, A², L², L³ and L⁴ do not contain any carbonyl groups.

Specific examples of the respective groups represented by the formulae (11) to (28) are described below.
The substituted or unsubstituted aromatic hydrocarbon group having 6 ring carbon atoms for Ar¹ to Ar³ is exemplified by substituted or unsubstituted benzene.
Examples of the substituted or unsubstituted aromatic hydrocarbon group or fused aromatic hydrocarbon group having 6 to 24 ring carbon atoms for Y, Y⁵ to Y⁷, R¹ to R³, L² to L⁴ and A¹ to A² are a residue of substituted or unsubstituted benzene, naphthalene, biphenyl, terphenyl, fluorene, phenanthrene, triphenylene, perylene, chrysene, fluoranthene, benzofluorene, benzotriphenylene, benzochrysene and anthracene, the residue having a valence corresponding to Y, Y⁵ to Y⁷, R¹ to R³, L² to L⁴ and A¹ to A², among which benzene, naphthalene, biphenyl, terphenyl, fluorene and phenanthrene are preferable.
Examples of the substituted or unsubstituted aromatic heterocyclic group or fused aromatic heterocyclic group having 6 ring atoms for Ar¹ to Ar³ are substituted or unsubstituted pyridine, pyridazine, pyrimidine, pyrazine, and 1,3,5-triazine. Examples of the substituted or unsubstituted aromatic heterocyclic group or fused aromatic heterocyclic group having 3 to 24 ring carbon atoms for Y, Y⁵ to Y⁷, R¹ to R³, L² to L⁴ and A¹ to A² are a residue of substituted or unsubstituted pyridine, pyridazine, pyrimidine, pyrazine, 1,3,5-triazine, carbazole, dibenzofuran, dibenzothiophene, phenoxazine, phenothiazine and dihydroacridine, the residue having a valence corresponding to Y, Y⁵ to Y⁷, R¹ to R³, L² to L⁴ and A¹ to A², among which pyridine, pyridazine, pyrimidine, pyrazine, carbazole, dibenzofuran, dibenzothiophene, phenoxazine and dihydroacridine are preferable. The substituted or unsubstituted monovalent fused aromatic heterocyclic group having 8 to 24 ring atoms for at least one R¹ is exemplified by one having a fused structure among the aromatic heterocyclic groups.
Examples of the alkyl group having 1 to 20 carbon atoms, the alkylene group and the trivalent or tetravalent saturated aromatic hydrocarbon group for Y, Y⁵ to Y⁷, R¹ to R³ and L² to L⁴ are a methyl group, an ethyl group, a propyl group, an isopropyl group, an n-butyl group, an s-butyl group, a t-butyl group, an isobutyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neo-pentyl group, a 1-methylpentyl group, a 2-methylpentyl group, a 1-pentylhexyl group, a 1-butylpentyl group, a 1-heptyloctyl group, a 3-methylpentyl group and divalent to tetravalent groups thereof, among which a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neo-pentyl group, a 1-methylpentyl group, a 1-pentylhexyl group, a 1-butylpentyl group and a 1-heptyloctyl group are preferable.
Examples of the substituted or unsubstituted cycloalkyl group having 3 to 20 ring carbon atoms, the cycloalkylene group and the trivalent or tetravalent saturated cyclic hydrocarbon group for Y, Y⁵ to Y⁷, R¹ to R³, L² to L⁴ and A¹ to A² are a cyclopropyl group, a cyclobutyl group, a cyclopentyl group, a cyclohexyl group or divalent to tetravalent groups thereof, among which a cyclobutyl group, a cyclopentyl group and a cyclohexyl group are preferable.
Examples of the alkoxy group having 1 to 20 carbon atoms for Y and Y⁵ to Y⁷ are a methoxy group, an ethoxy group, a methoxy group, an i-propoxy group, an n-propoxy group, an n-butoxy group, an s-butoxy group and a t-butoxy group, among which a methoxy group, an ethoxy group, a methoxy group, an i-propoxy group and an n-propoxy group are preferable.
Examples of the substituted-silyl group having 1 to 20 carbon atoms for Y, Y⁵ to Y⁷, R¹ to R³, L² to L⁴ and A¹ to A² are a trimethylsilyl group, a triethylsilyl group, a tributylsilyl group, a trioctylsilyl group, a triisobutylsilyl group, a dimethylethylsilyl group, a dimethylisopropylsilyl group, a dimethylpropylsilyl group, a dimethylbutylsilyl group, a dimethyltertiarybutylsilyl group, a diethylisopropylsilyl group, a phenyldimethylsilyl group, a diphenylmethylsilyl group, a diphenyltertiarybutyl group, a triphenylsilyl group and divalent to trivalent groups thereof, among which a trimethylsilyl group, a triethylsilyl group and a tributylsilyl group are preferable.
Examples of the aralkyl group having 7 to 24 carbon atoms for Y, Y⁵ to Y⁷ and R¹ to R³ are a benzyl group, a phenethyl group and a phenylpropyl group.

Examples of the substituent for the groups of the formulae (11) to (28) includes: an alkyl group having 1 to 10 carbon atoms such as a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, a hydroxymethyl group, a 1-hydroxyethyl group, a 2-hydroxyethyl group, a 2-hydroxyisobutyl group, a 1,2-dihydroxyethyl group, a 1,3-dihydroxyisopropyl group, a 2,3-dihydroxy-t-butyl group, a 1,2,3-trihydroxypropyl group, a chloromethyl group, a 1-chloroethyl group, a 2-chloroethyl group, a 2-chloroisobutyl group, a 1,2-dichloroethyl group, a 1,3-dichloroisopropyl group, a 2,3-dichloro-t-butyl group, a 1,2,3-trichloropropyl group, a bromomethyl group, a 1-bromoethyl group, a 2-bromoethyl group, a 2-bromoisobutyl group, a 1,2-dibromoethyl group, a 1,3-dibromoisopropyl group, a 2,3-dibromo-t-butyl group, a 1,2,3-tribromopropyl group, an iodomethyl group, a 1-iodoethyl group, a 2-iodoethyl group, a 2-iodoisobutyl group, a 1,2-diiodoethyl group, a 1,3-diiodoisopropyl group, a 2,3-diiodo-t-butyl group, a 1,2,3-triiodopropyl group, aminomethyl group, a 1-aminoethyl group, a 2-aminoethyl group, a 2-aminoisobutyl group, a 1,2-diaminoethyl group, a 1,3-diaminoisopropyl group, a 2,3-diamino-t-butyl group, a 1,2,3-triaminopropyl group, a cyanomethyl group, a 1-cyanoethyl group, a 2-cyanoethyl group, a 2-cyanoisobutyl group, a 1,2-dicyanoethyl group, a 1,3-dicyanoisopropyl group, a 2,3-dicyano-t-butyl group, a 1,2,3-tricyanopropyl group, a nitromethyl group, a 1-nitroethyl group, a 2-nitroethyl group, a 2-nitroisobutyl group, a 1,2-dinitroethyl group, a 1,3-dinitroisopropyl group, a 2,3-dinitro-t-butyl group, and a 1,2,3-trinitropropyl group; a cycloalkyl group having 3 to 40 ring carbon atoms such as a cyclopropyl group, a cyclobutyl group, a cyclopentyl group, a cyclohexyl group, a 4-methyl cyclohexyl group, a 1-adamantyl group, a 2-adamantyl group, a 1-norbornyl group and 2-norbomyl group; an alkoxy group having 1 to 6 carbon atoms such as an ethoxy group, a methoxy group, an i-propoxy group, an n-propoxy group, an s-butoxy group, a t-butoxy group, a pentoxy group and a hexyloxy group; a cycloalkoxy group having 3 to 10 ring carbon atoms such as a cyclopentoxy group and a cyclohexyloxy group; an aromatic hydrocarbon group or fused aromatic hydrocarbon group having 6 to 40 ring carbon atoms; an aromatic heterocyclic group or fused aromatic heterocyclic group having 3 to 40 ring carbon atoms; an amino group substituted with an aromatic hydrocarbon group or fused aromatic hydrocarbon group having 6 to 40 ring carbon atoms; an ester group having an aromatic hydrocarbon group or fused aromatic hydrocarbon group having 6 to 40 ring carbon atoms; an ester group having an alkyl group having 1 to 6 carbon atoms; a cyano group; a nitro group; and a halogen atom.
Among these, an alkyl group having 1 to 6 carbon atoms, a phenyl group, a pyridyl group, a carbazolyl group and a dibenzofuranyl group are preferable. The number of the substituents is preferably one or two.

In the compounds of the formulae (12), (14), (16), (18), (20), (24) to (26) and (28), s is preferably 2.
In the formula (13), (15), (17), (19), (21), (22), (23) or (27), the total number of the substituents represented by Y⁵, Y⁶ and Y⁷ is preferably 3 or less. In the formula (14), (16), (18), (20), (24), (25), (26) or (28), the total number of the substituents represented by Y⁵, Y⁶ and Y⁷ for each structure [ ]ₛ is preferably 3 or less.

In the formulae (11) and (12), Ar¹, Ar² and Ar³ each represent a substituted or unsubstituted aromatic hydrocarbon group having 6 ring carbon atoms or a substituted or unsubstituted aromatic heterocyclic group having 6 ring atoms. The aromatic hydrocarbon group having 6 ring carbon atoms or the aromatic heterocyclic group having 6 ring atoms can increase triplet energy as compared with a conjugated system expanded by presence of a fused ring.

In the compounds represented by the formulae (11) to (26), both of X¹ and X² are preferably represented by N-R¹ and the same applies to X³ and X⁴, X⁵ and X⁶, X⁷ and X⁸, X⁹ and X¹⁰, and X¹¹ and X¹². With crosslinkage by N, a hole transporting capability of the compound can be increased to promote lowering voltage applied to the device. Particularly, the compound is preferably usable as the host material and the hole transporting material.
At least one R¹ is preferably a dibenzofuran residue or a carbazole residue. More preferably, all of R¹ are dibenzofuran residues or carbazole residues. When the fused aromatic heterocyclic ring exhibiting an electron transporting capability (e.g., dibenzofuran and carbazole) is bonded, stability against holes (resistance to oxidation) is increased to prolong lifetime as compared with a nitrogen-containing heterocyclic ring (not a fused ring) such as pyrimidine. When the fused aromatic heterocyclic ring exhibiting an electron transporting capability and having a large energy gap (e.g., dibenzofuran and carbazole) is bonded to N, a decrease in efficiency is prevented and stability against holes (resistance to oxidation) is increased when the compound is used as a phosphorescent device.
In the formula (11) or (12), it is preferable that: both of X¹ and X² or both of X³ and X⁴ are represented by N-R¹; and N-R¹ of X¹ and N-R₁ of X² or N-R¹ of X³ and N-R¹ of X⁴ are different.
In the formulae (13) to (16), it is preferable that: both of X⁵ and X⁶ are represented by N-R¹; and N-R¹ of X⁵ and N-R¹ of X⁶ are different.
Thus, when a structure of each of the formulae (11) to (28) is asymmetric, crystallization is suppressed to increase thin-film stability and prolong the lifetime of the device as compared with a symmetric structure.

In the formulae (13) to (20), both of X⁵ and X⁶ are preferably CR²R³.
Since the compound in which X⁵ and X⁶ are present on the same side relative to the benzene rings (a), (b) and (c) as shown in the formulae (13), (14), (17) and (18) can slightly increase triplet energy, luminous efficiency can be enhanced, as compared with a compound in which X⁵ and X⁶ are on sides opposed to each other. The same applies to when X⁵ and X⁶ are CR²R³.
Moreover, when the benzene rings (a) and (c) are bonded to the benzene ring (b) at para-positions as shown in the formulae (13) to (20), the electron transporting capability can be enhanced to lower voltage applied to the device.
When the benzene rings (a) and (c) are bonded to the benzene ring (b) at meta-positions, triplet energy can be further increased to enhance luminous efficiency as compared with when the benzene rings (a) and (c) are bonded to the benzene ring (b) at para-positions.

In the formulae (11) to (28), at least one of X¹ and X² is preferably an oxygen atom and the same applies to X³ and X⁴, X⁵ and X⁶, X⁷ and X⁸, X⁹ and X¹⁰, and X¹¹ and X¹². In the formulae (13) to (20), at least one of X⁵ and X⁶ is preferably an oxygen atom and the compound preferably has a benzofuran structure. It is particularly preferable that both of X⁵ and X⁶ are oxygen atoms and the compound has a benzofurano dibenzofuran structure. Since an oxygen atom exhibits a high electronegativity to improve electron transporting capability, thereby lowering voltage applied to the device, the compound is preferably usable as, in particular, the host material or the electron transporting material. When both of X⁵ and X⁶ are oxygen atoms, triplet energy can be increased to enhance luminous efficiency. In the formulae (11) to (28), since A¹, A², L², L³ and L⁴ do not contain any carbonyl groups (i.e., no carbonyl group is at a terminal), the lifetime of the device can be prevented from being shortened.

Specific examples of the compounds represented by the above formulae (11) to (28) will be shown below, but the invention is not limited to those.

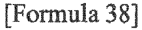

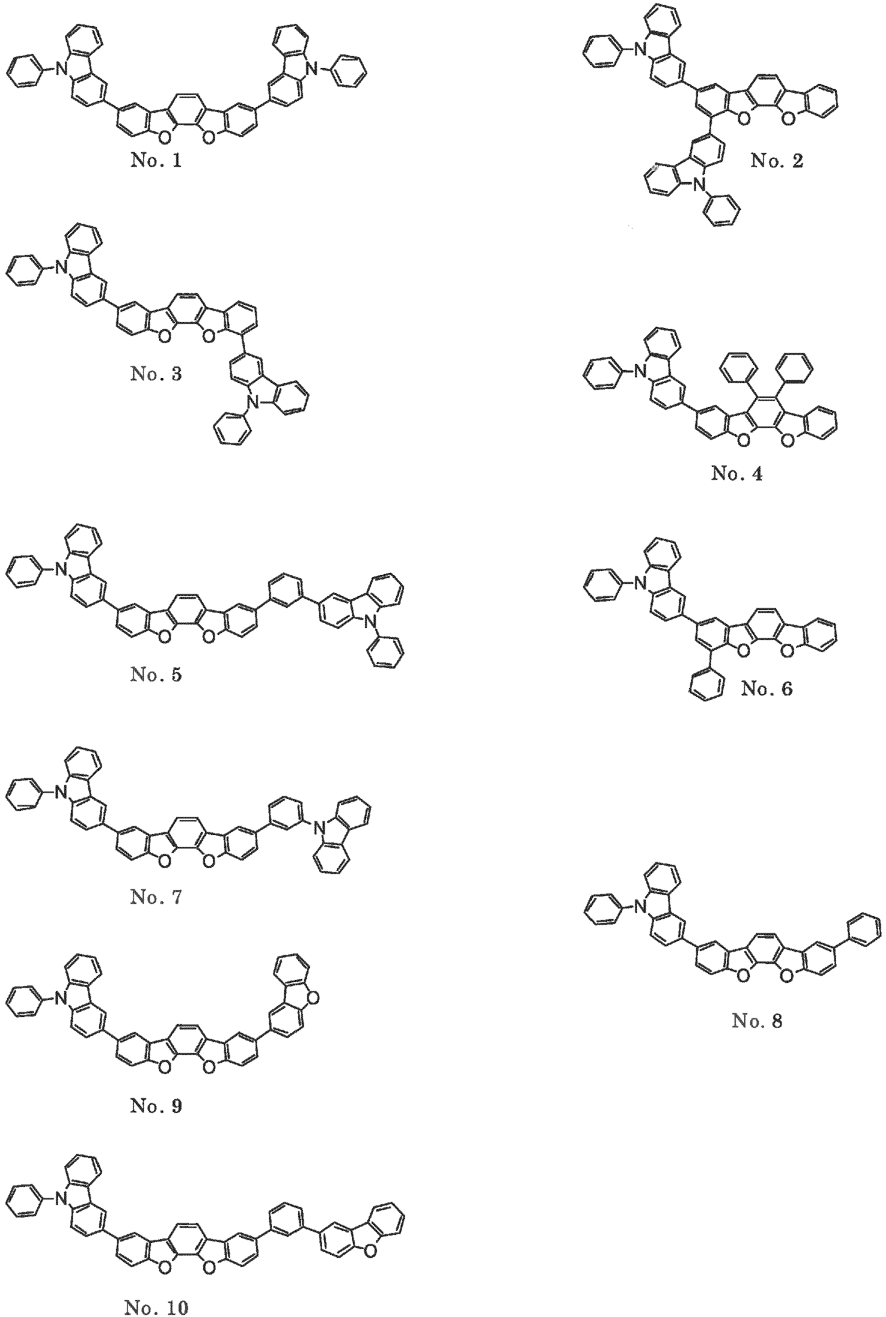

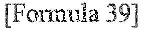

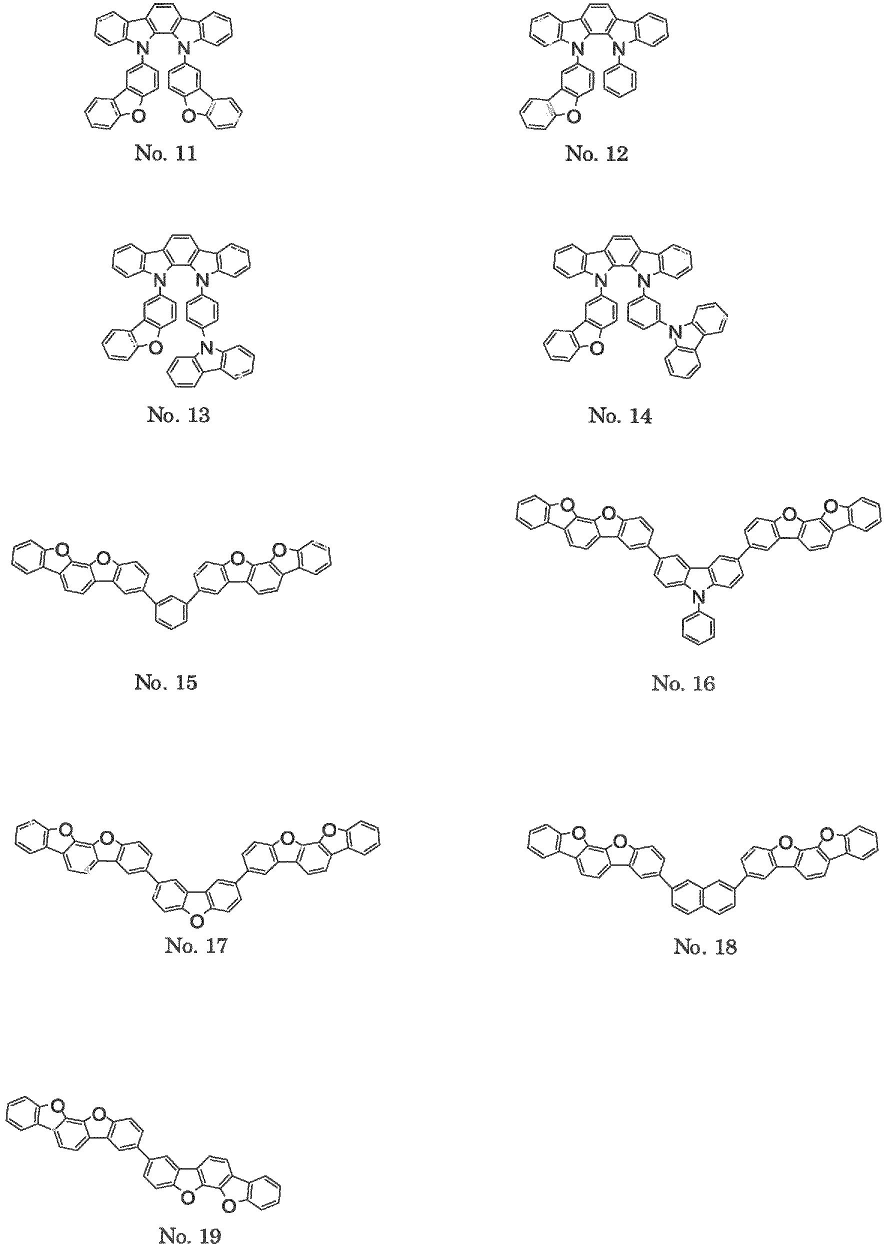

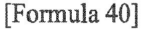

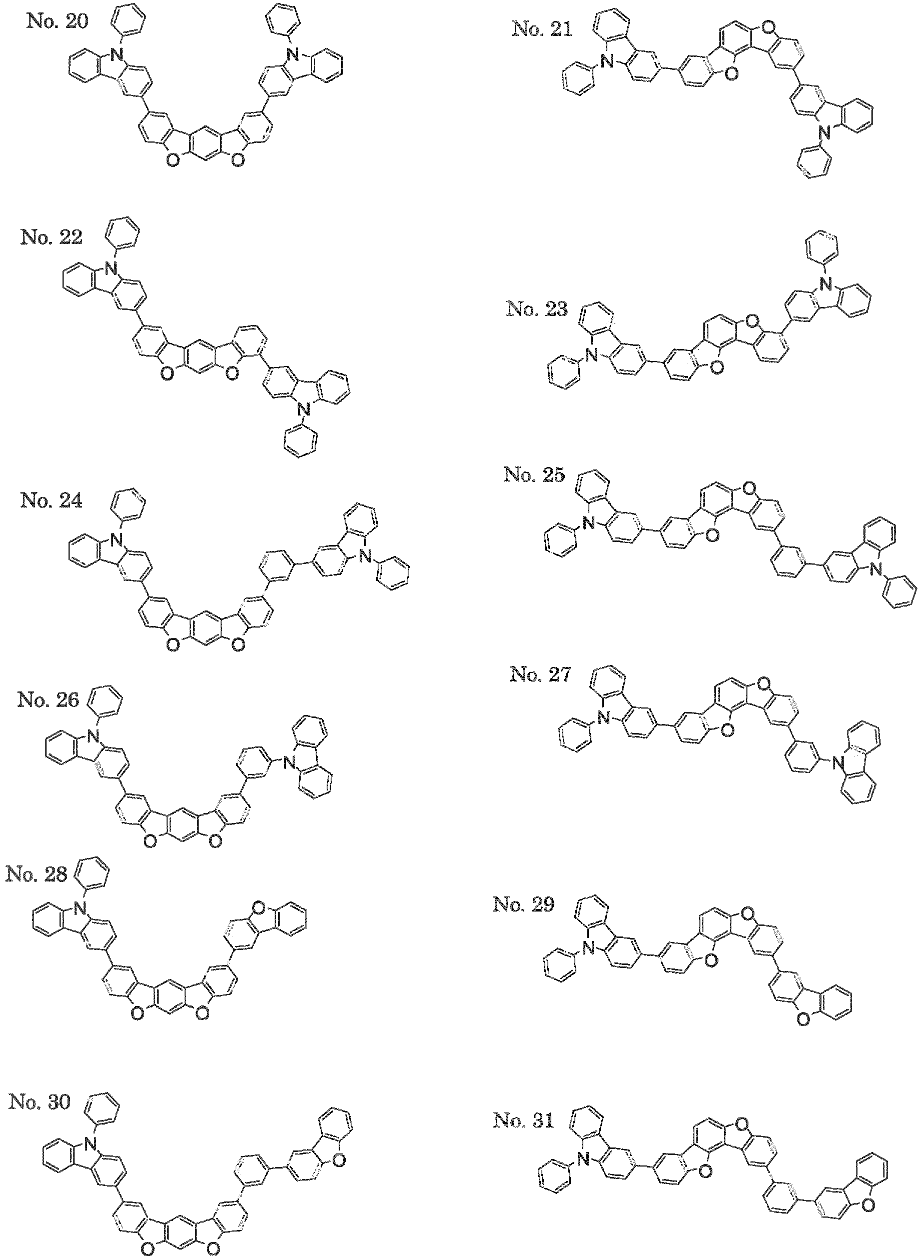

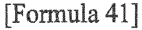

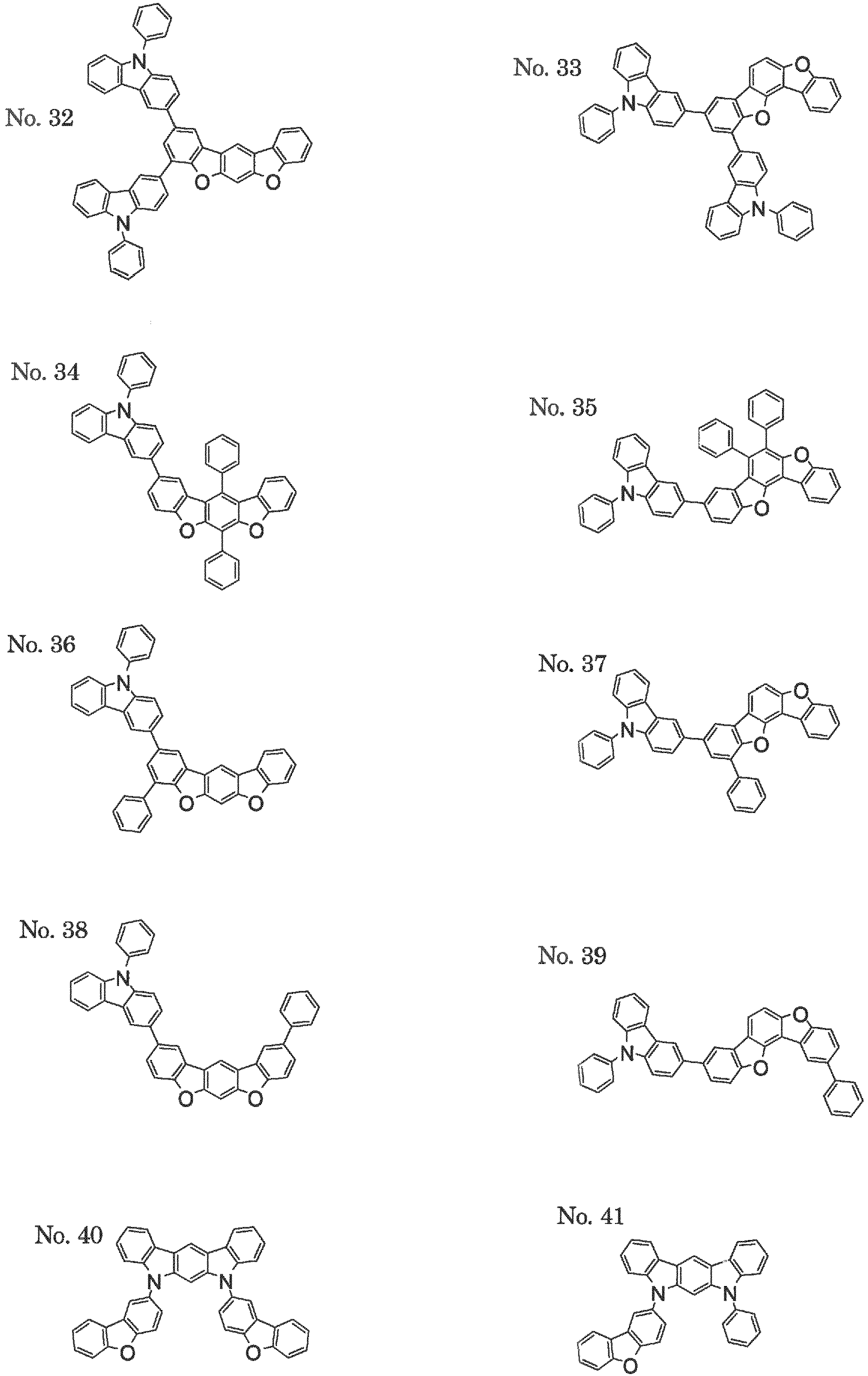

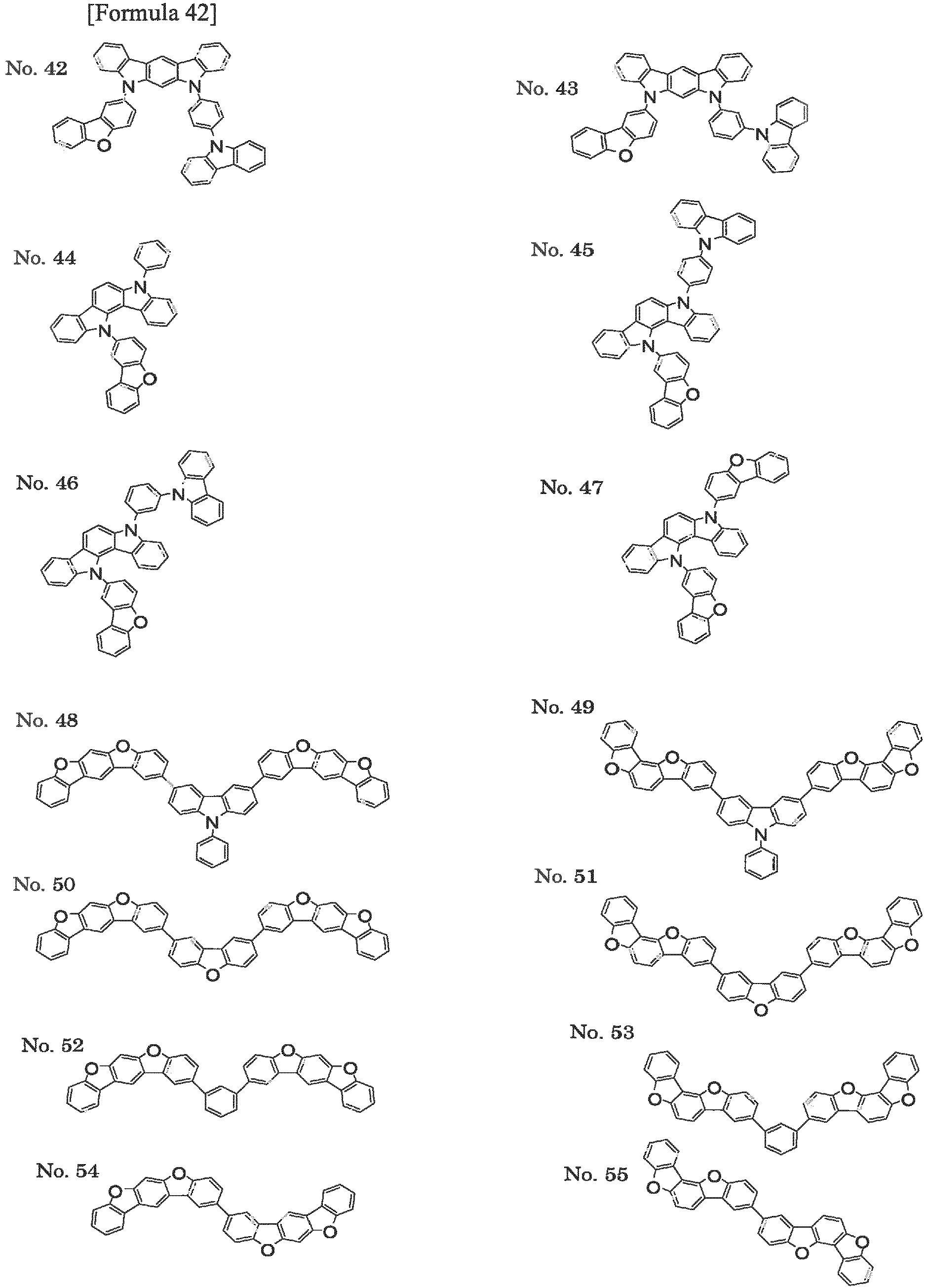

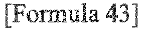

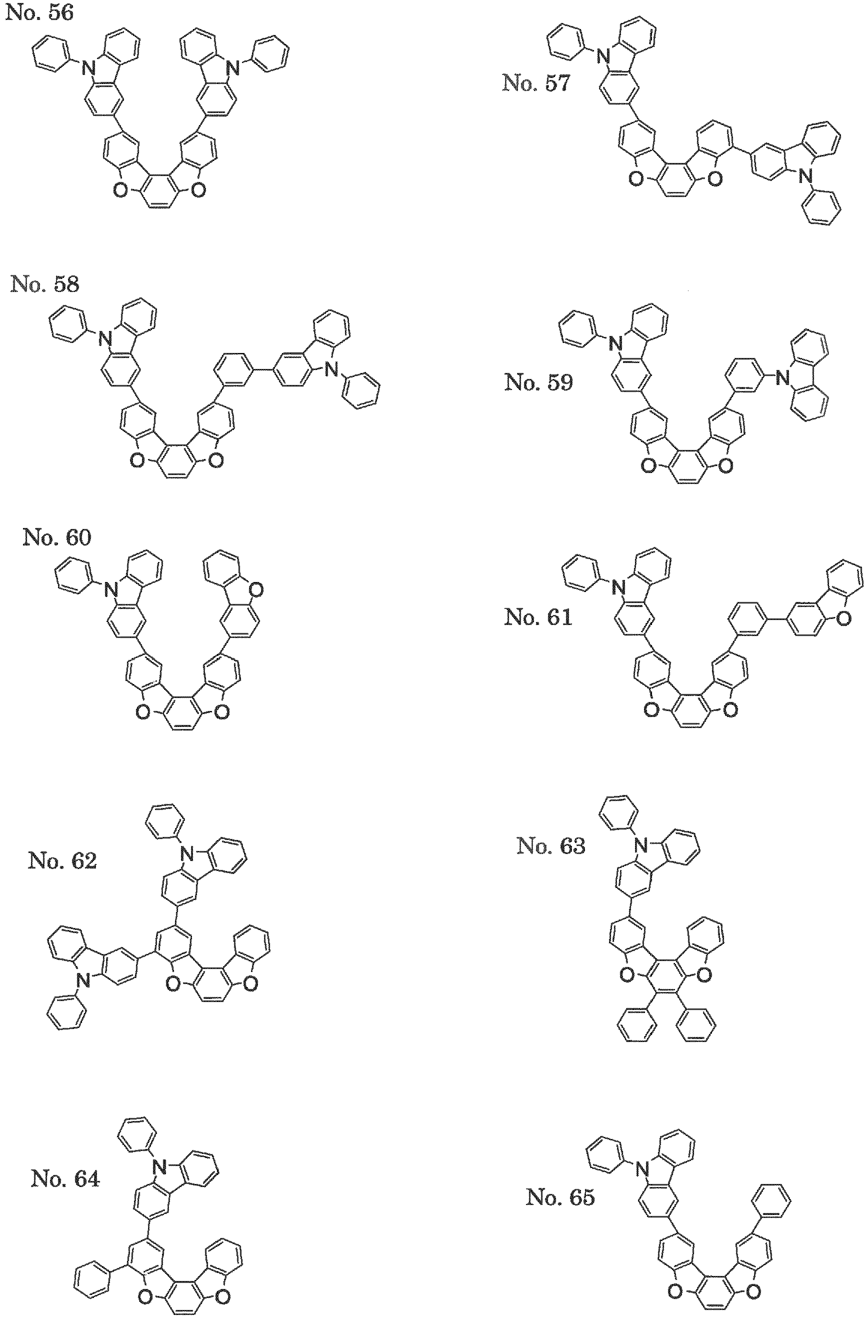

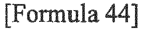

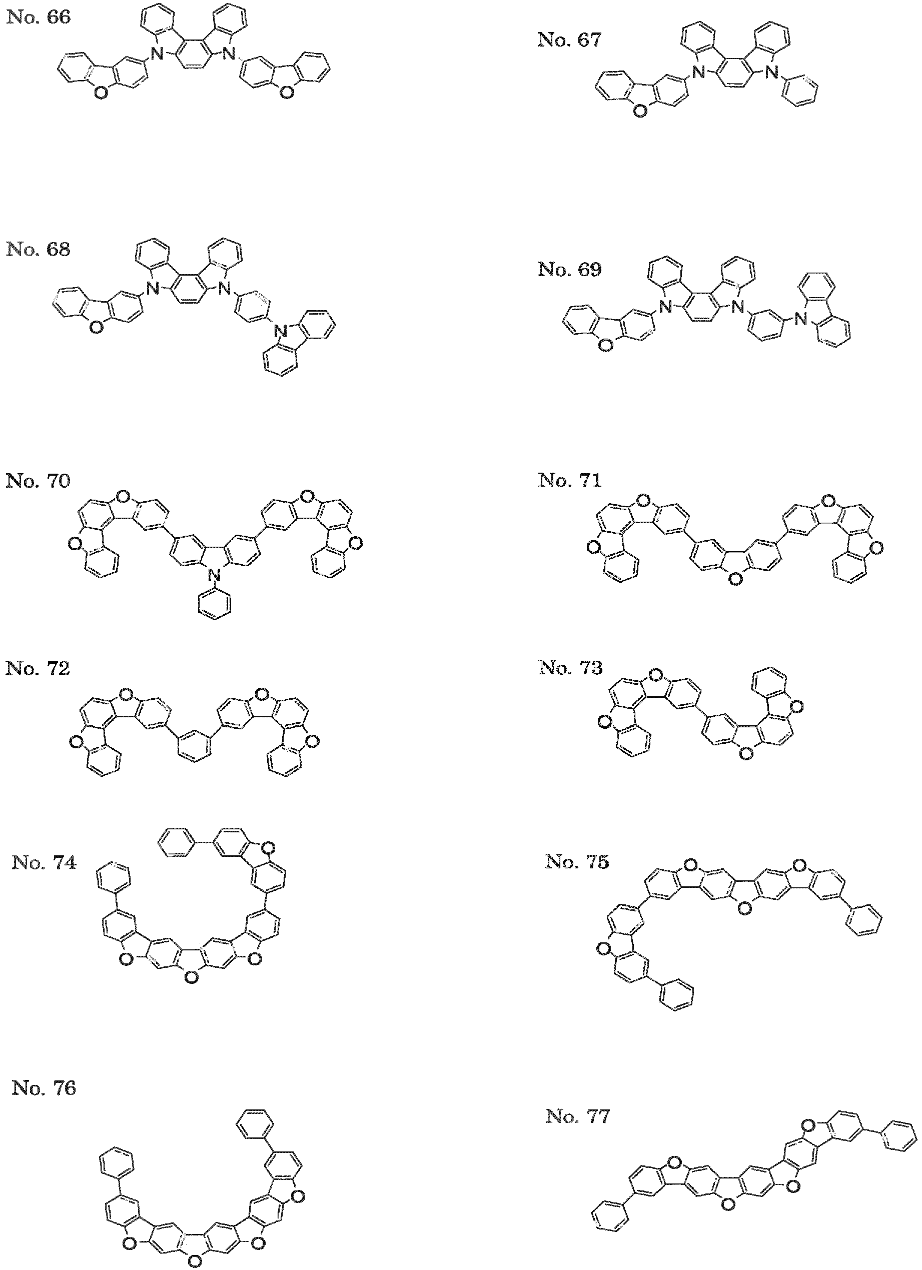

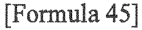

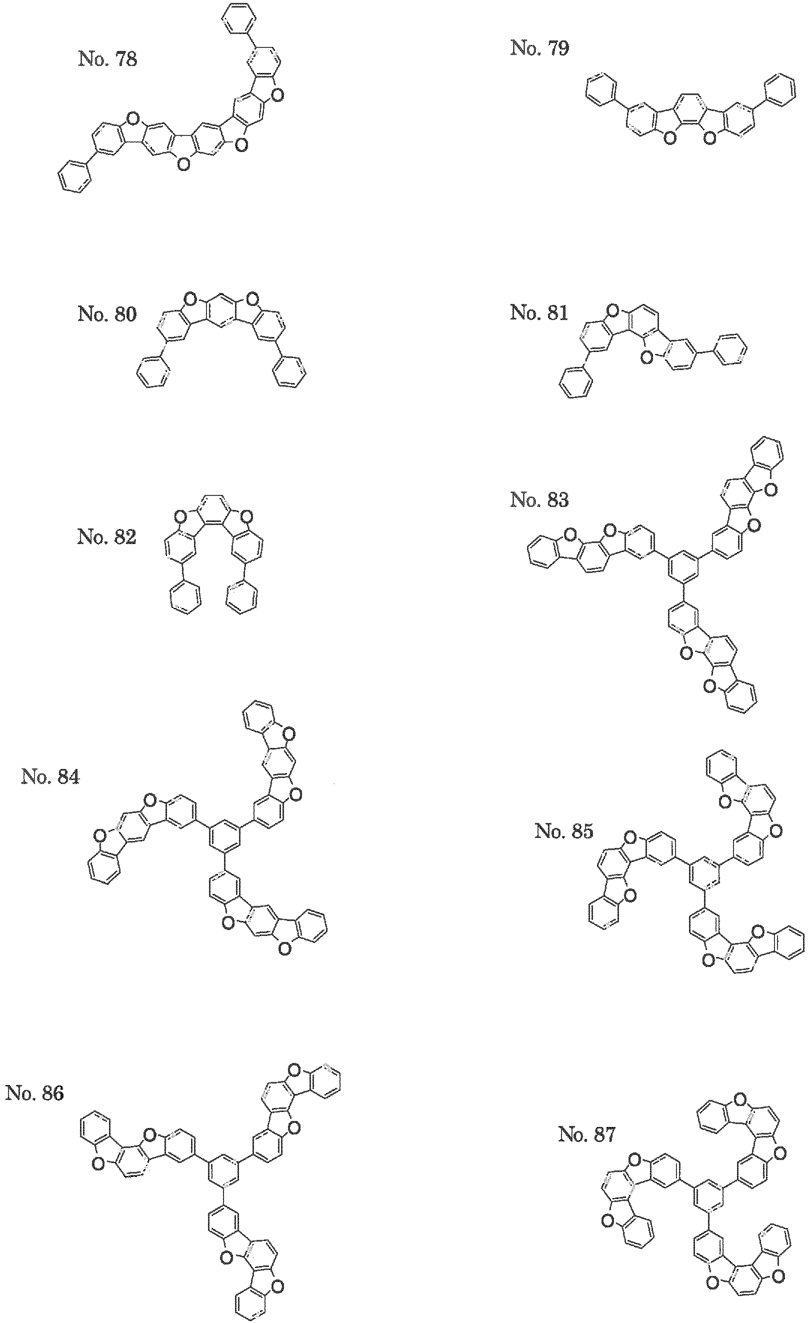

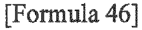

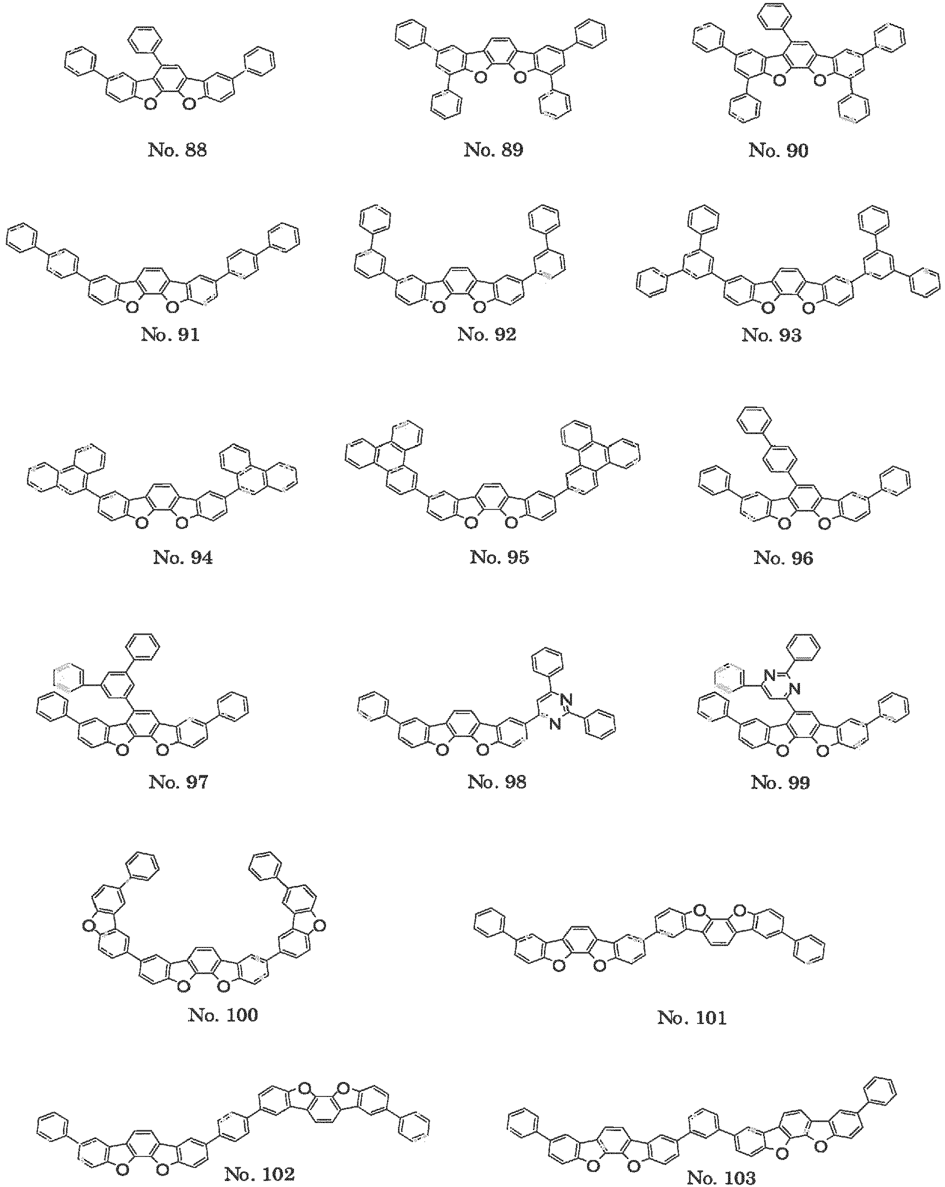

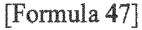

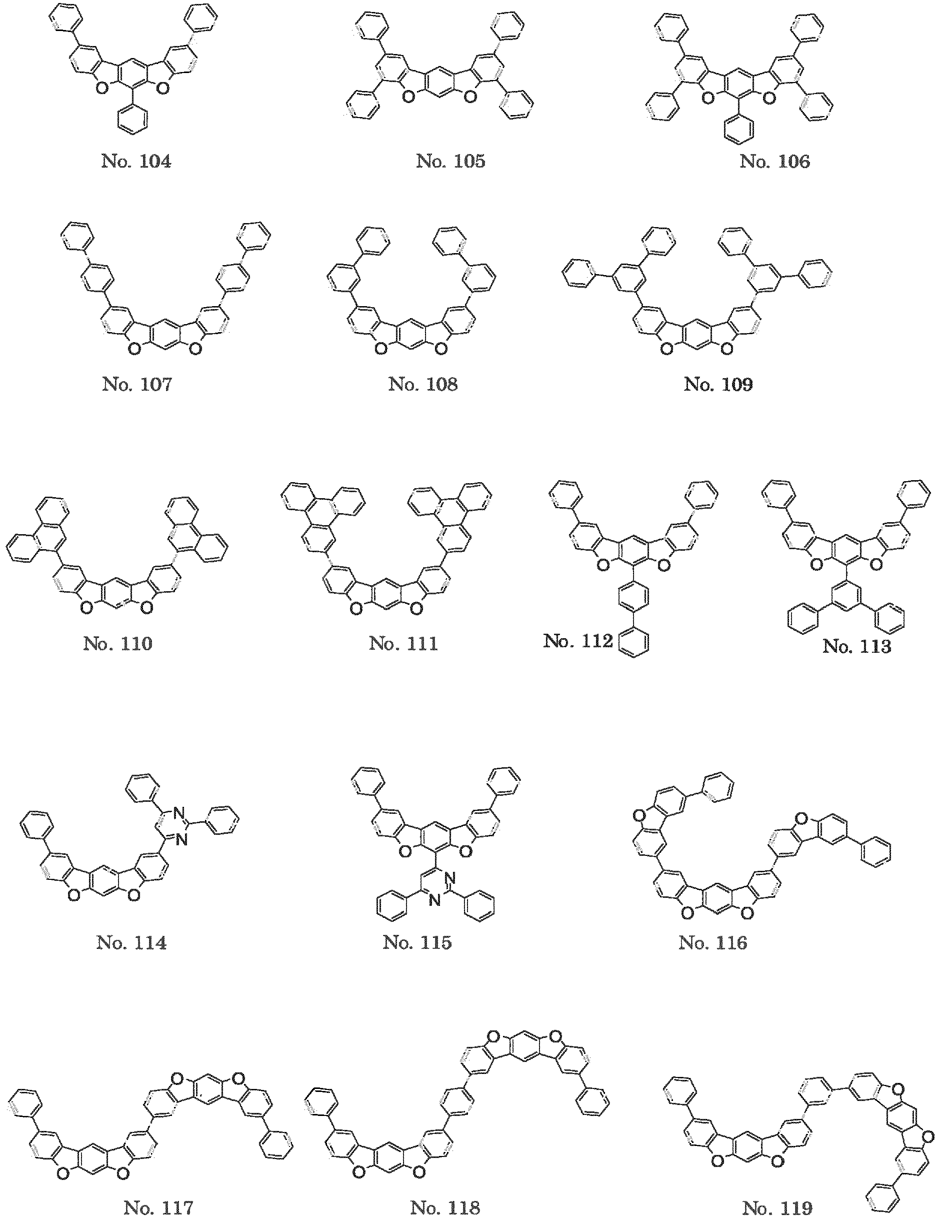

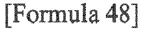

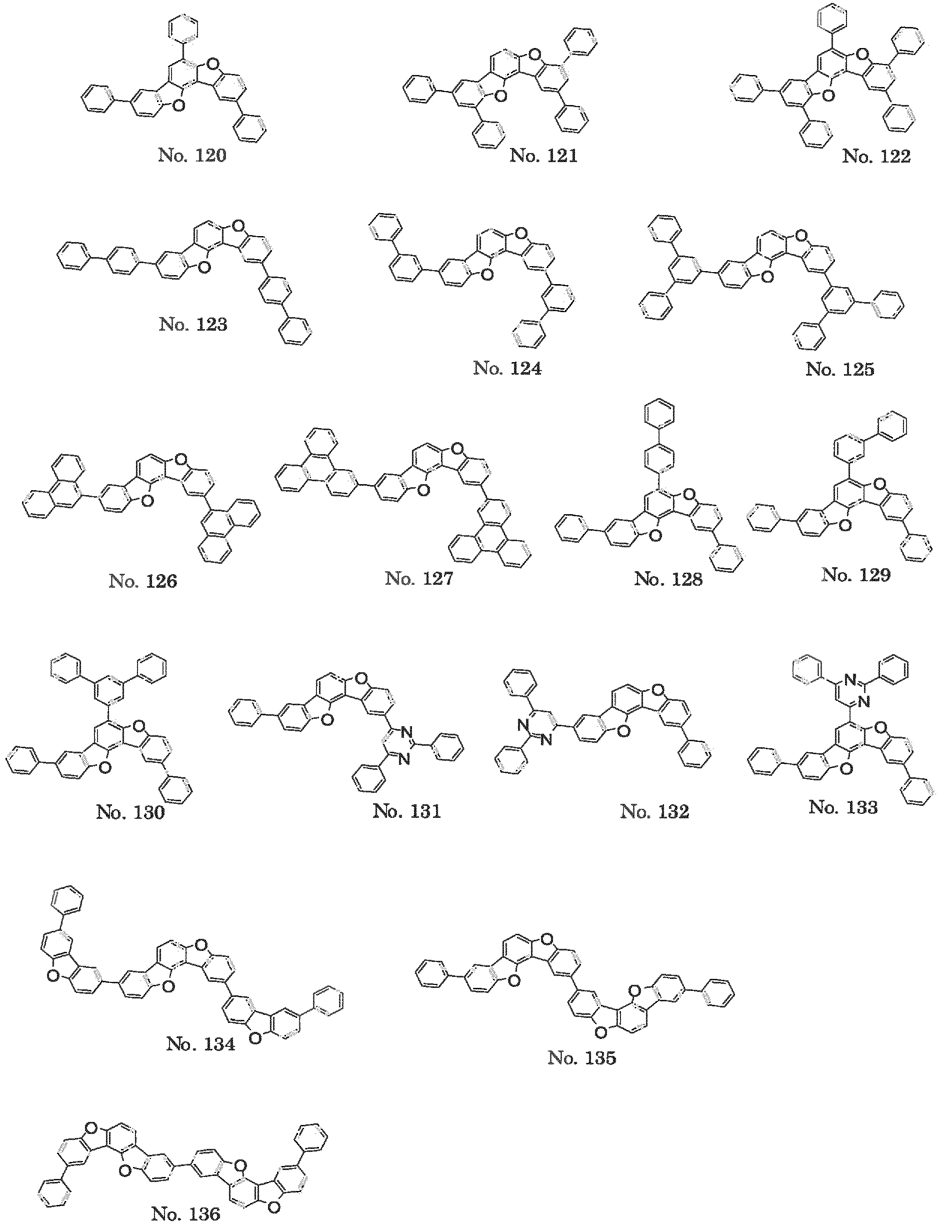

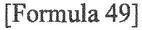

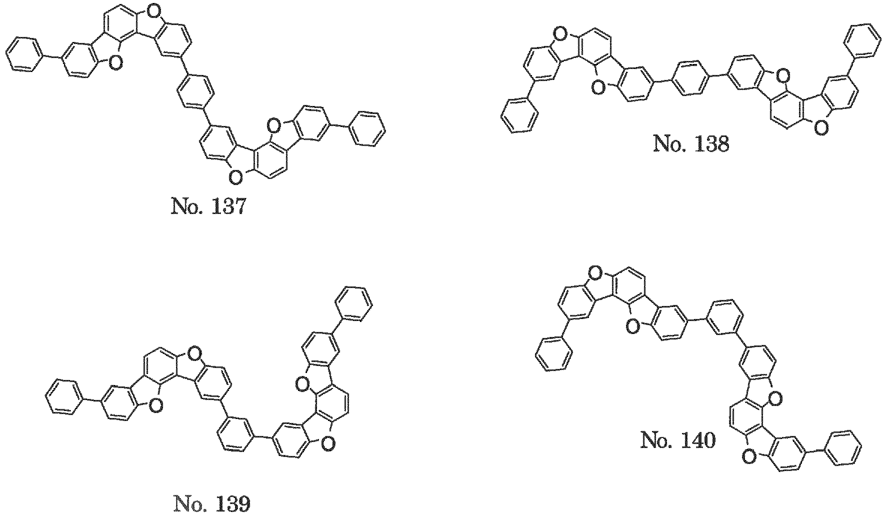

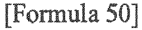

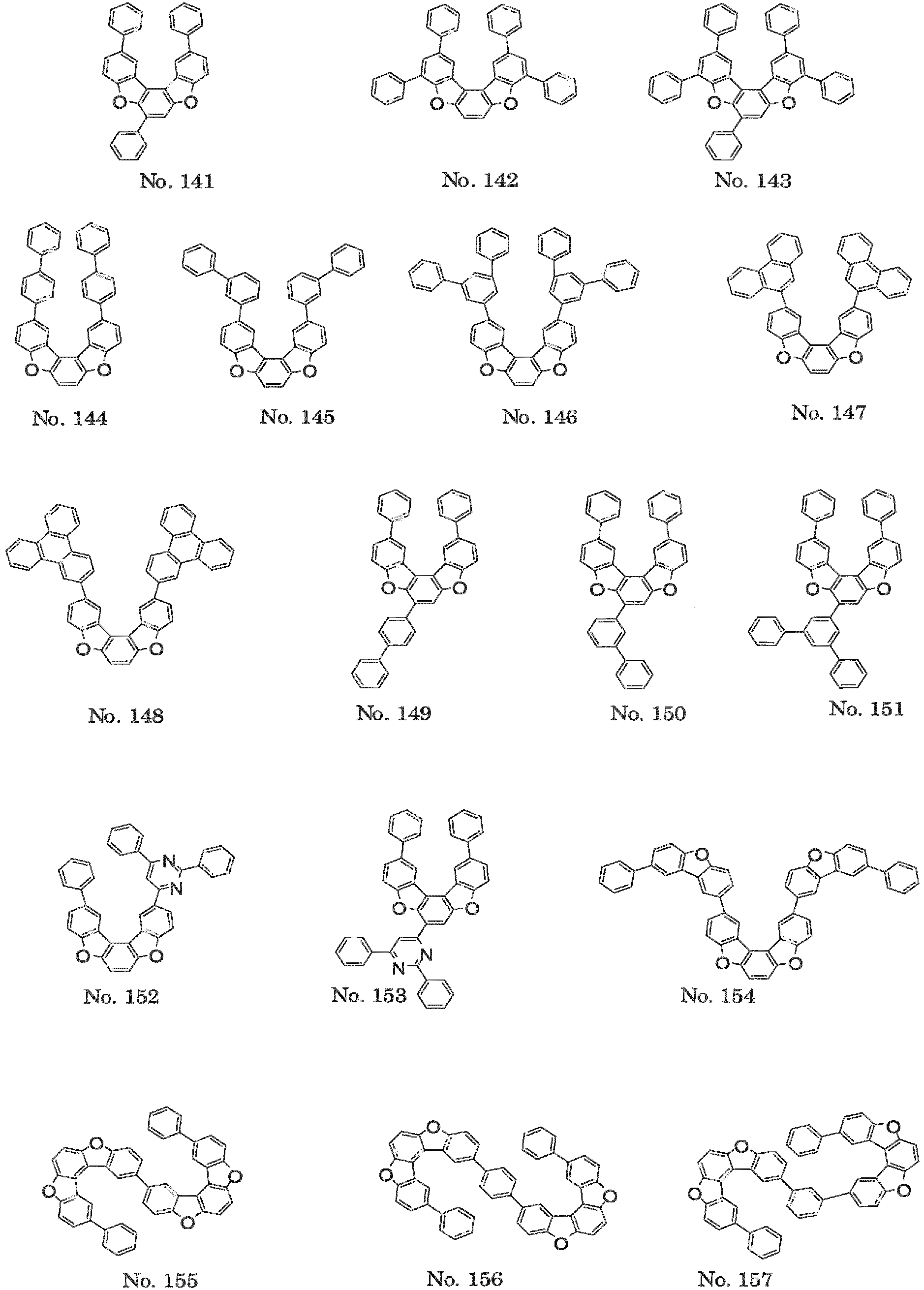

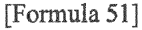

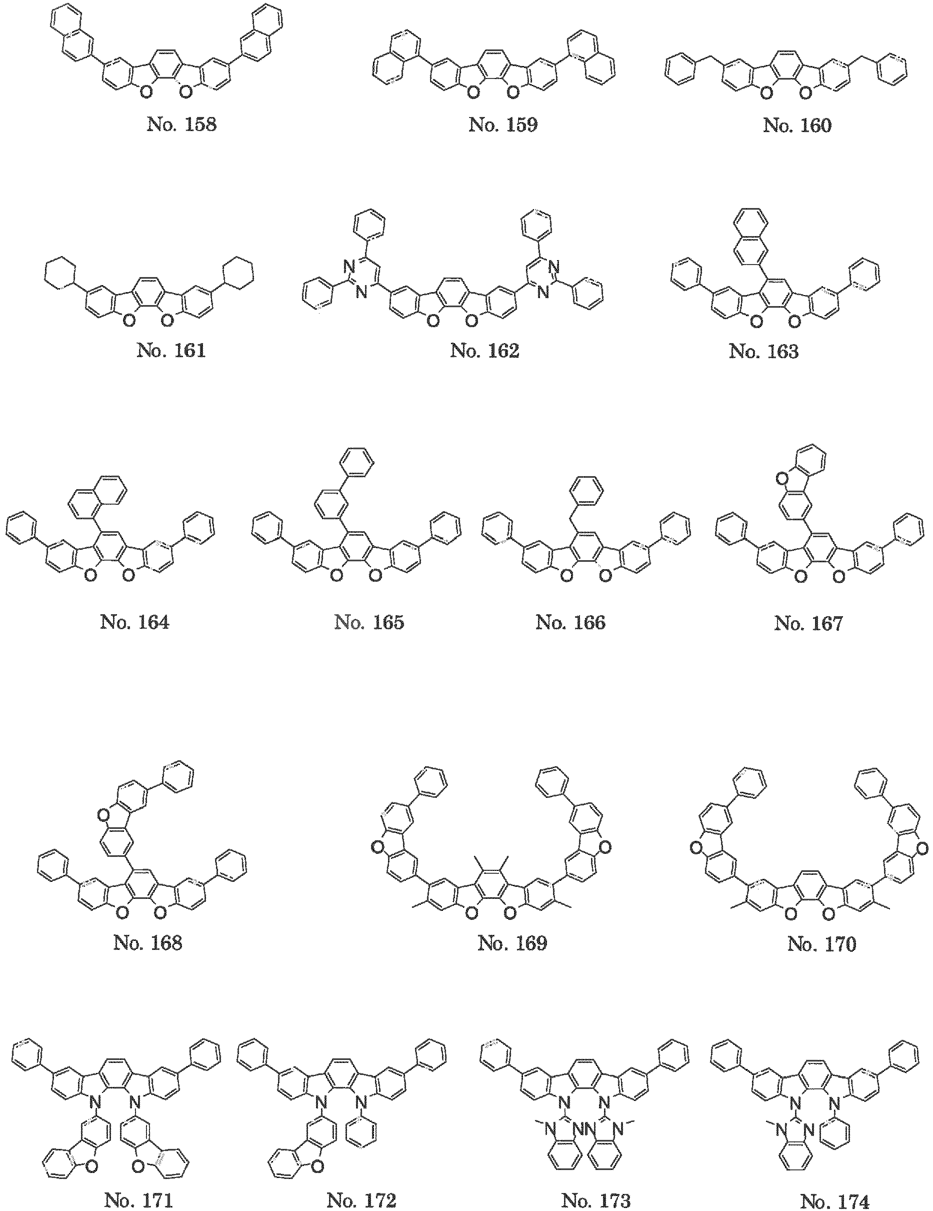

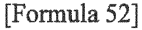

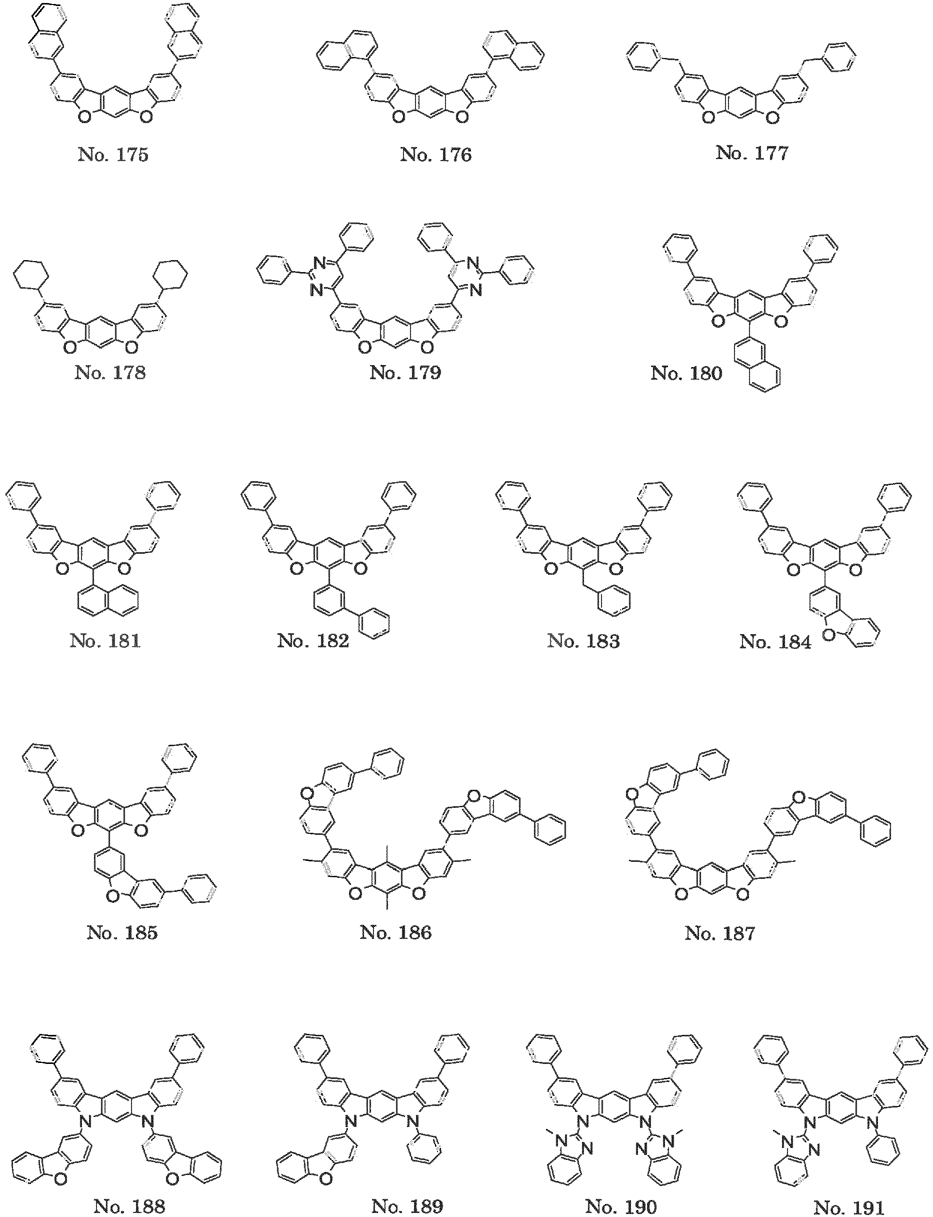

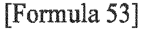

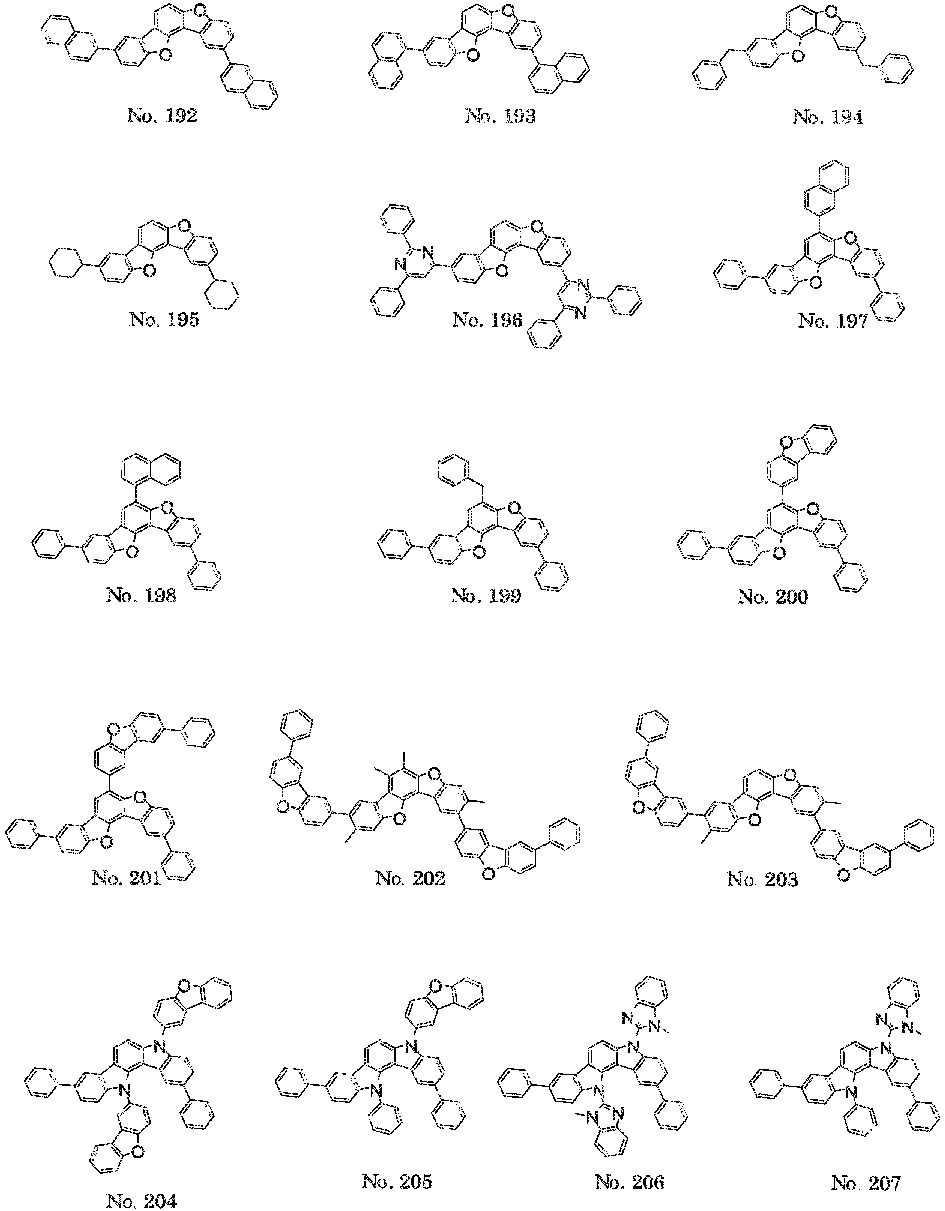

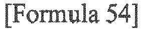

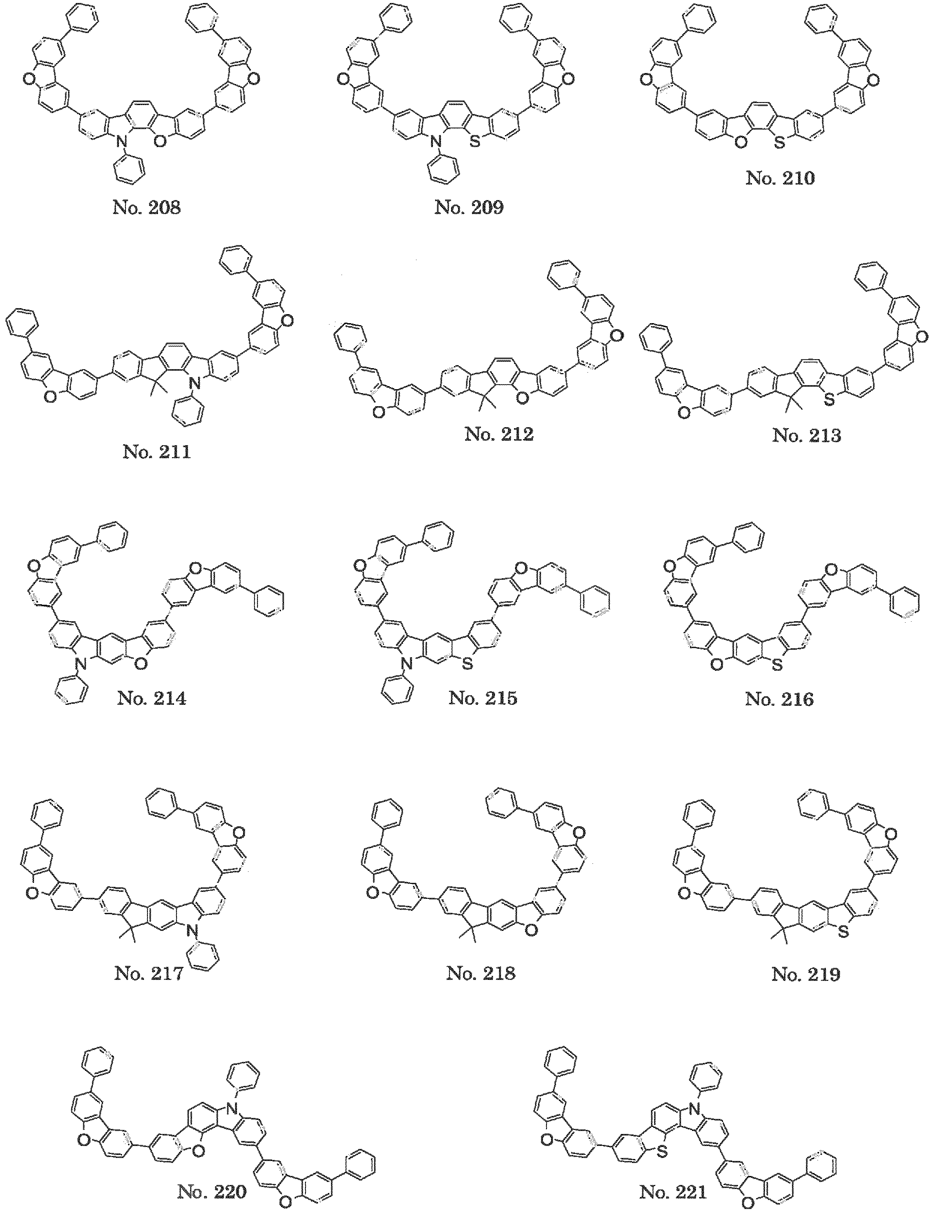

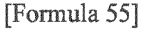

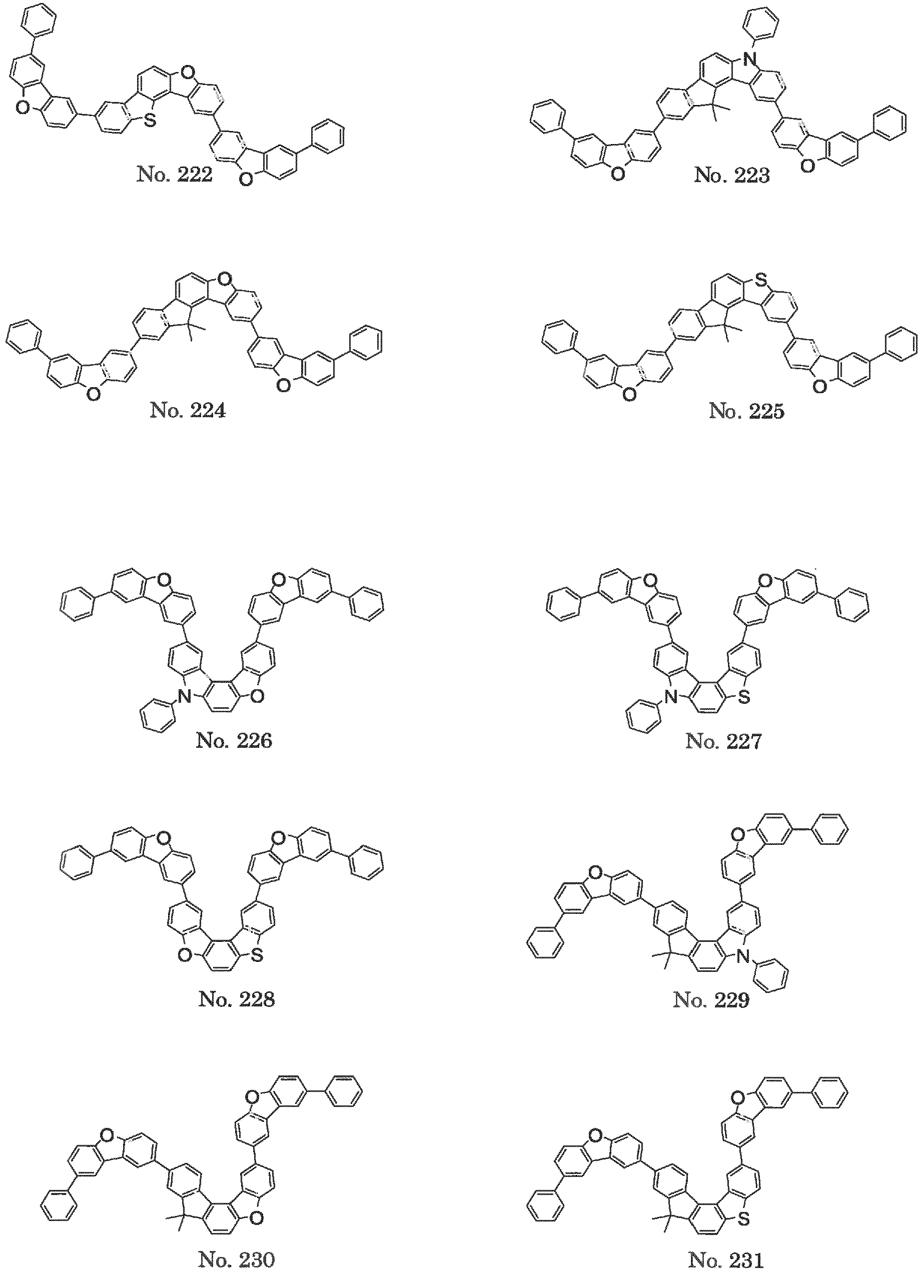

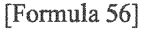

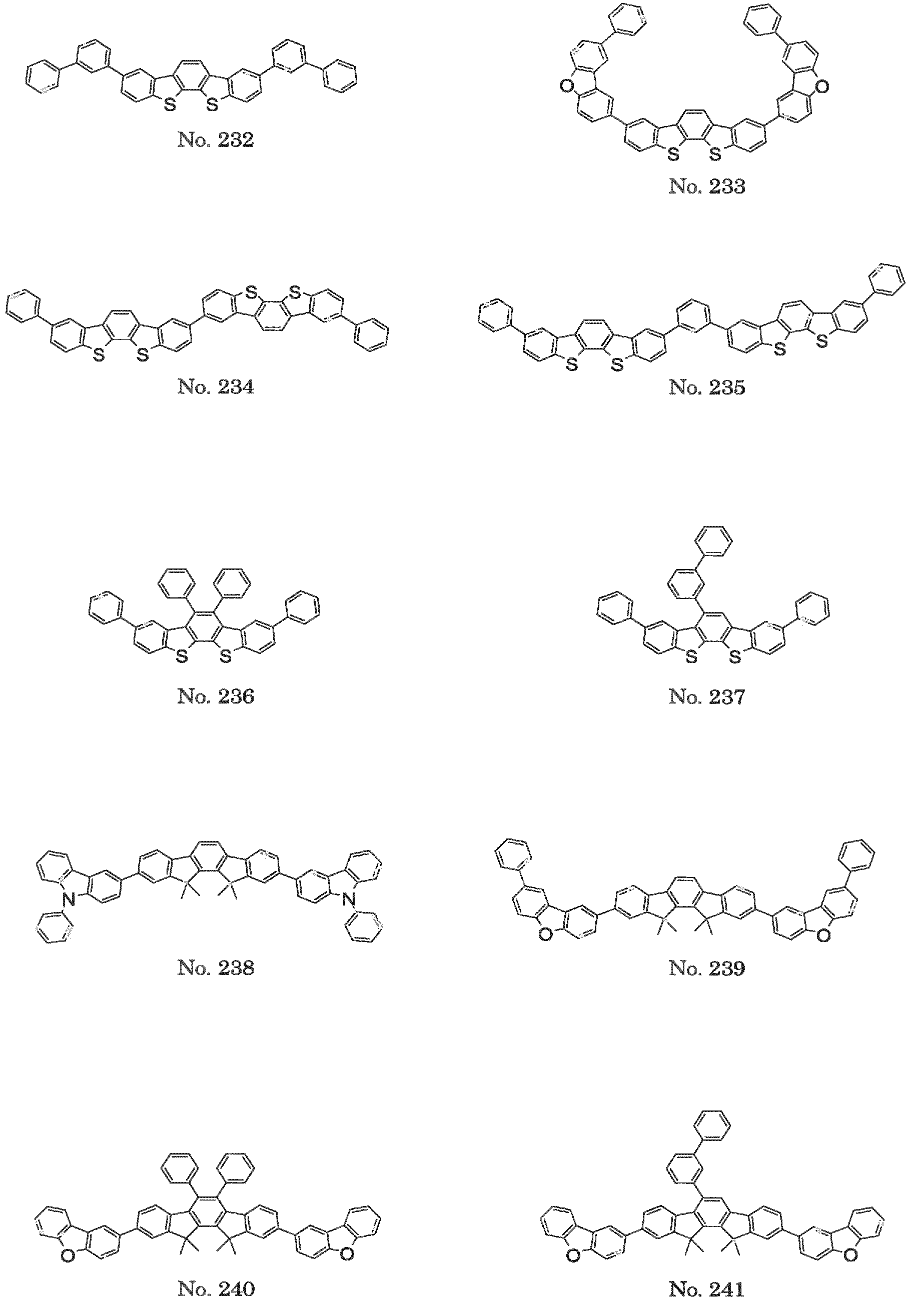

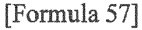

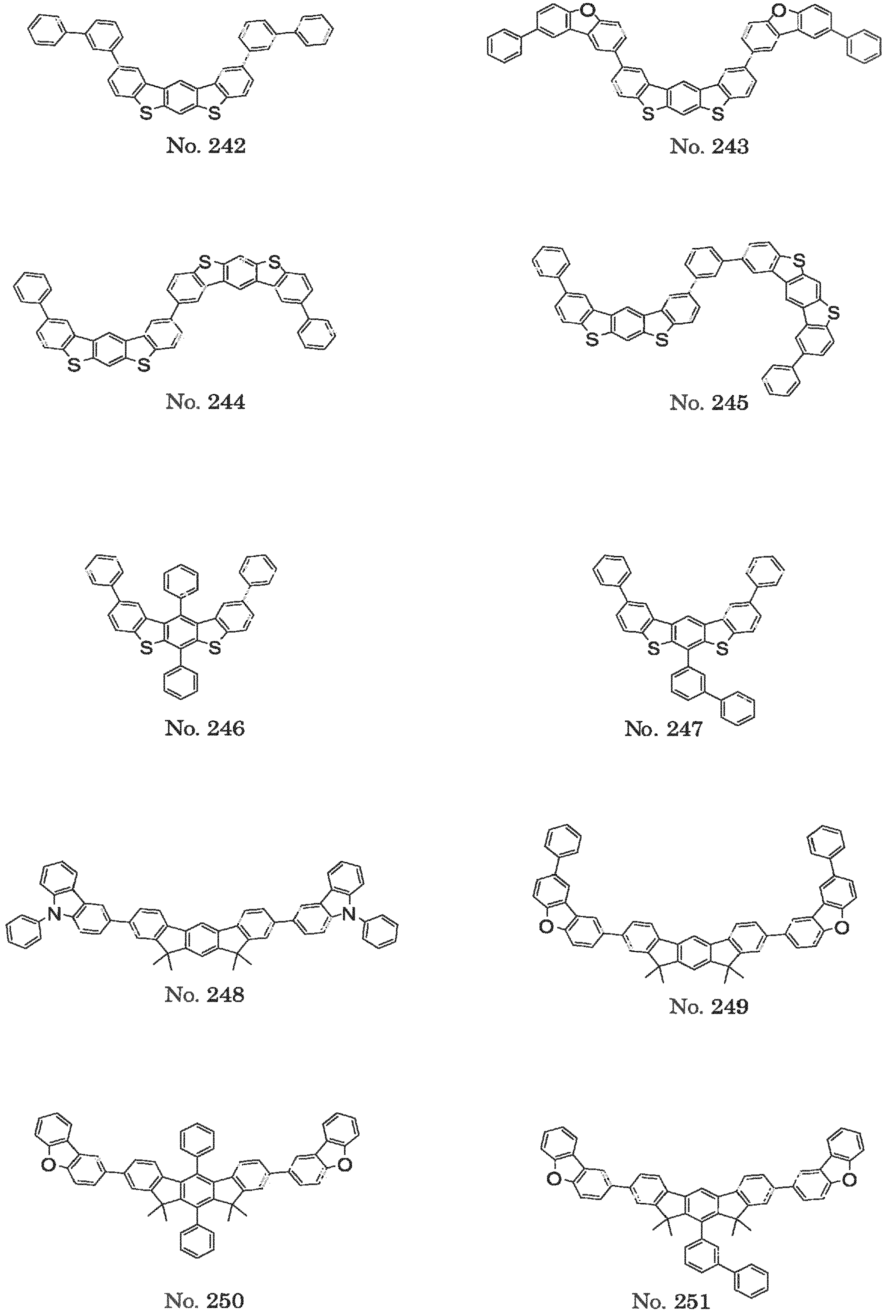

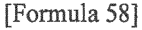

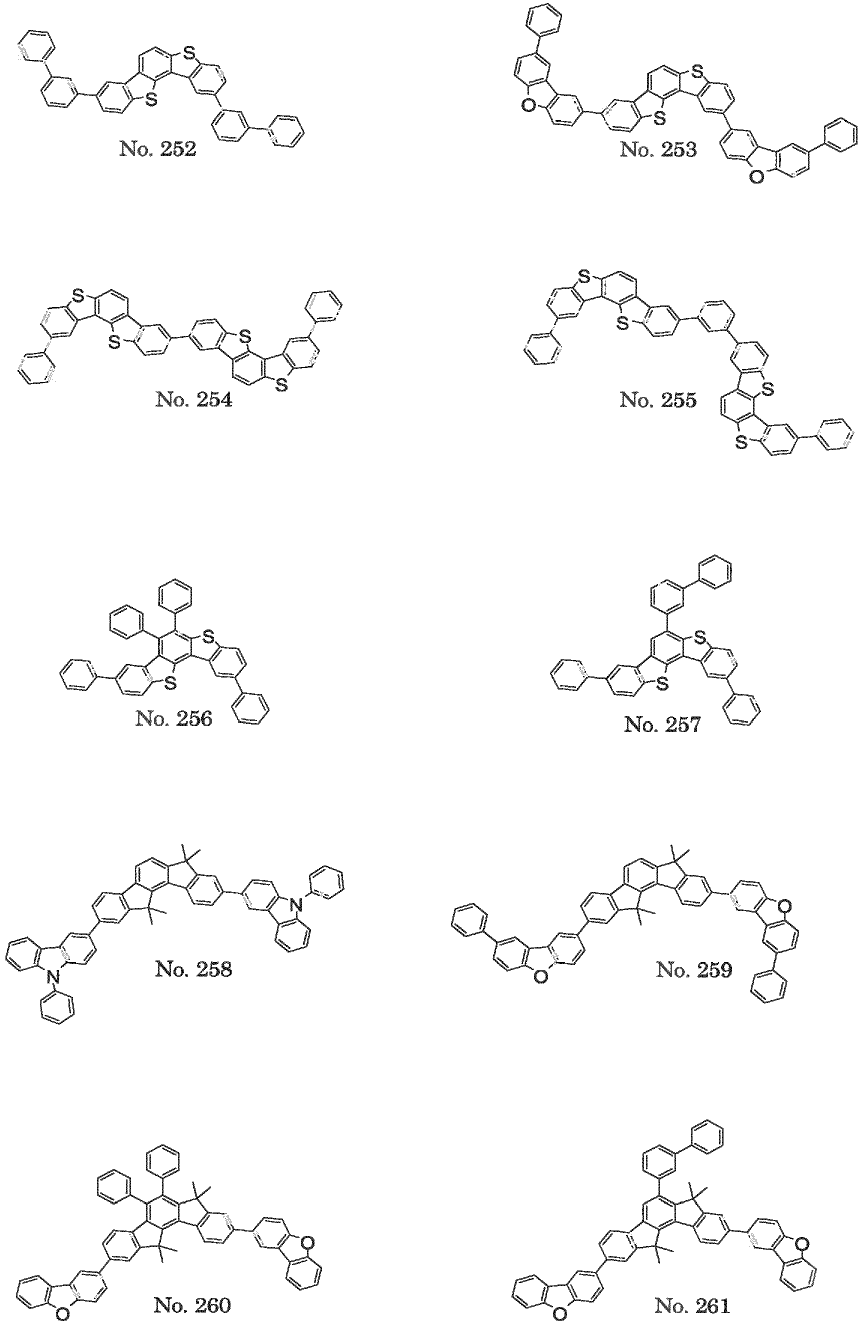

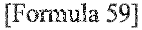

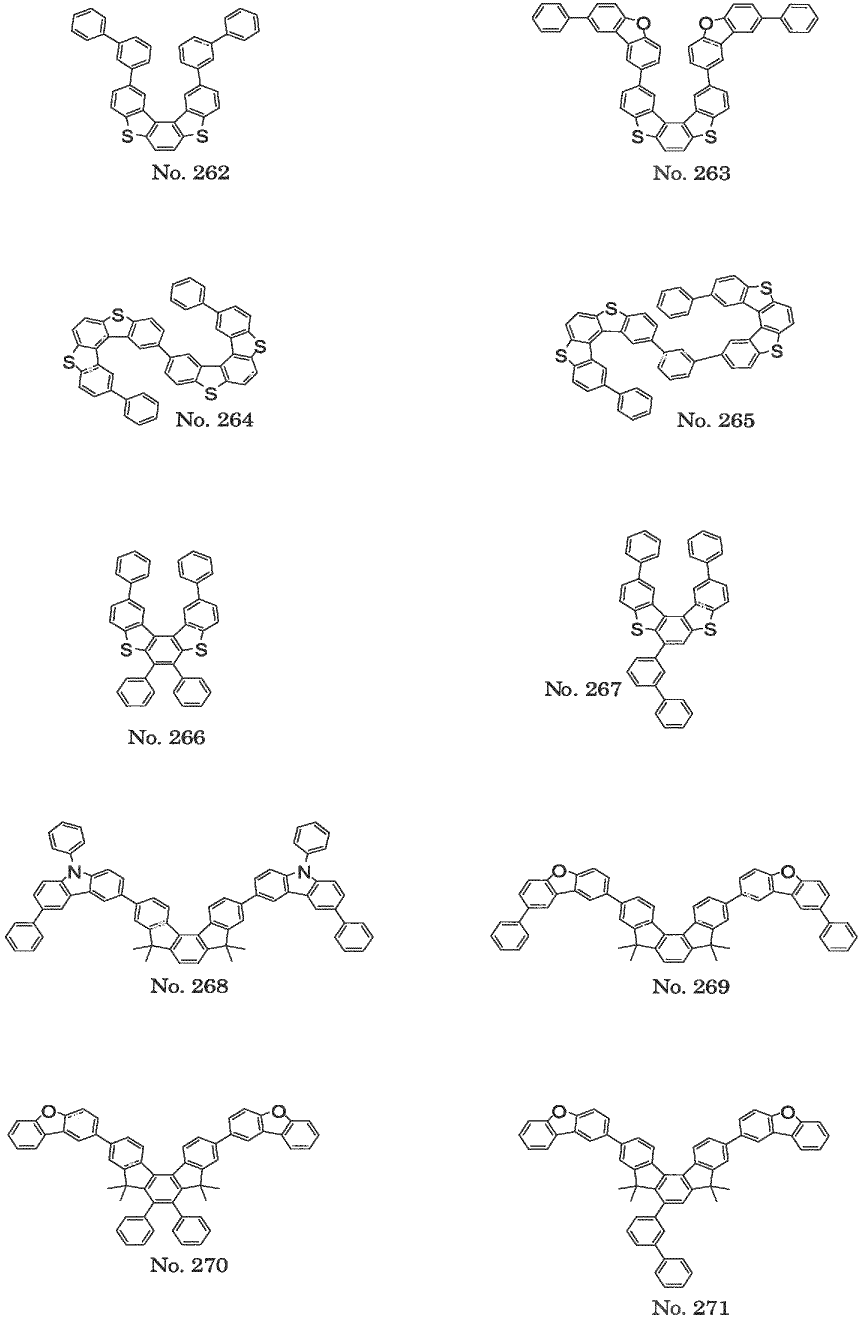

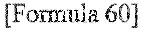

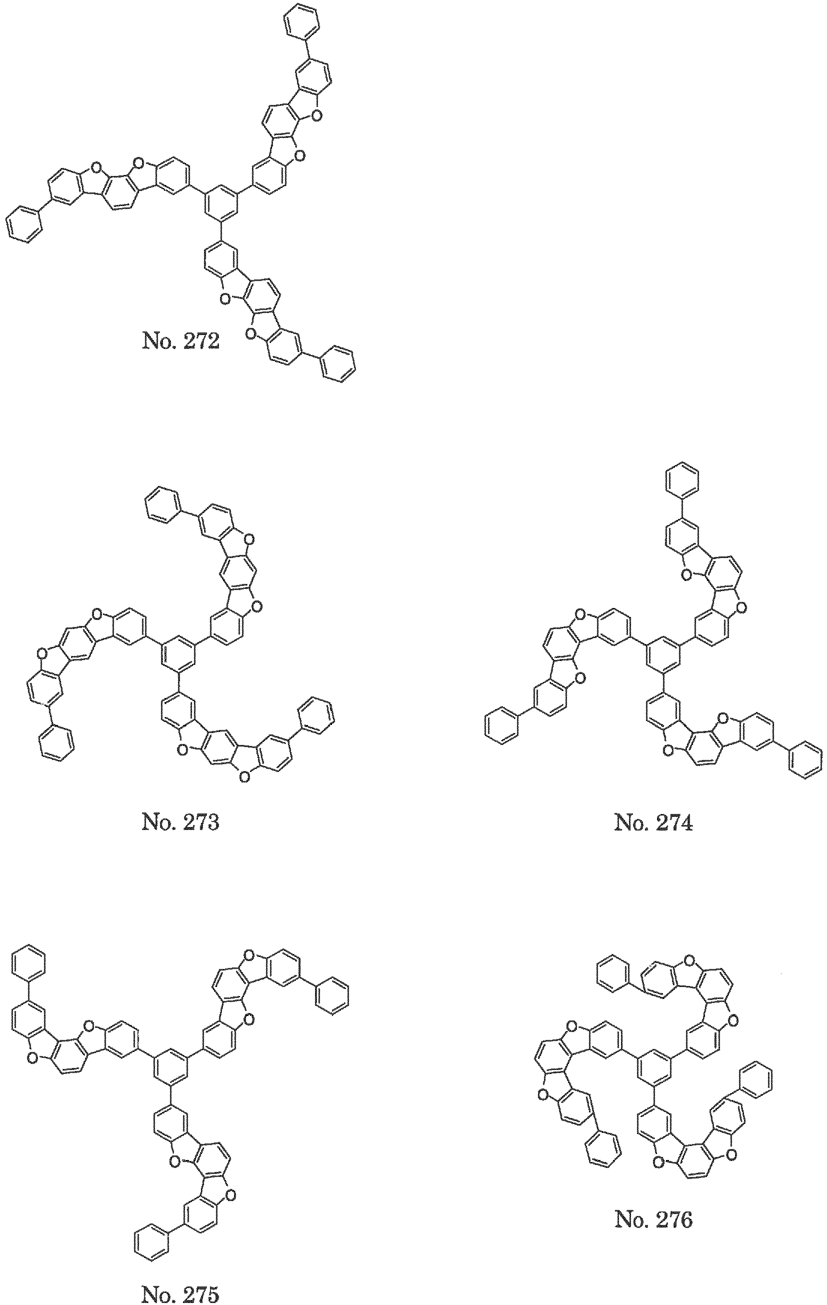

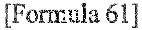

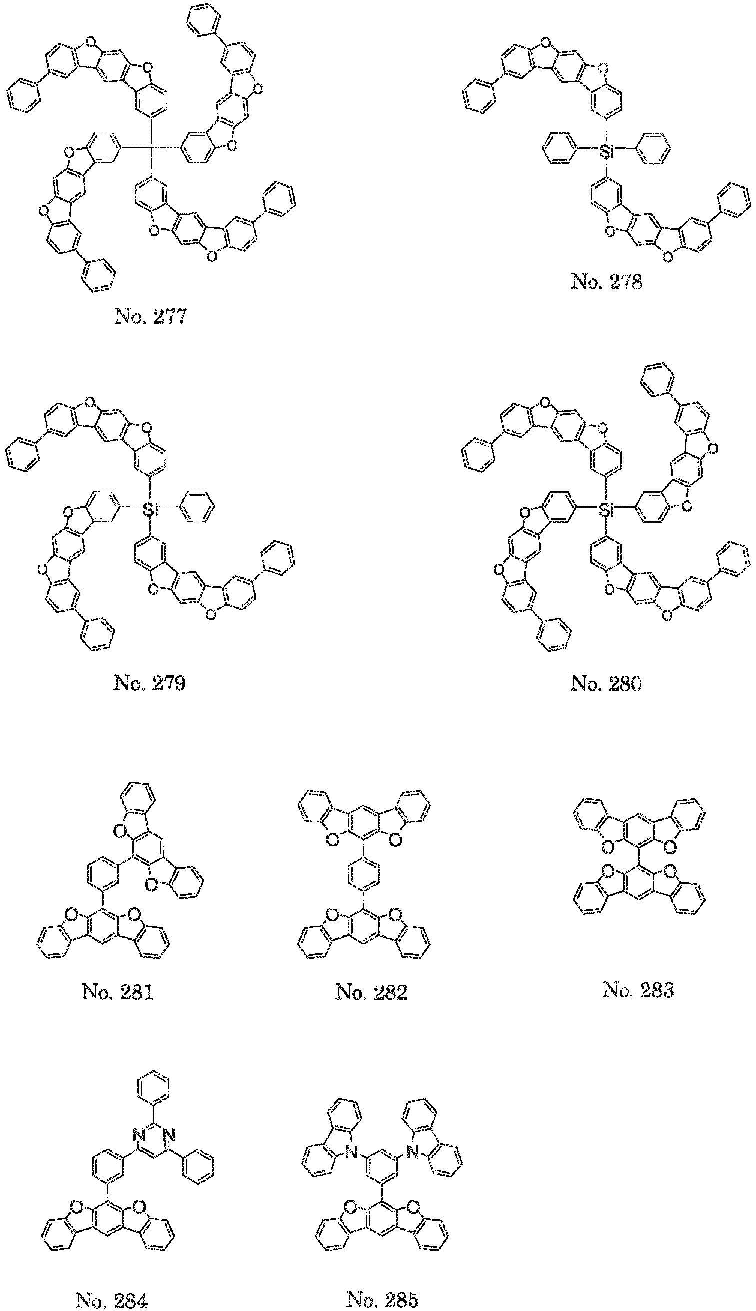

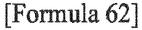

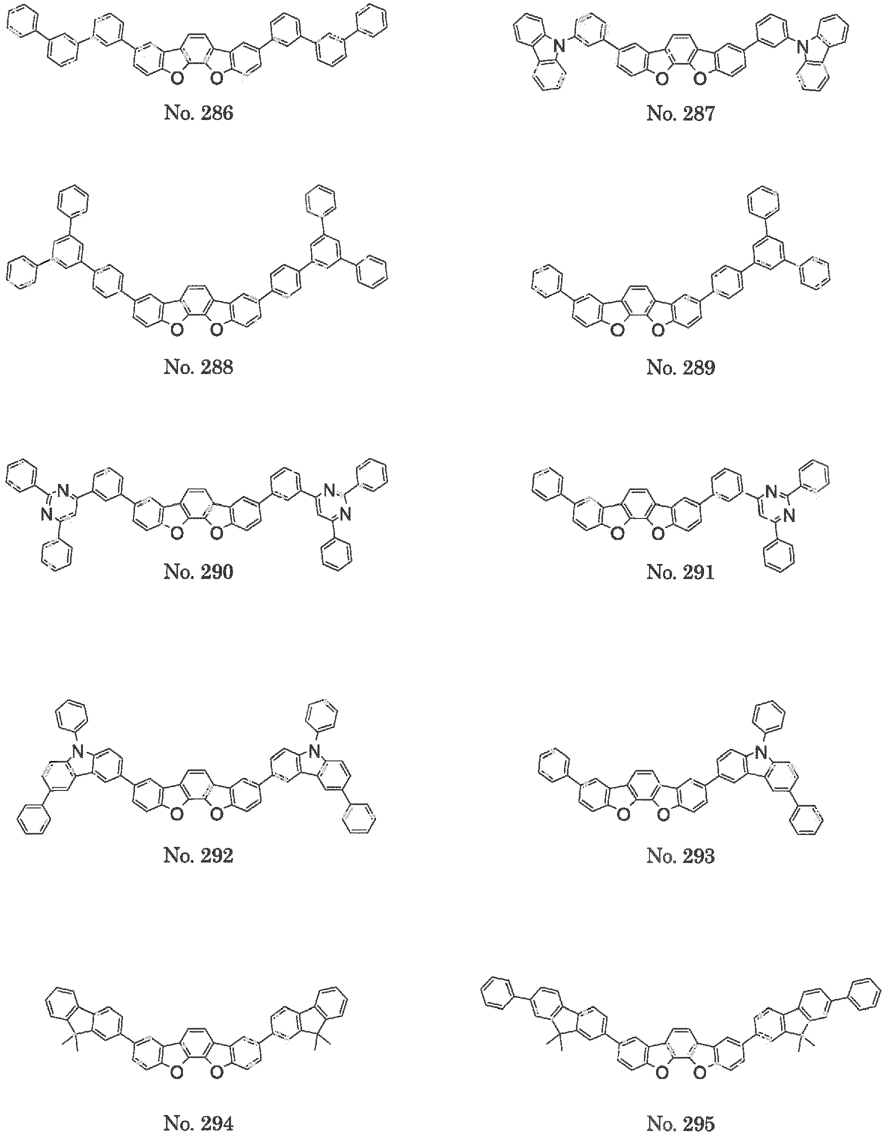

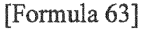

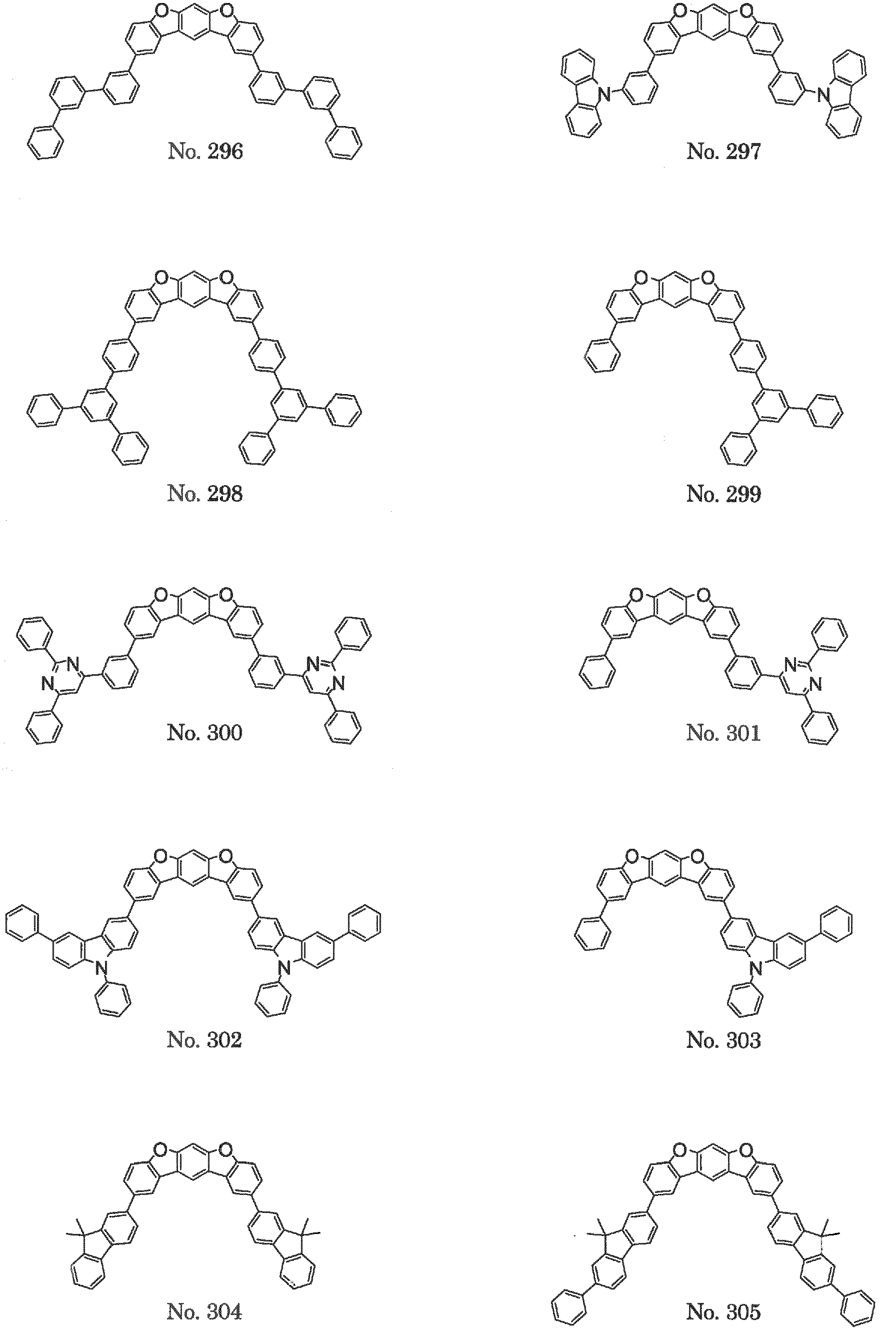

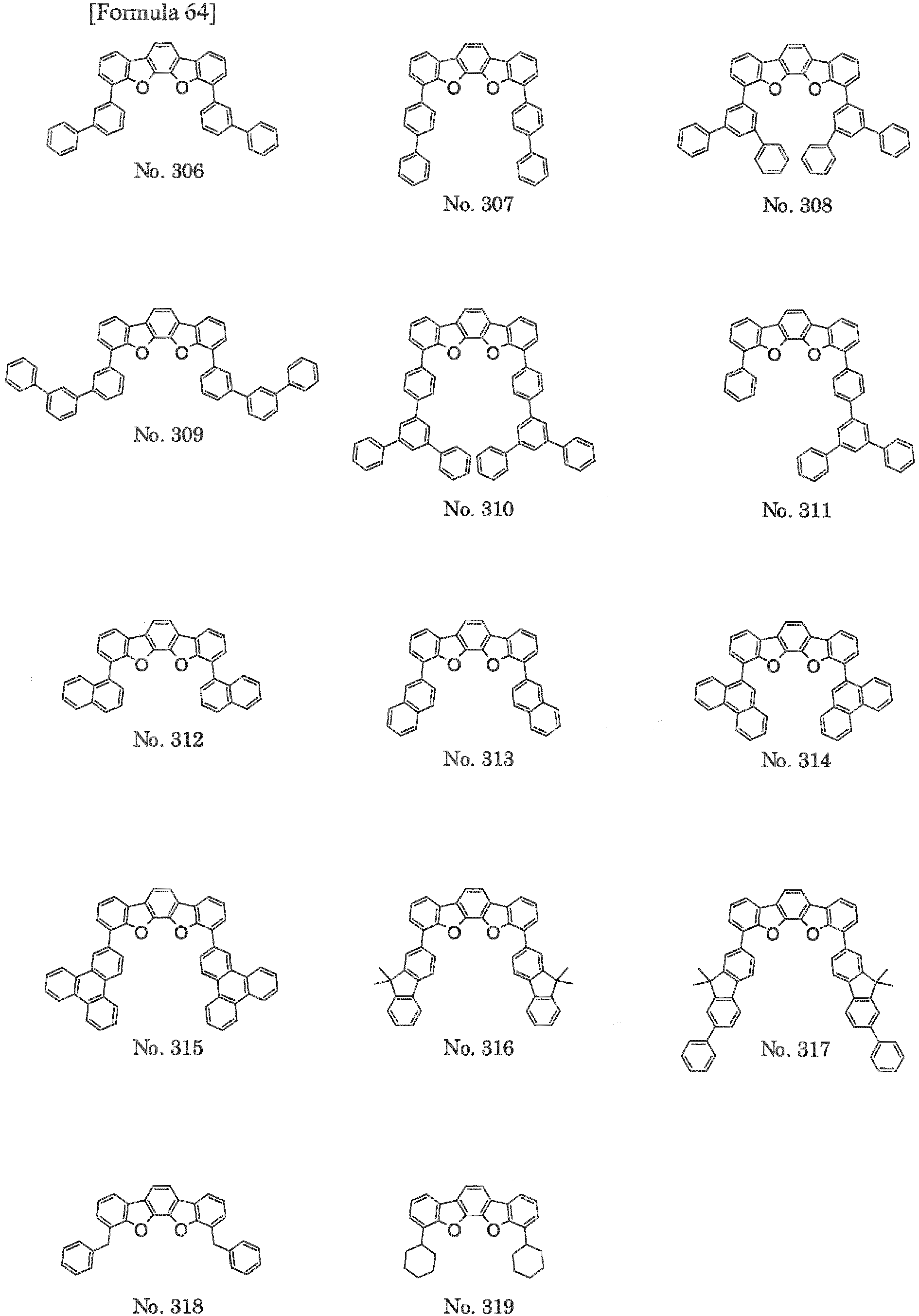

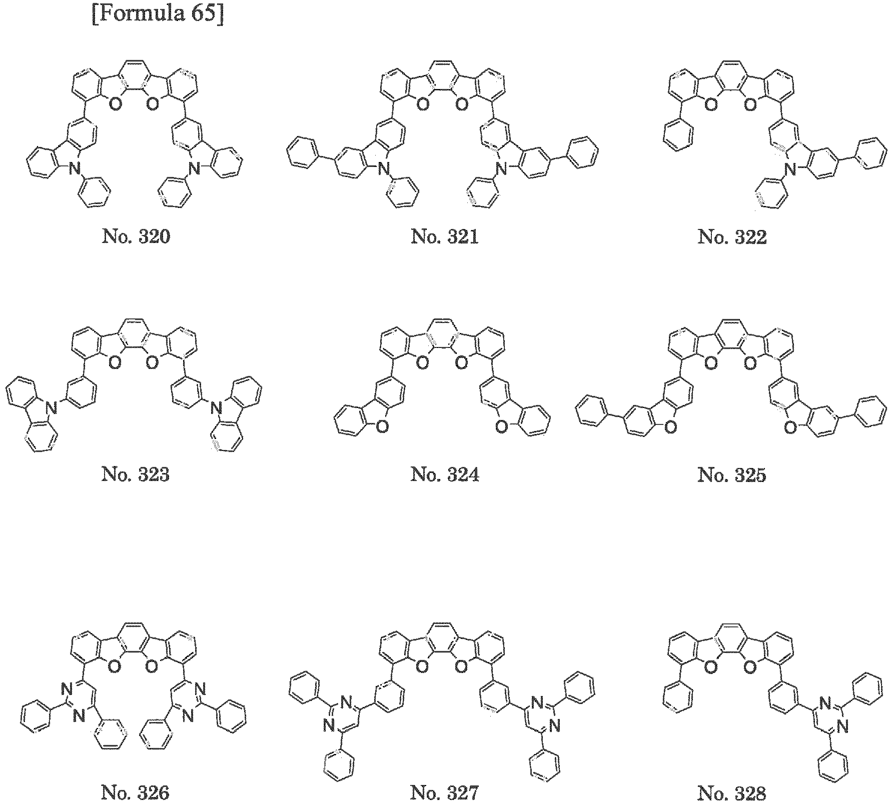

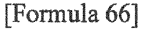

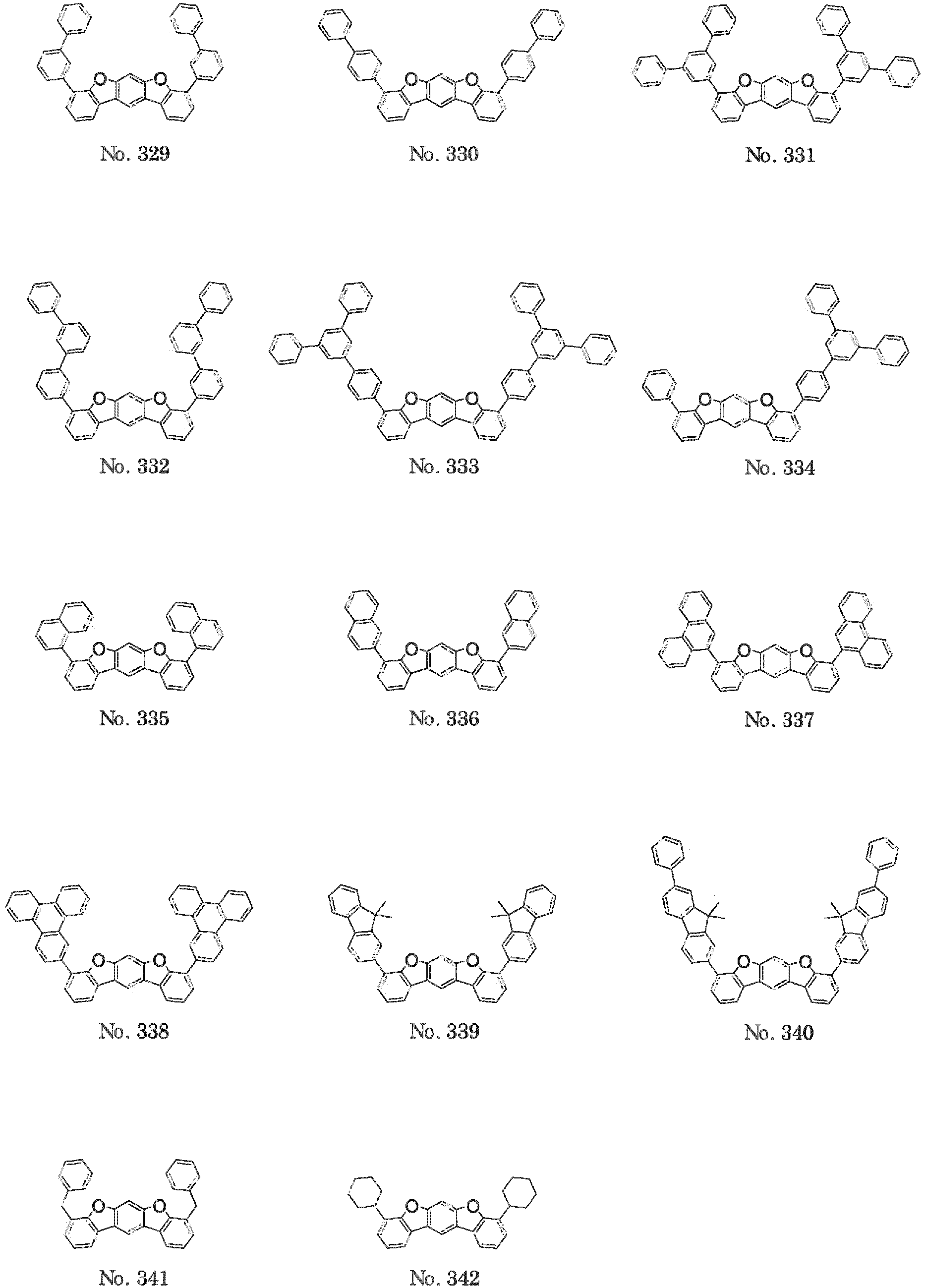

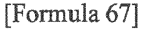

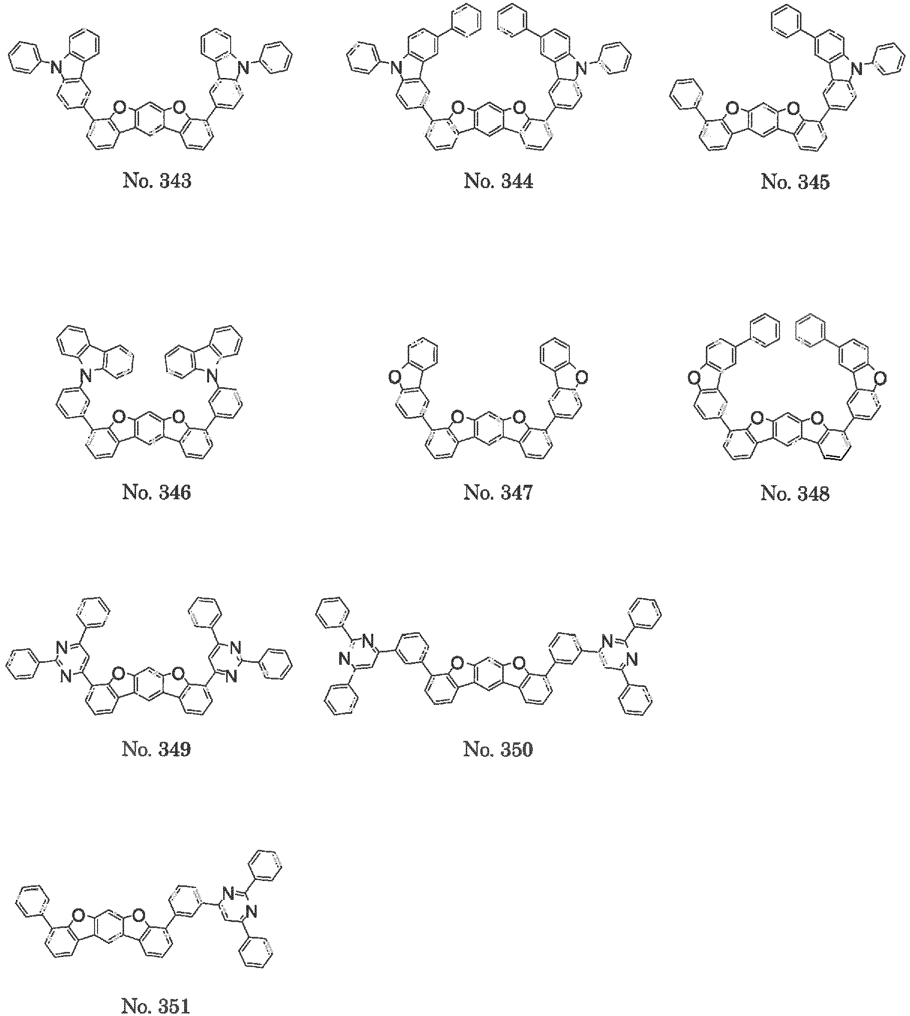

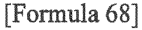

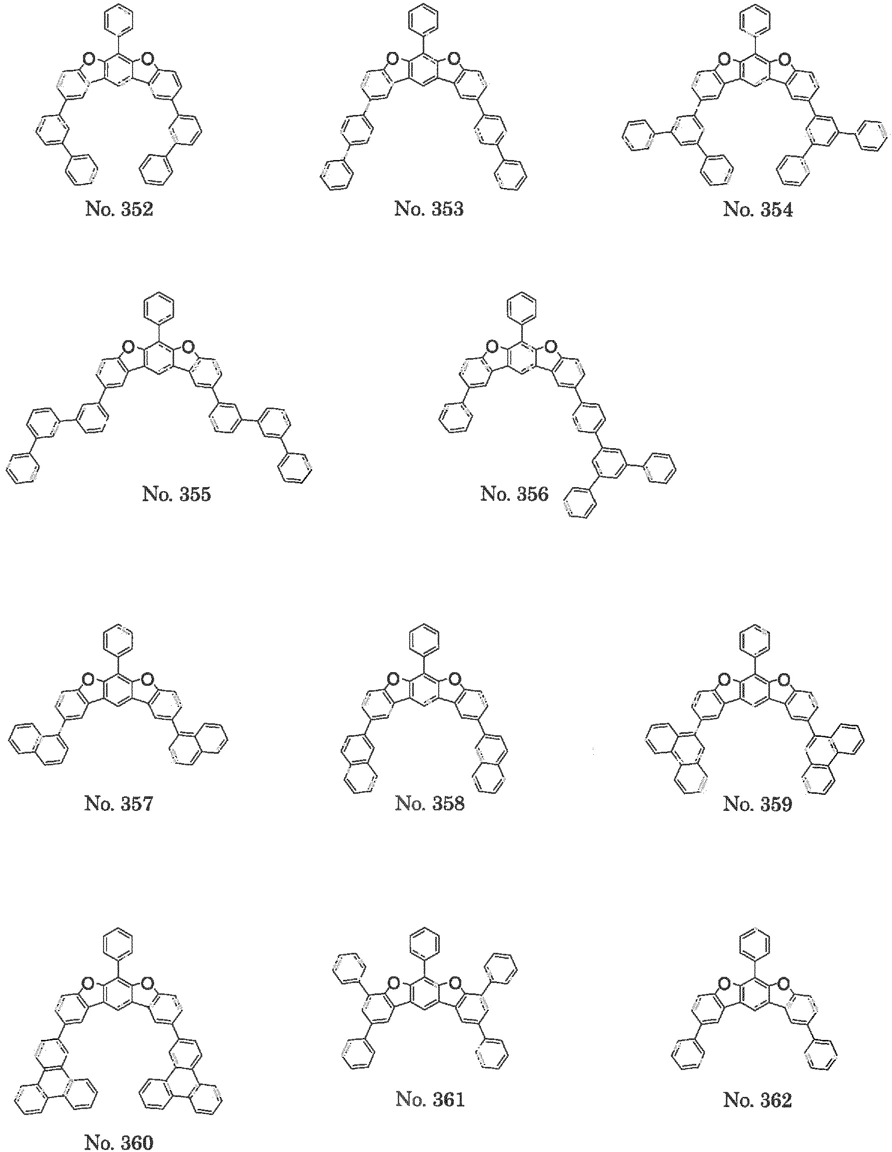

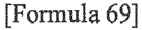

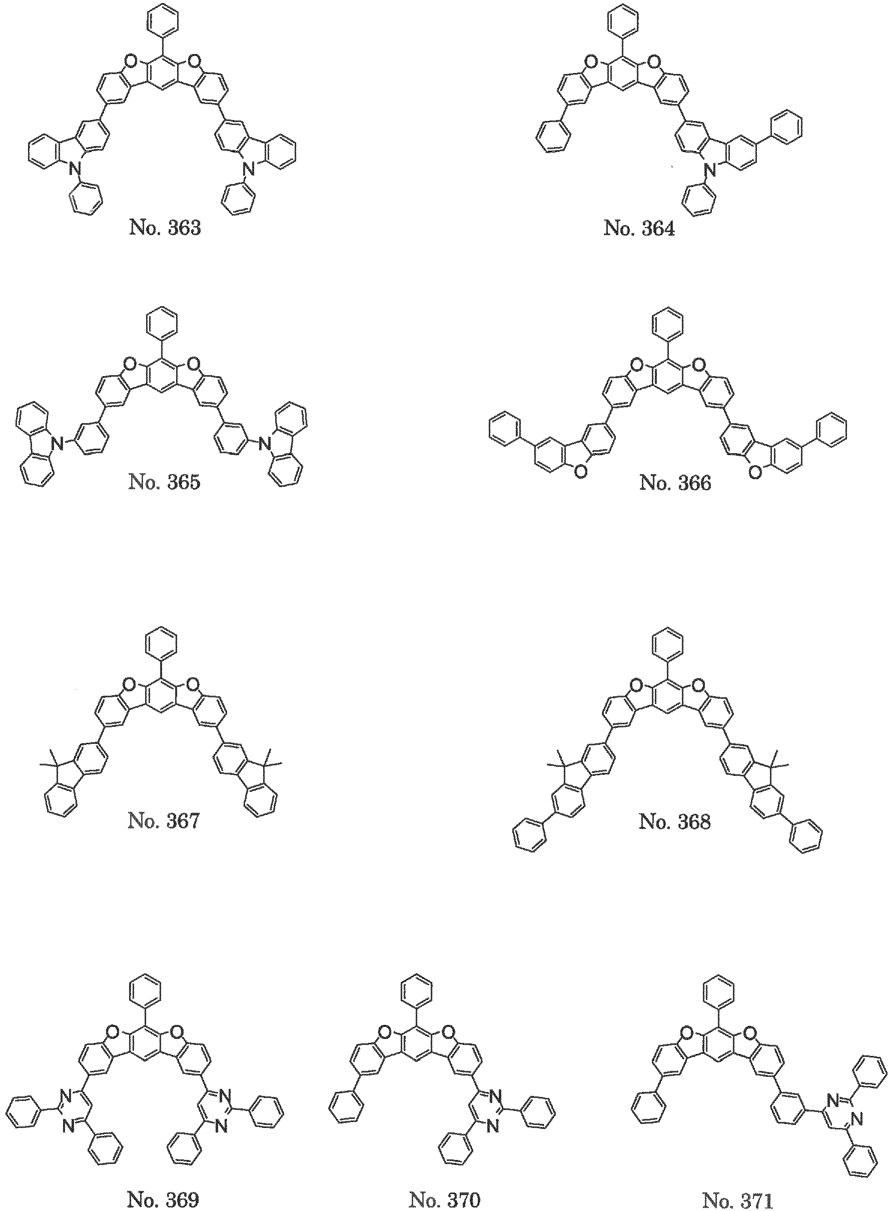

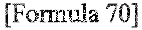

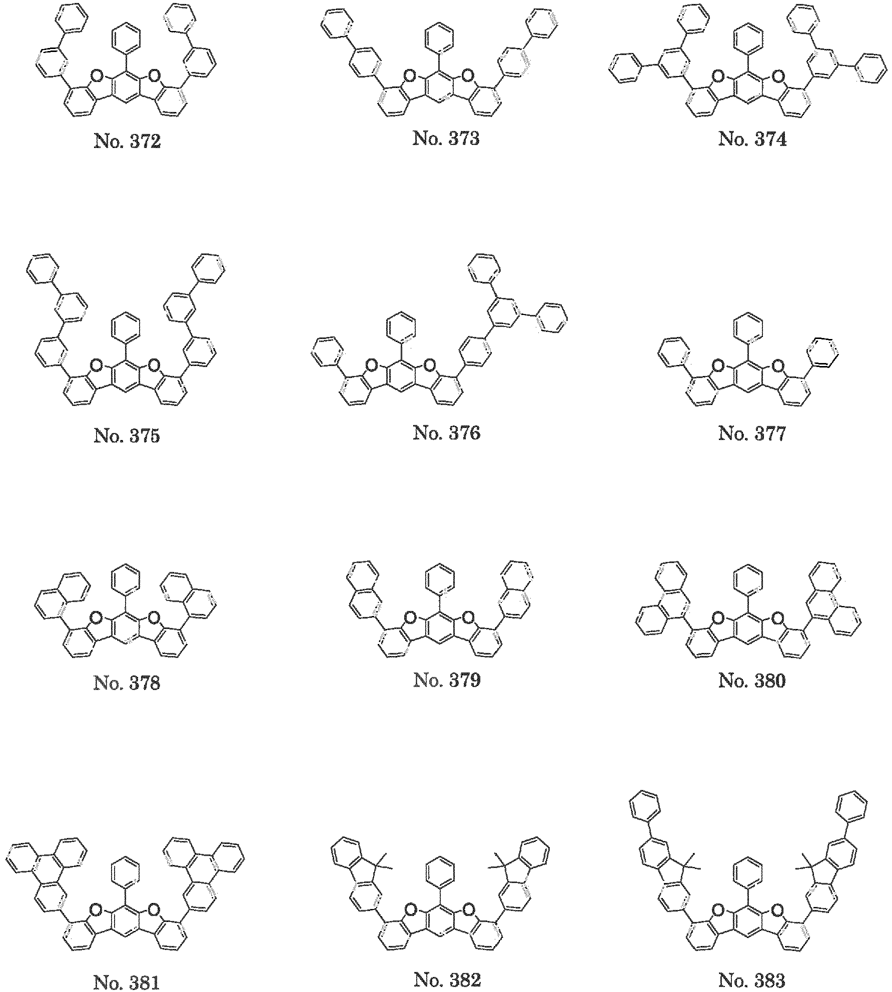

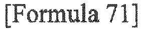

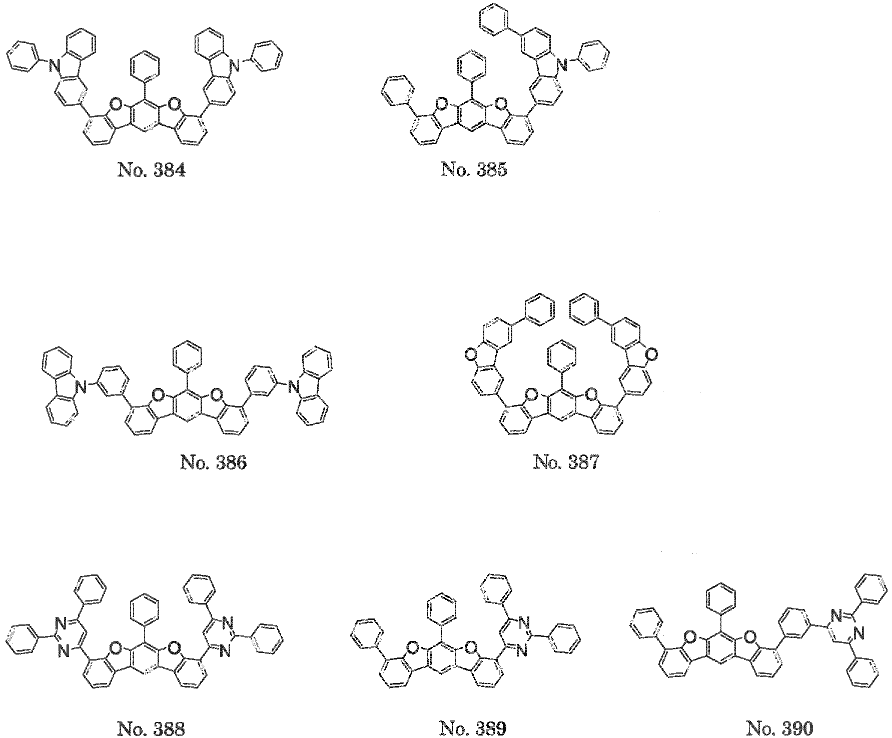

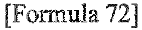

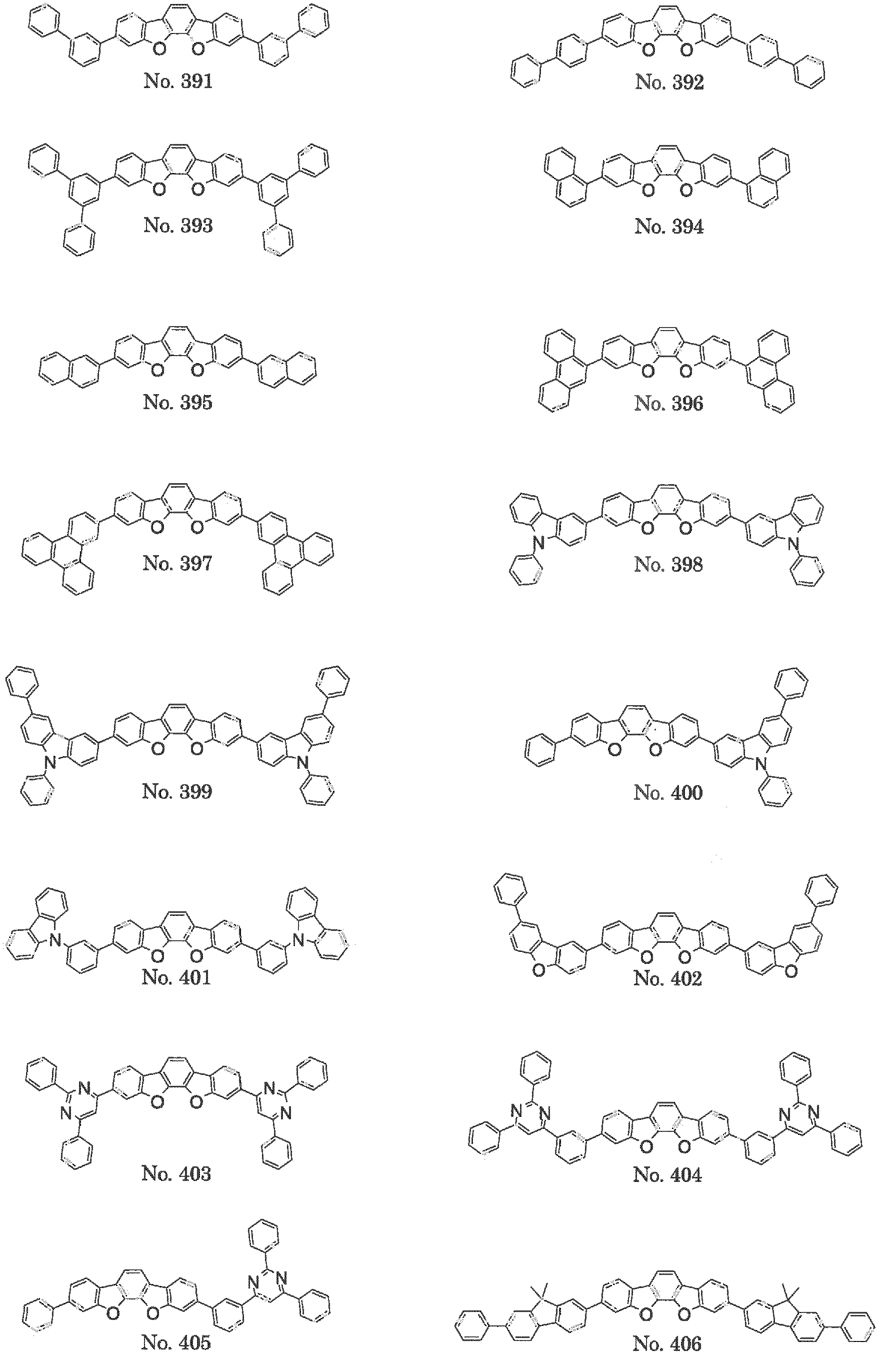

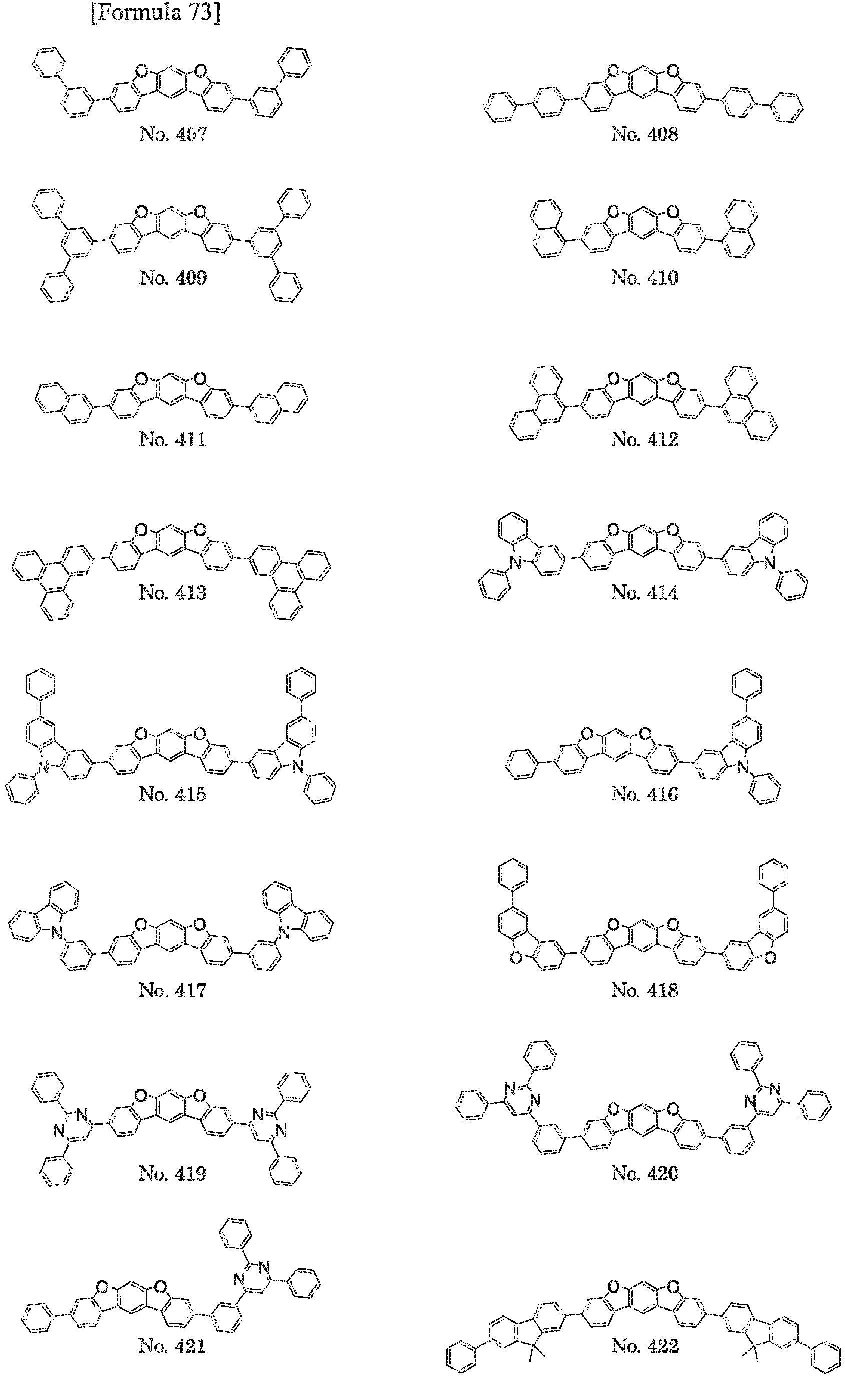

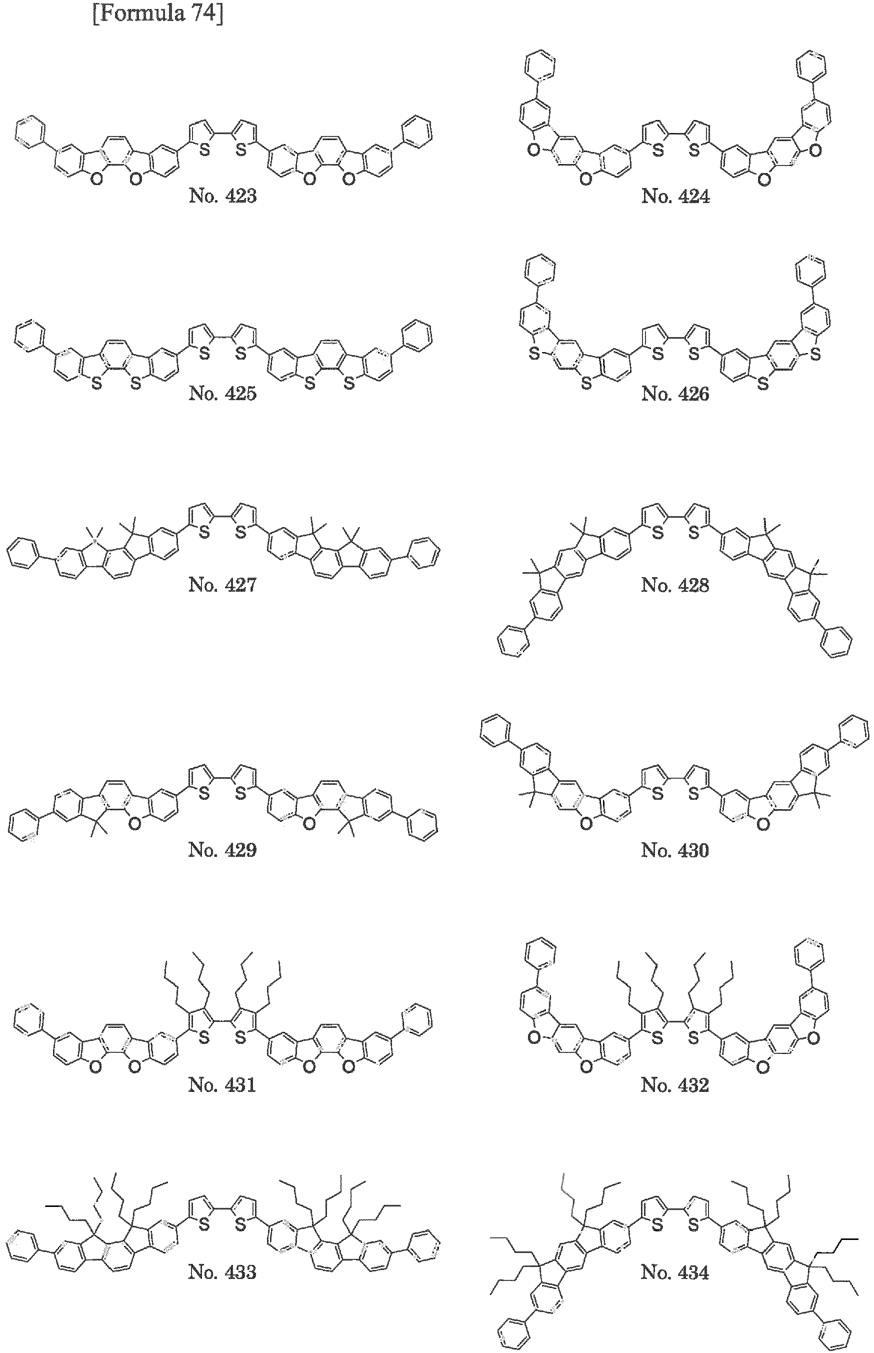

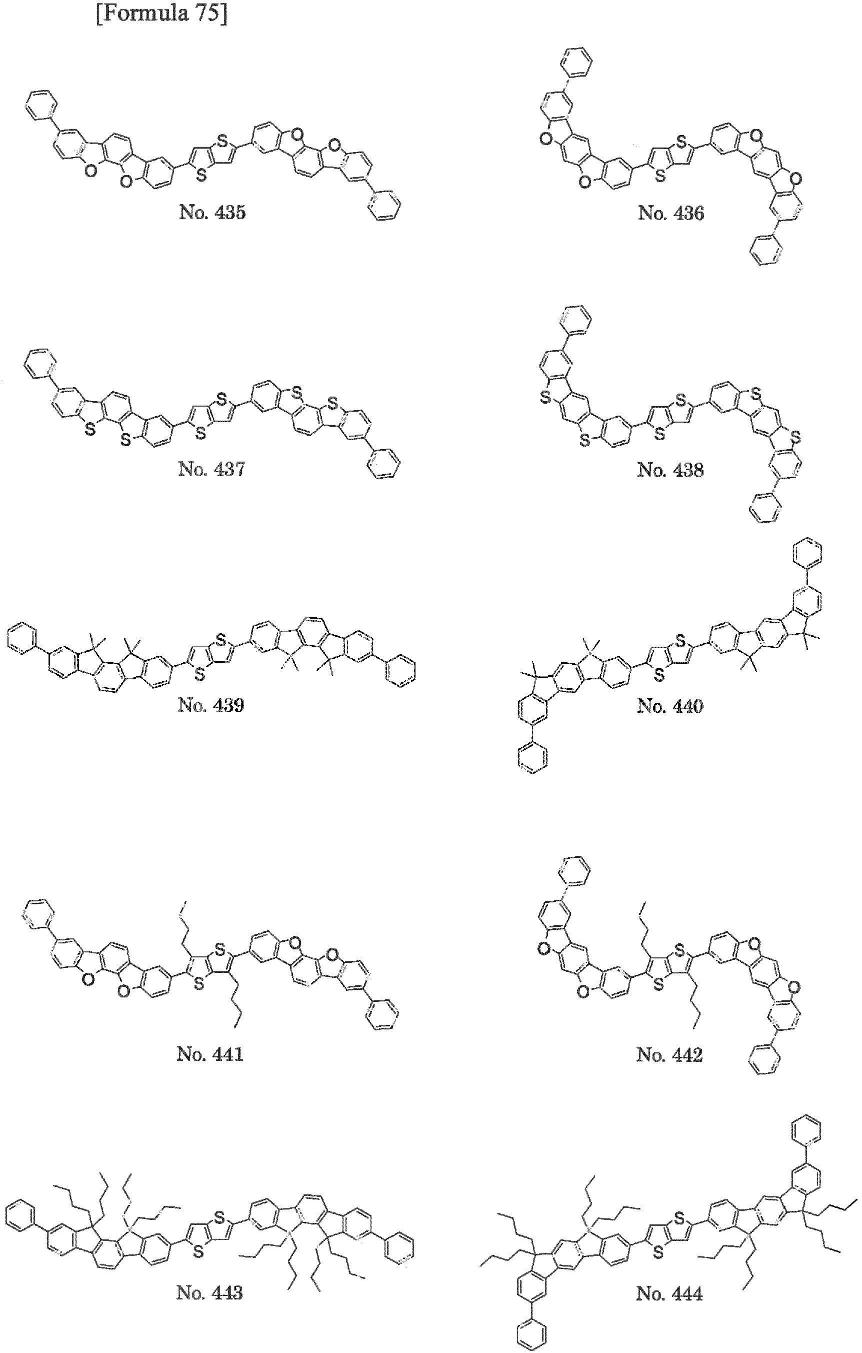

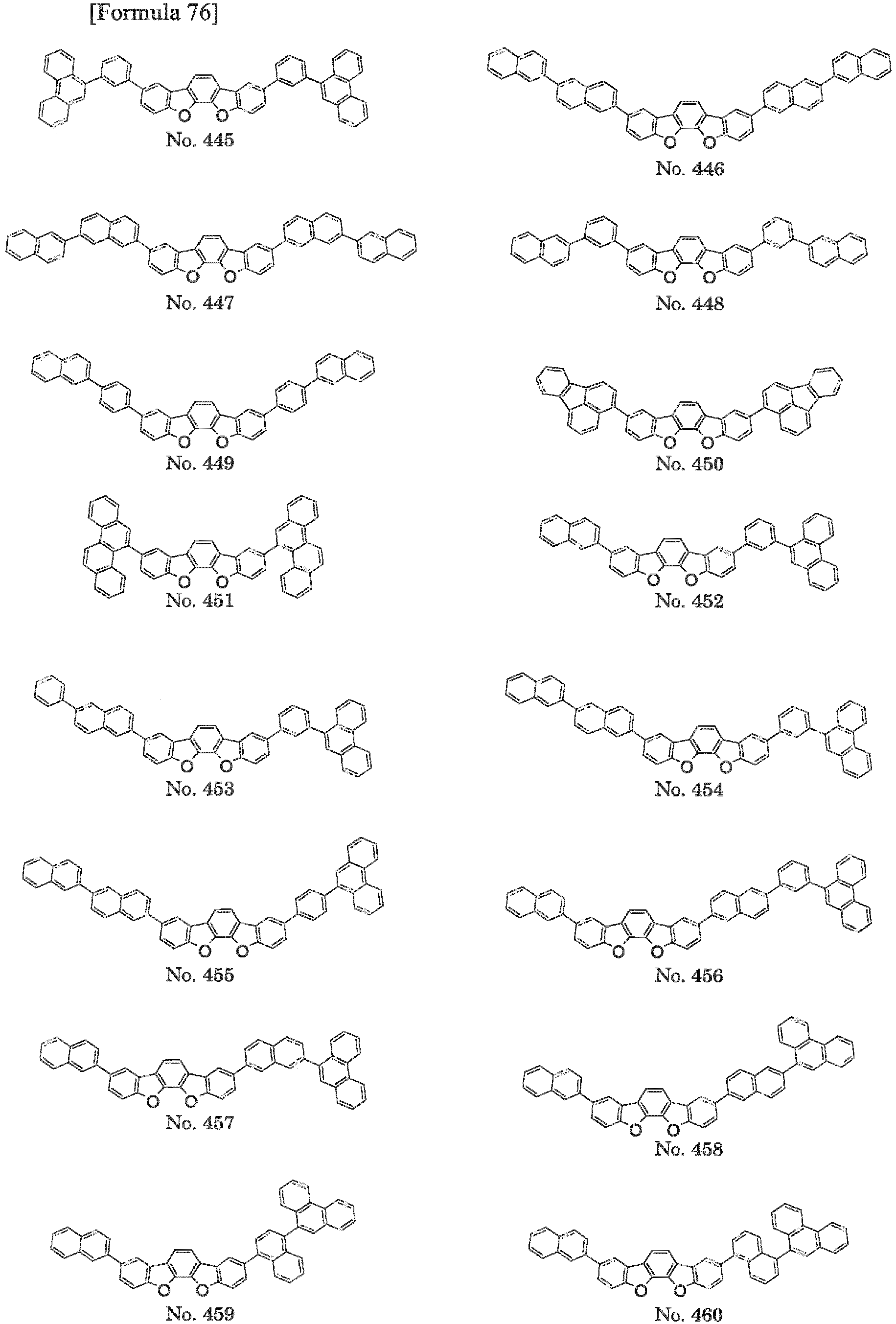

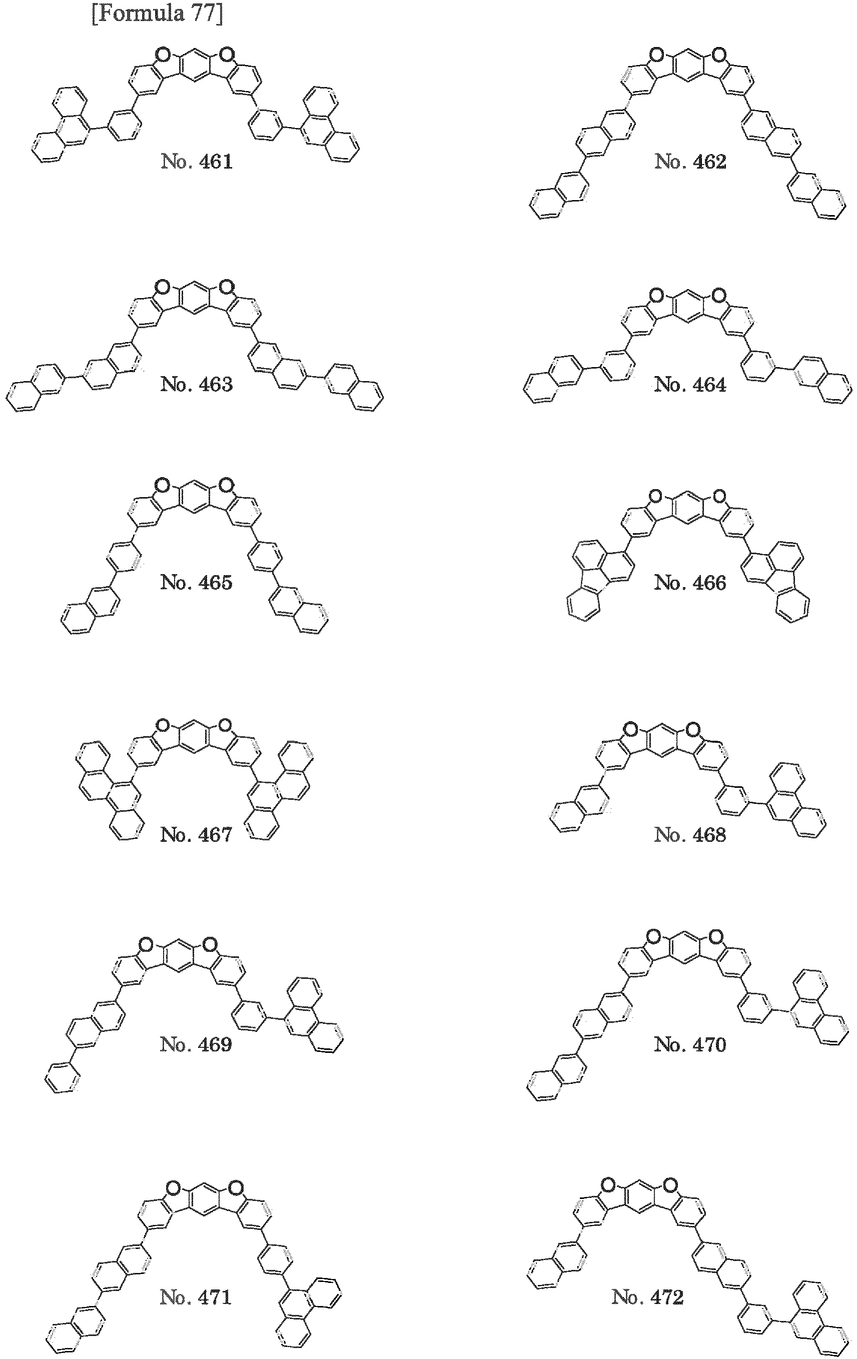

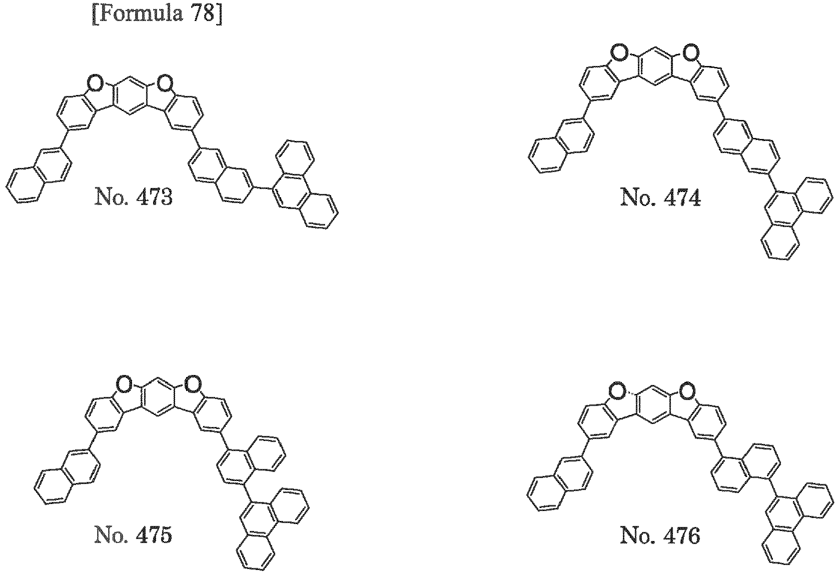

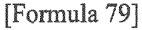

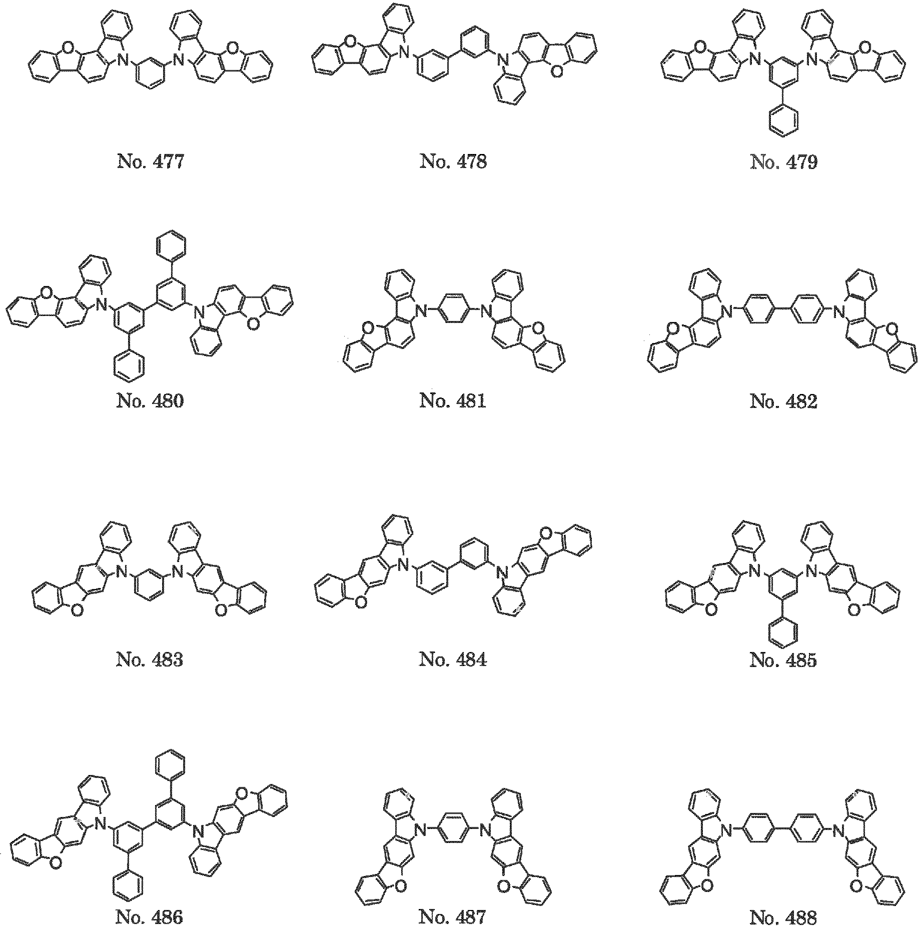

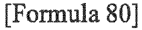

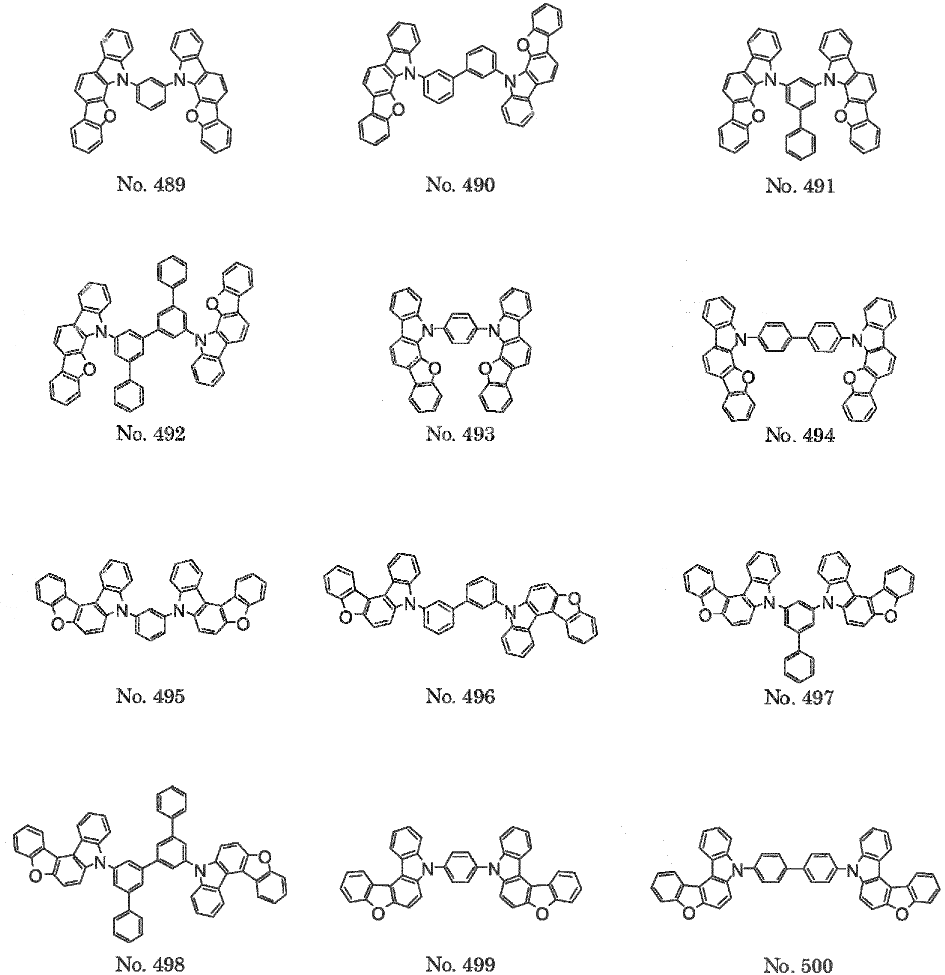

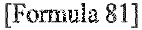

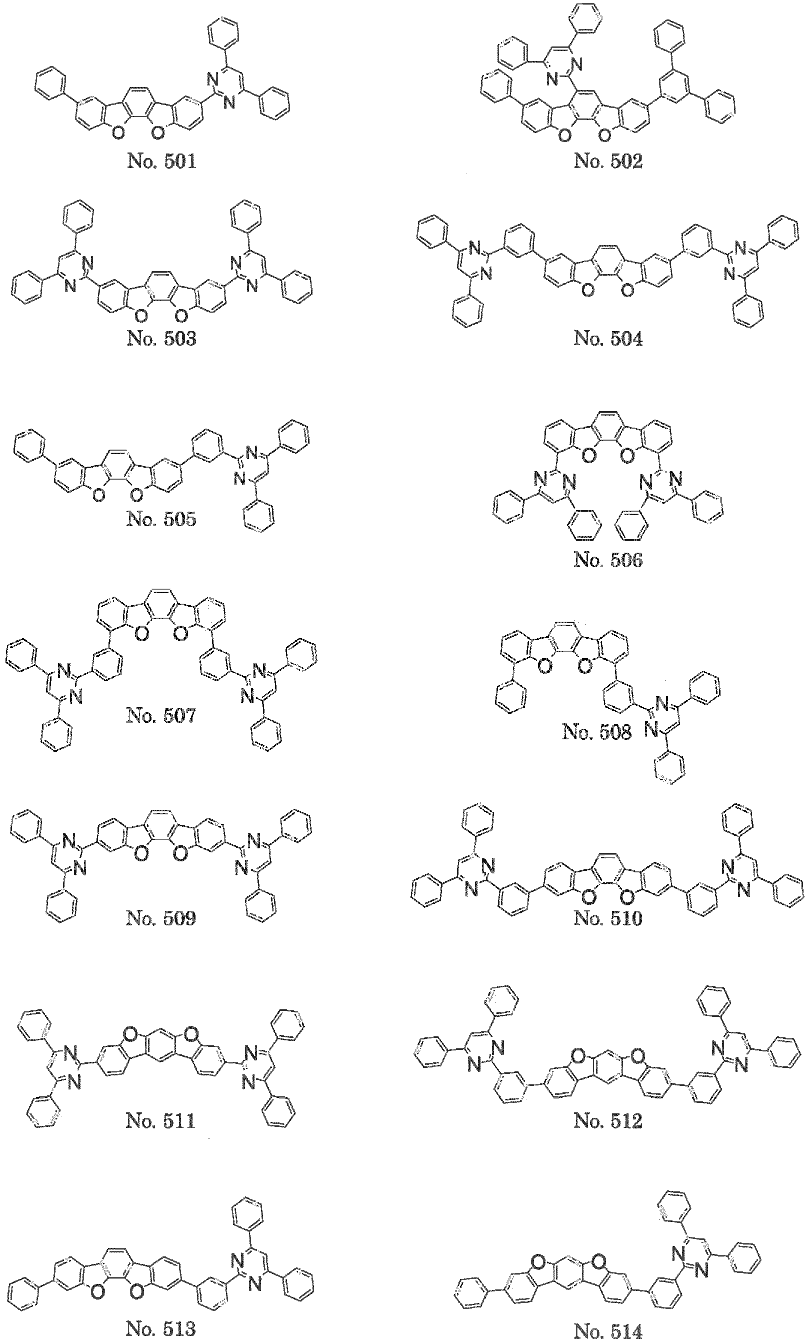

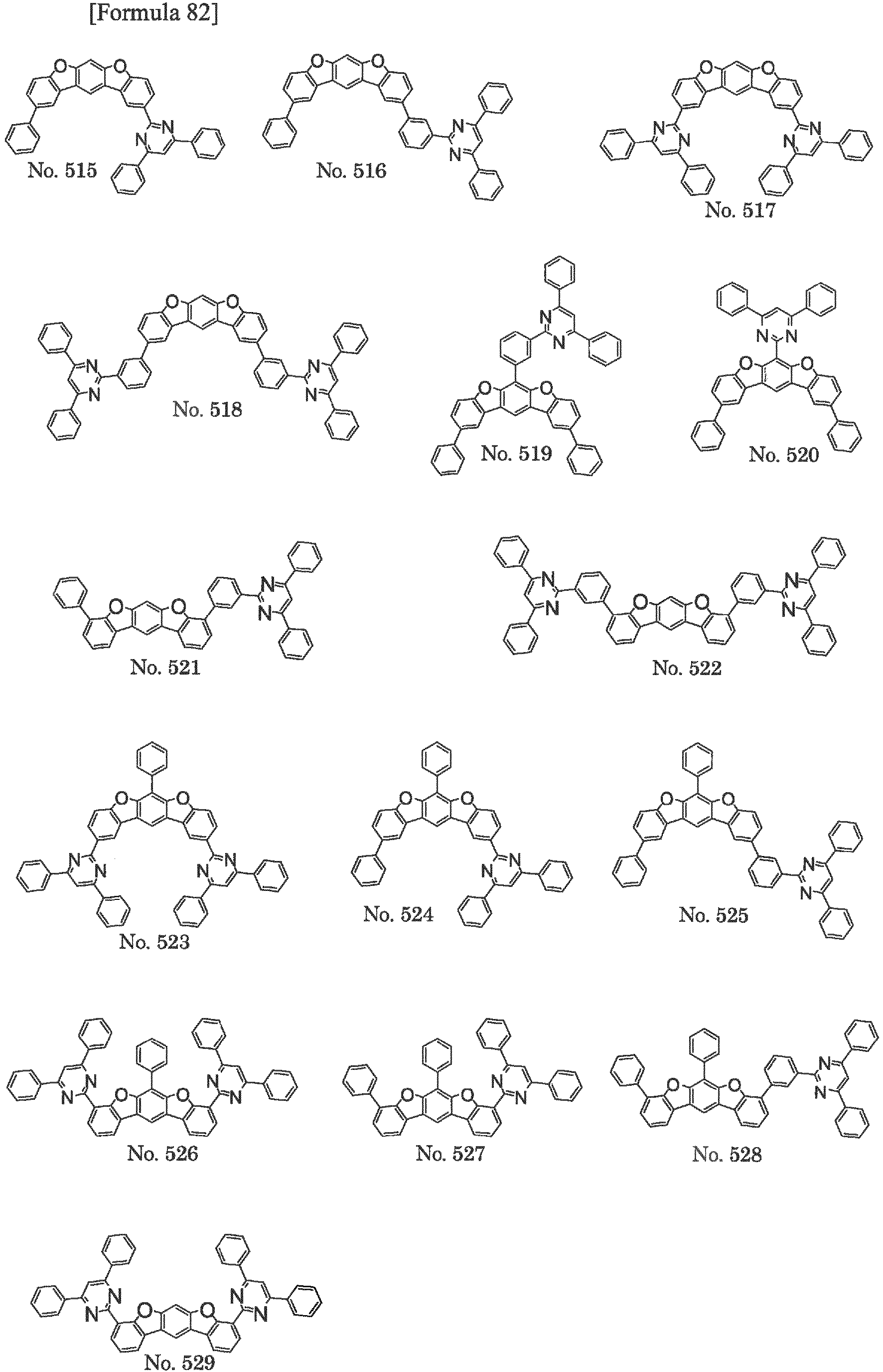

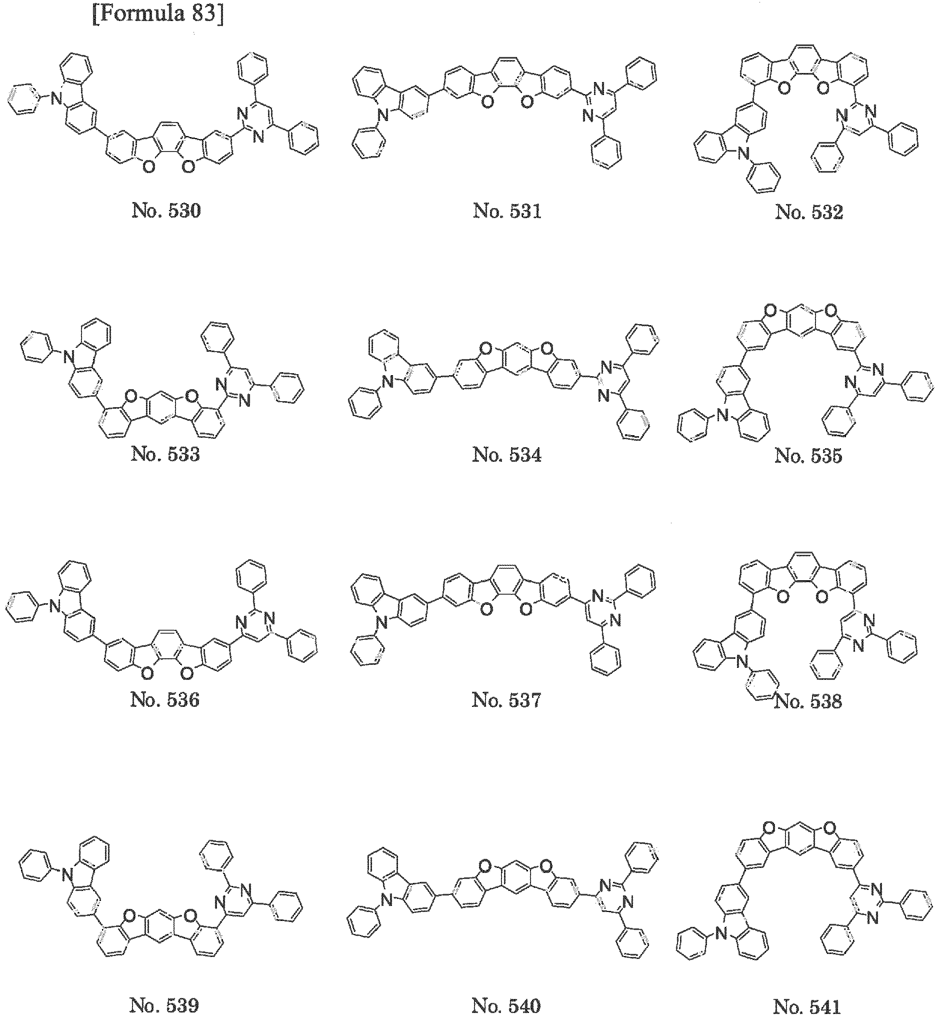

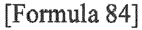

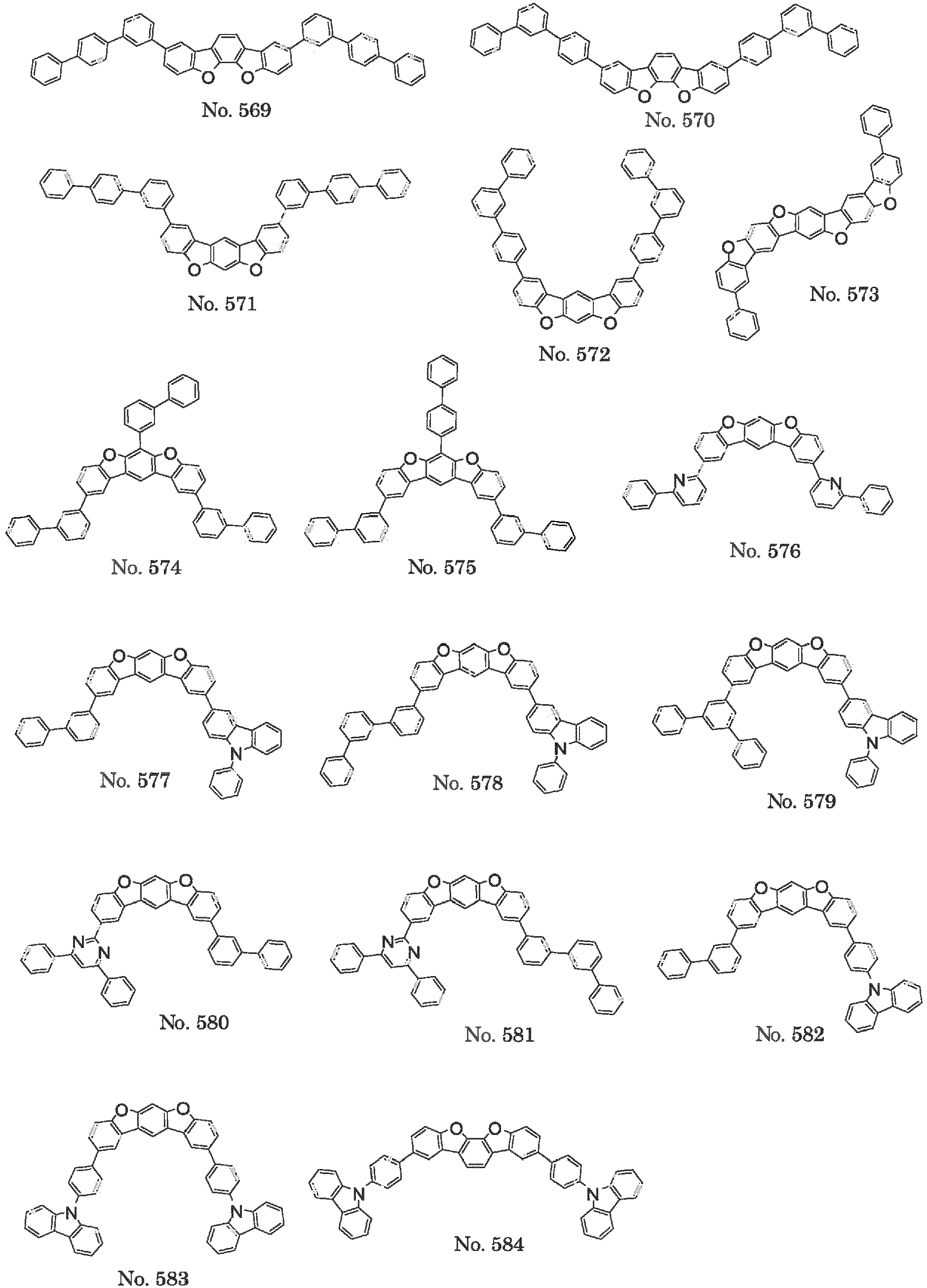

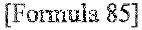

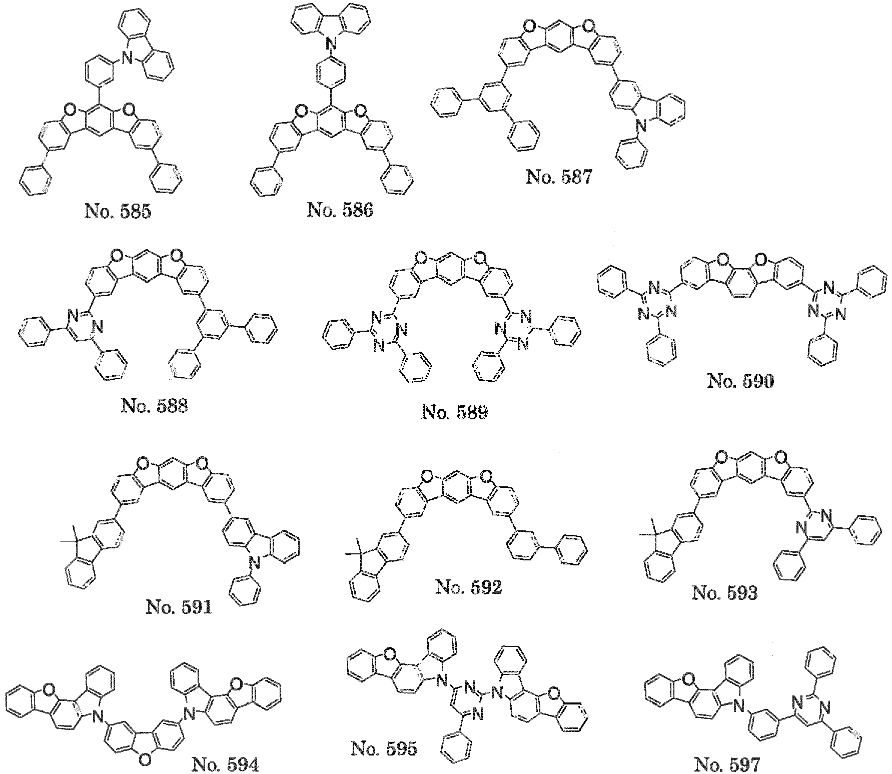

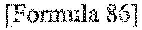

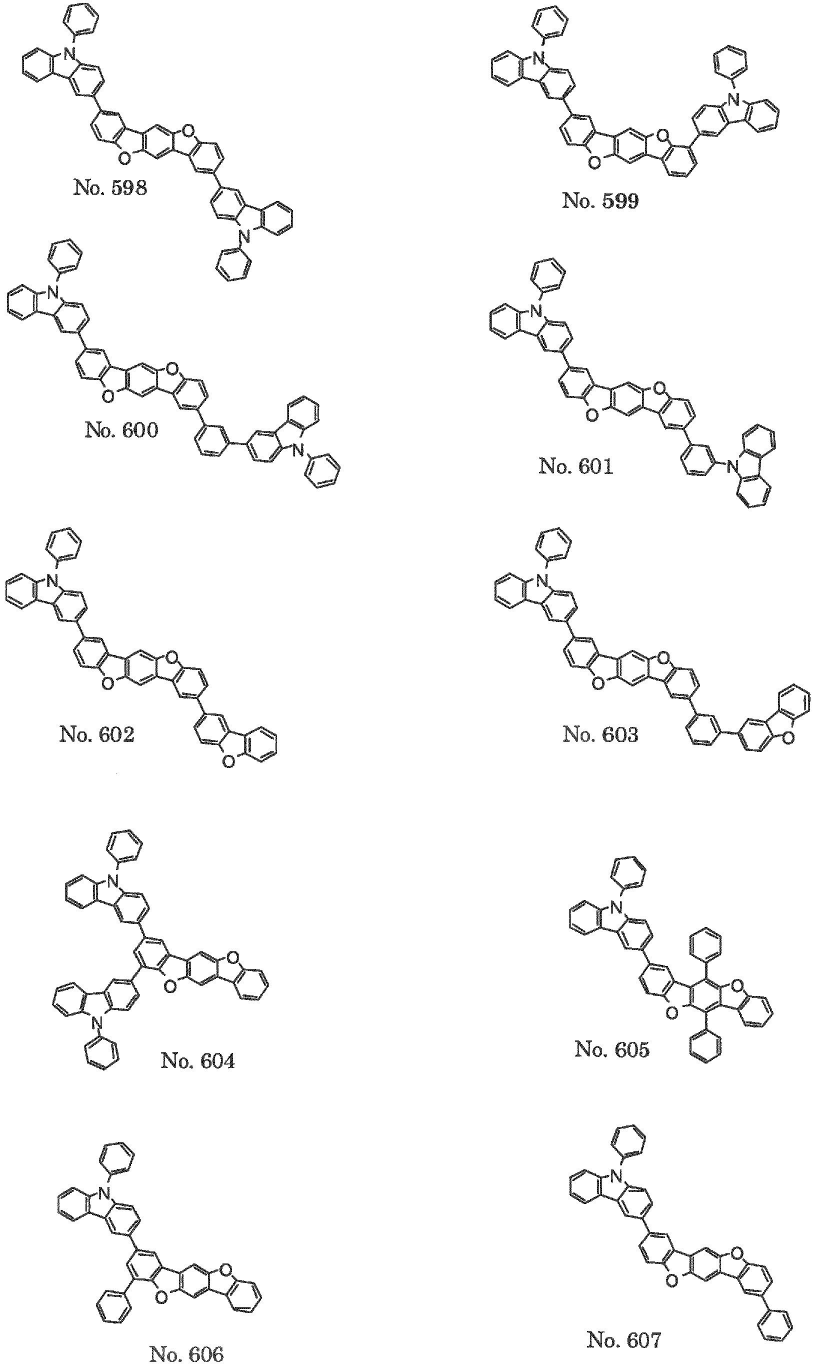

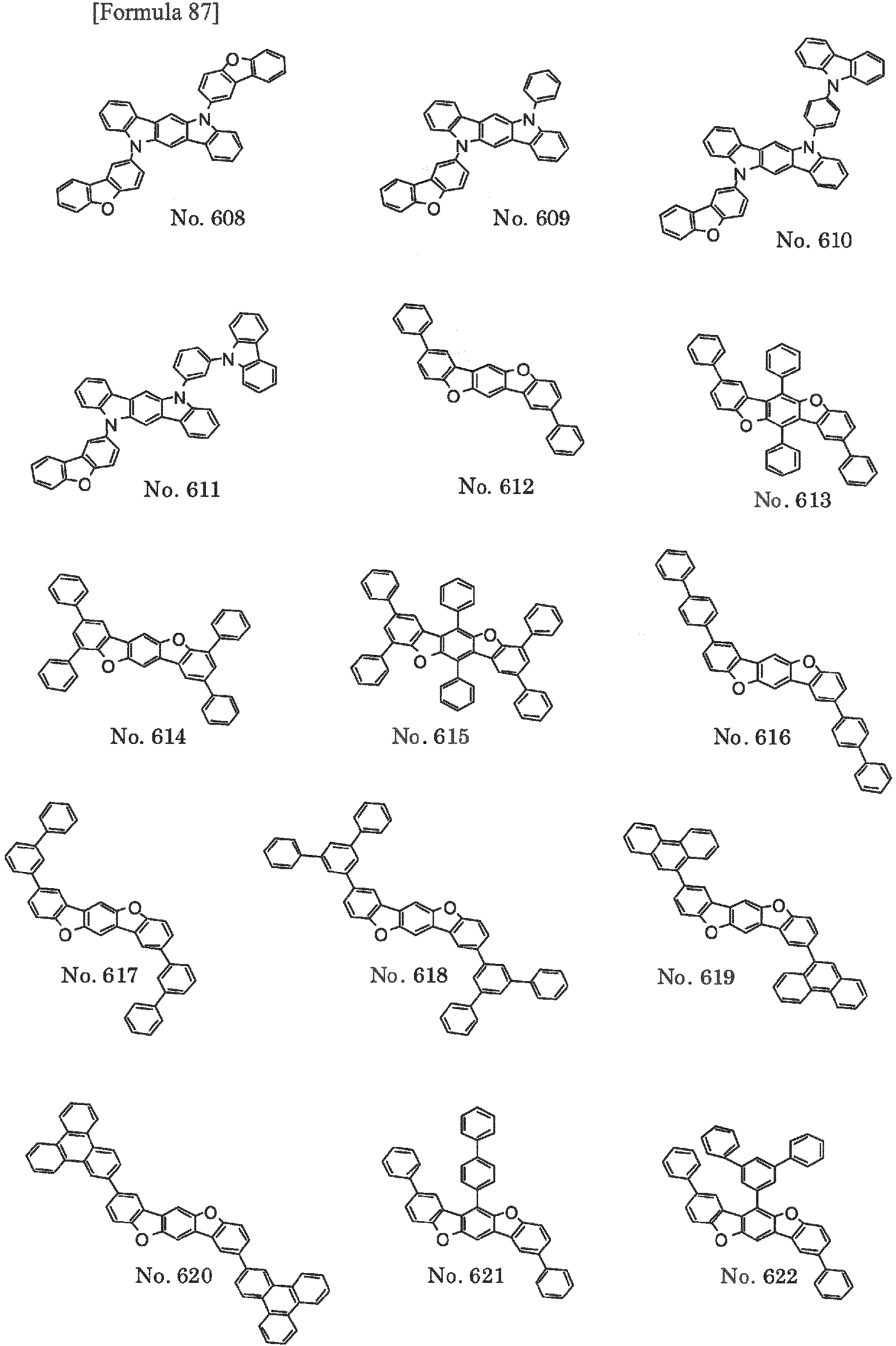

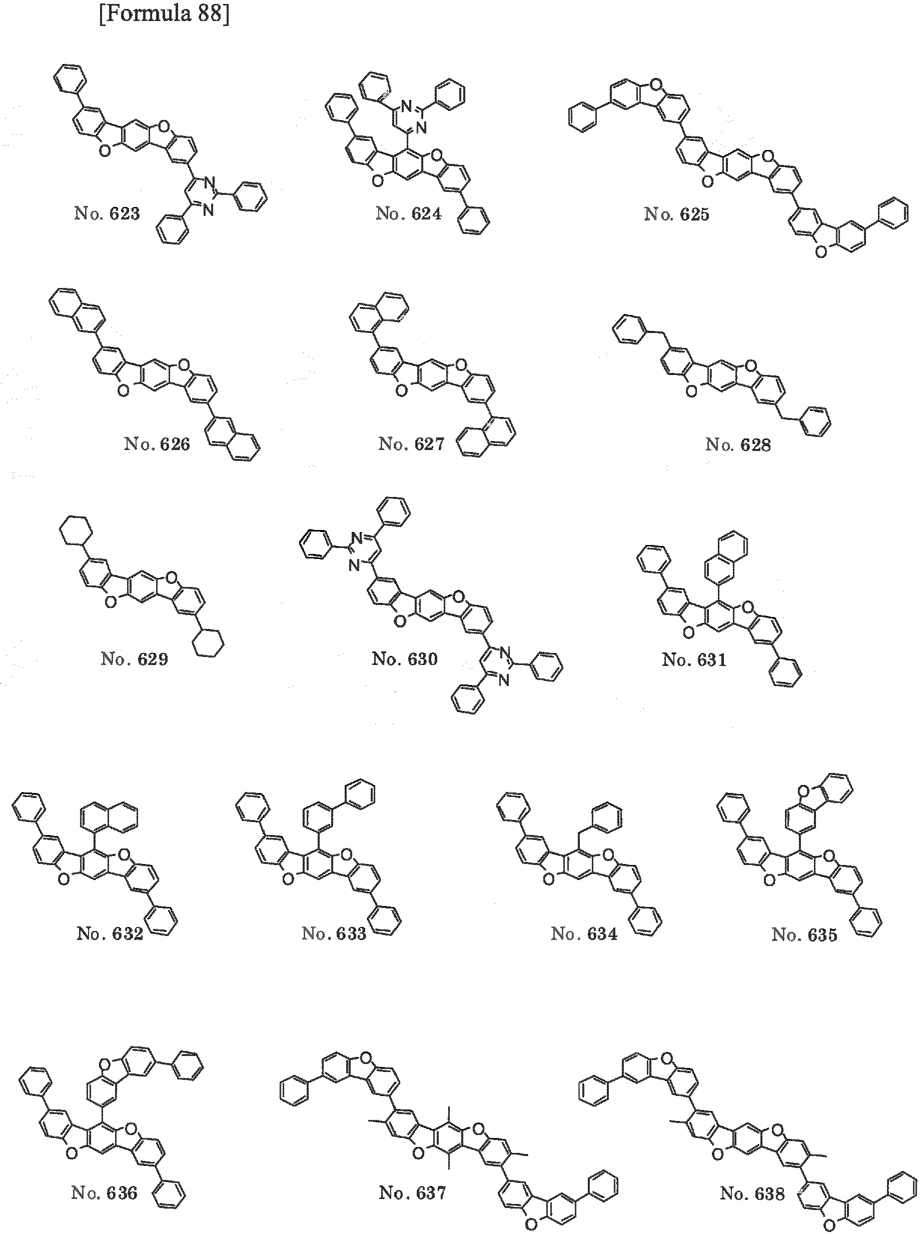

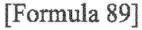

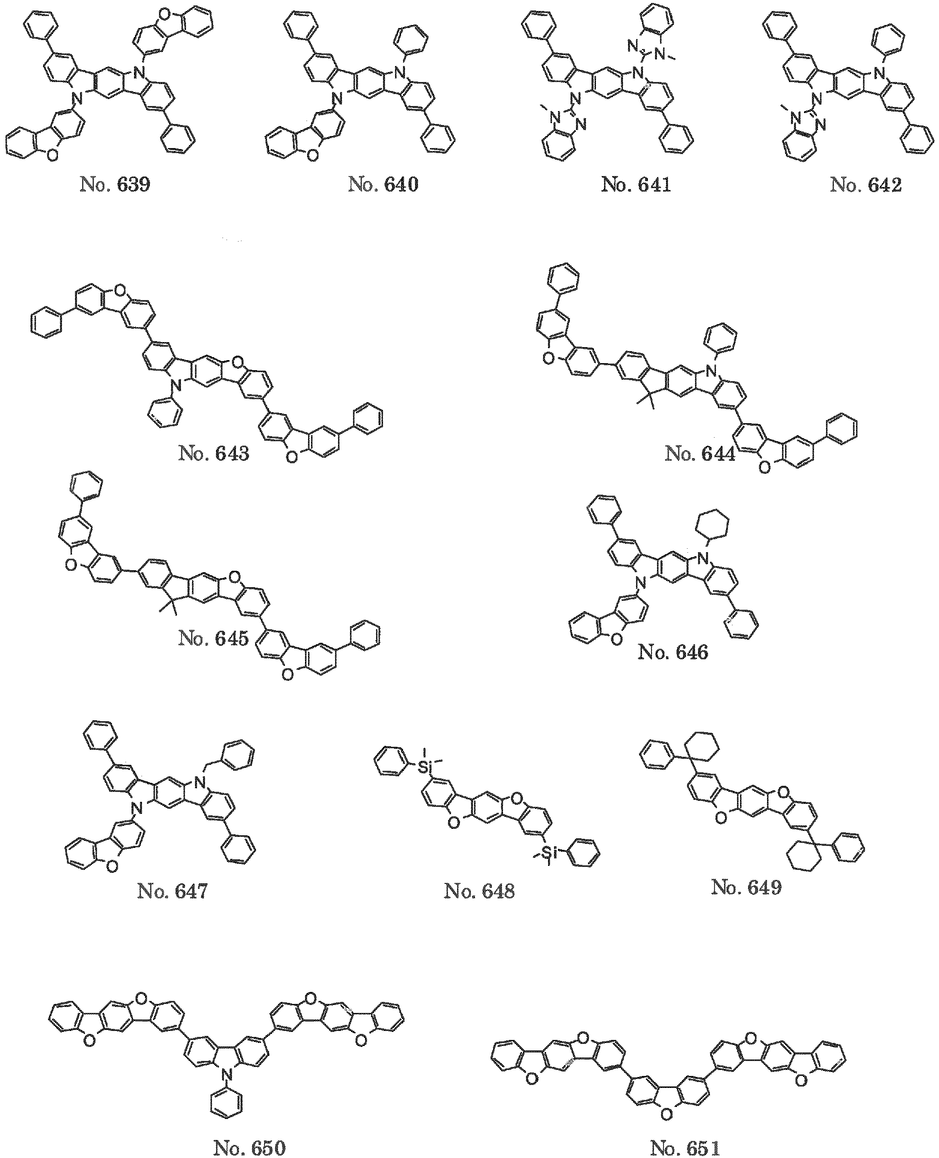

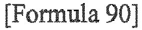

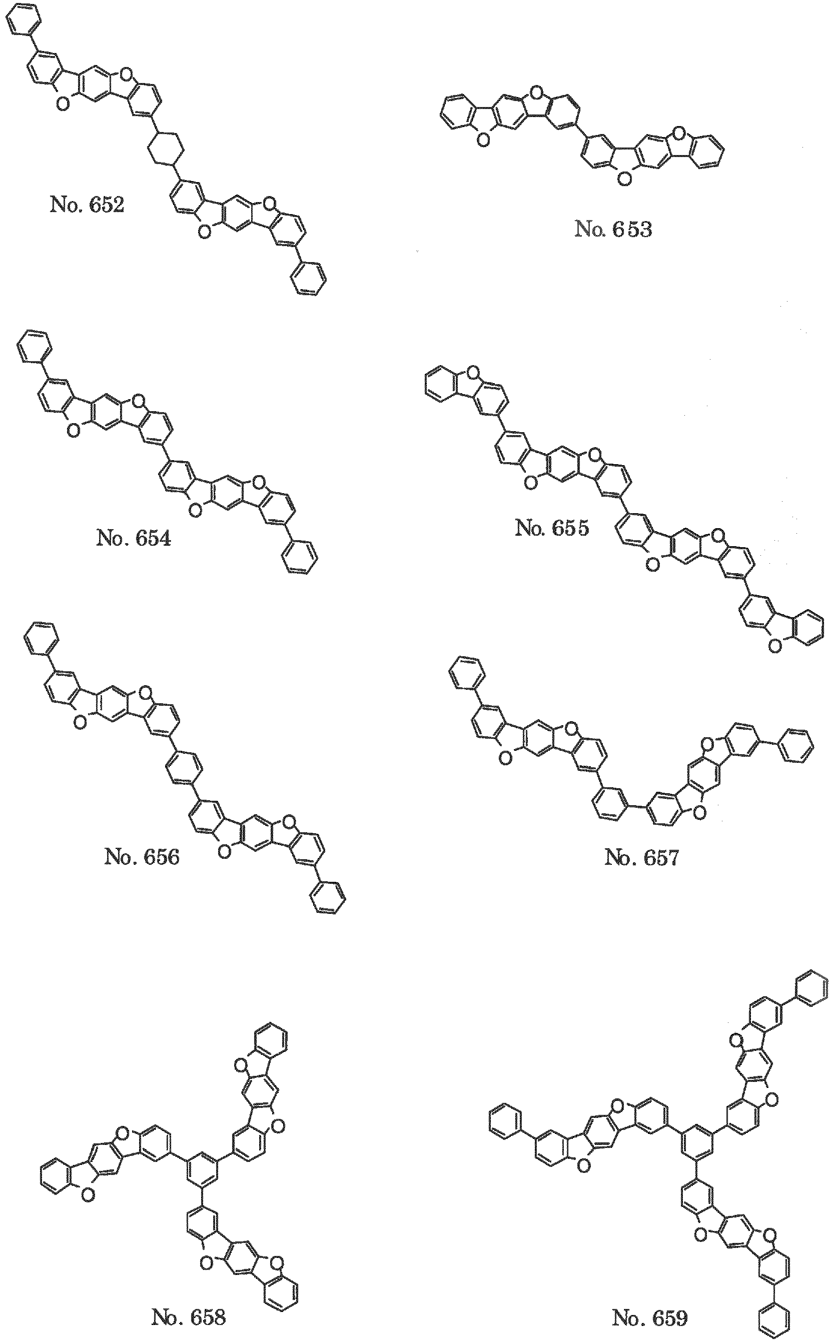

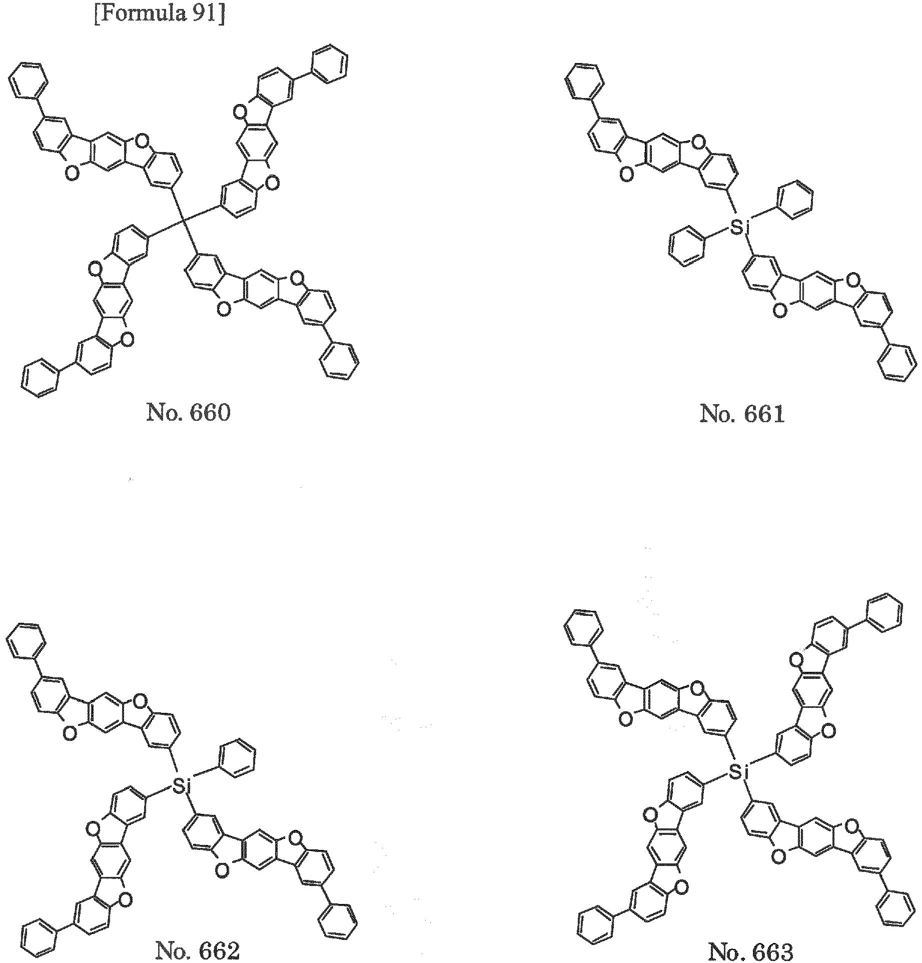

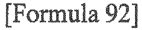

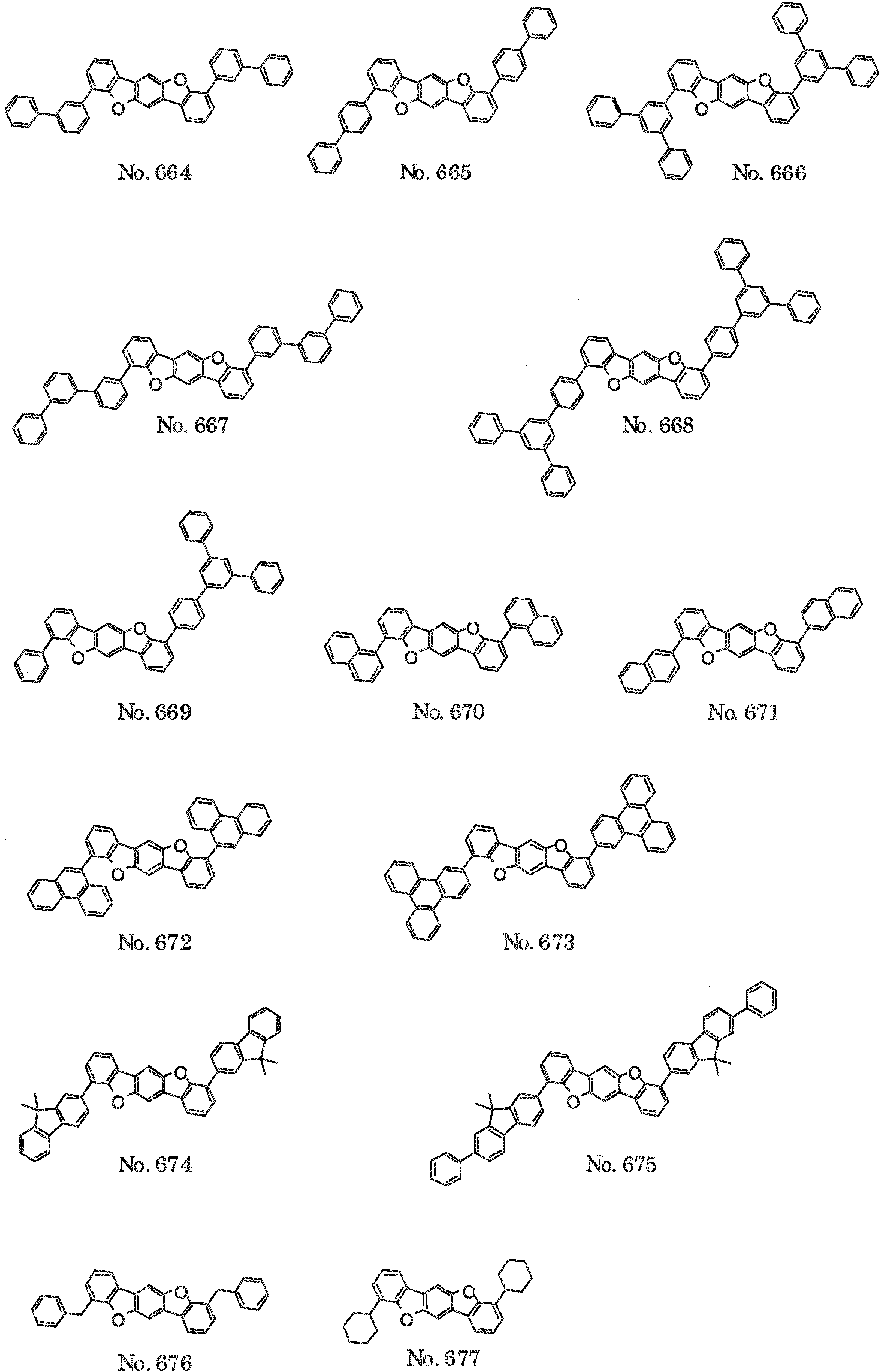

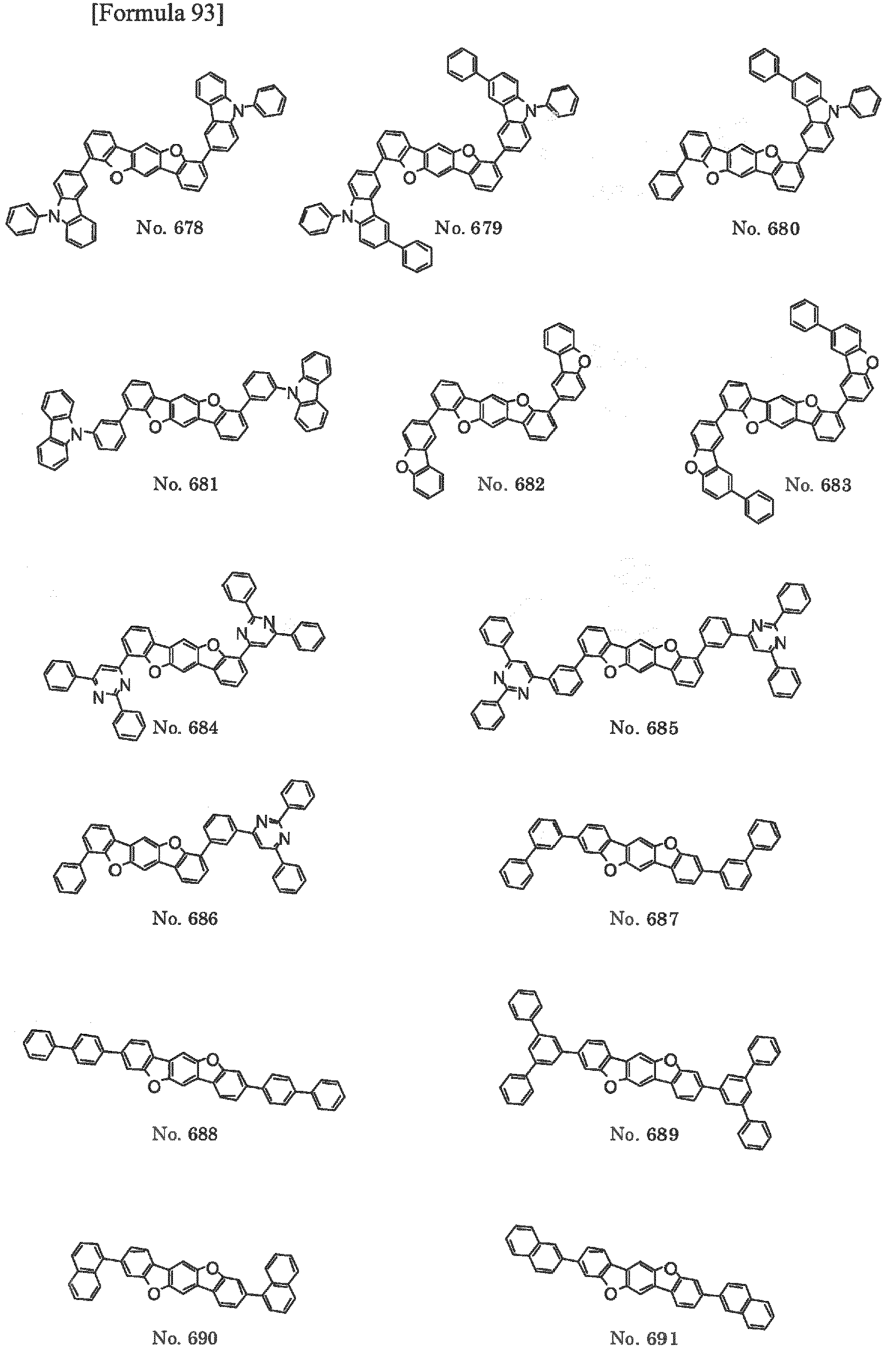

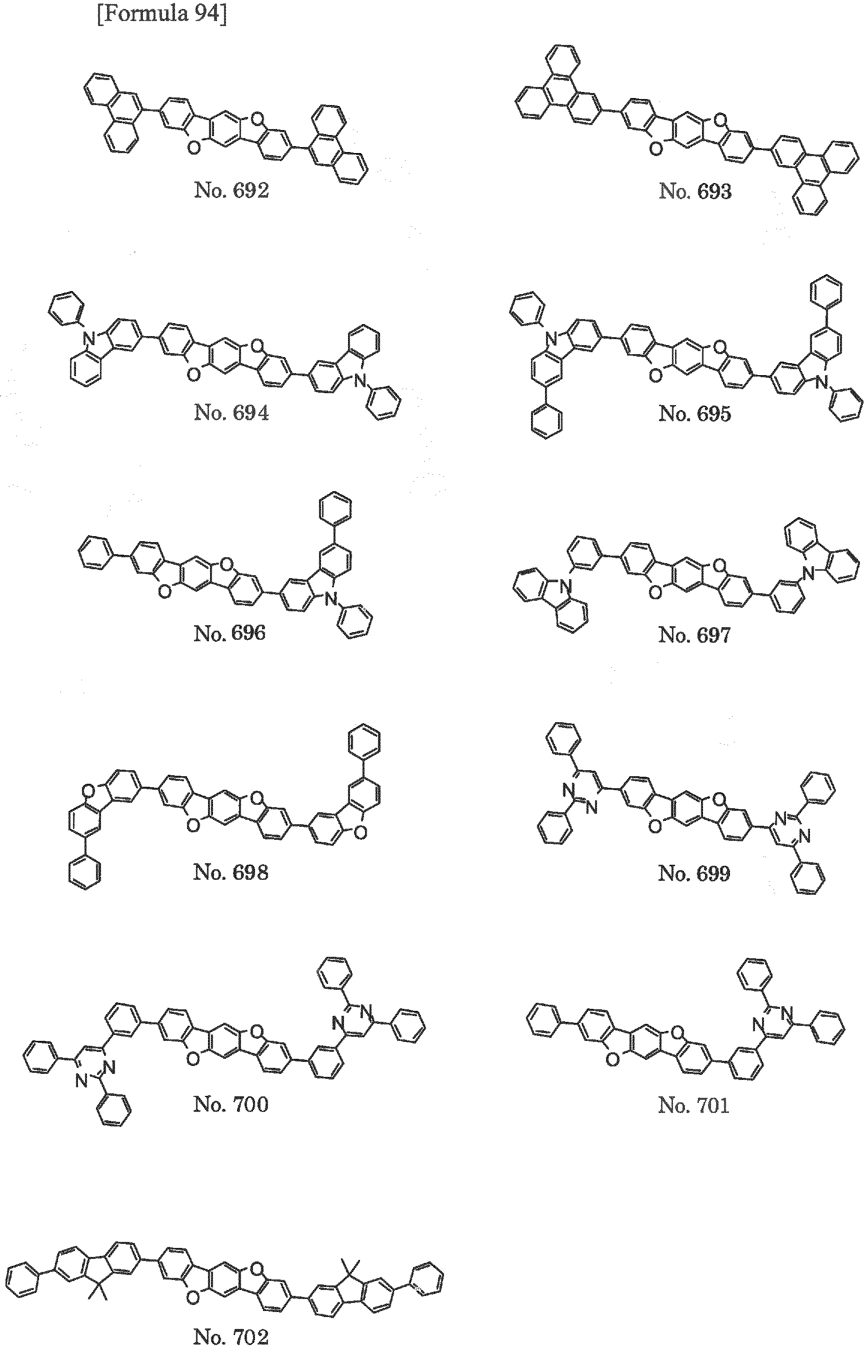

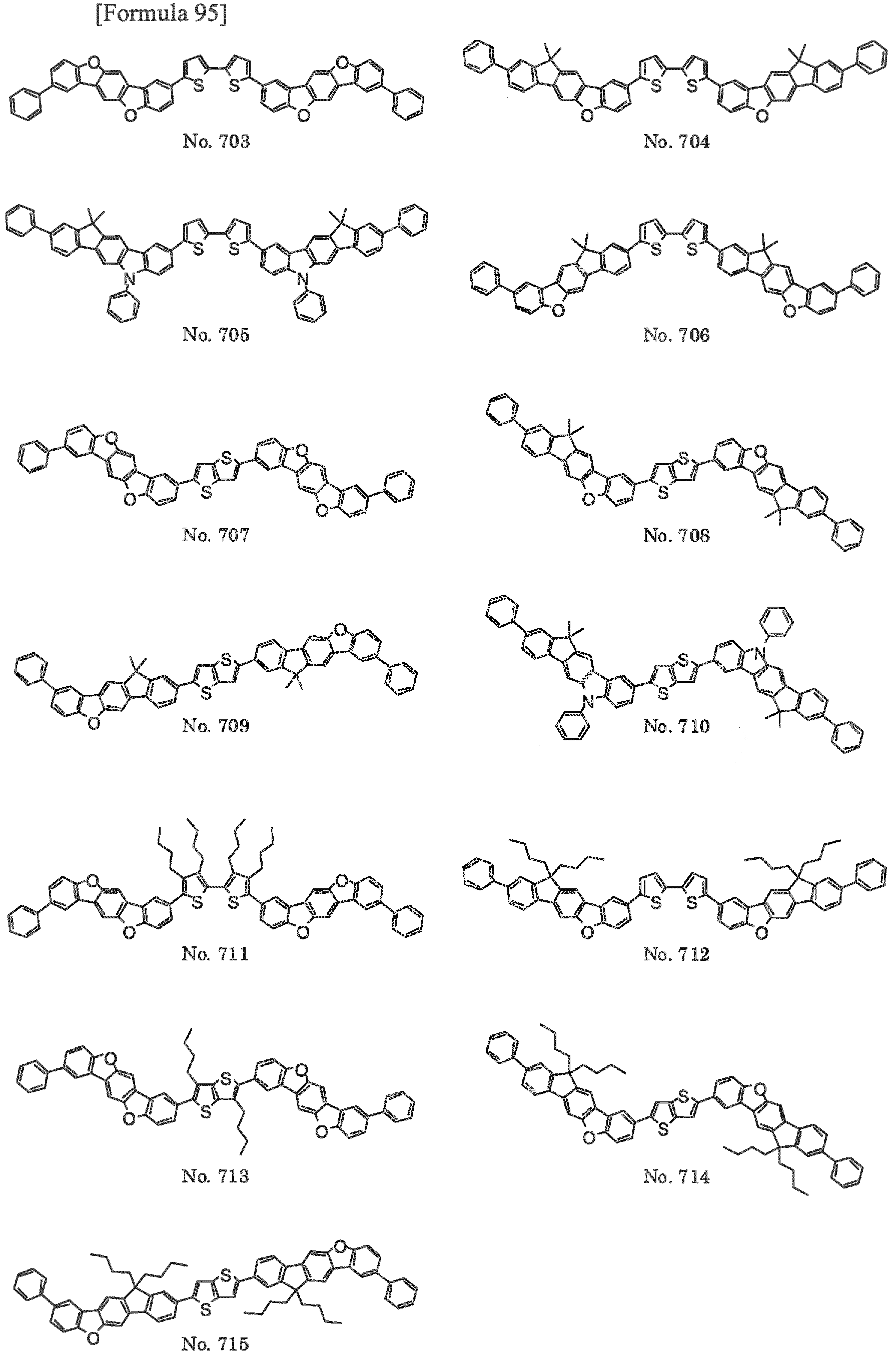

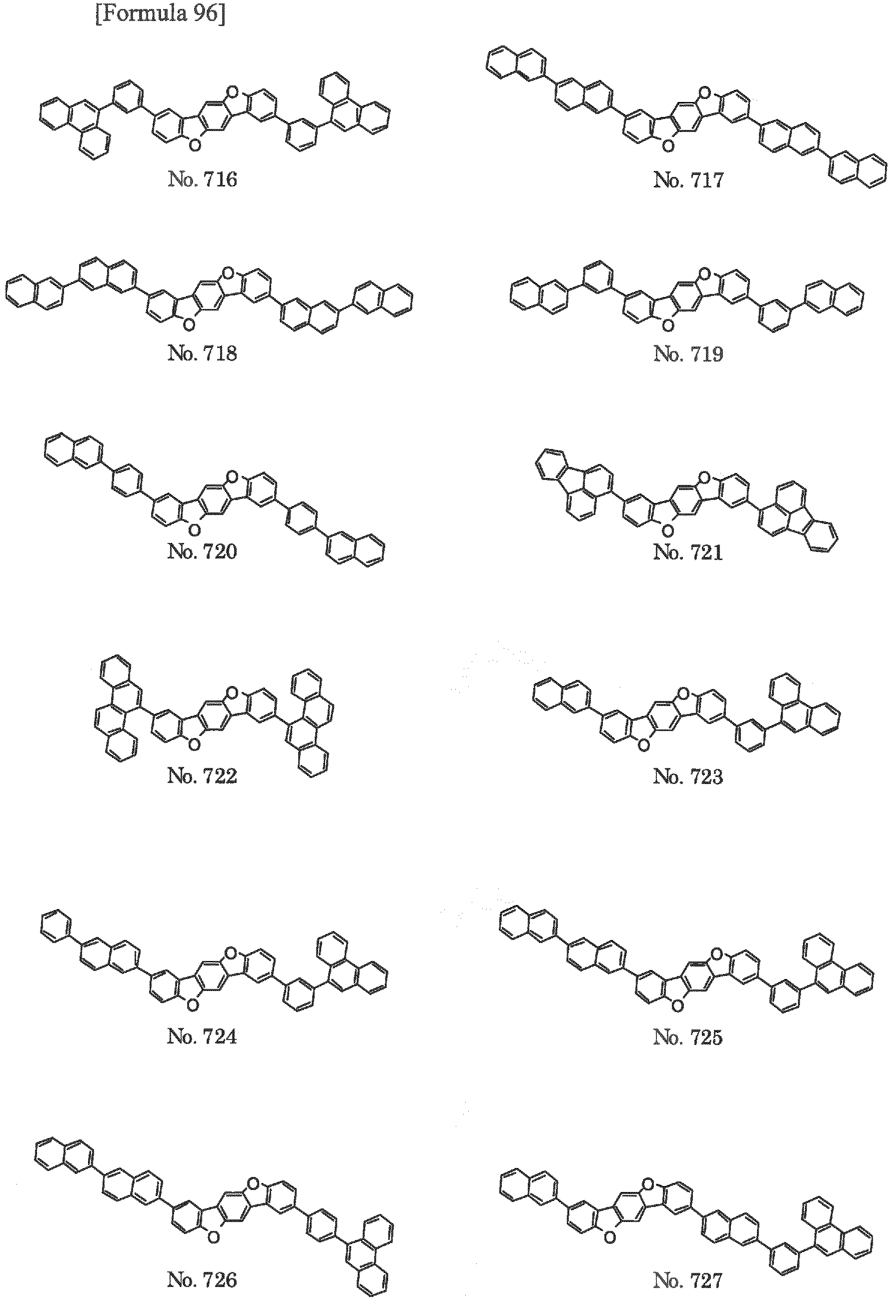

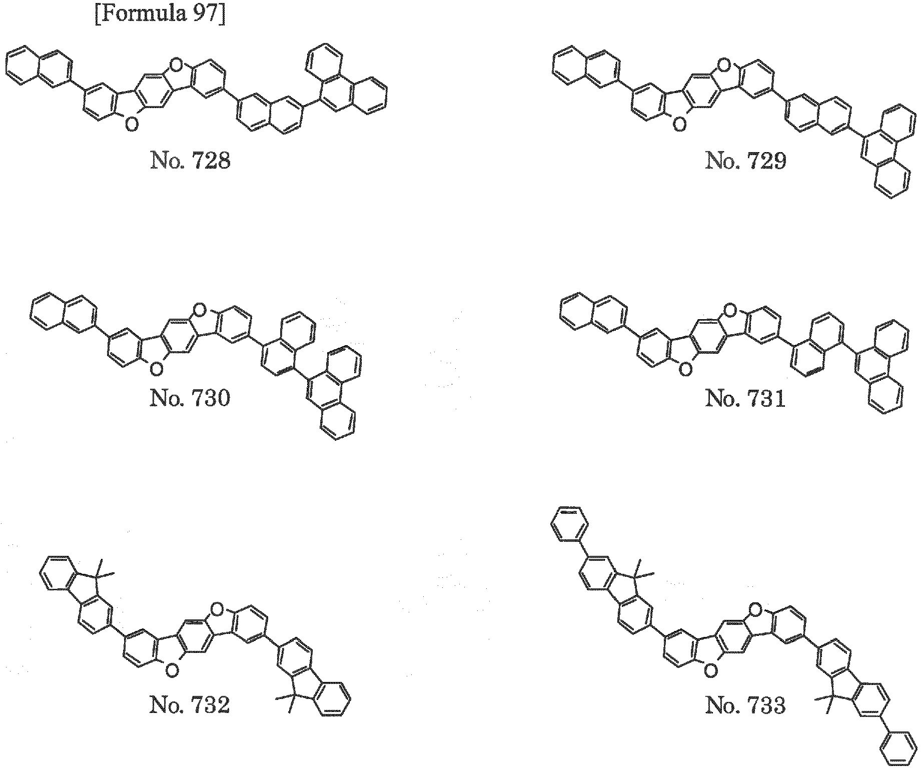

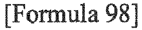

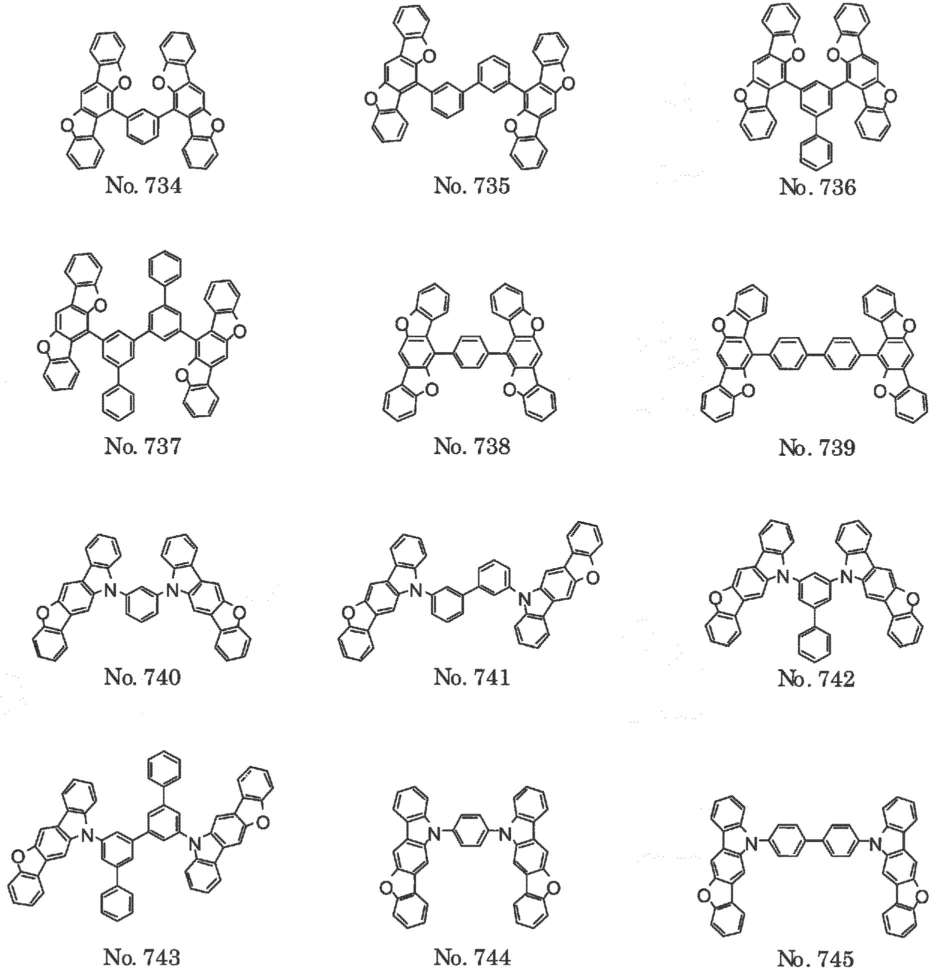

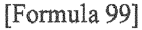

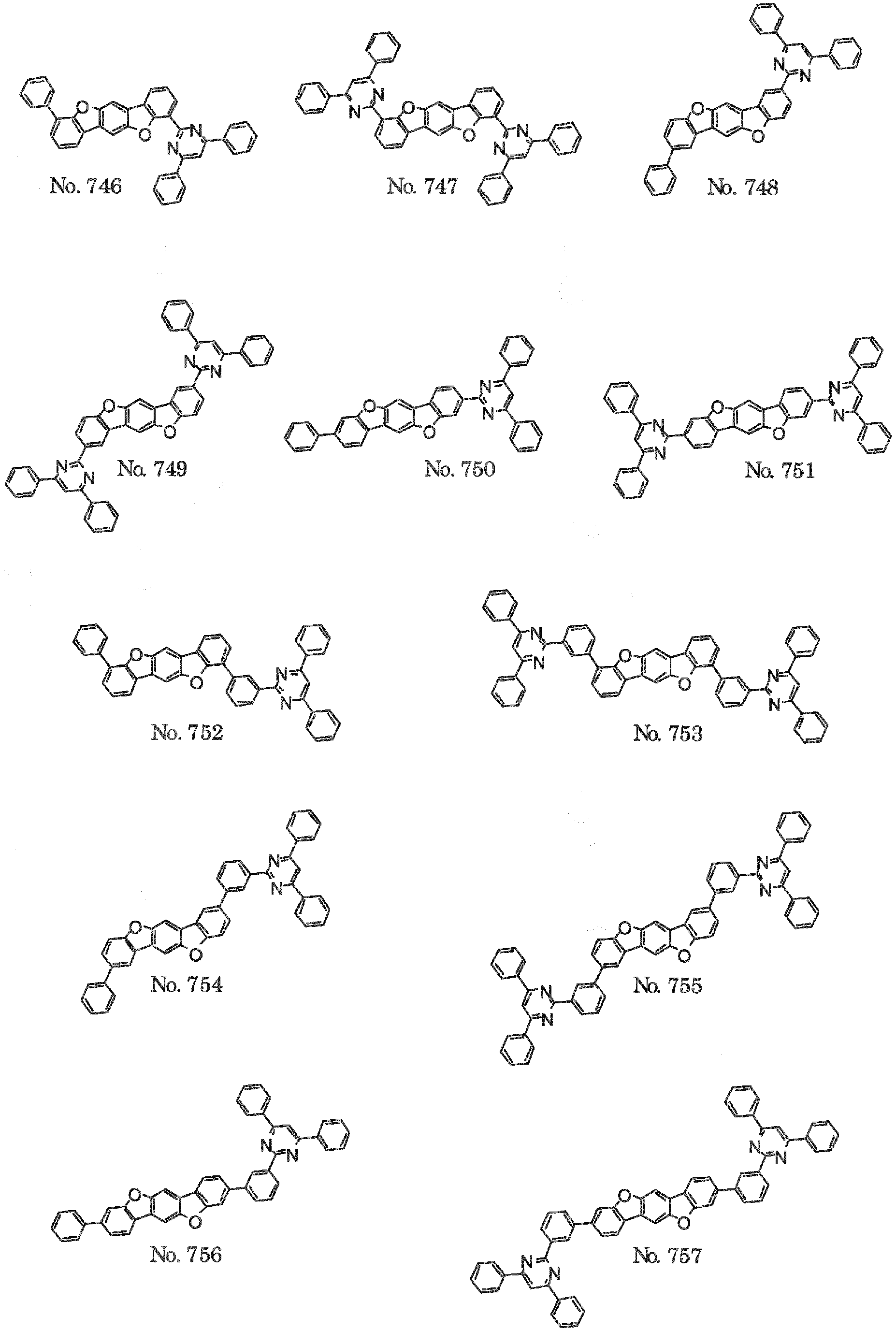

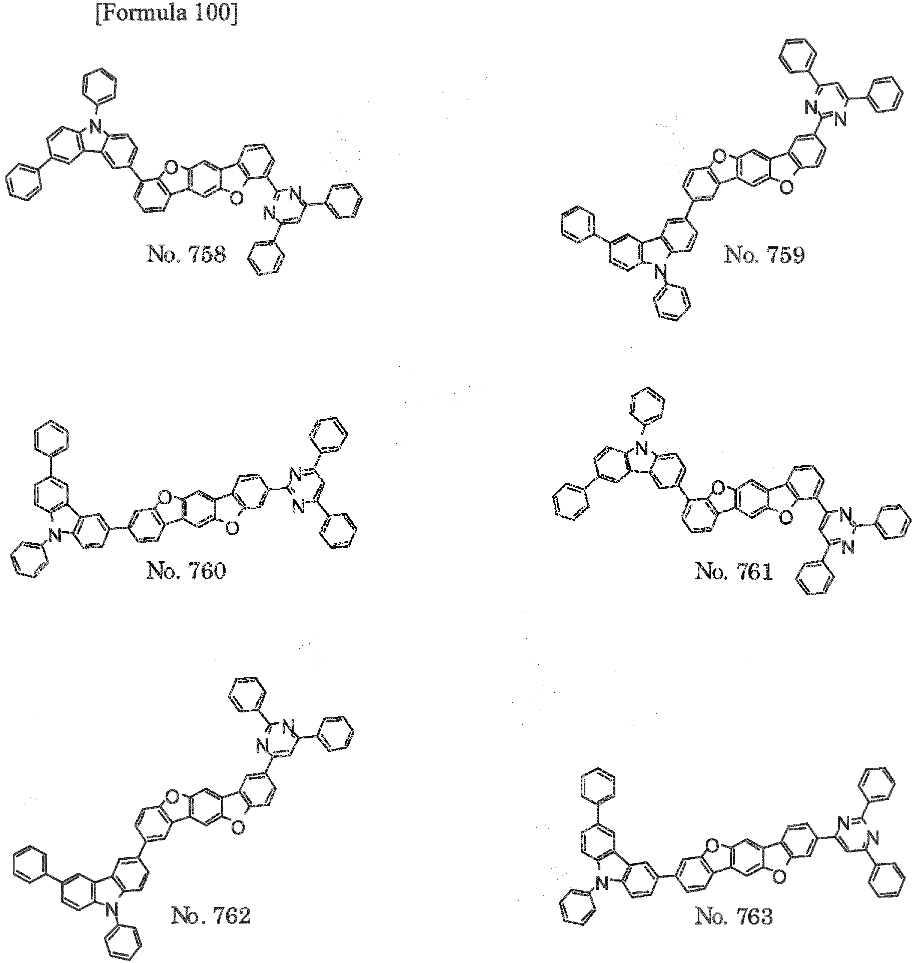

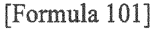

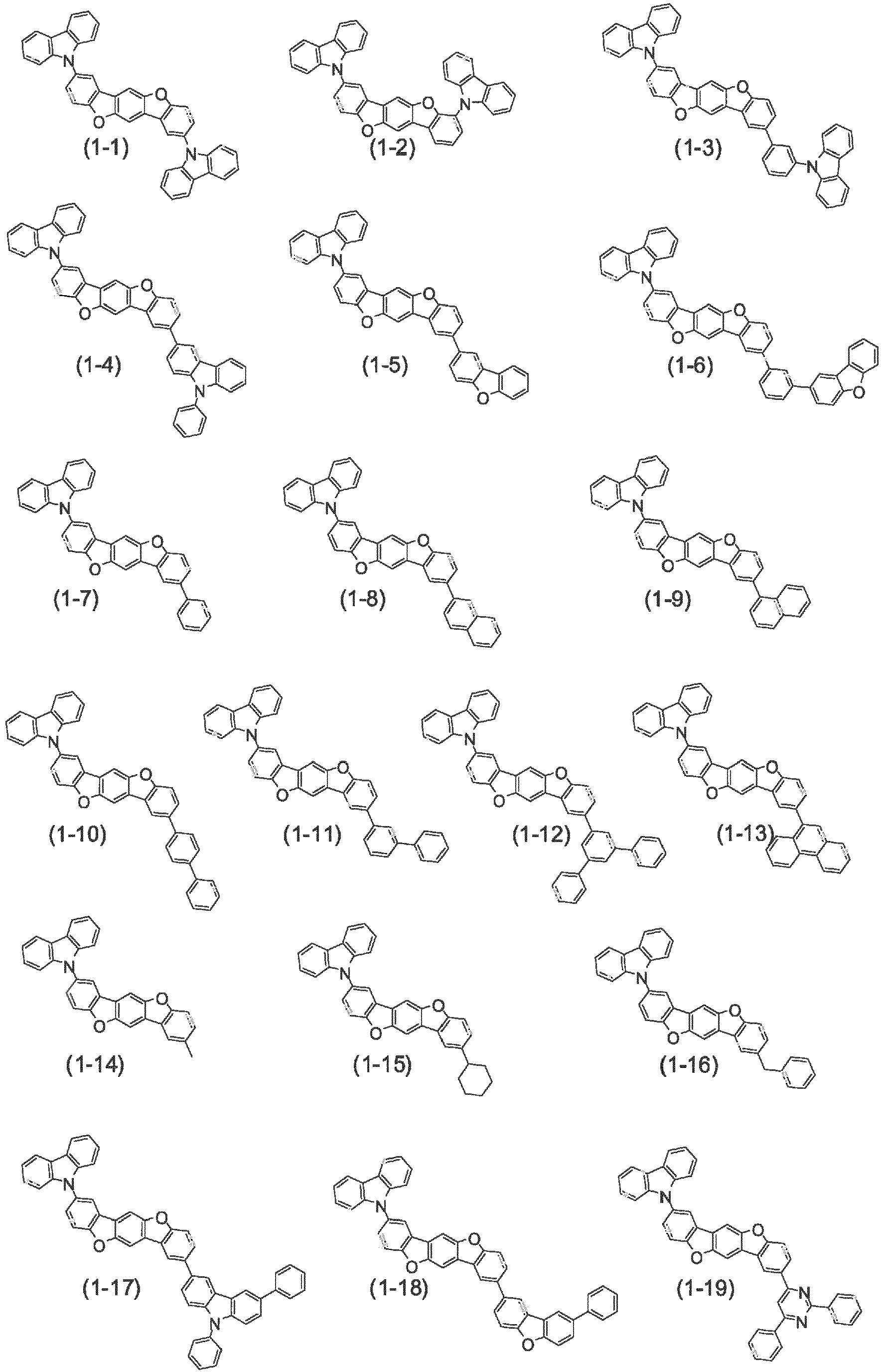

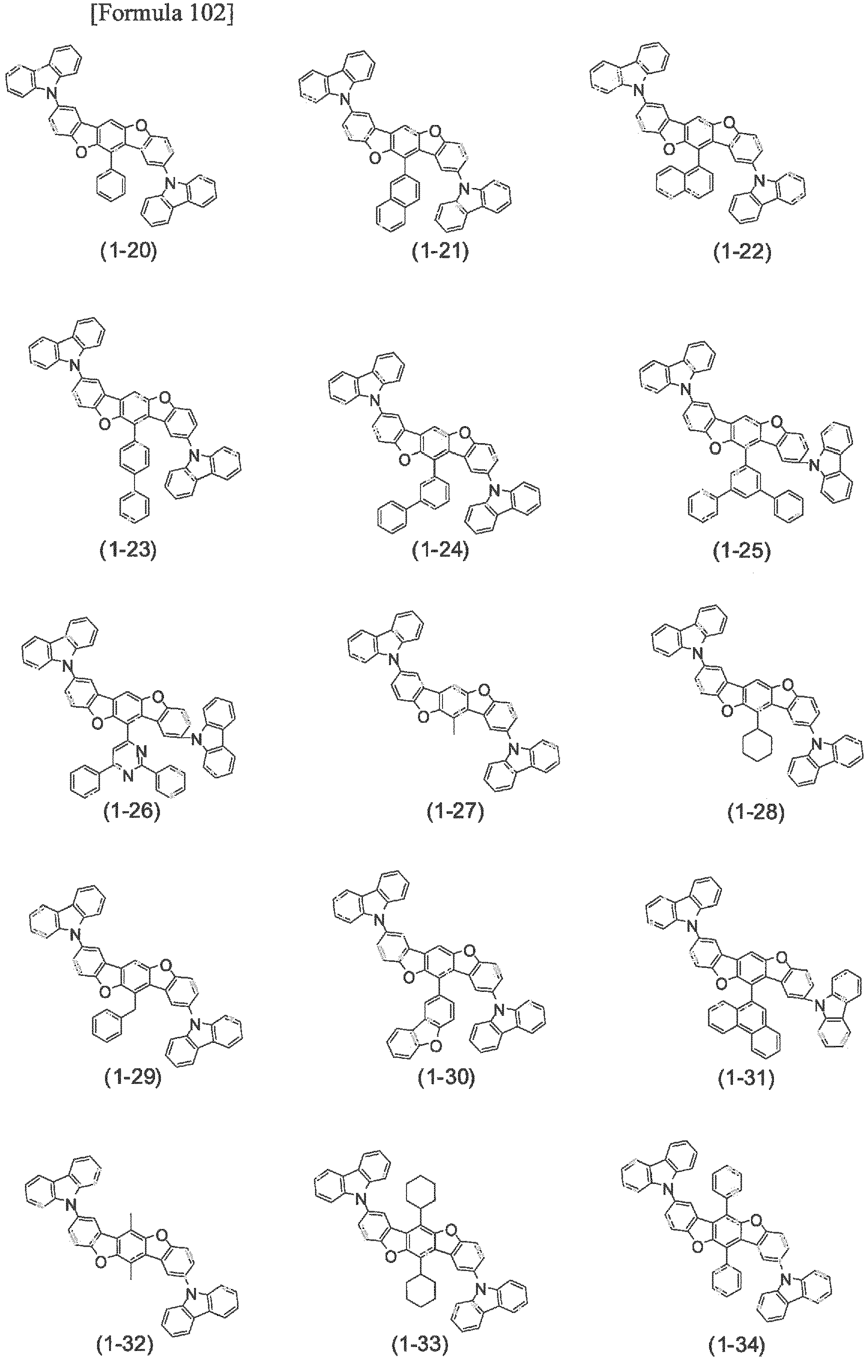

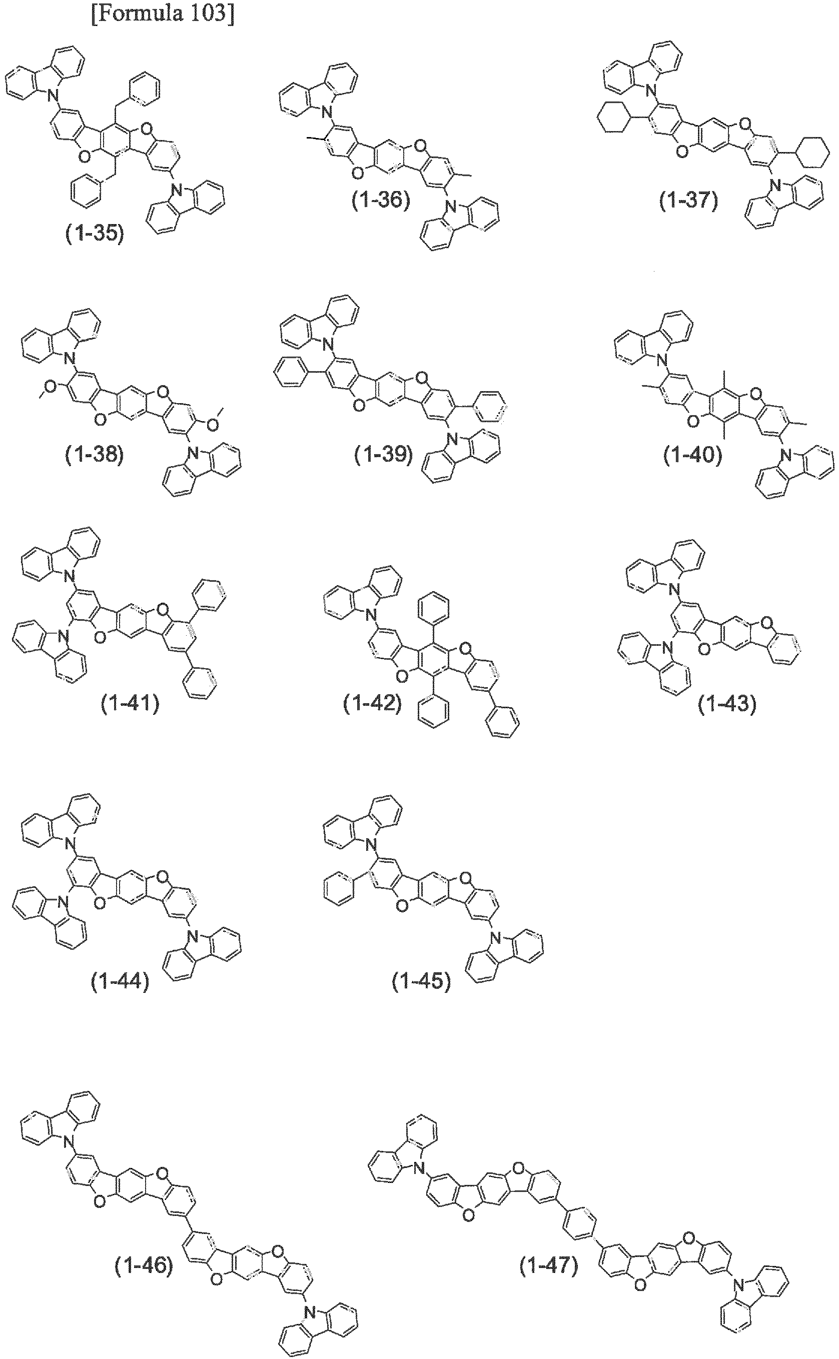

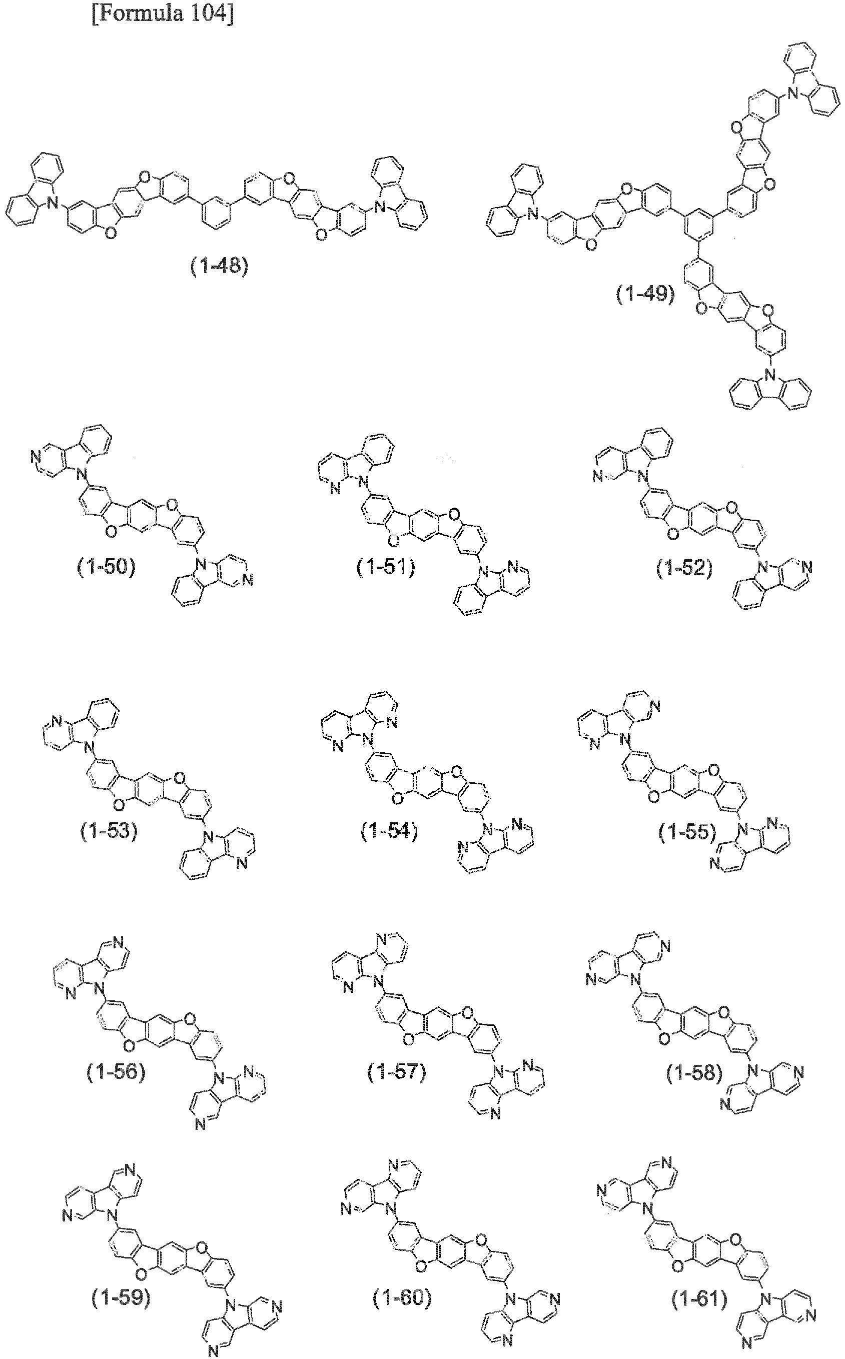

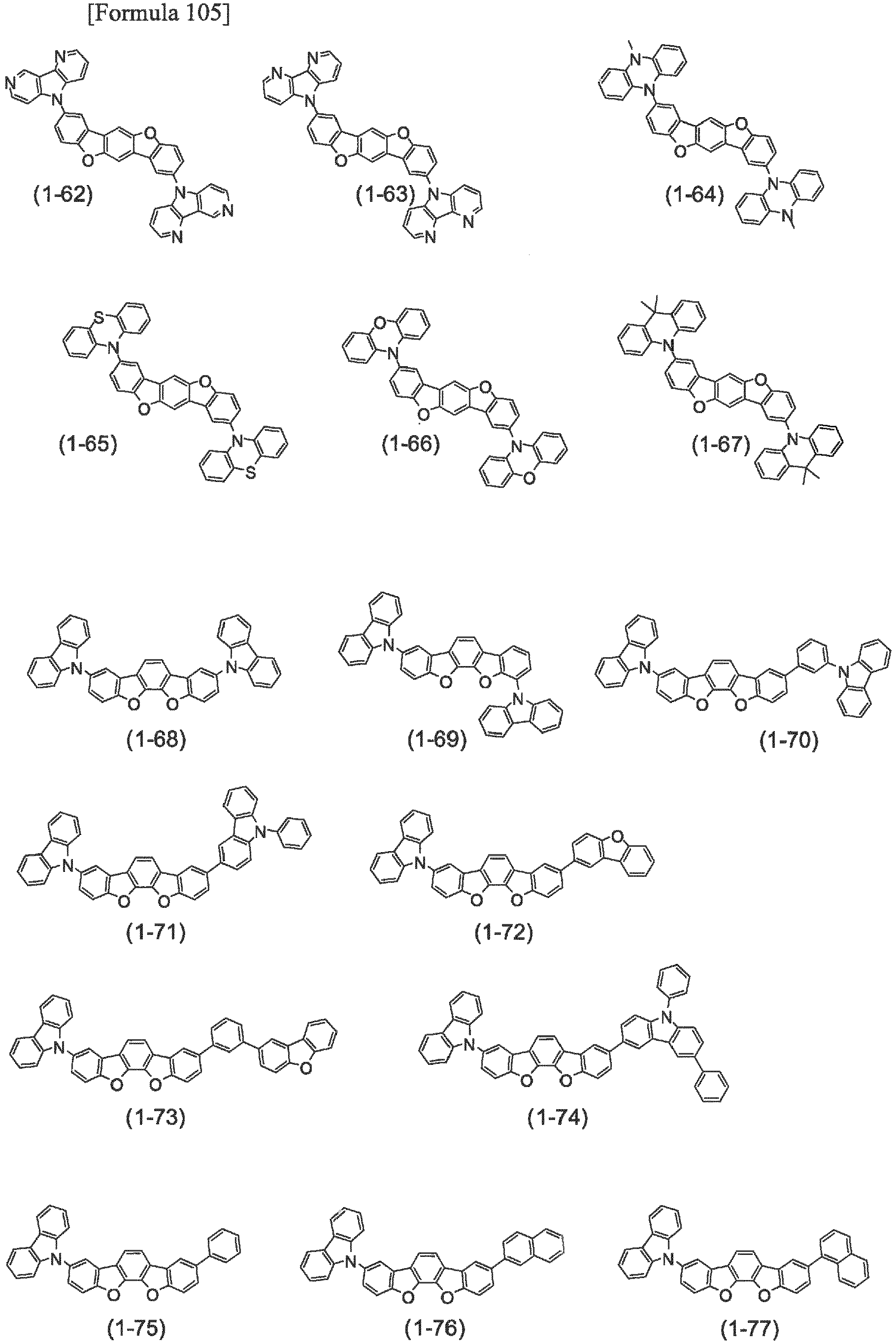

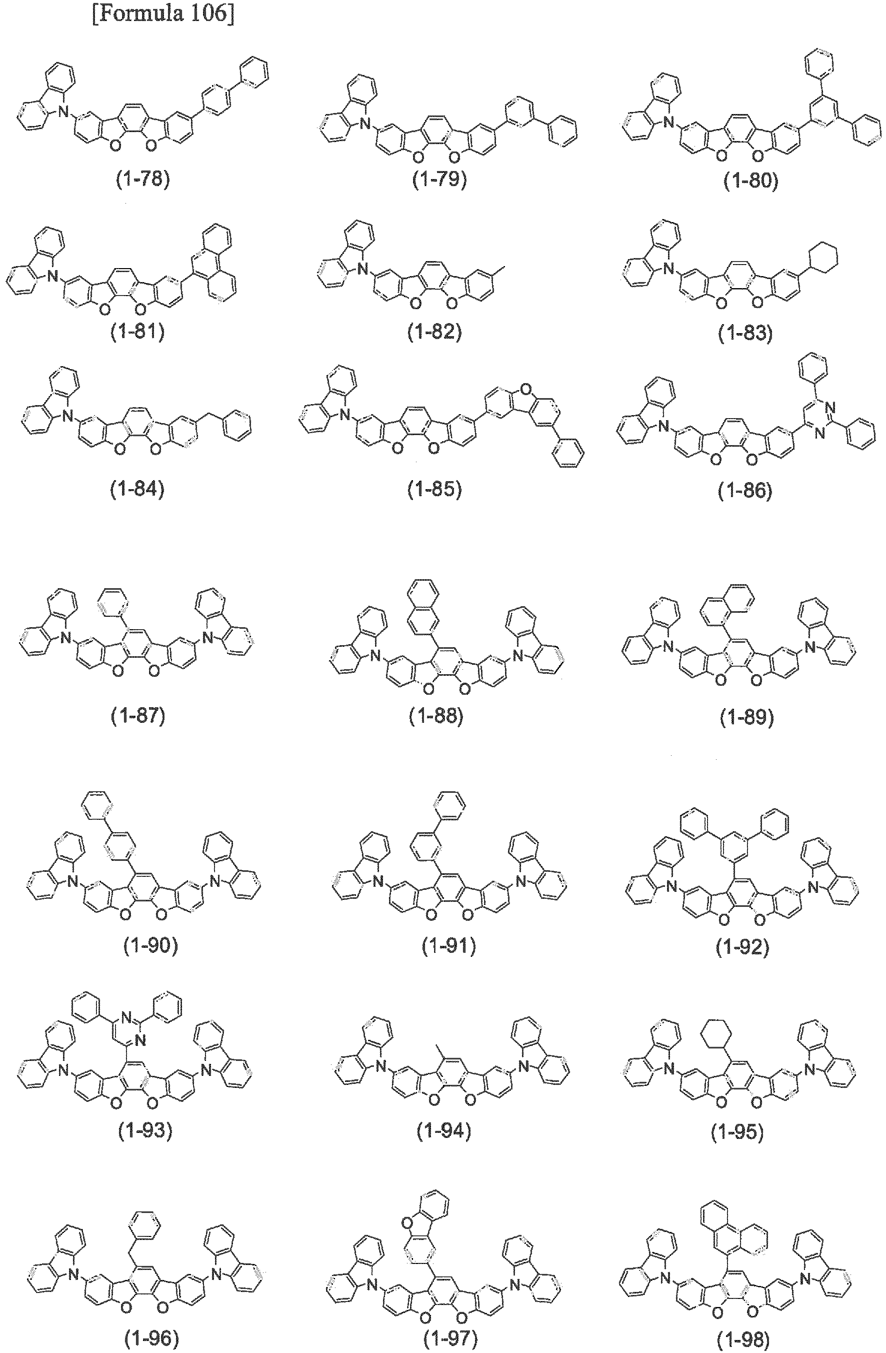

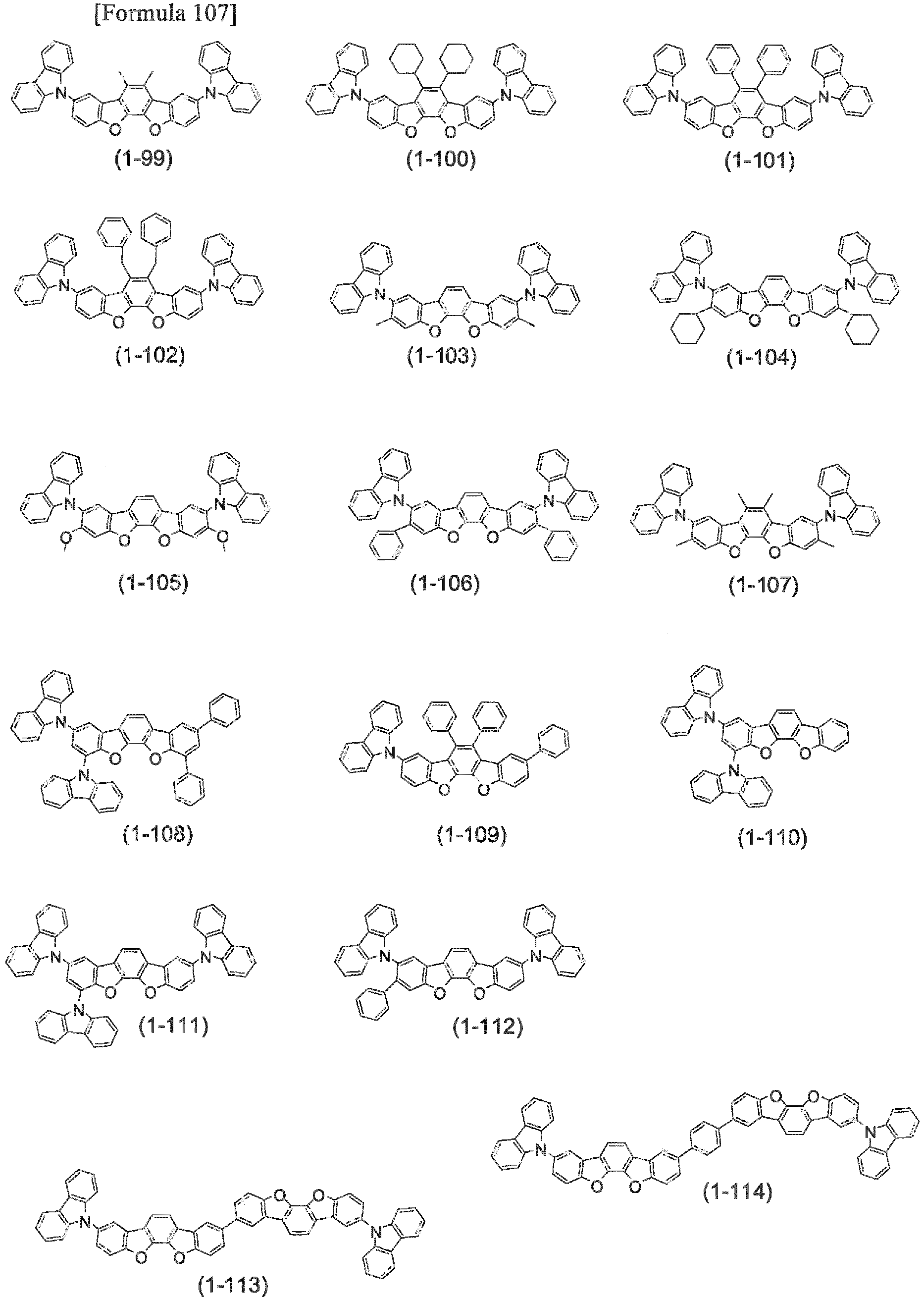

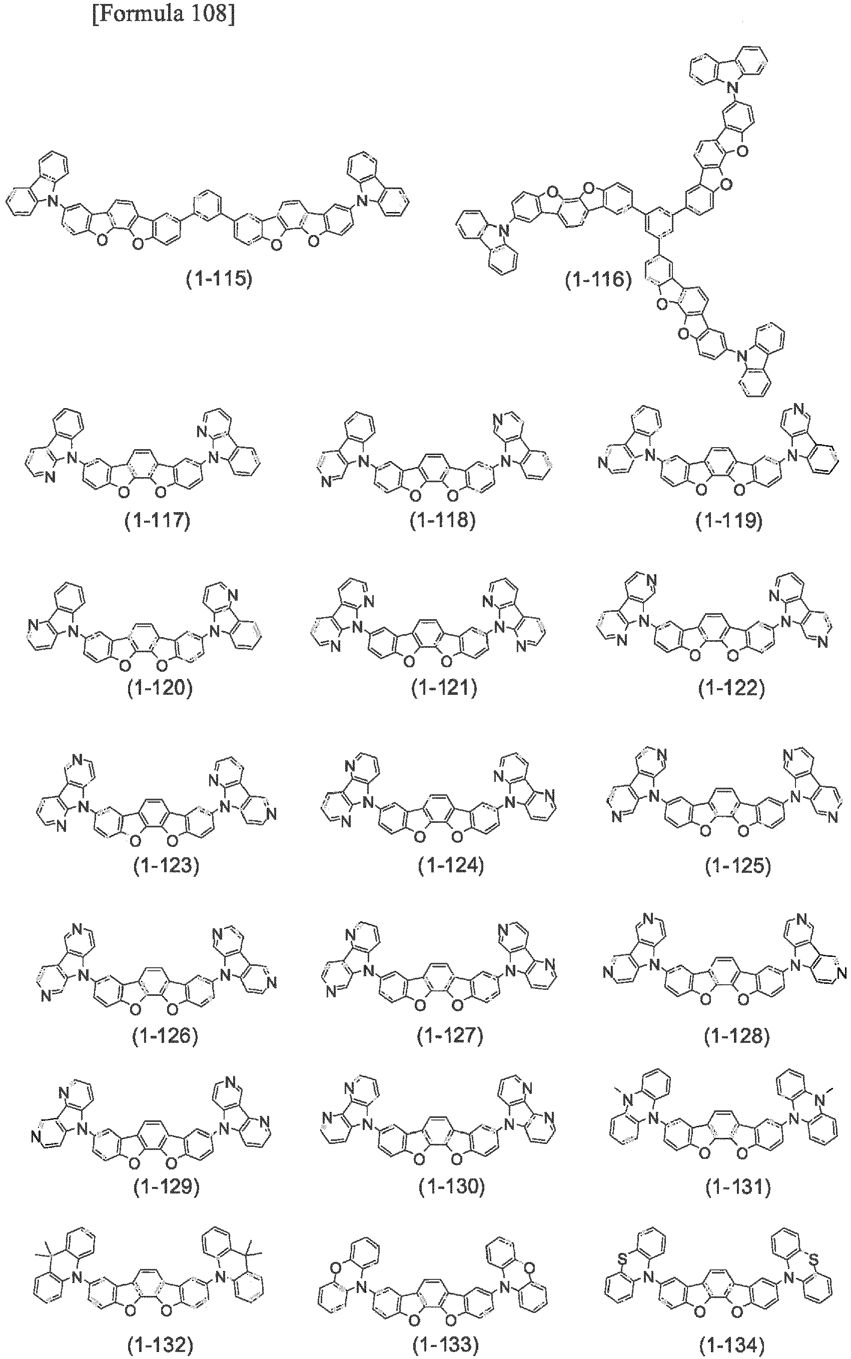

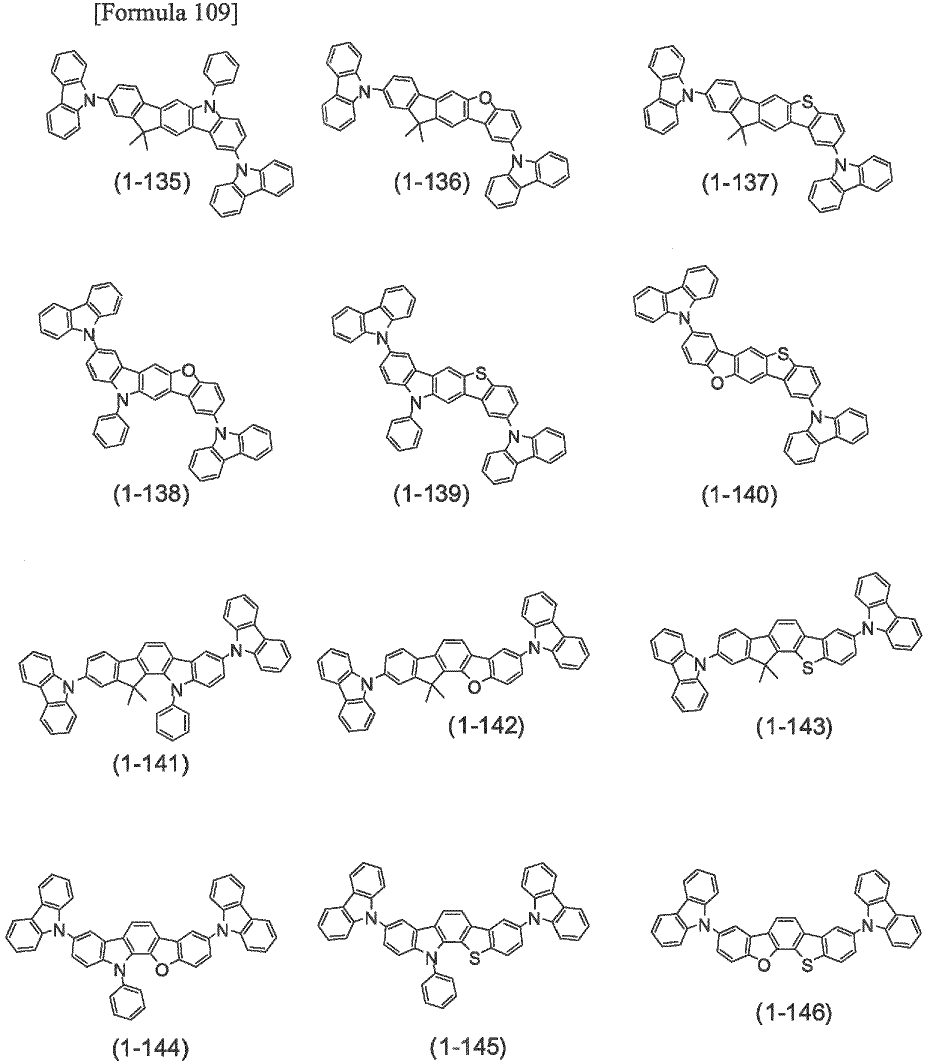

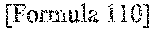

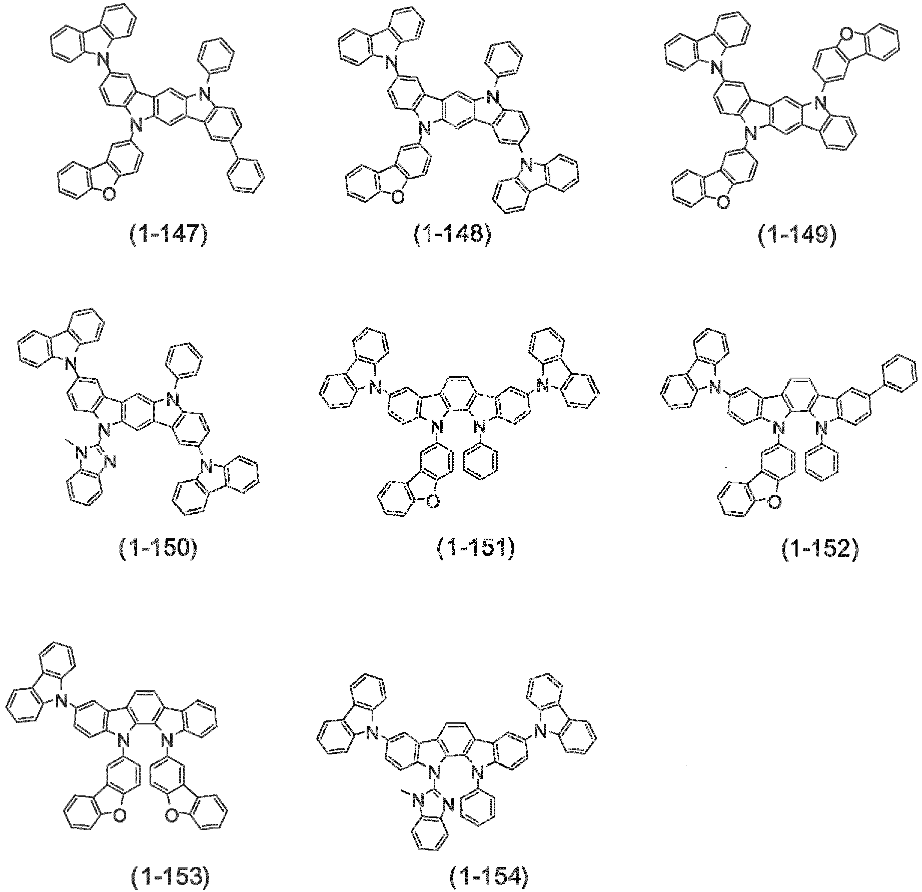

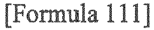

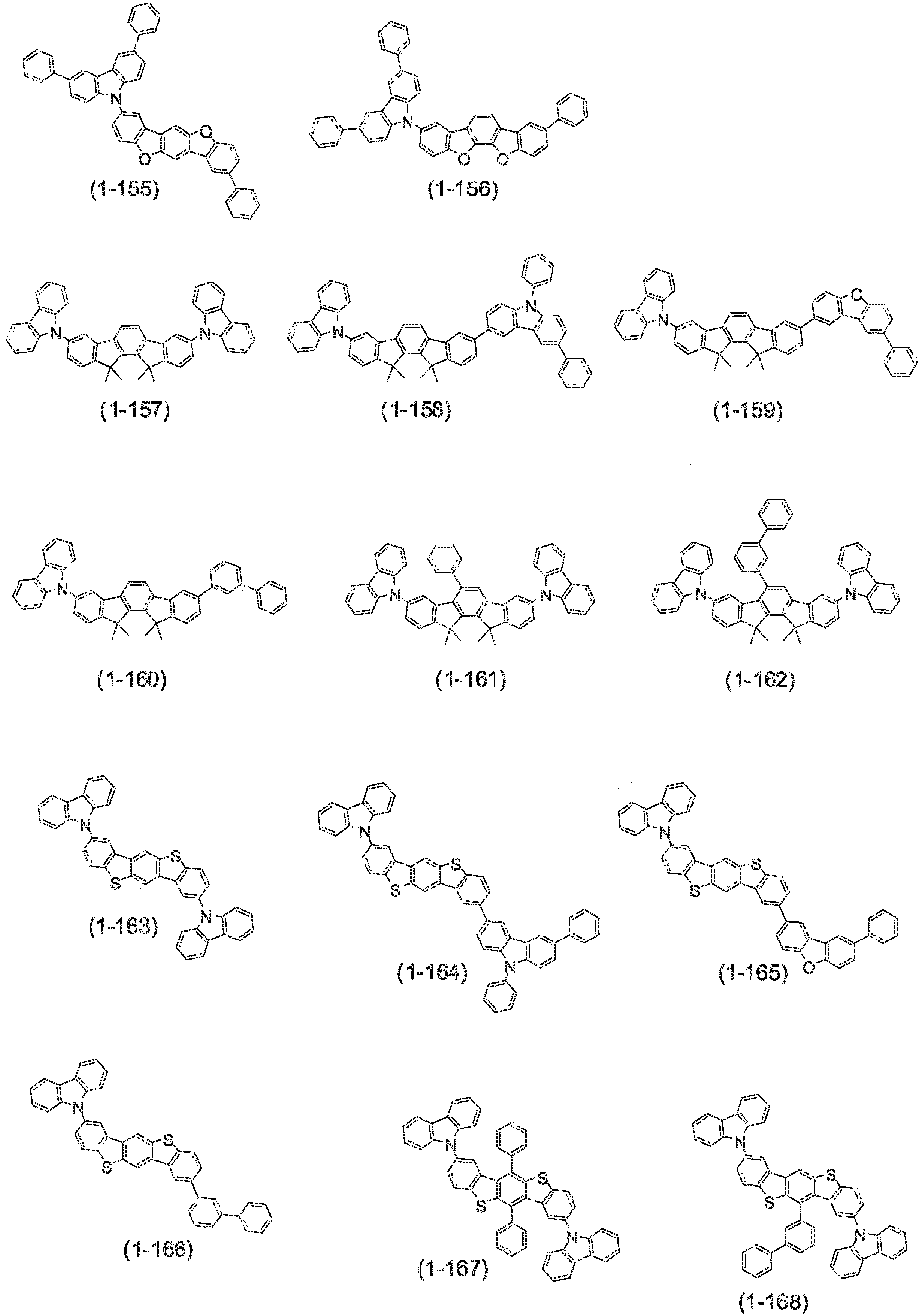

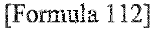

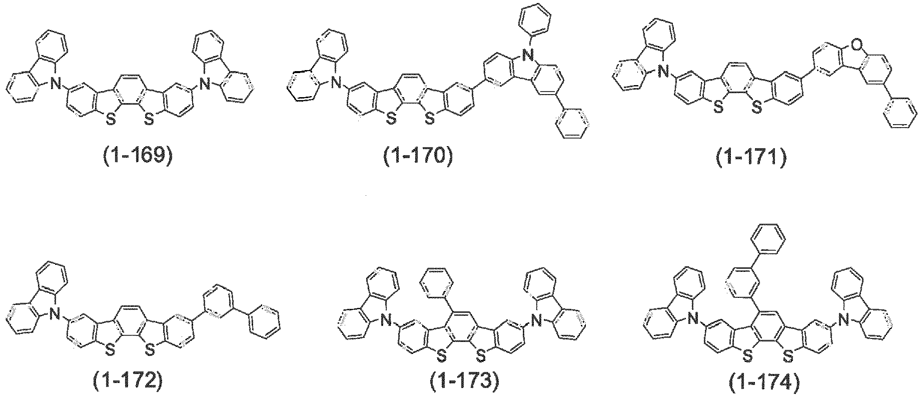

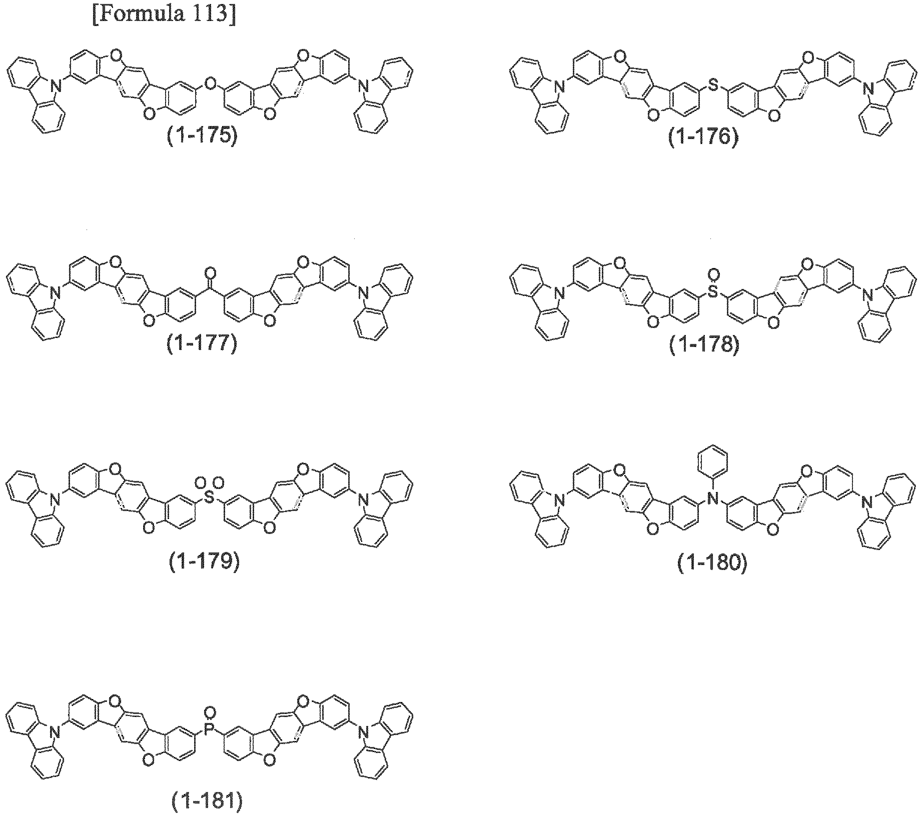

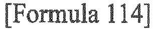

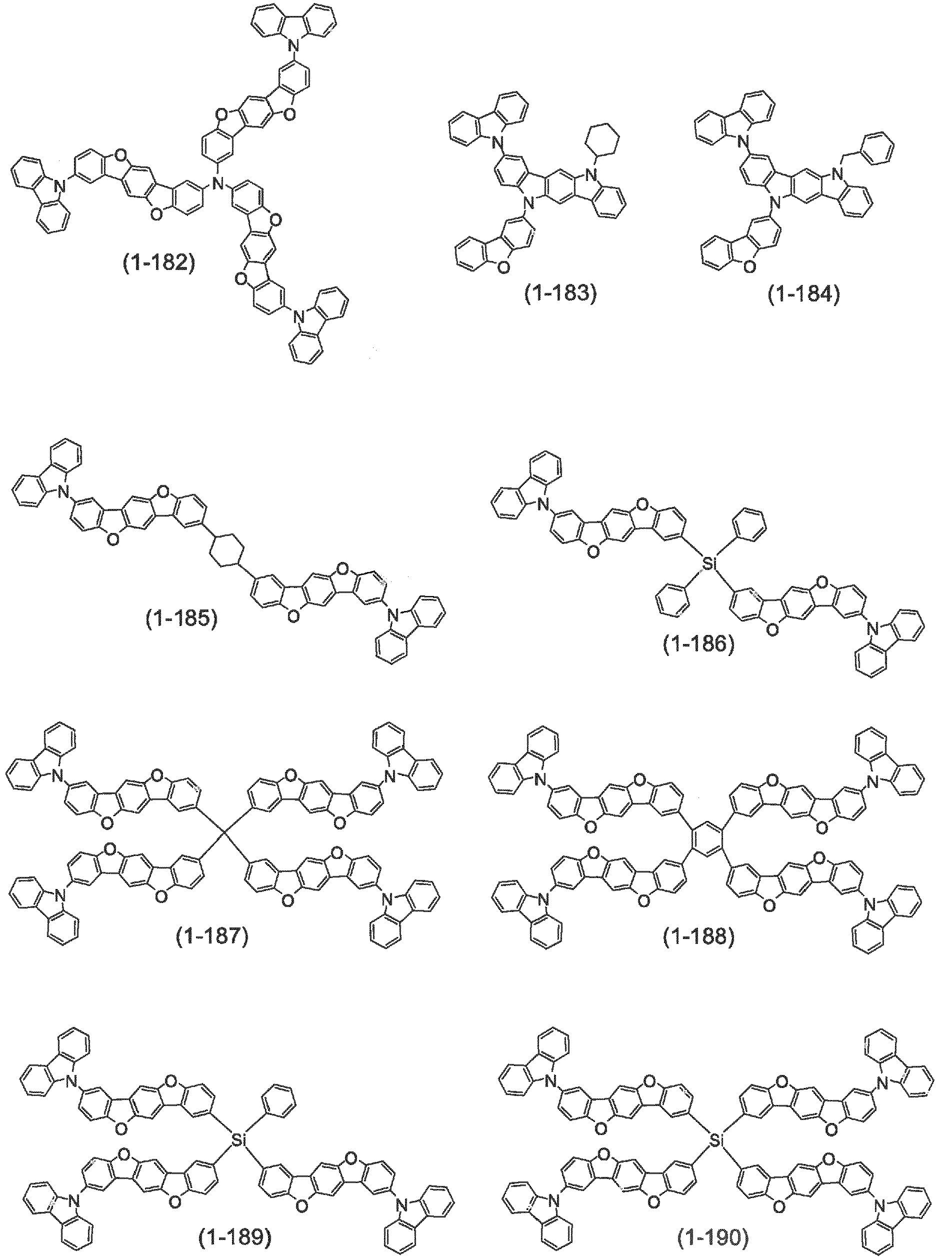

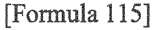

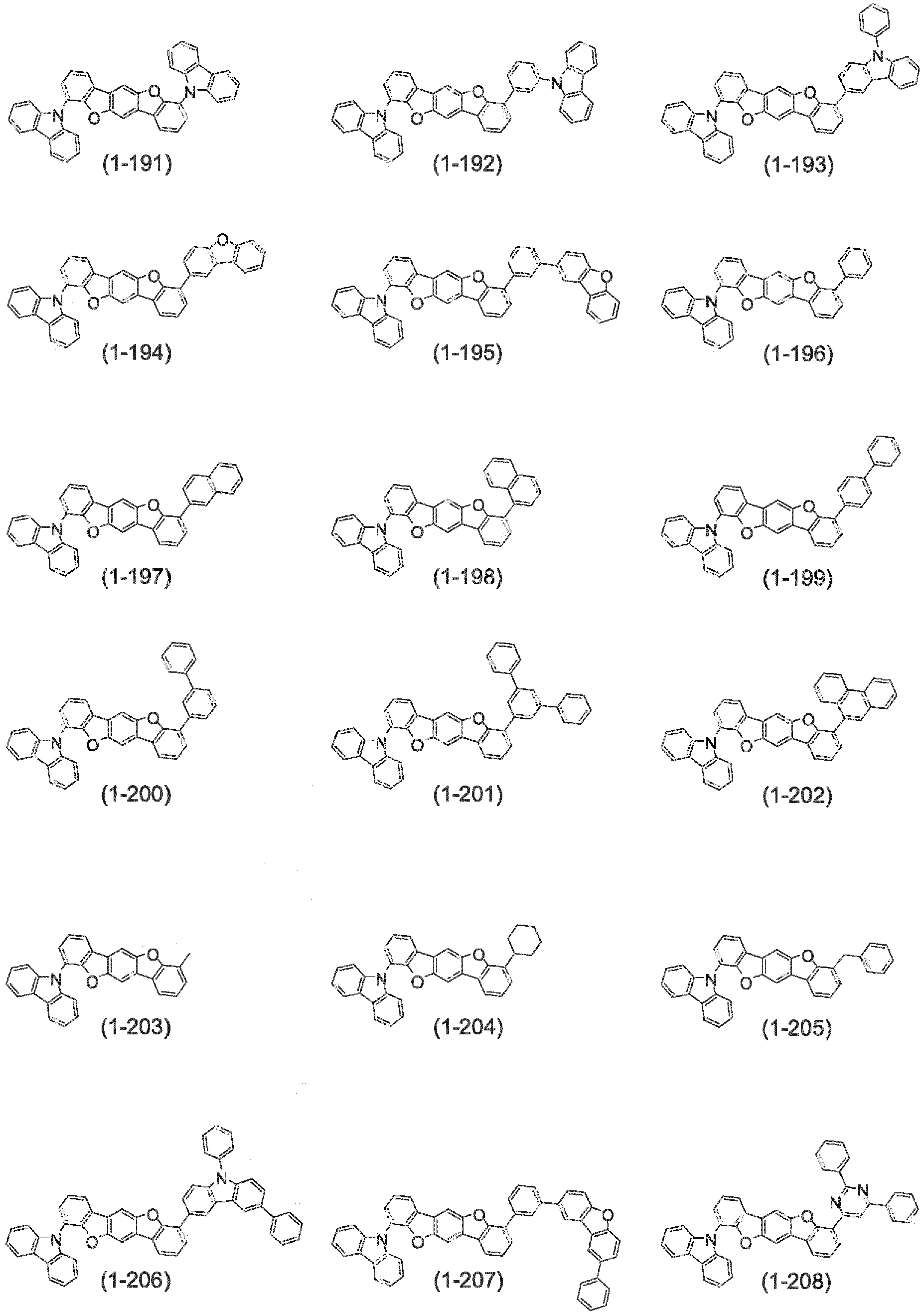

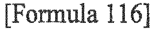

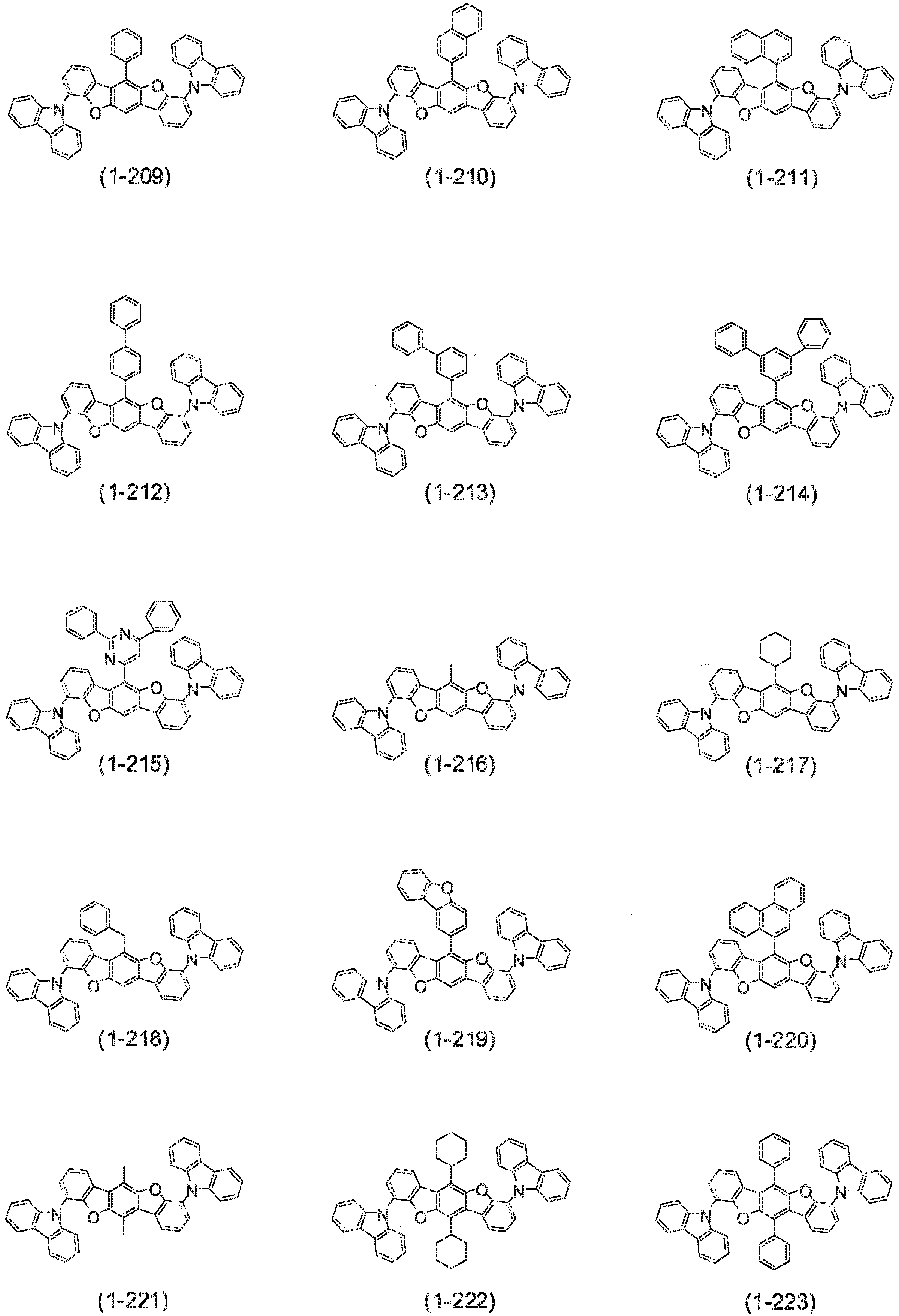

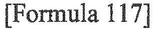

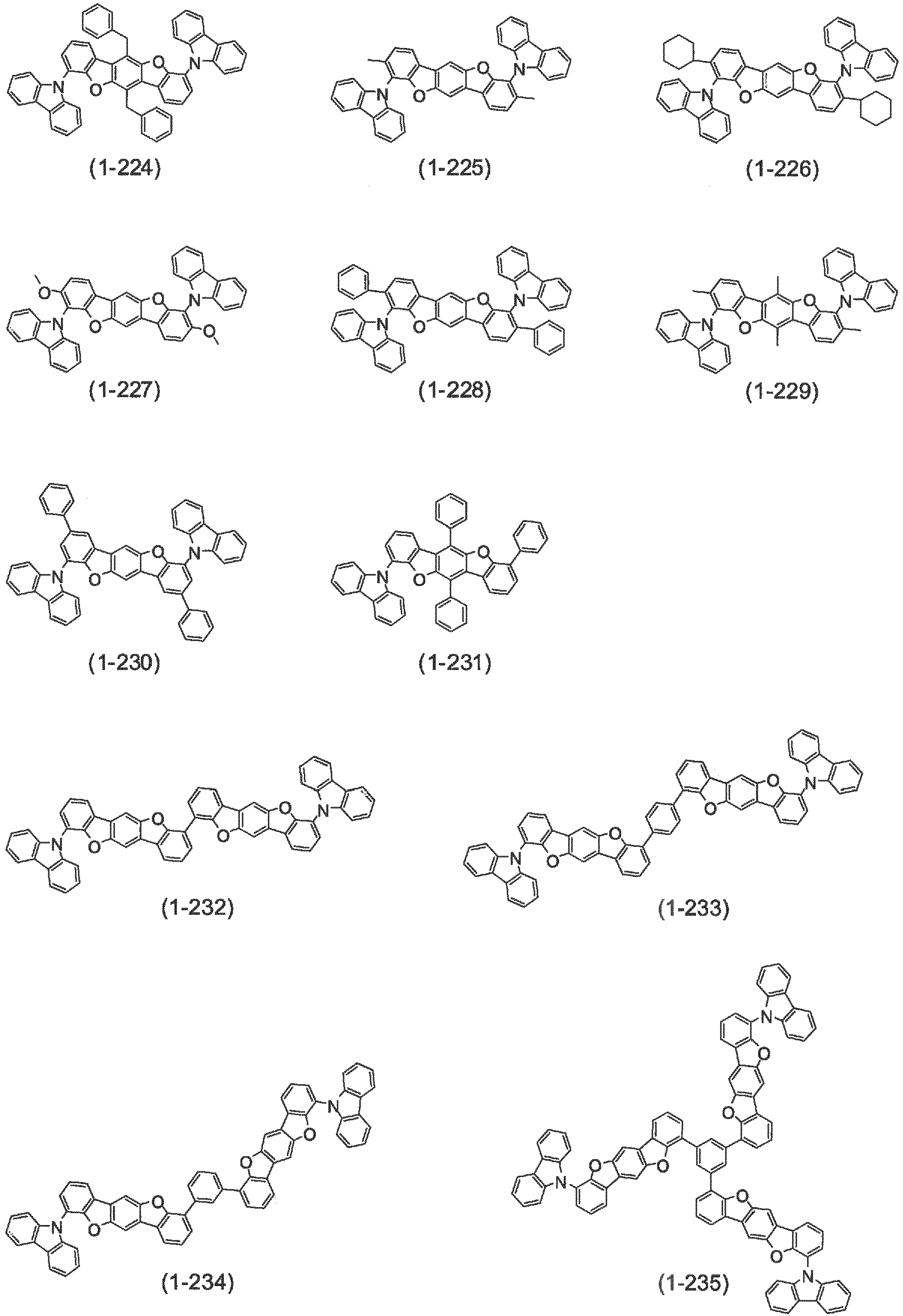

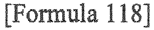

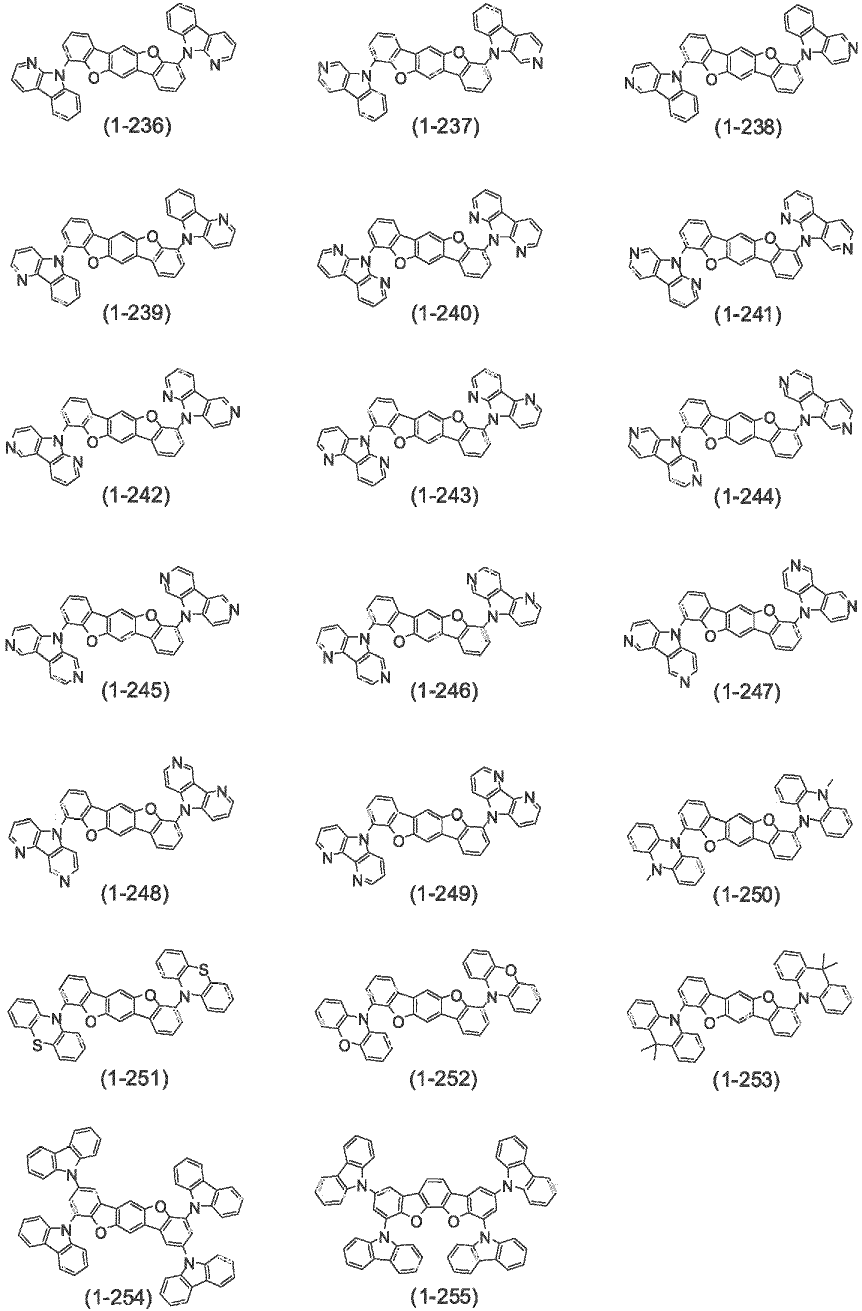

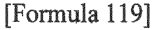

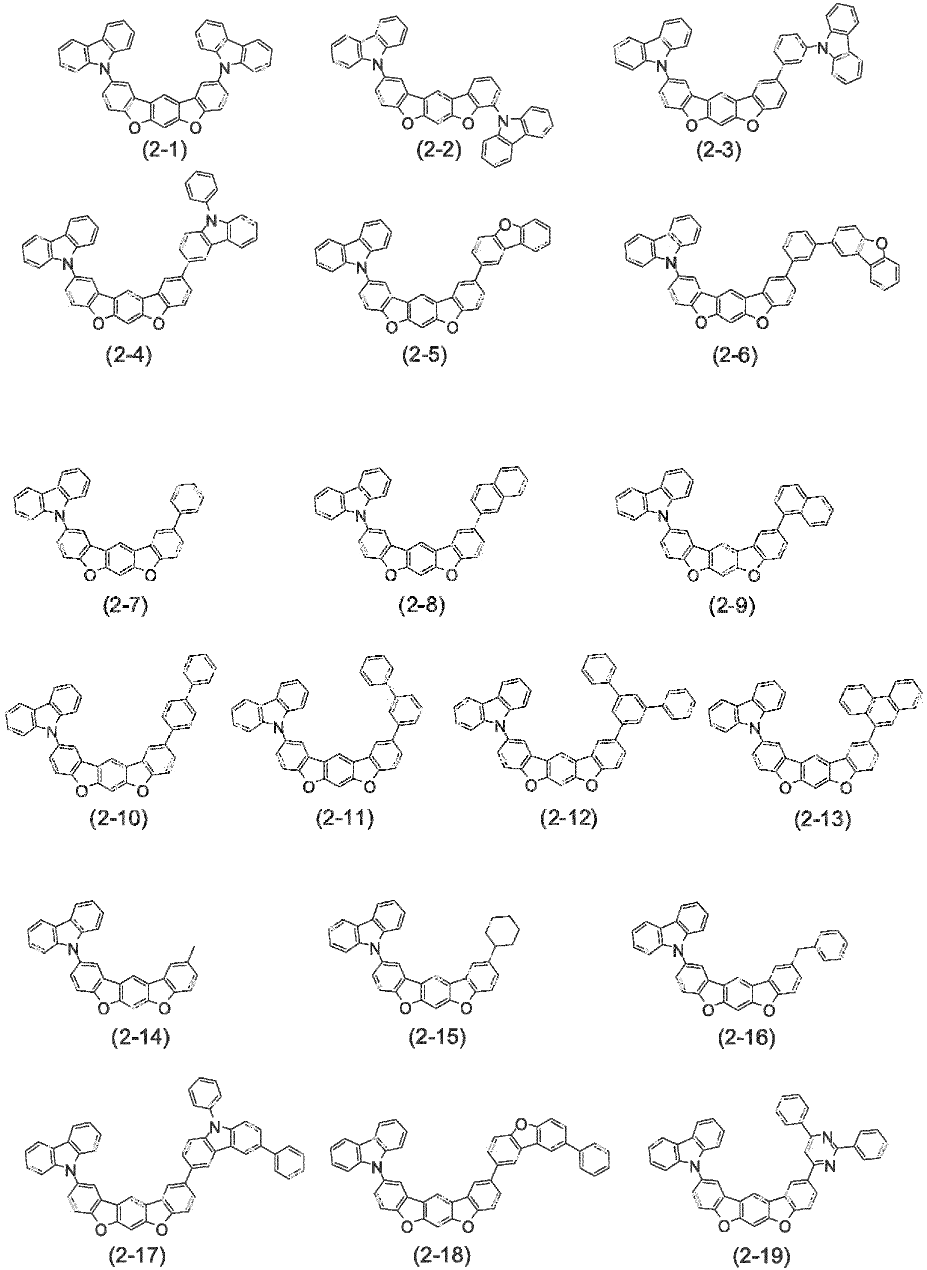

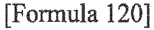

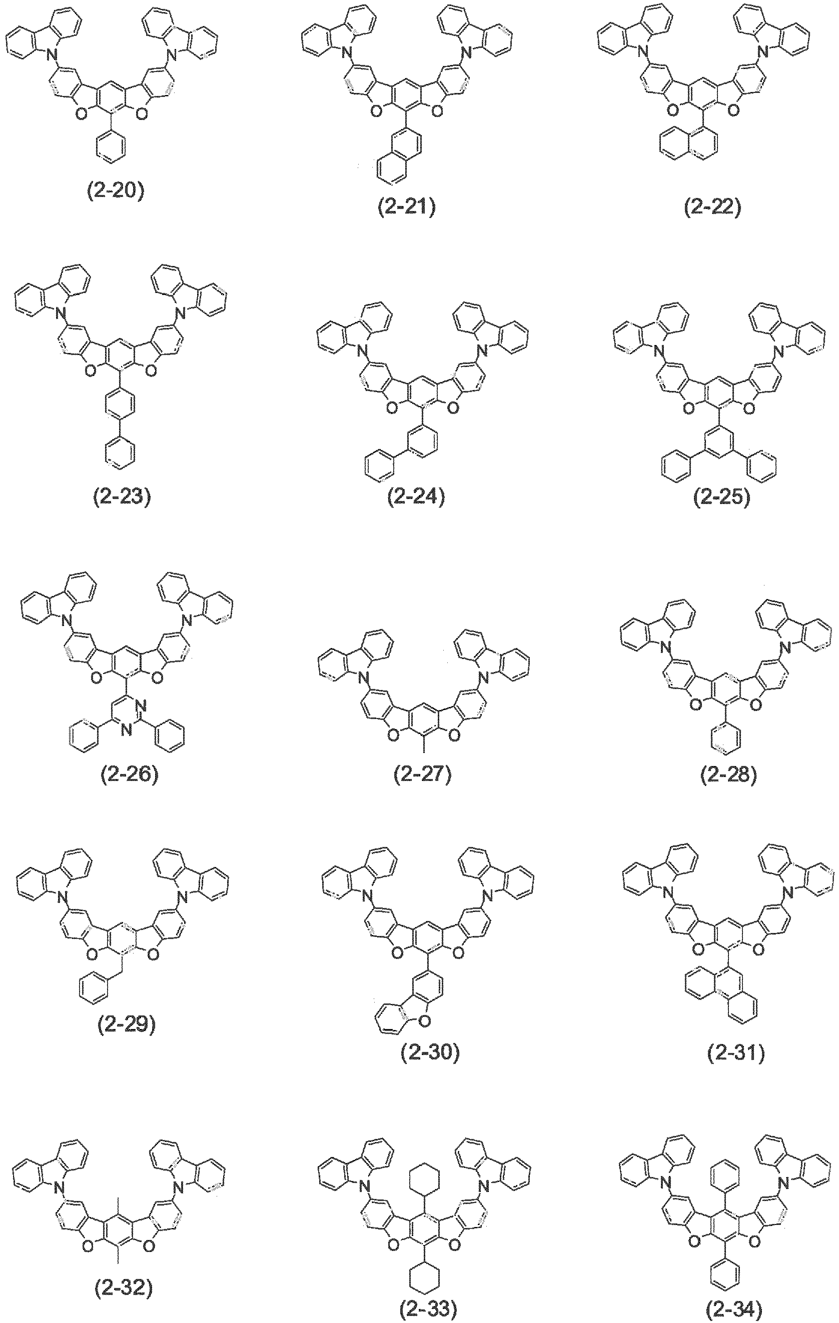

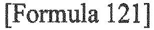

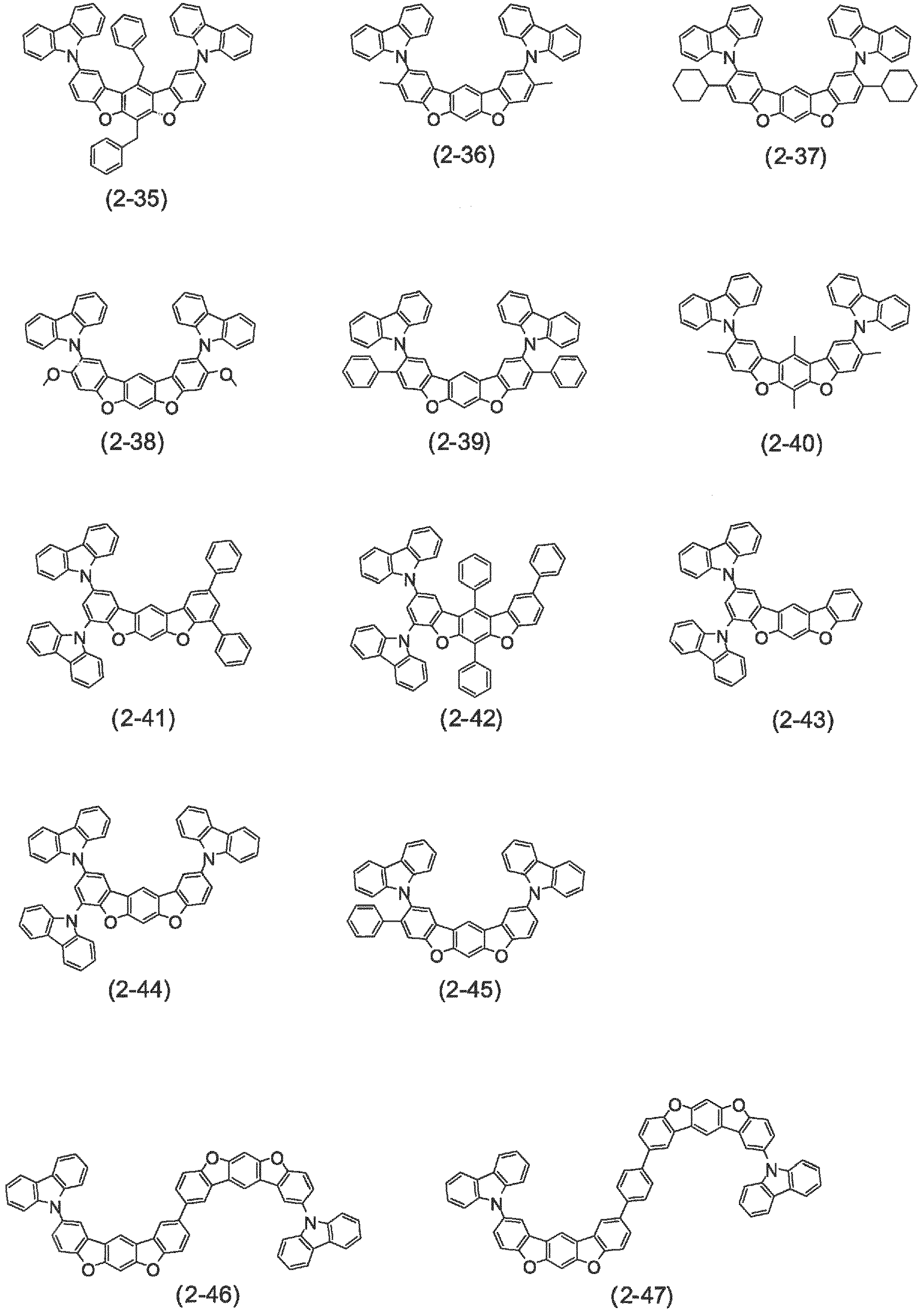

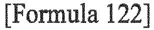

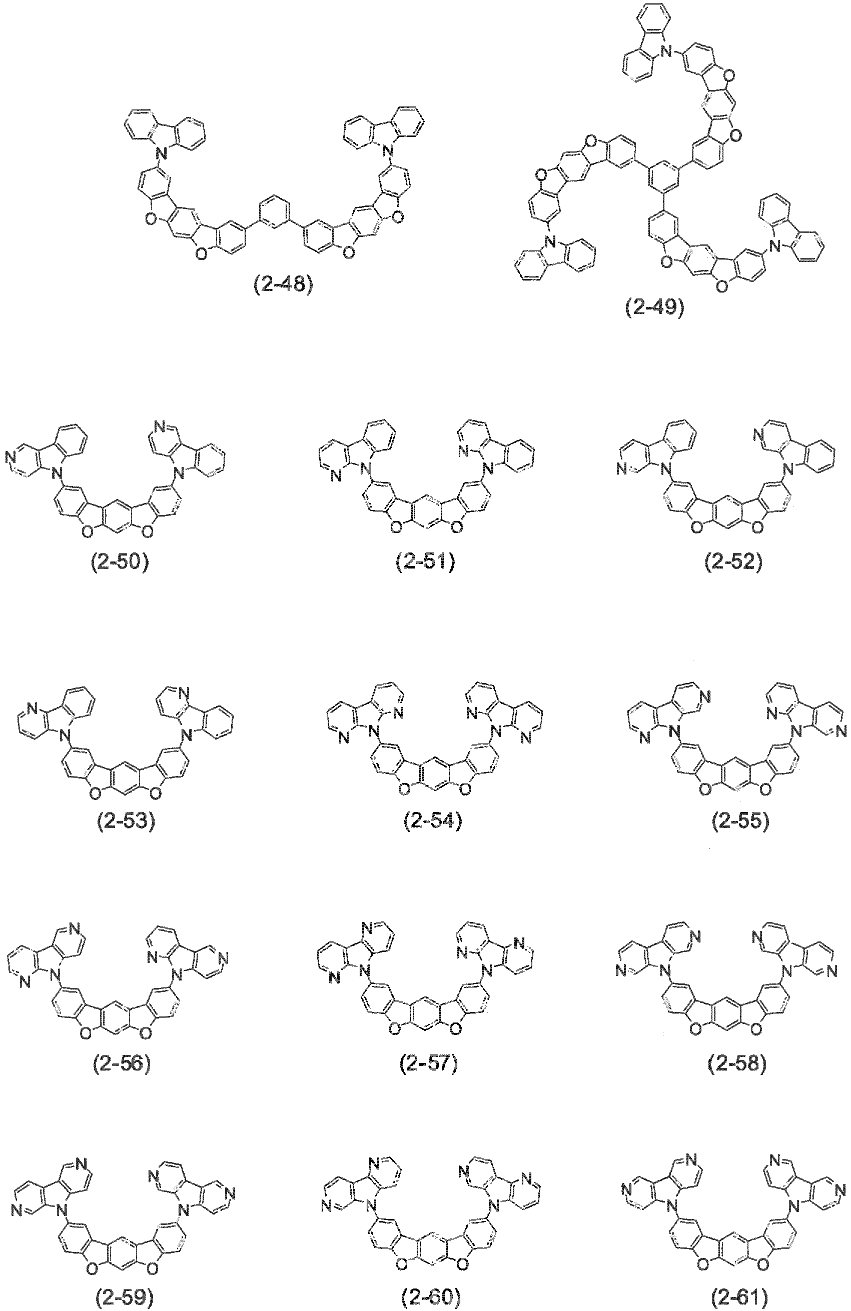

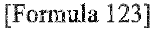

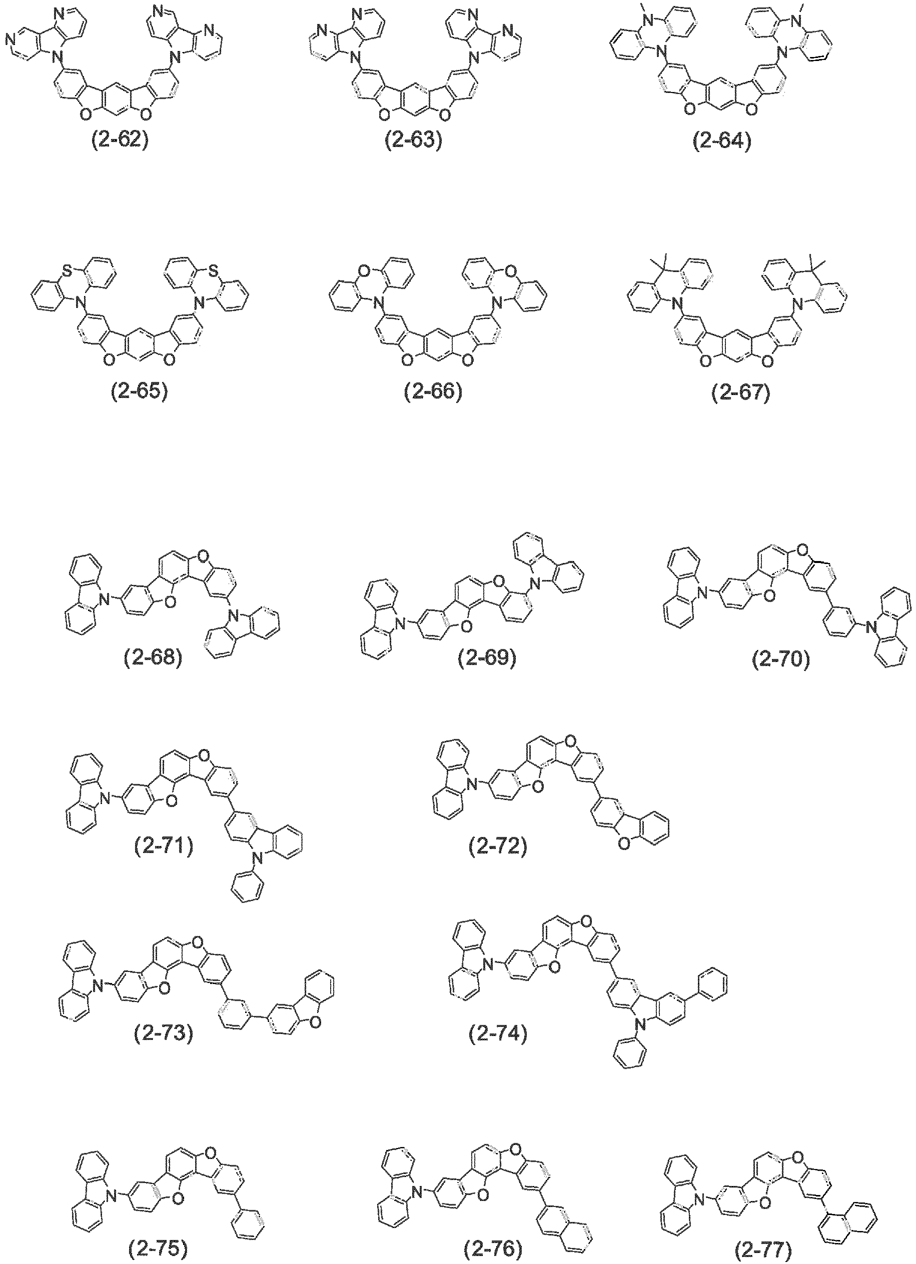

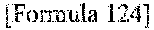

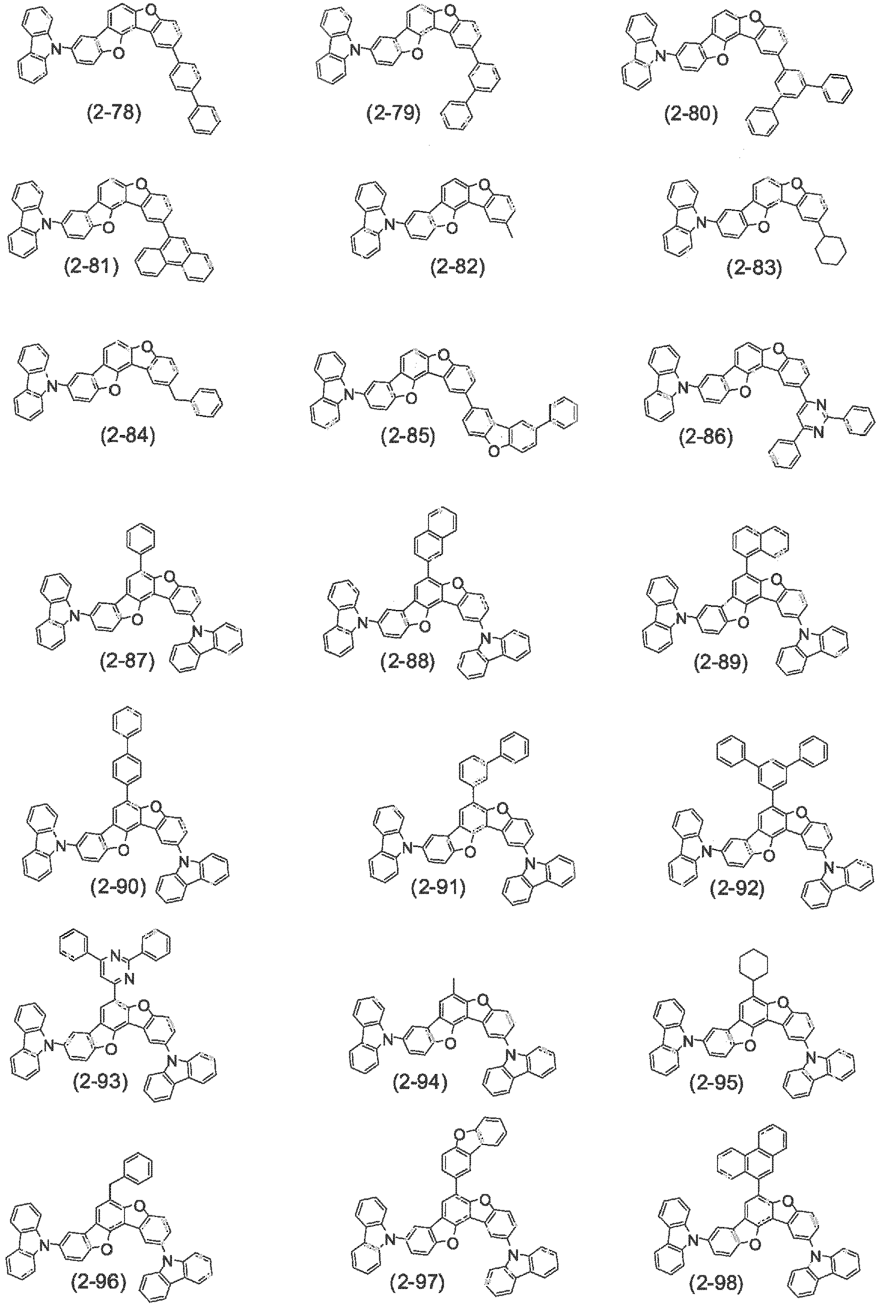

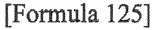

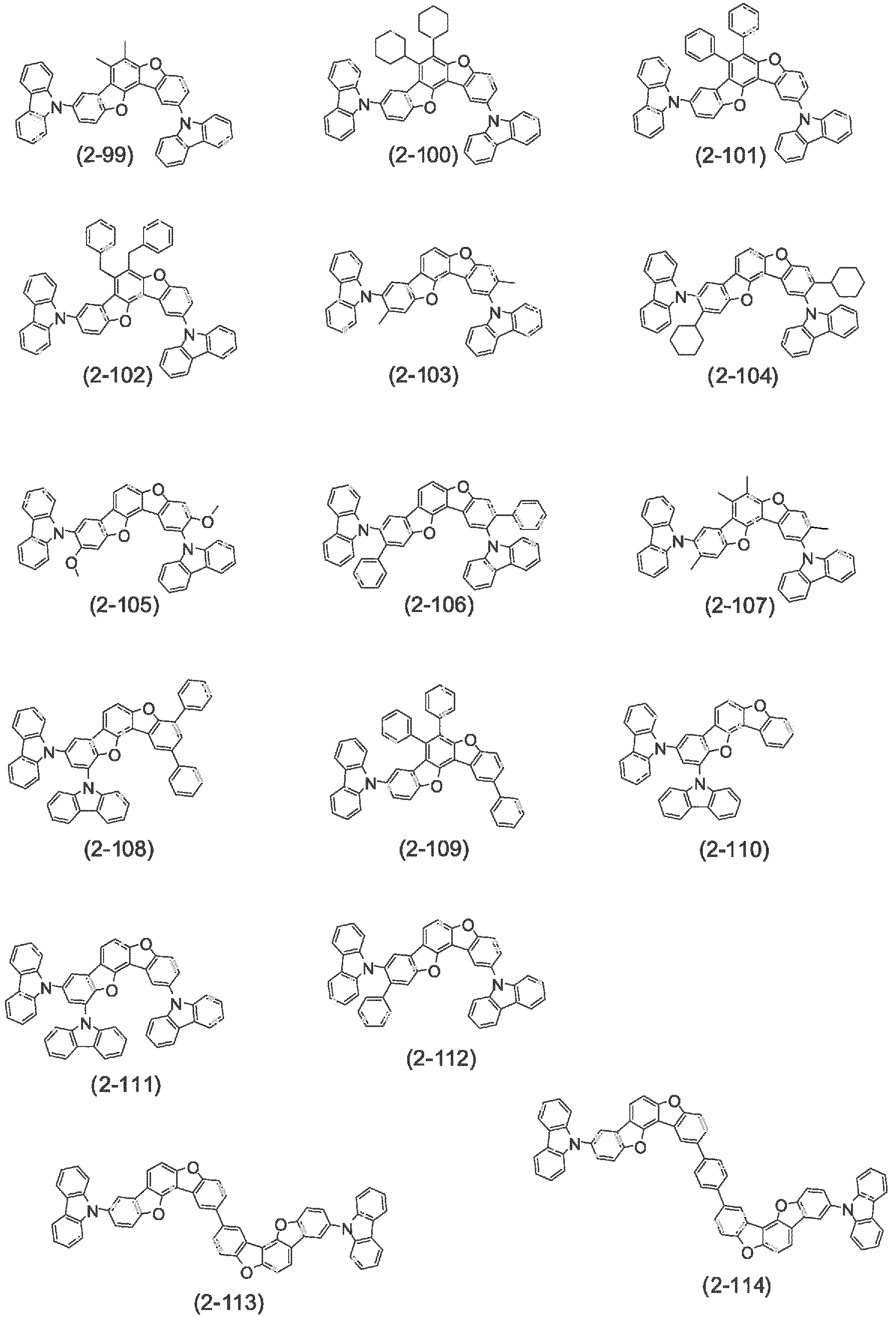

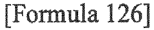

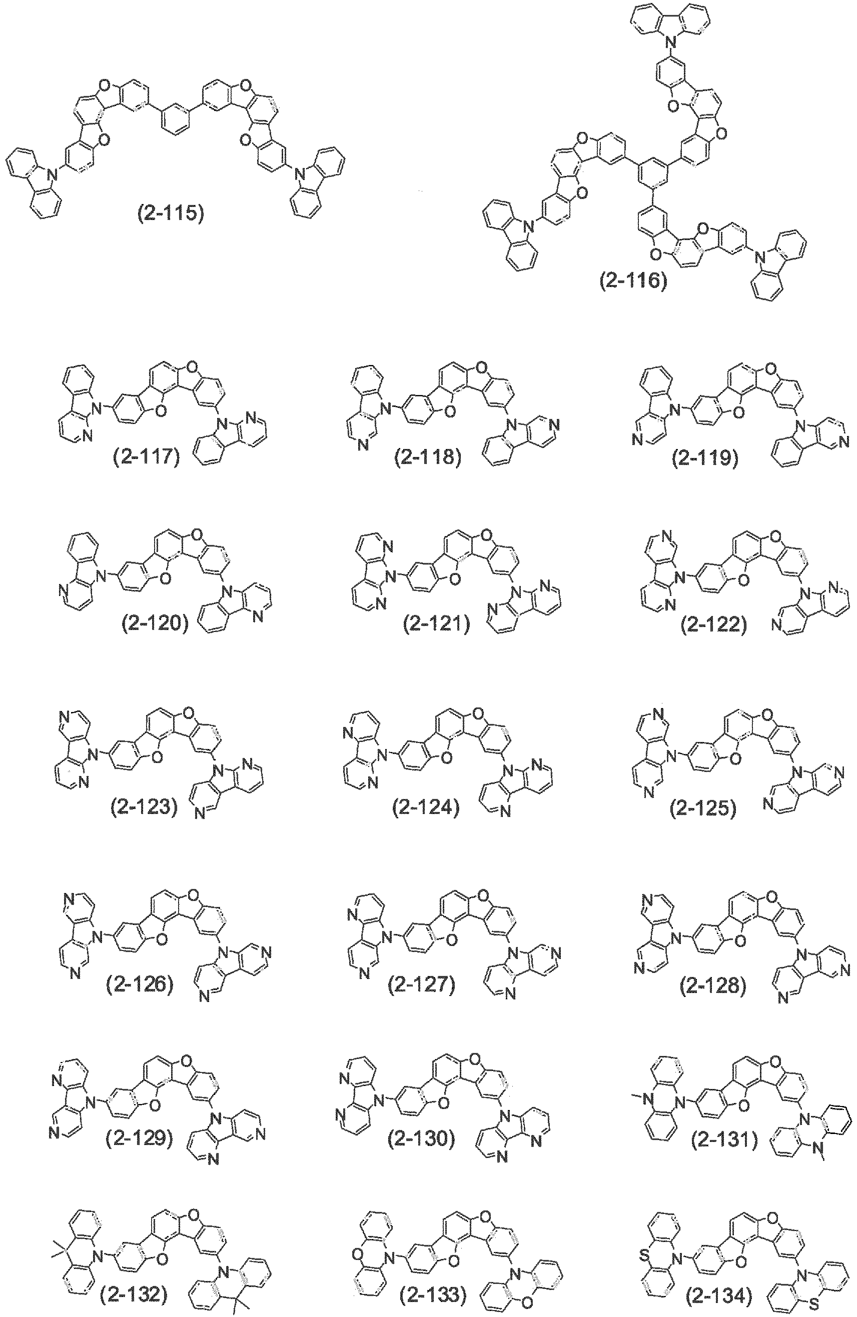

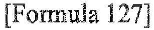

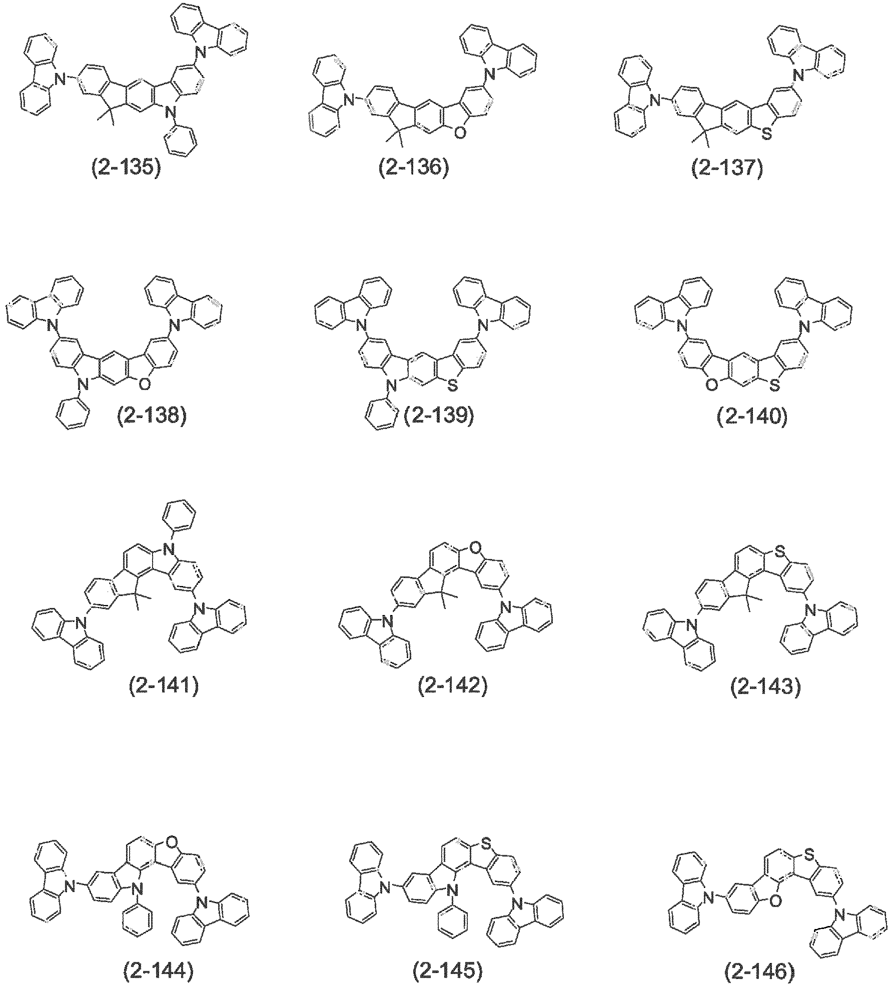

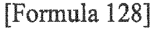

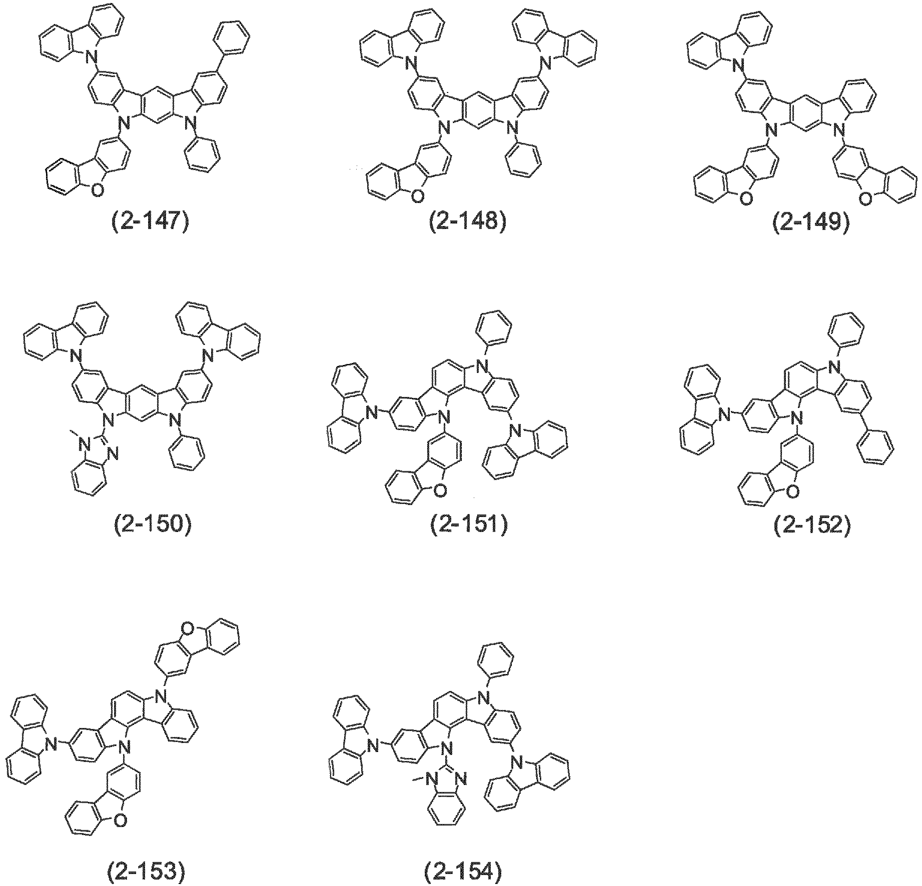

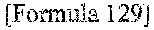

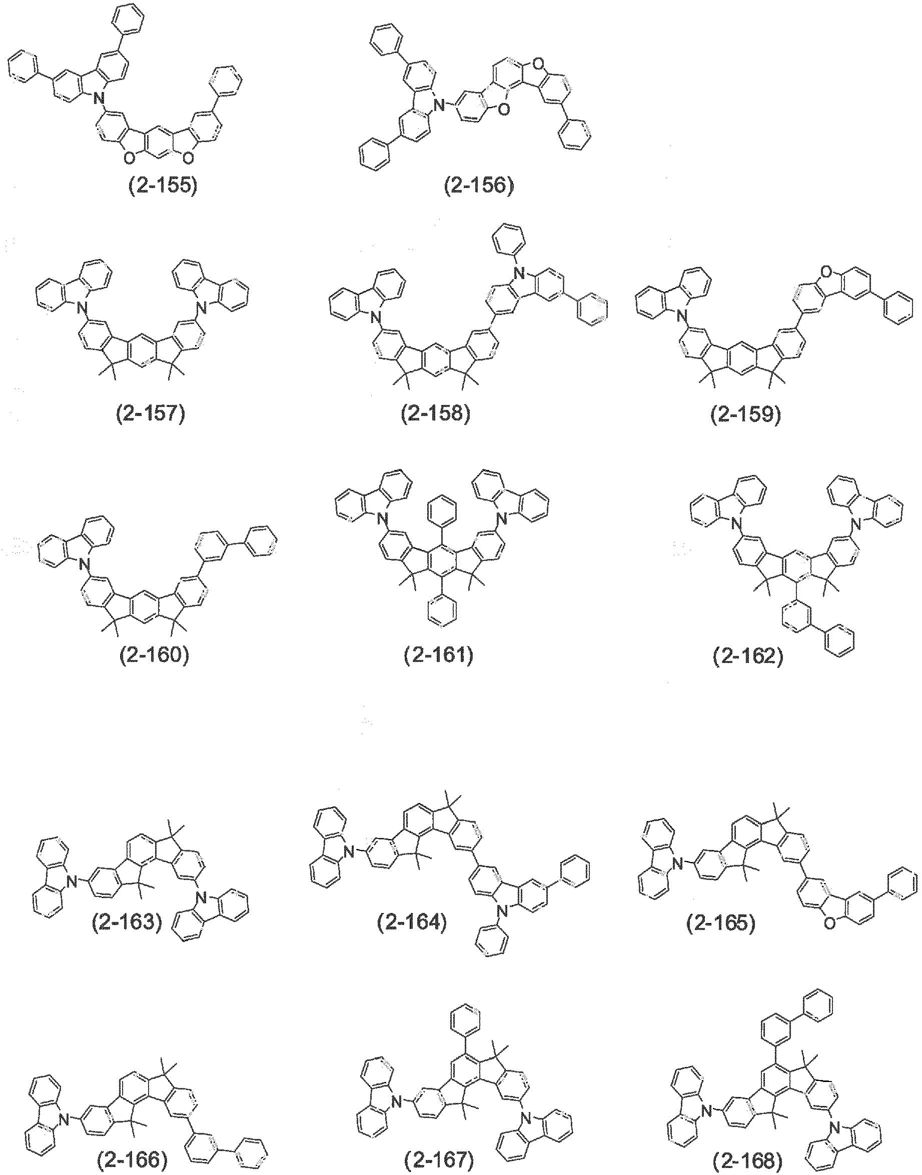

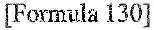

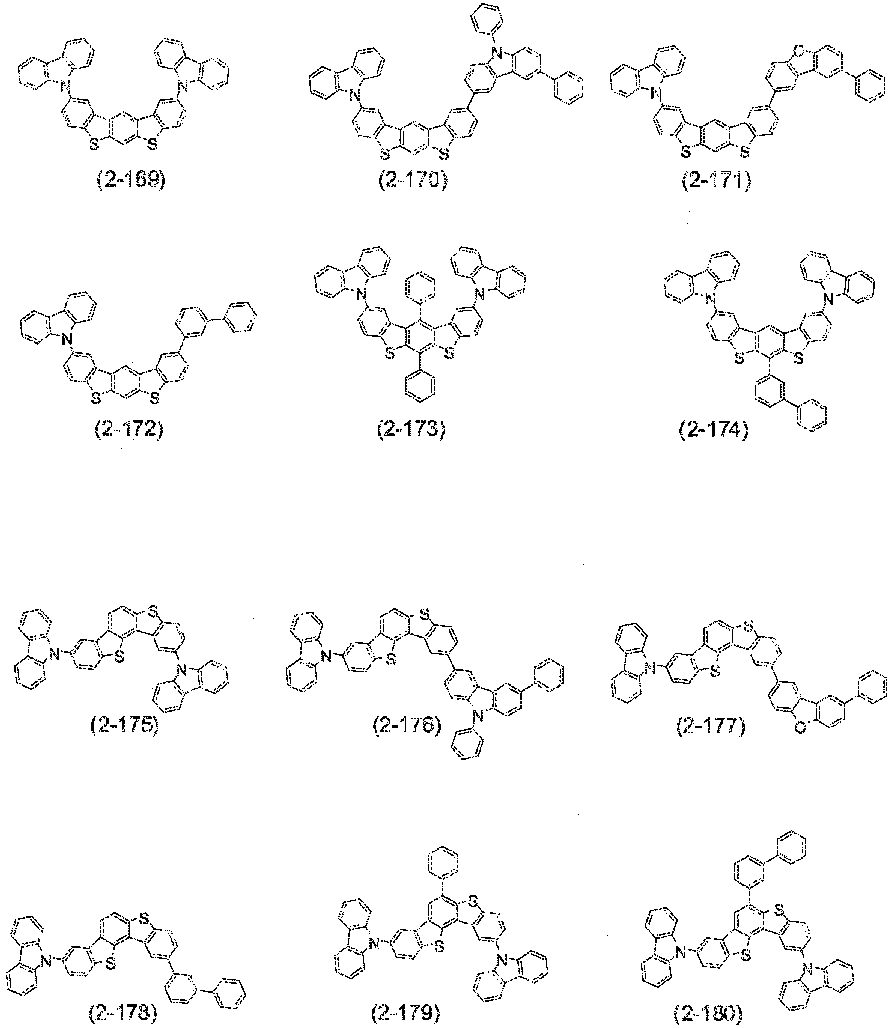

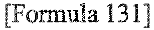

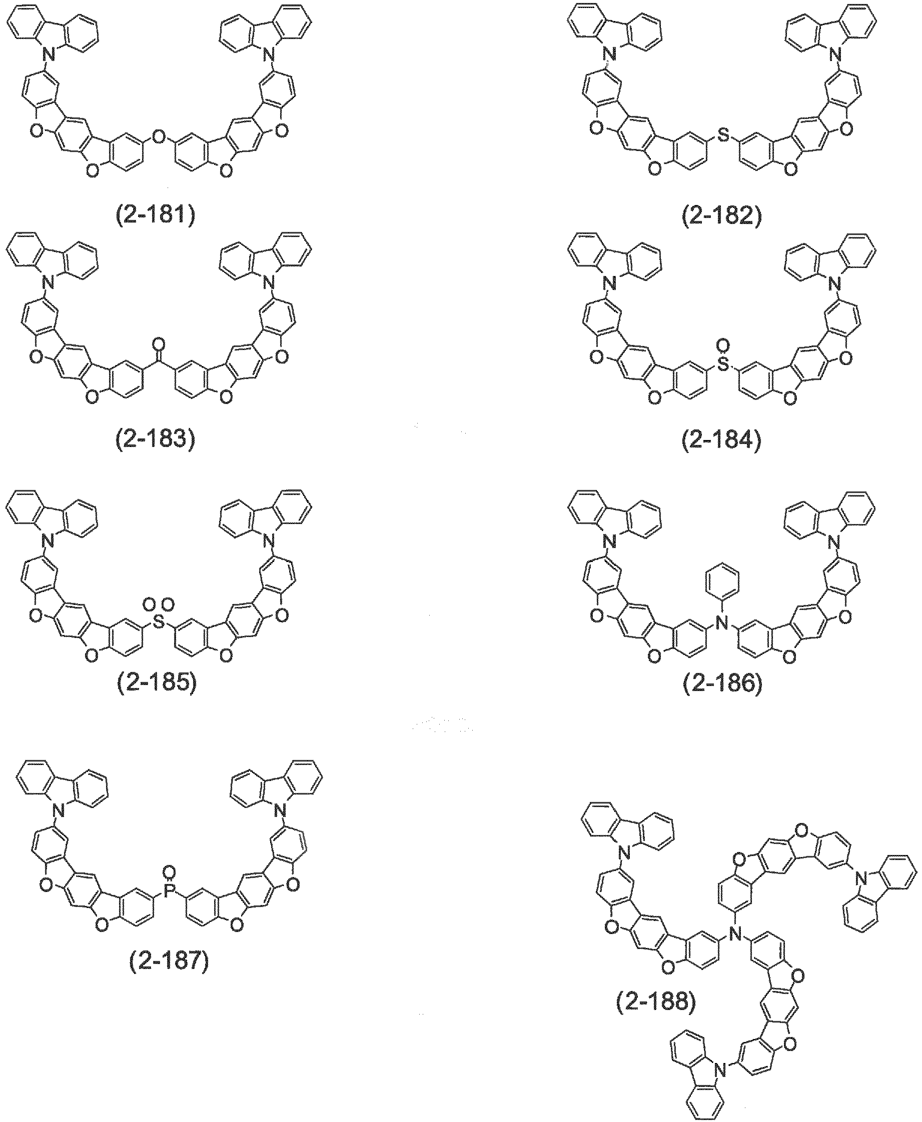

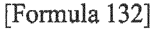

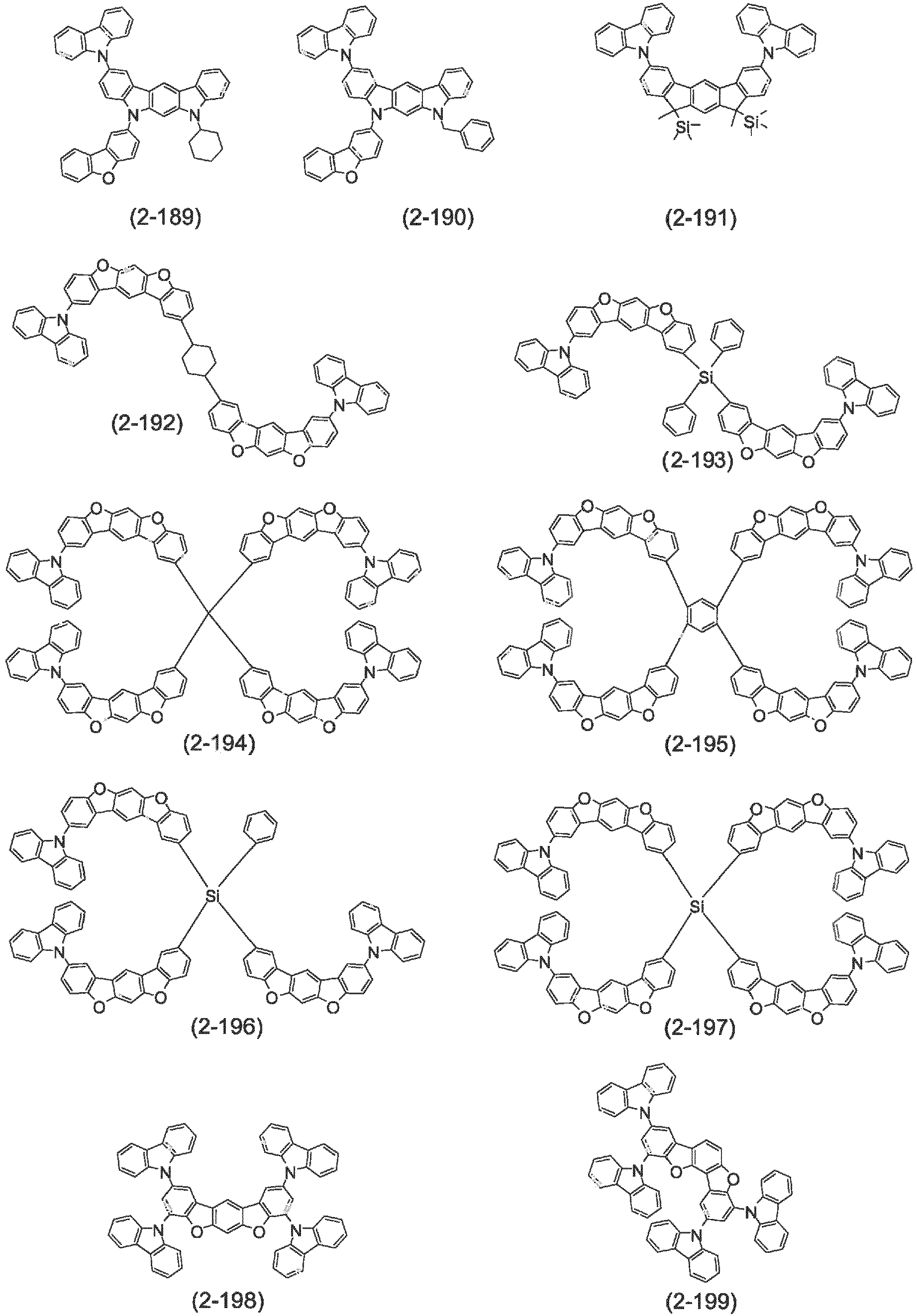

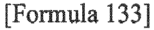

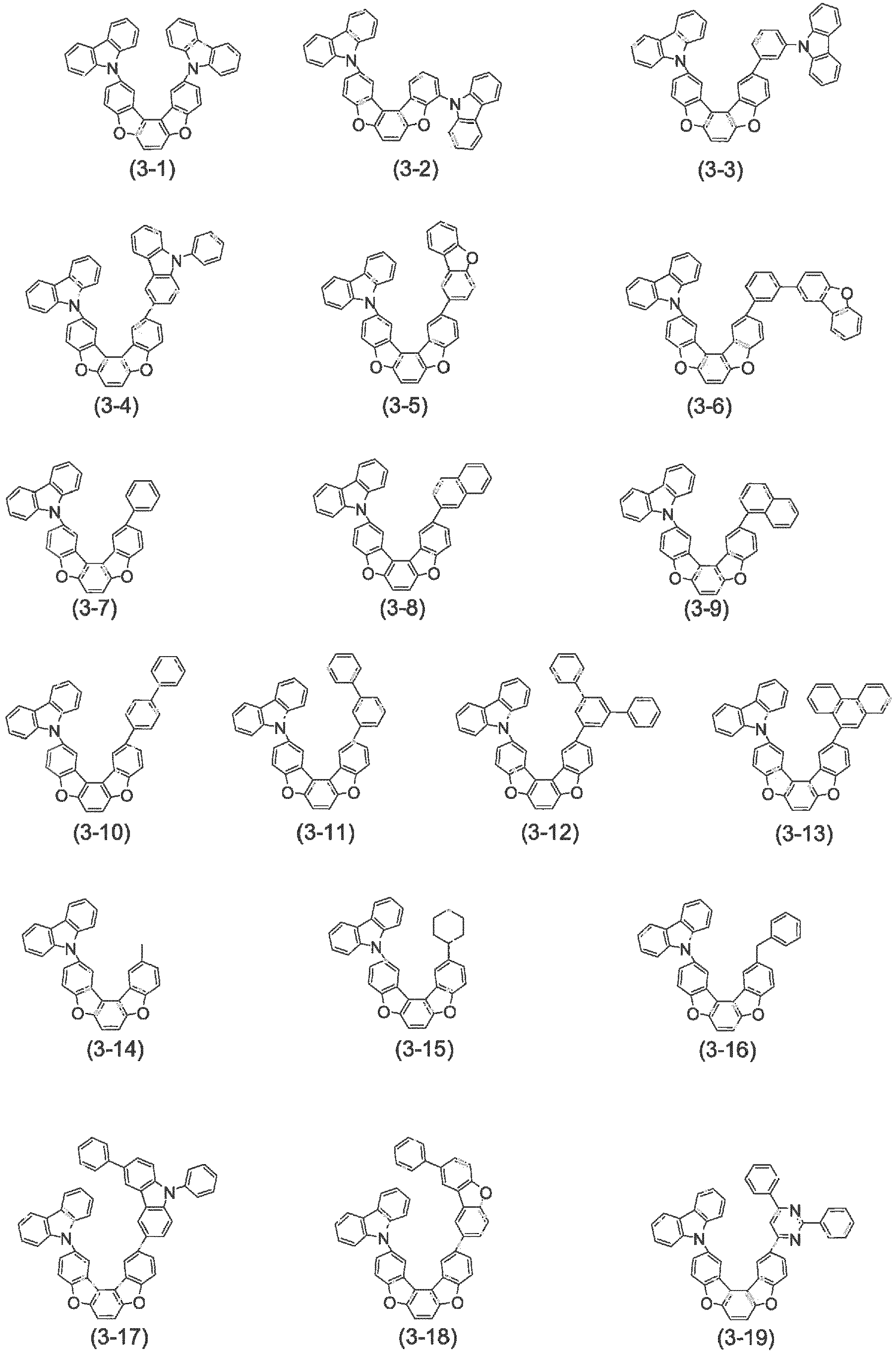

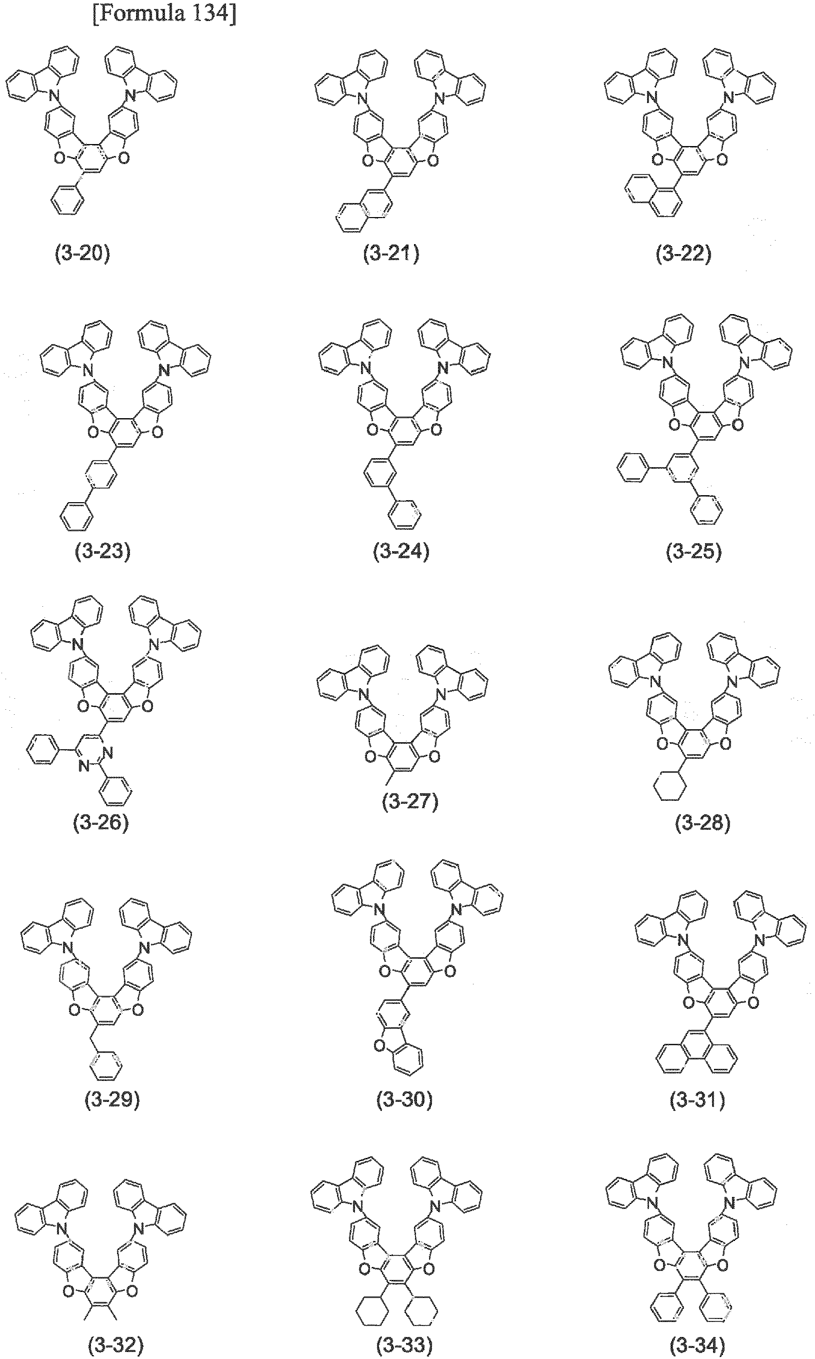

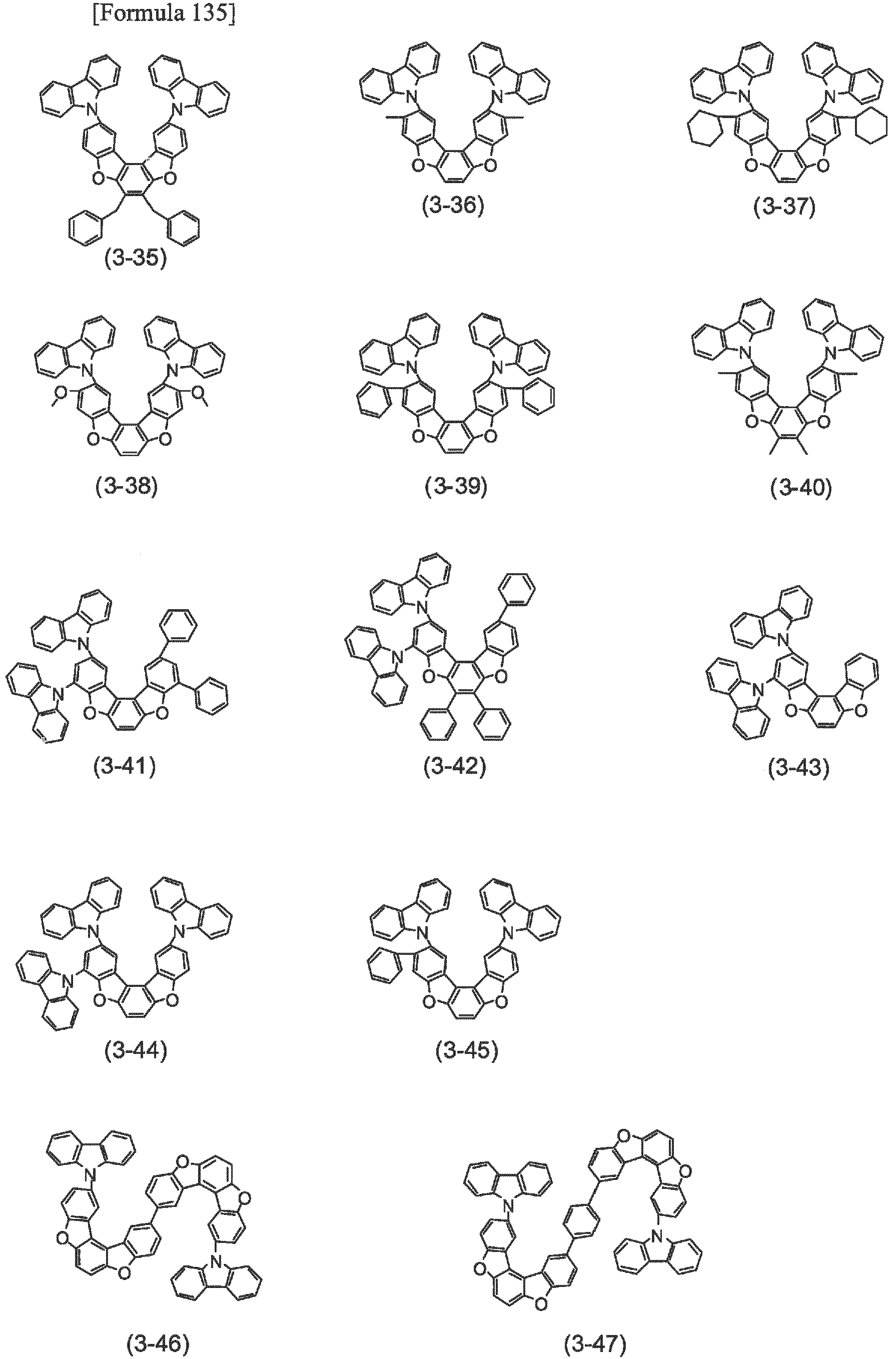

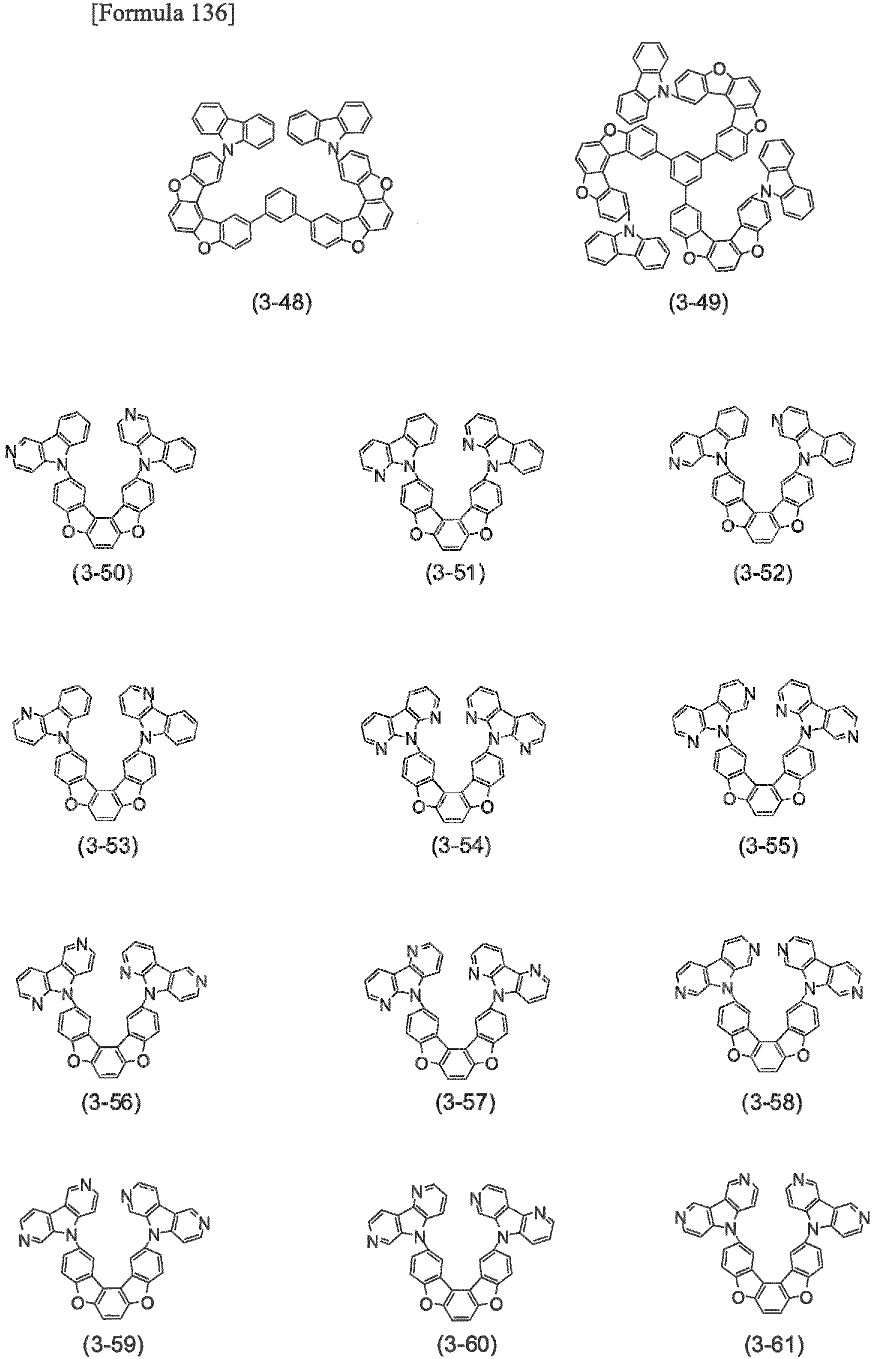

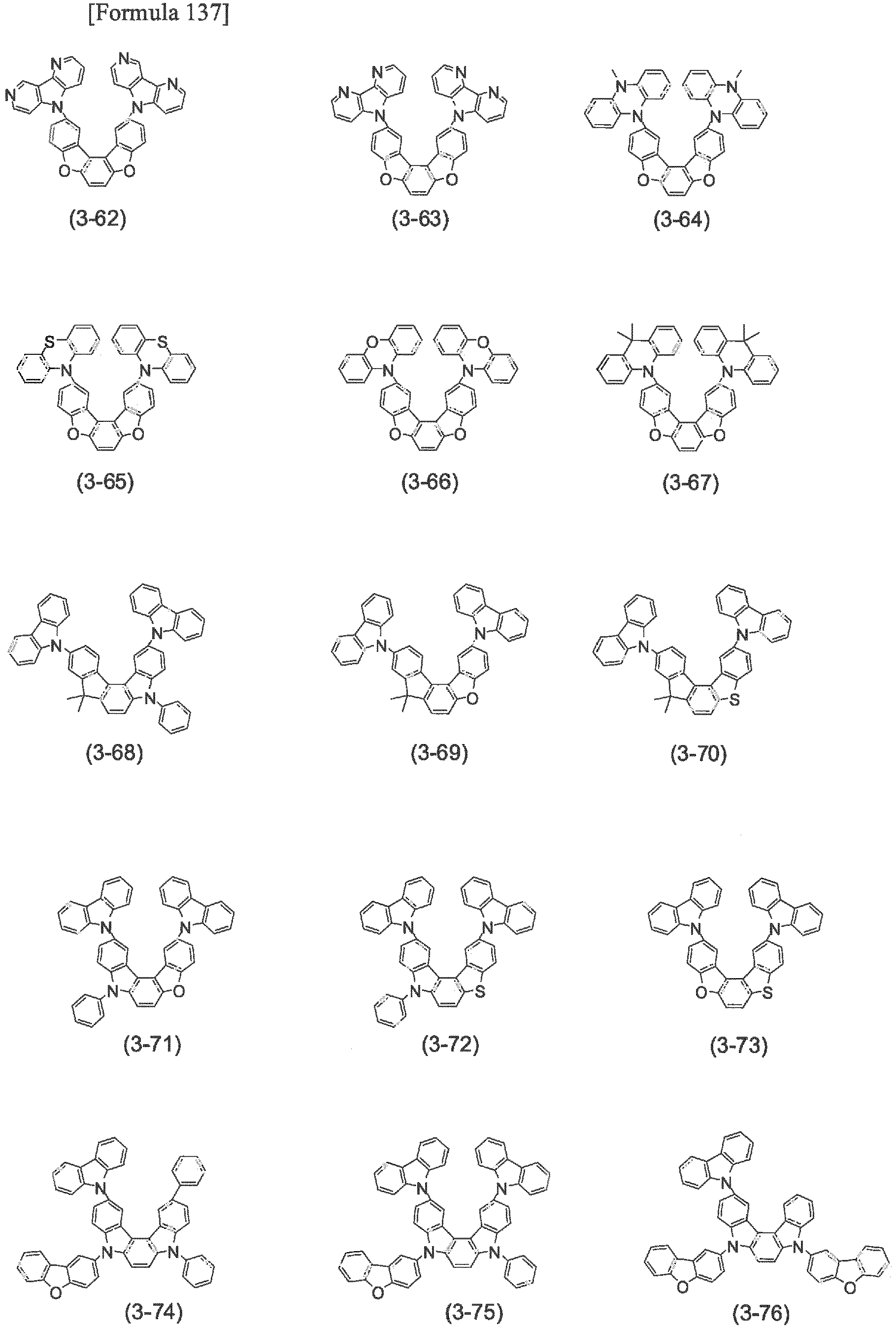

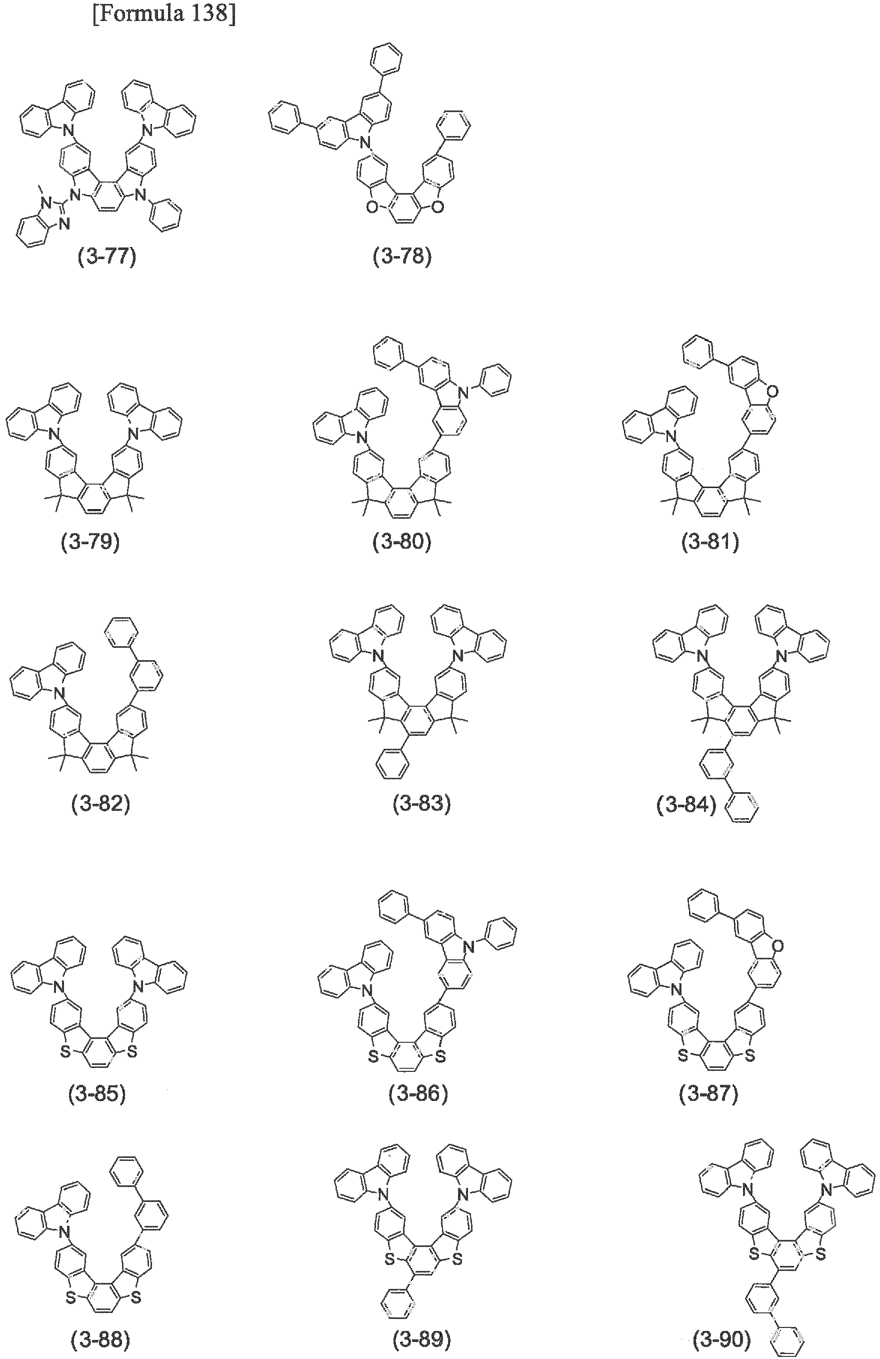

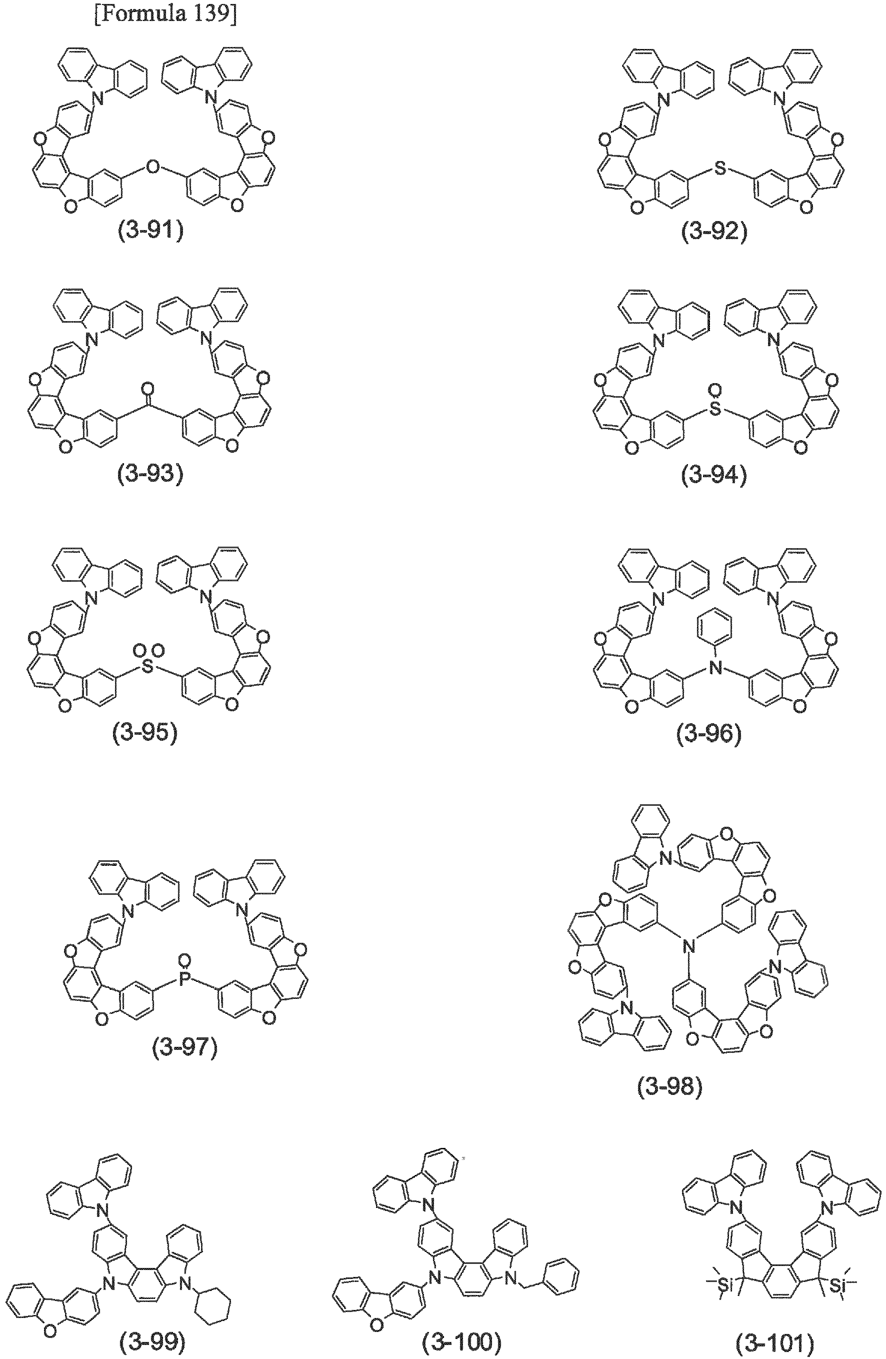

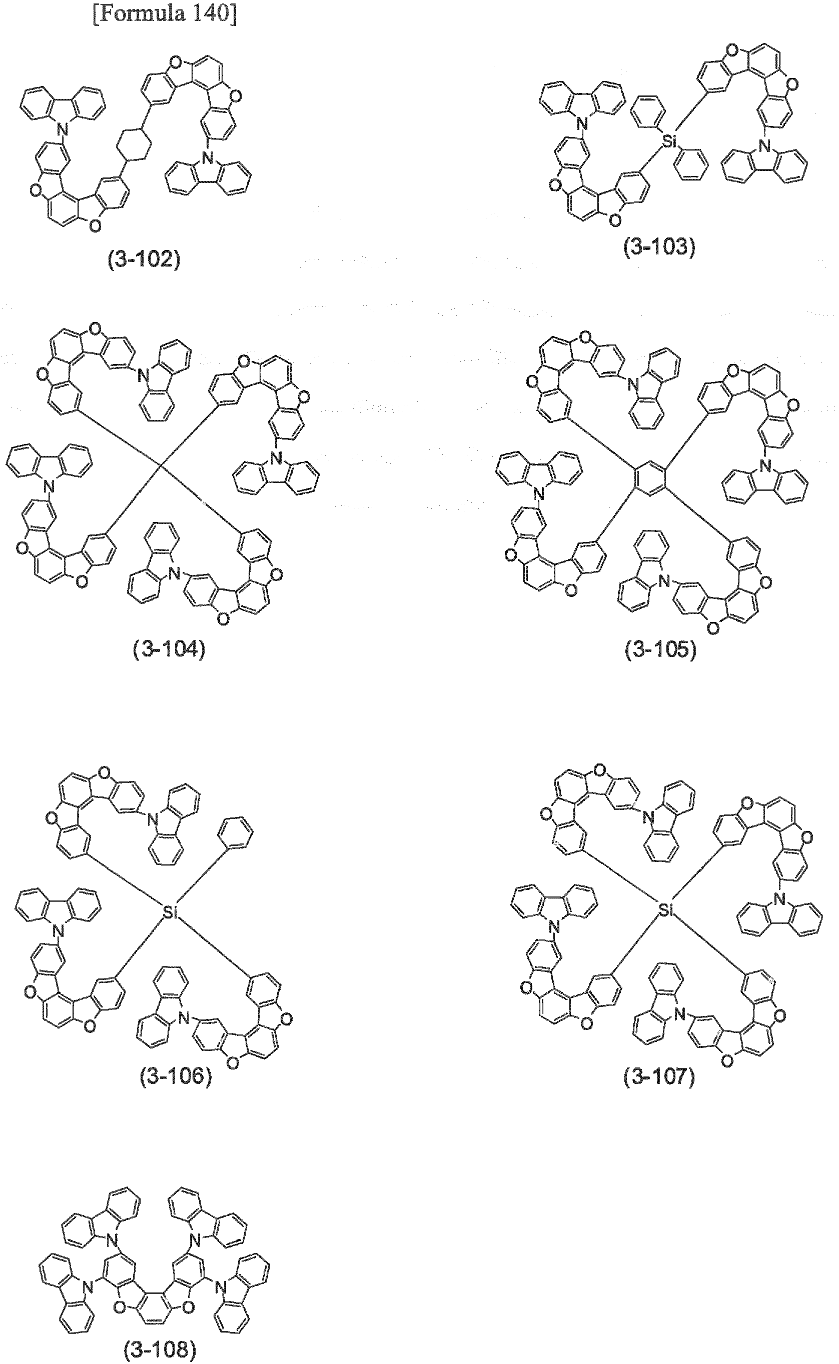

### Phosphorescent Material

In this exemplary embodiment, the emitting layer contains a phosphorescent material as a dopant.
The phosphorescent material is preferably a compound containing a metal selected from iridium (Ir), osmium (Os) and platinum (Pt) because such a compound, which exhibits high phosphorescence quantum yield, can further enhance external quantum efficiency of an emitting device. The phosphorescent material is more preferably a metal complex such as an iridium complex, an osmium complex or a platinum complex, among which an iridium complex and a platinum complex are further preferable and ortho metalation of an iridium complex is the most preferable.
Examples of such a preferable metal complex are shown below.

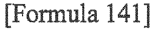

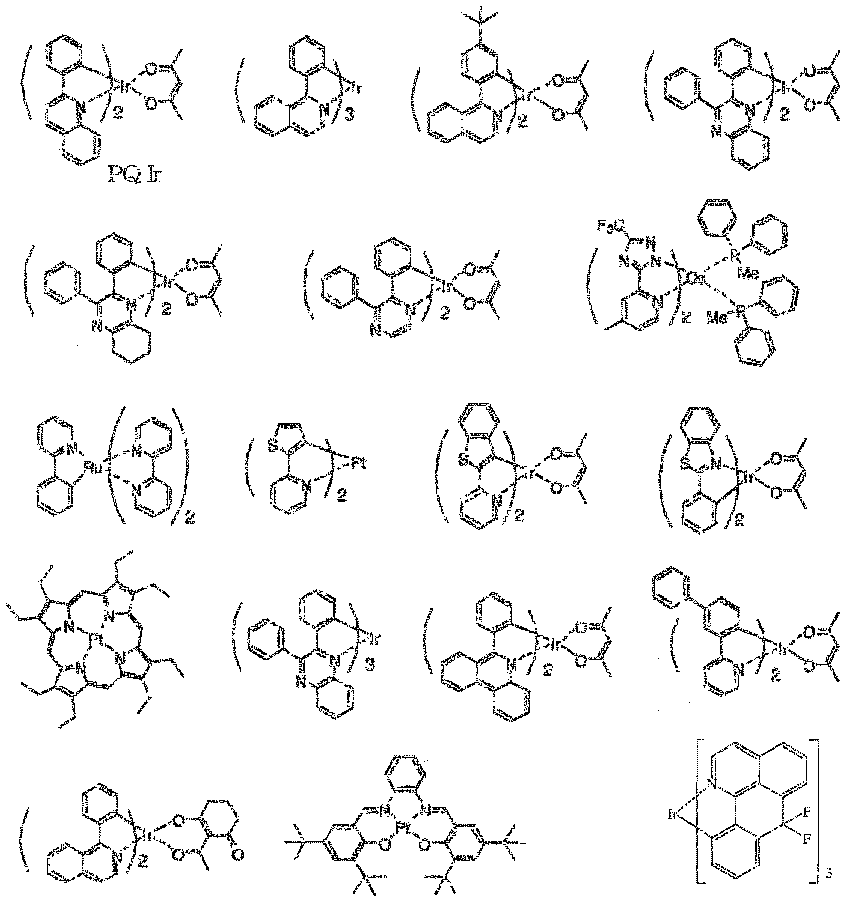

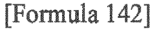

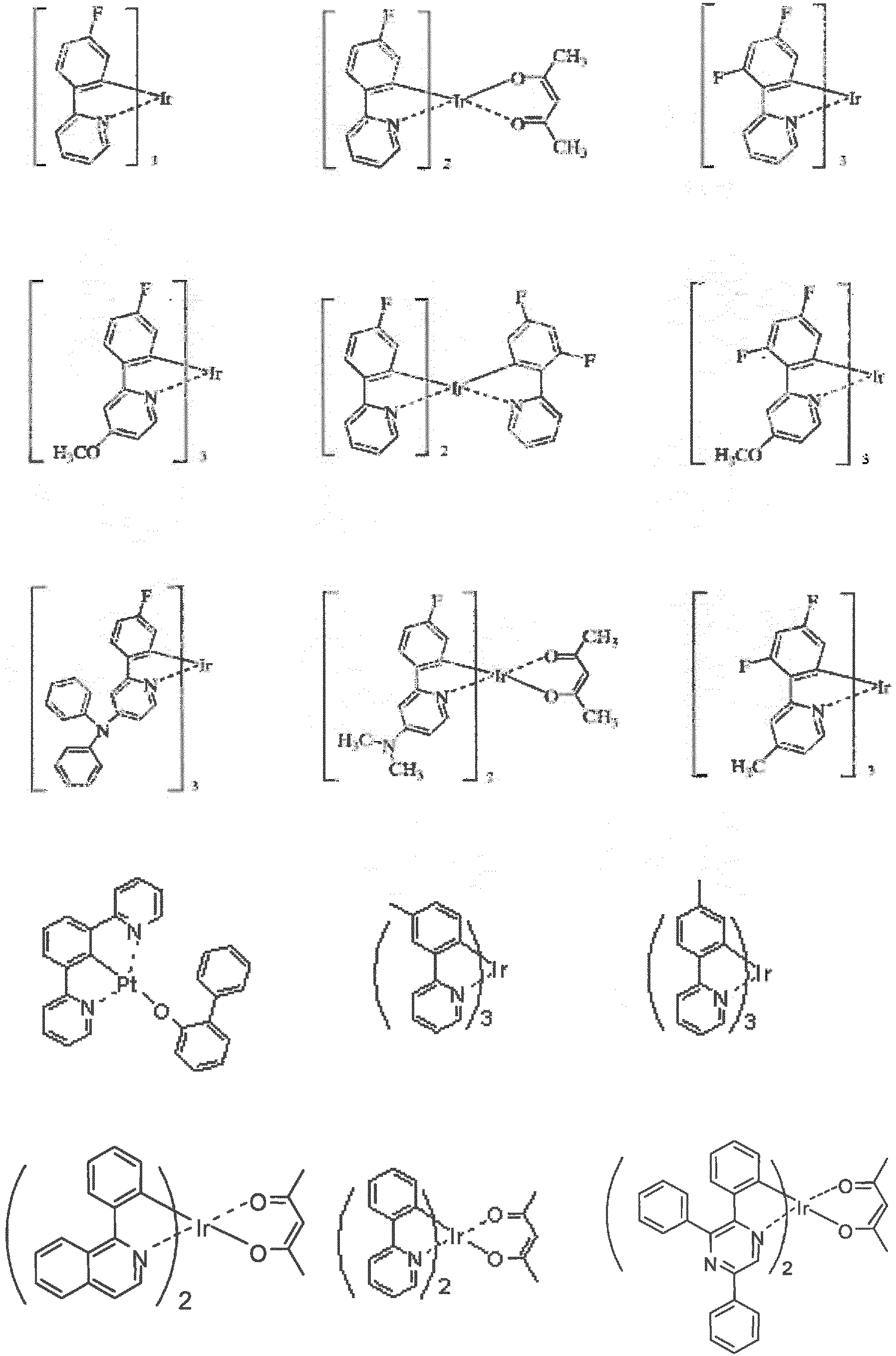

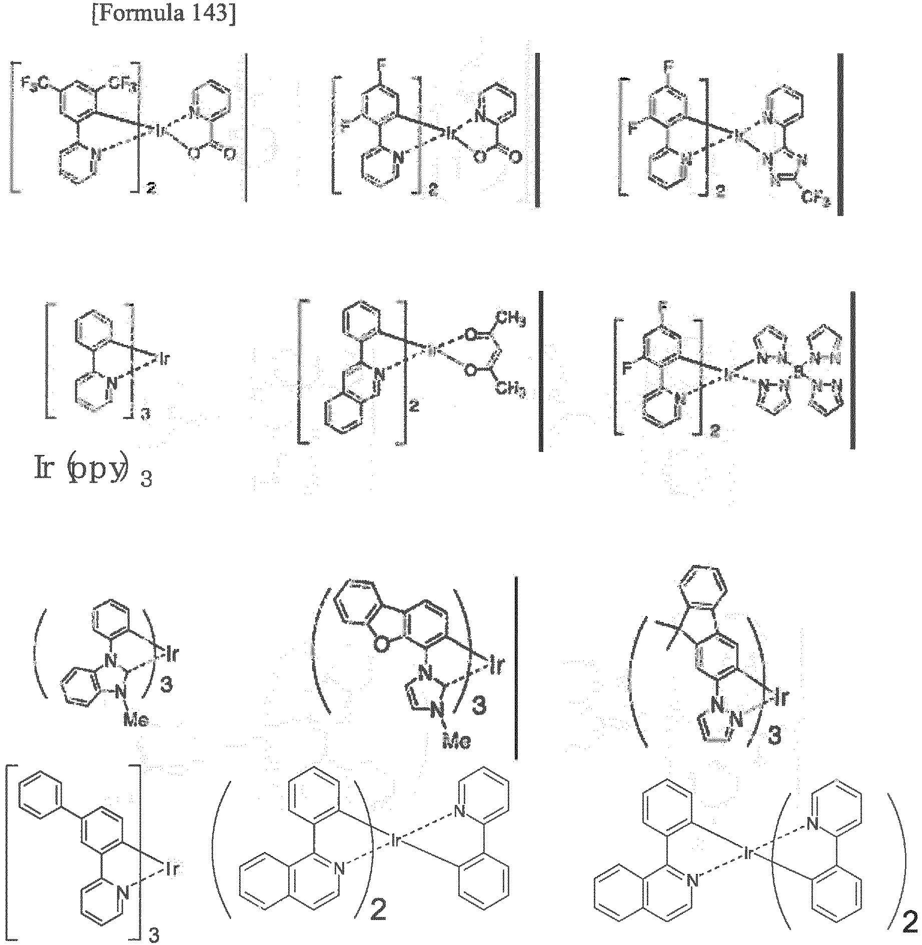

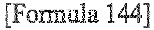

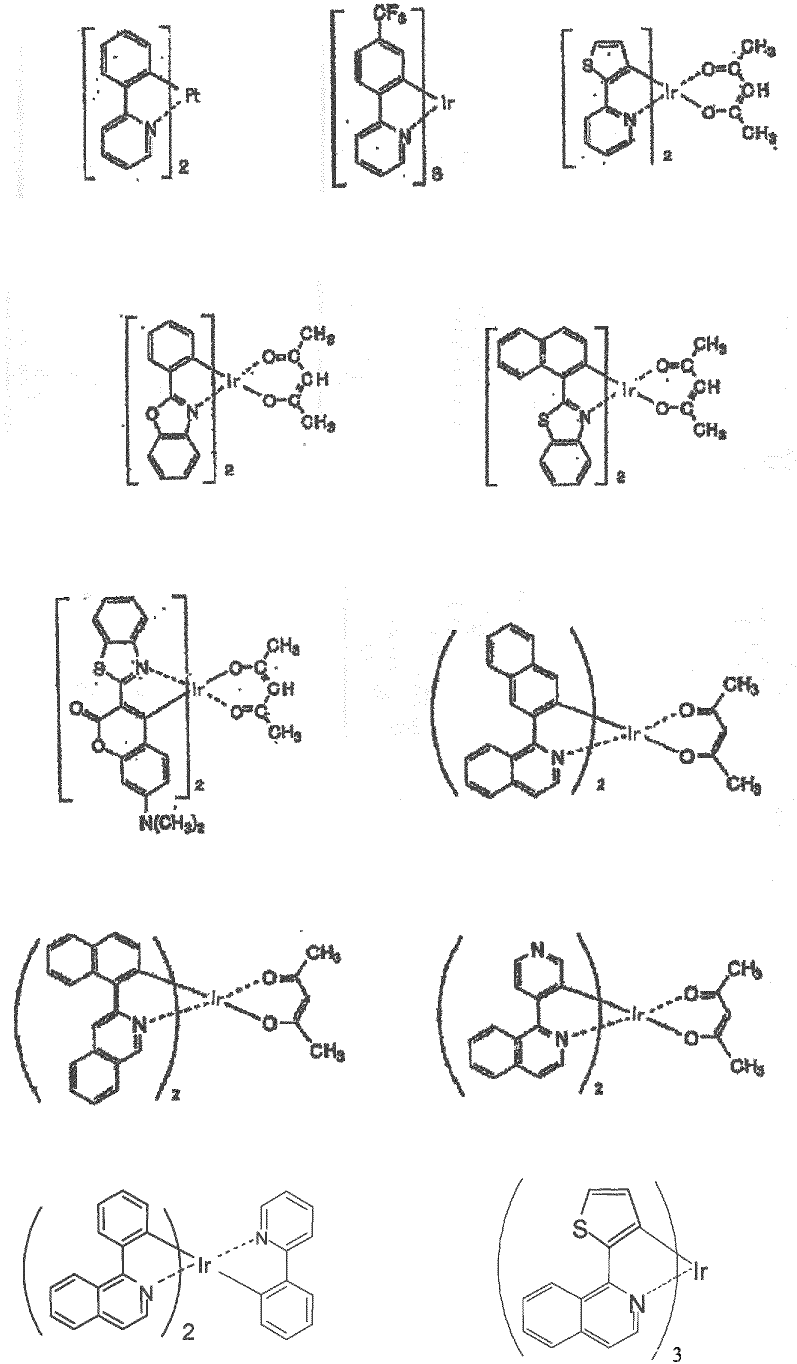

In this exemplary embodiment, at least one of the phosphorescent materials contained in the emitting layer preferably emits light with the maximum wavelength of 450 nm to 720 nm.
By doping the phosphorescent material (phosphorescent dopant) having such an emission wavelength to the specific host material used in this exemplary embodiment to form the emitting layer, the organic EL device can exhibit high efficiency.

### Reduction-causing Dopant

In the organic EL device according to this exemplary embodiment, a reduction-causing dopant may be preferably contained in an interfacial region between the cathode and the organic thin-film layer.
With this structure, the organic EL device can emit light with enhanced luminance intensity and have a longer lifetime.
The reduction-causing dopant may be at least one compound selected from a group of an alkali metal, an alkali metal complex, an alkali metal compound, an alkaline earth metal, an alkaline earth metal complex, an alkaline earth metal compound, a rare-earth metal, a rare-earth metal complex, a rare-earth metal compound and the like.

Examples of the alkali metal are Na (work function: 2.36 eV), K (work function: 2.28 eV), Rb (work function: 2.16 eV), and Cs (work function: 1.95 eV), among which the alkali metal having a work function of 2.9 eV or less is particularly preferable. Among the above, the reduction-causing dopant is preferably K, Rb or Cs, more preferably Rb or Cs, the most preferably Cs.
Examples of the alkaline earth metal are Ca (work function: 2.9 eV), Sr (work function: 2.0 eV to 2.5 eV), and Ba (work function: 2.52 eV), among which the alkali earth metal having a work function of 2.9 eV or less is particularly preferable.
Examples of the rare-earth metal are Sc, Y, Ce, Tb, and Yb, among which the rare-earth metal having a work function of 2.9 eV or less is particularly preferable.
Since the above preferred metals have particularly high reducibility, addition of a relatively small amount of the metals to an electron injecting zone can enhance luminance intensity and lifetime of the organic EL device.

Examples of the alkali metal compound are an alkali oxide such as Li₂O, Cs₂O or K₂O, an alkali halide such as LiF, NaF, CsF or KF and the like, among which LiF, Li₂O and NaF are preferable.
Examples of the alkaline earth metal compound are BaO, SrO, CaO, a mixture thereof such as BaₓSr₁₋ₓO (0<x<1) or BaₓCa₁₋ₓO (0<x<1) and the like, among which BaO, SrO and CaO are preferable.
Examples of the rare-earth metal compound are YbF₃, ScF₃, ScO₃, Y₂O₃, Ce₂O₃, GdF₃, TbF₃ and the like, among which YbF₃, ScF₃ and TbF₃ are preferable.

The alkali metal complex, the alkaline earth metal complex and the rare earth metal complex are not specifically limited as long as they contain at least one metal ion of an alkali metal ion, an alkaline earth metal ion and a rare earth metal ion. A ligand for each of the complexes is preferably quinolinol, benzoquinolinol, acridinol, phenanthridinol, hydroxyphenyl oxazole, hydroxyphenyl thiazole, hydroxydiaryl oxadiazole, hydroxydiaryl thiadiazole, hydroxyphenyl pyridine, hydroxyphenyl benzoimidazole, hydroxybenzo triazole, hydroxy fluborane, bipyridyl, phenanthroline, phthalocyanine, porphyrin, cyclopentadiene, β-diketones, azomethines, or a derivative thereof, but the ligand is not limited thereto.

The reduction-causing dopant is added to preferably form a layer or an island pattern in the interfacial region. The layer of the reduction-causing dopant or the island pattern of the reduction-causing dopant is preferably formed by depositing the reduction-causing dopant by resistance heating deposition while an emitting material for forming the interfacial region or an organic substance as an electron-injecting material are simultaneously deposited, so that the reduction-causing dopant is dispersed in the organic substance. Dispersion concentration at which the reduction-causing dopant is dispersed in the organic substance is a mole ratio (organic substance to reduction-causing dopant) of 100 : 1 to 1: 100, preferably 5 : 1 to 1 : 5.
When the reduction-causing dopant forms the layer, the emitting material or the electron injecting material for forming the organic layer of the interfacial region is initially layered, and the reduction-causing dopant is subsequently deposited singularly thereon by resistance heating deposition to form a preferably 0.1 nm- to 15 nm-thick layer.
When the reduction-causing dopant forms the island pattern, the emitting material or the electron injecting material for forming the organic layer of the interfacial region is initially formed in an island shape, and the reduction-causing dopant is subsequently deposited singularly thereon by resistance heating deposition to form a preferably 0.05 nm- to 1 nm-thick island shape.
A ratio of the main component to the reduction-causing dopant in the organic EL device according to this exemplary embodiment is preferably a mole ratio (main component to reduction-causing dopant) of 5:1 to 1:5, more preferably 2:1 to 1:2.

### Electron Injecting Layer and Electron Transporting Layer

The electron injecting layer or the electron transporting layer, which aids injection of the electrons into the emitting layer, has a large electron mobility. The electron injecting layer is provided for adjusting energy level, by which, for instance, abrupt changes in the energy level can be reduced.
The organic EL device according to this exemplary embodiment preferably includes the electron injecting layer between the emitting layer and the cathode, and the electron injecting layer preferably contains a nitrogen-containing cyclic derivative as a main component. The electron injecting layer may serve as the electron transporting layer.
It should be noted that "as a main component" means that the nitrogen-containing cyclic derivative is contained in the electron injecting layer at a content of 50 mass% or more.

A preferable example of an electron transporting material for forming the electron injecting layer is an aromatic heterocyclic compound having at least one heteroatom in a molecule. Particularly, a nitrogen-containing cyclic derivative is preferable. The nitrogen-containing cyclic derivative is preferably an aromatic ring having a nitrogen-containing six-membered or five-membered ring skeleton, or a fused aromatic cyclic compound having a nitrogen-containing six-membered or five-membered ring skeleton.
The nitrogen-containing cyclic derivative is preferably exemplified by a nitrogen-containing cyclic metal chelate complex represented by the following formula (A).

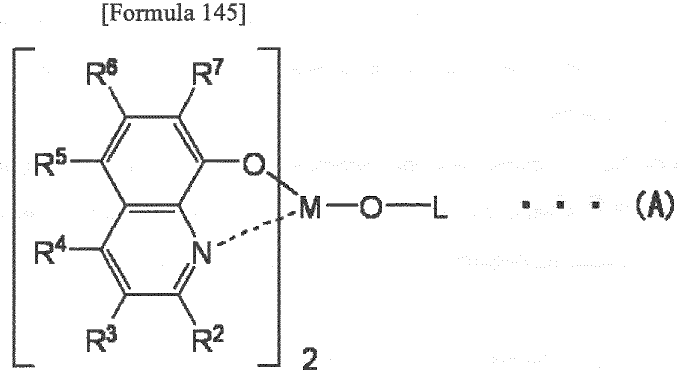

In the formula (A), R² to R⁷ each independently represent a hydrogen atom, a halogen atom, an oxy group, an amino group, a hydrocarbon group having 1 to 40 carbon atoms, an alkoxy group, an aryloxy group, an alkoxycarbonyl group or an aromatic heterocyclic group or fused aromatic heterocyclic group. R² to R⁷ may be substituted or unsubstituted.
Examples of the halogen atom include fluorine, chlorine, bromine, and iodine. In addition, examples of the substituted or unsubstituted amino group include an alkylamino group, arylamino group, and aralkylamino group.

The alkoxycarbonyl group is represented by -COOY'. Examples of Y' are the same as the examples of the alkyl group. The alkylamino group and the aralkylamino group are represented by -NQ¹Q². Examples for each of Q¹ and Q² are the same as the examples described in relation to the alkyl group and the aralkyl group, and preferred examples for each of Q¹ and Q² are also the same as those described in relation to the alkyl group and the aralkyl group. Either one of Q¹ and Q² may be a hydrogen atom.
The arylamino group is represented by -NAr¹Ar². Examples for each of Ar¹ and Ar² are the same as the examples described in relation to the non-fused aromatic hydrocarbon group and the fused aromatic hydrocarbon group. Either one of Ar¹ and Ar² may be a hydrogen atom.

M represents aluminum (Al), gallium (Ga) or indium (In), among which In is preferable.
L in the formula (A) represents a group represented by a formula (A') or (A") below.

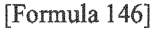

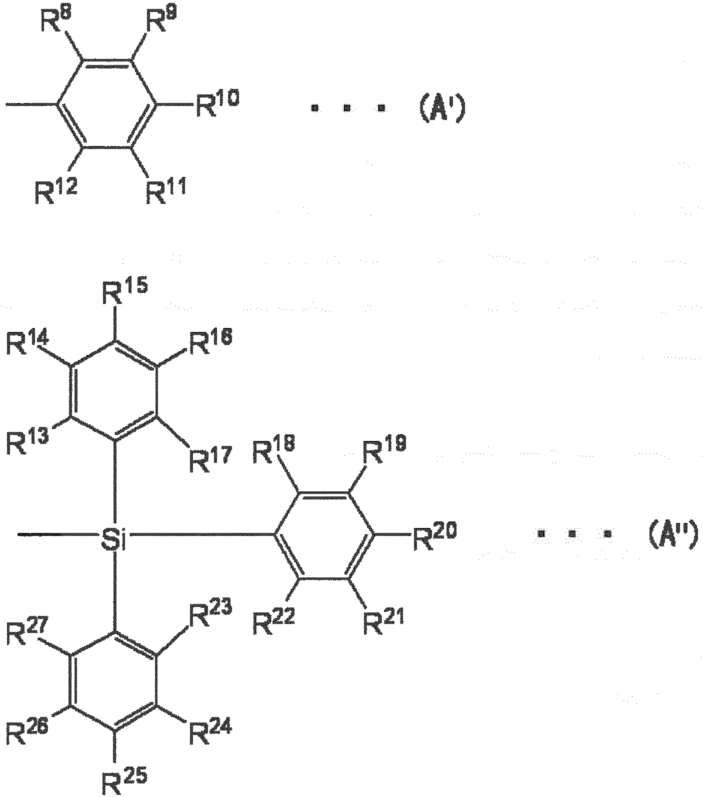

In the formula (A'), R⁸ to R¹² each independently represent a hydrogen atom or a substituted or unsubstituted hydrocarbon group having 1 to 40 carbon atoms. Adjacent groups may form a cyclic structure. In the formula (A"), R¹³ to R²⁷ each independently represent a hydrogen atom or a substituted or unsubstituted hydrocarbon group having 1 to 40 carbon atoms. Adjacent groups may form a cyclic structure.
Examples of the hydrocarbon group having 1 to 40 carbon atoms represented by each of R⁸ to R¹² and R¹³ to R²⁷ in the formulae (A') and (A") are the same as those of R² to R⁷ in the formula (A).
Examples of a divalent group formed when an adjacent set of R⁸ to R¹² and R¹³ to R²⁷ forms a cyclic structure are a tetramethylene group, a pentamethylene group, a hexamethylene group, a diphenylmethane-2,2'-diyl group, a diphenylethane-3,3'-diyl group, and a diphenylpropane-4,4'-diyl group.

Moreover, in this exemplary embodiment, the electron transporting layer may contain the biscarbazole derivatives represented by the formulae (1) to (3) (or the formulae (4) to (6)).

As an electron transporting compound used for the electron injecting layer or the electron transporting layer, 8-hydroxyquinoline or a metal complex of its derivative, an oxadiazole derivative, and a nitrogen-containing heterocyclic derivative are preferable. A specific example of the 8-hydroxyquinoline or the metal complex of its derivative is a metal chelate oxinoid compound containing a chelate of oxine (typically 8-quinolinol or 8-hydroxyquinoline). For instance, tris(8-quinolinol) aluminum can be used. Examples of the oxadiazole derivative are as follows.

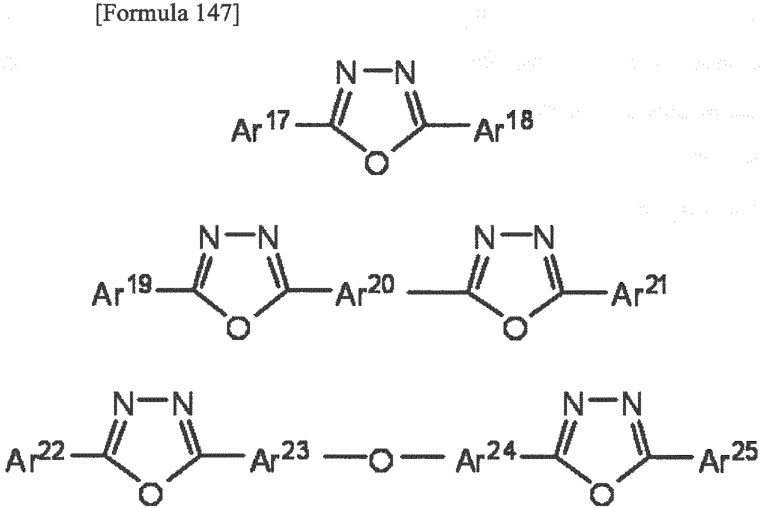

In the formulae, Ar¹⁷, Ar¹⁸, Ar¹⁹, Ar²¹, Ar²² and Ar²⁵ each represent a substituted or unsubstituted aromatic hydrocarbon group or fused aromatic hydrocarbon group having 6 to 40 ring carbon atoms. Ar¹⁷, Ar¹⁹ and Ar²² may be the same as or different from Ar¹⁸, Ar²¹ and Ar²⁵, respectively. Examples of the aromatic hydrocarbon group or fused aromatic hydrocarbon group having 6 to 40 ring carbon atoms are a phenyl group, a naphthyl group, a biphenyl group, an anthranil group, a perylenyl group and a pyrenyl group. Examples of the substituent therefor are an alkyl group having 1 to 10 carbon atoms, an alkoxy group having 1 to 10 carbon atoms and a cyano group.
Ar²⁰, Ar²³ and Ar²⁴ each represent a substituted or unsubstituted divalent aromatic hydrocarbon group or fused aromatic hydrocarbon group having 6 to 40 ring carbon atoms. Ar²³ and Ar²⁴ may be mutually the same or different.
Examples of the divalent aromatic hydrocarbon group or fused aromatic hydrocarbon group having 6 to 40 ring carbon atoms are a phenylene group, a naphthylene group, a biphenylene group, an anthranylene group, a perylenylene group and a pyrenylene group. Examples of the substituent therefor are an alkyl group having 1 to 10 carbon atoms, an alkoxy group having 1 to 10 carbon atoms and a cyano group.

Such an electron transporting compound is preferably an electron transporting compound that can be favorably formed into a thin film(s). Examples of the electron transport compound are as follows.

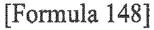

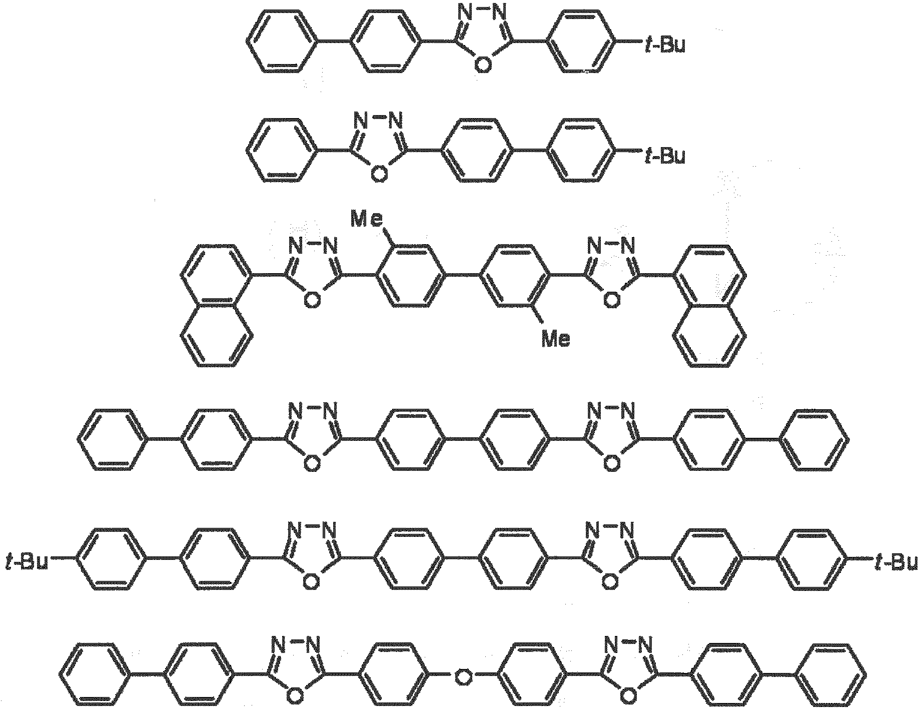

An example of the nitrogen-containing heterocyclic derivative as the electron transporting compound is a nitrogen-containing compound that is not a metal complex, the derivative being formed of an organic compound represented by one of the following general formulae. Examples of the nitrogen-containing heterocyclic derivative are a five-membered ring or six-membered ring derivative having a skeleton represented by the following formula (A) and a derivative having a structure represented by the following formula (B).

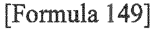

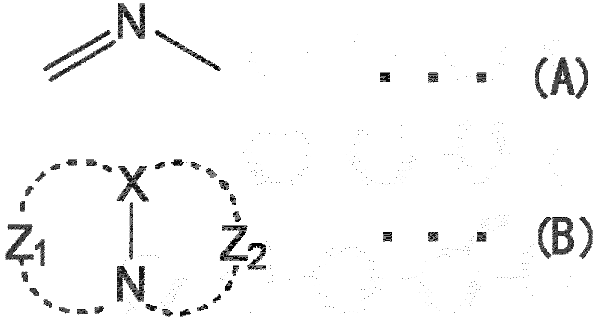

In the formula (B), X represents a carbon atom or a nitrogen atom. Z₁ and Z₂ each independently represent an atom group from which a nitrogen-containing heterocycle can be formed.

Preferably, the nitrogen-containing heterocyclic derivative is an organic compound having a nitrogen-containing aromatic polycyclic group having a five-membered ring or six-membered ring. Further, when the nitrogen-containing heterocyclic derivative is such a nitrogen-containing aromatic polycyclic group that contains plural nitrogen atoms, the nitrogen-containing heterocyclic derivative is preferably a nitrogen-containing aromatic polycyclic organic compound having a skeleton formed by a combination of the skeletons respectively represented by the formulae (A) and (B), or by a combination of the skeletons respectively represented by the formulae (A) and (C).

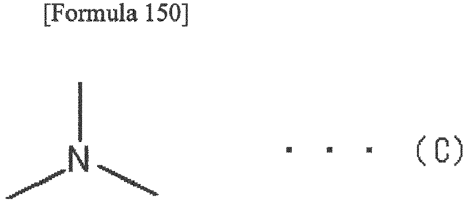

A nitrogen-containing group of the nitrogen-containing aromatic polycyclic organic compound is selected from nitrogen-containing heterocyclic groups respectively represented by the following general formulae.

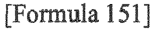

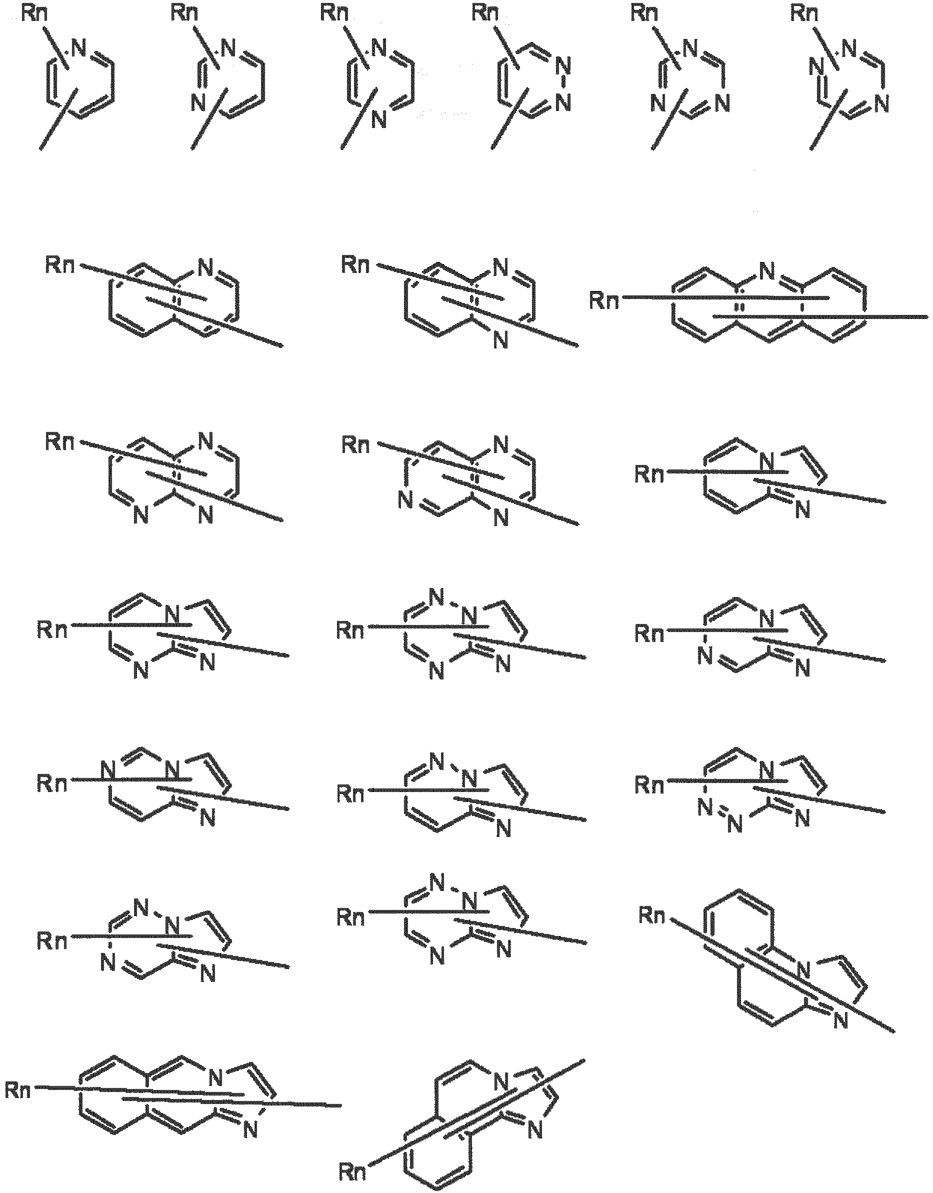

In the formulae: R represents an aromatic hydrocarbon group or fused aromatic hydrocarbon group having 6 to 40 ring carbon atoms, an aromatic heterocyclic group or fused aromatic heterocyclic group having 2 to 40 ring carbon atoms, an alkyl group having 1 to 20 carbon atoms or an alkoxy group having 1 to 20 carbon atoms; and n represents an integer in a range of 0 to 5. When n is an integer of 2 or more, plural R may be mutually the same or different.

A preferable specific compound is a nitrogen-containing heterocyclic derivative represented by the following formula.

HAr-L¹-Ar¹-Ar²

In the formula: HAr represents a substituted or unsubstituted nitrogen-containing heterocyclic group having 1 to 40 ring carbon atoms; L¹ represents a single bond, a substituted or unsubstituted aromatic hydrocarbon group or fused aromatic hydrocarbon group having 6 to 40 ring carbon atoms, or a substituted or unsubstituted aromatic heterocyclic group or fused aromatic heterocyclic group having 2 to 40 ring carbon atoms; Ar¹ represents a substituted or unsubstituted divalent aromatic hydrocarbon group having 6 to 40 ring carbon atoms; and Ar² represents a substituted or unsubstituted aromatic hydrocarbon group or fused aromatic hydrocarbon group having 6 to 40 ring carbon atoms, or a substituted or unsubstituted aromatic heterocyclic group or fused aromatic heterocyclic group having 2 to 40 ring carbon atoms.
HAr is exemplarily selected from the following group.

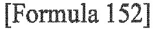

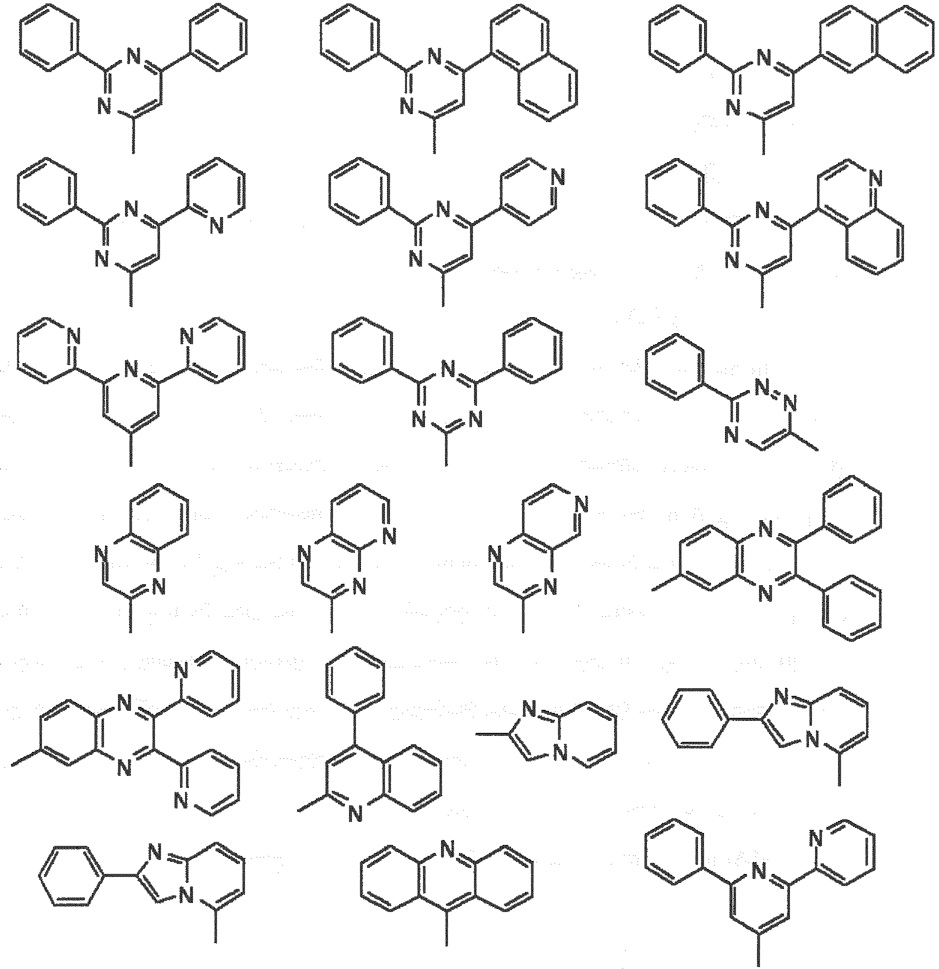

L¹ is exemplarily selected from the following group.

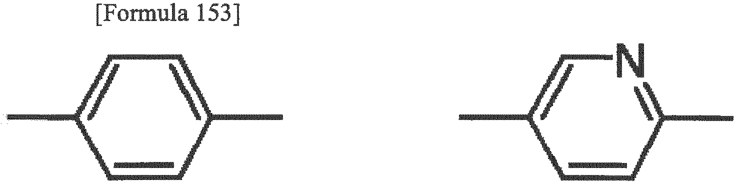

Ar¹ is exemplarily selected from the following arylanthranil group.

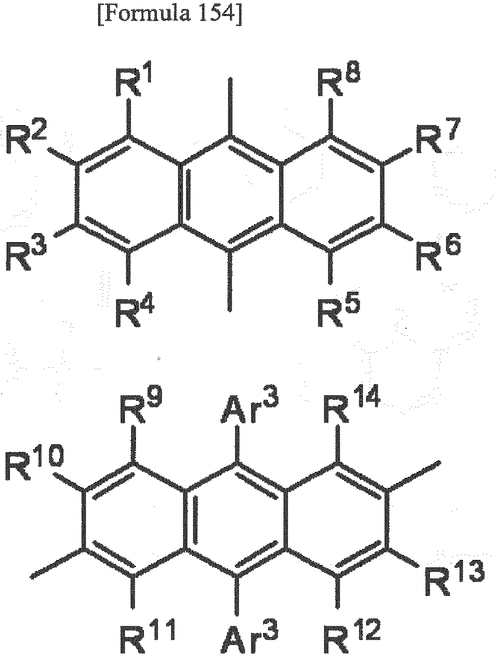

In the formulae: R¹ to R¹⁴ each independently represent a hydrogen atom, a halogen atom, an alkyl group having 1 to 20 carbon atoms, an alkoxy group having 1 to 20 carbon atoms, an aryloxy group having 6 to 40 ring carbon atoms, a substituted or unsubstituted aromatic hydrocarbon group or fused aromatic hydrocarbon group having 6 to 40 ring carbon atoms or an aromatic heterocyclic group or fused aromatic heterocyclic group having 2 to 40 ring carbon atoms; and Ar³ represents a substituted or unsubstituted aromatic hydrocarbon group or fused aromatic hydrocarbon group having 6 to 40 ring carbon atoms or an aromatic heterocyclic group or fused aromatic heterocyclic group having 2 to 40 ring carbon atoms.
All of R¹ to R⁸ of a nitrogen-containing heterocyclic derivative may be hydrogen atoms.

Ar² is exemplarily selected from the following group.

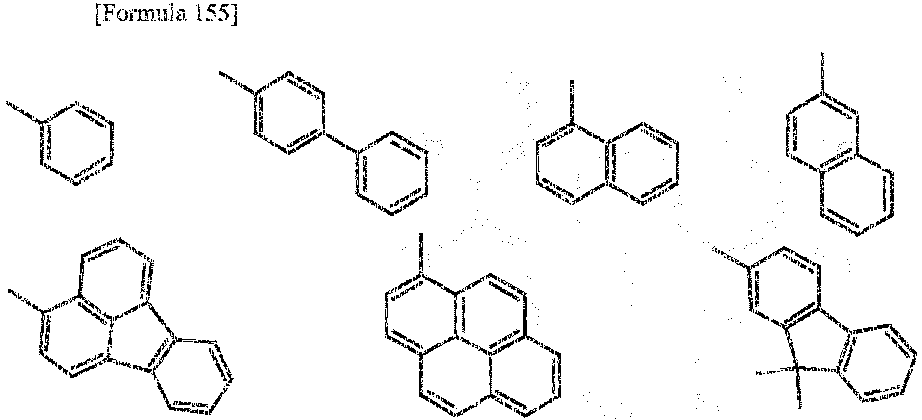

Other than the above, the following compound (see JP-A-9-3448) can be favorably used for the nitrogen-containing aromatic polycyclic organic compound as the electron transporting compound.

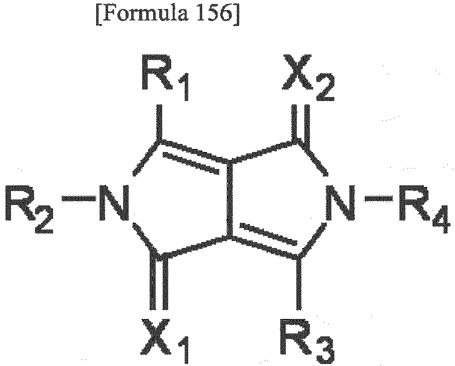

In the formula: R₁ to R₄ each independently represent a hydrogen atom, a substituted or unsubstituted aliphatic group, a substituted or unsubstituted alicyclic group, a substituted or unsubstituted carbocyclic aromatic cyclic group or a substituted or unsubstituted heterocyclic group; and X₁ and X₂ each independently represent an oxygen atom, a sulfur atom or a dicyanomethylene group.

The following compound (see JP-A-2000-173774) can also be favorably used for the electron transporting compound.

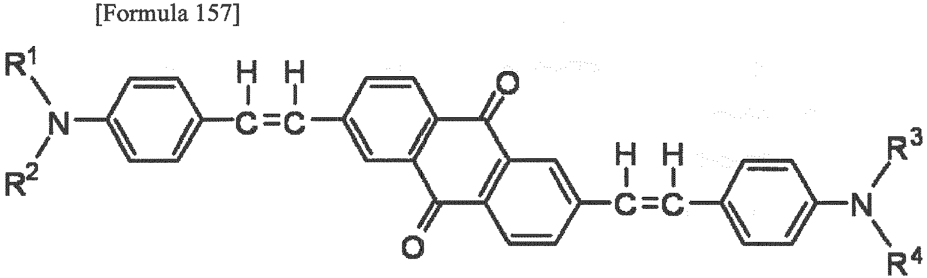

In the formula, R¹, R², R³ and R⁴, which may be mutually the same or different, each represent an aromatic hydrocarbon group or a fused aromatic hydrocarbon group represented by the following formula.

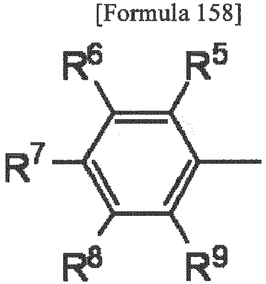

In the formula, R⁵, R⁶, R⁷, R⁸ and R⁹, which may be mutually the same or different, each represent a hydrogen atom, a saturated or unsaturated alkoxy group, an alkyl group, amino group or an alkylamino group. At least one of R⁵, R⁶, R⁷, R⁸ and R⁹ represents a saturated or unsaturated alkoxy group, an alkyl group, an amino group or an alkylamino group.

A polymer compound containing the nitrogen-containing heterocyclic group or a nitrogen-containing heterocyclic derivative may be used for the electron transporting compound.

The electron transporting layer preferably contains at least one of nitrogen-containing heterocycle derivatives respectively represented by the following formulae (201) to (203).

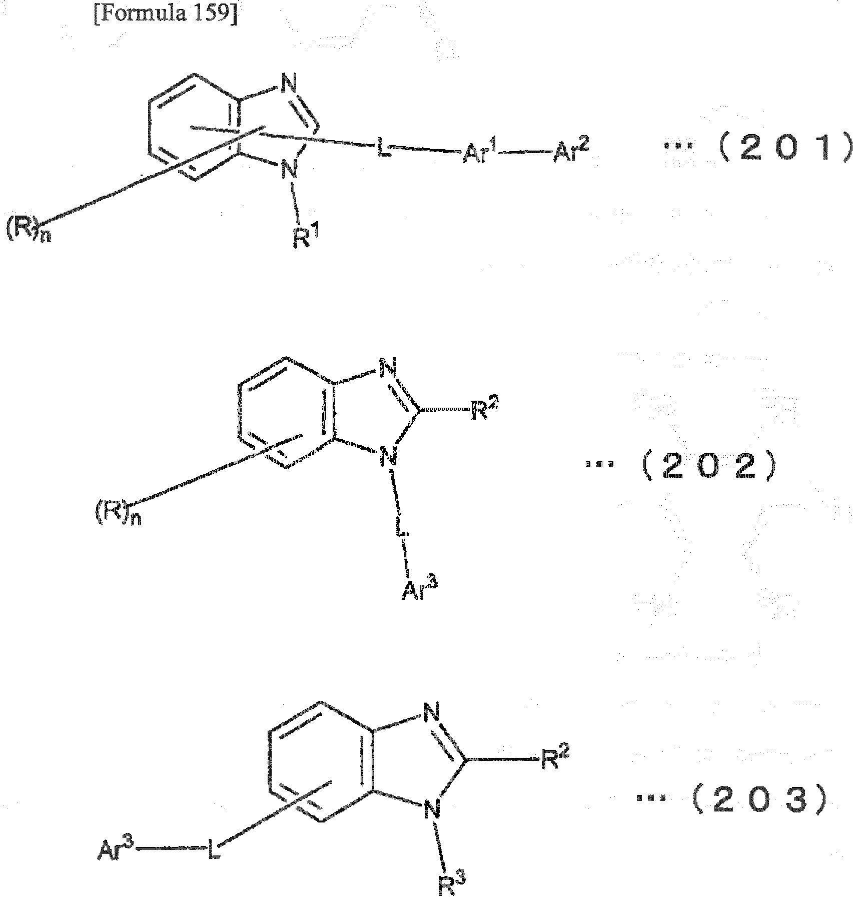

In the formulae (201) to (203), R represents a hydrogen atom, a substituted or unsubstituted aromatic hydrocarbon group or fused aromatic hydrocarbon group having 6 to 60 ring carbon atoms, a substituted or unsubstituted pyridyl group, a substituted or unsubstituted quinolyl group, a substituted or unsubstituted alkyl group having 1 to 20 carbon atoms, or a substituted or unsubstituted alkoxy group having 1 to 20 carbon atoms.
n represents an integer of 0 to 4.
R¹ represents a substituted or unsubstituted aromatic hydrocarbon group or fused aromatic hydrocarbon group having 6 to 60 ring carbon atoms, a substituted or unsubstituted pyridyl group, a substituted or unsubstituted quinolyl group, a substituted or unsubstituted alkyl group having 1 to 20 carbon atoms, or an alkoxy group having 1 to 20 carbon atoms.
R² and R³ each independently represents a hydrogen atom, a substituted or unsubstituted aromatic hydrocarbon group or fused aromatic hydrocarbon group having 6 to 60 ring carbon atoms, a substituted or unsubstituted pyridyl group, a substituted or unsubstituted quinolyl group, a substituted or unsubstituted alkyl group having 1 to 20 carbon atoms, or a substituted or unsubstituted alkoxy group having 1 to 20 carbon atoms.
L represents a substituted or unsubstituted aromatic hydrocarbon group or fused aromatic hydrocarbon group having 6 to 60 ring carbon atoms, a substituted or unsubstituted pyridinylene group, a substituted or unsubstituted quinolinylene group, or a substituted or unsubstituted fluorenylene group.
Ar¹ represents a substituted or unsubstituted aromatic hydrocarbon group or fused aromatic hydrocarbon group having 6 to 60 ring carbon atoms, a substituted or unsubstituted pyridinylene group, or a substituted or unsubstituted quinolinylene group. Ar² represents substituted or unsubstituted aromatic hydrocarbon group or fused aromatic hydrocarbon group having 6 to 60 ring carbon atoms, a substituted or unsubstituted pyridyl group, a substituted or unsubstituted quinolyl group, a substituted or unsubstituted alkyl group having 1 to 20 carbon atoms, or a substituted or unsubstituted alkoxy group having 1 to 20 carbon atom.

Ar³ represents a substituted or unsubstituted aromatic hydrocarbon group or fused aromatic hydrocarbon group having 6 to 60 ring carbon atoms, a substituted or unsubstituted pyridyl group, a substituted or unsubstituted quinolyl group, a substituted or unsubstituted alkyl group having 1 to 20 carbon atoms, a substituted or unsubstituted alkoxy group having 1 to 20 carbon atoms, or a group represented by -Ar¹-Ar² (Ar¹ and Ar² may be the same as the above).
In the formulae (201) to (203), R represents a hydrogen atom, a substituted or unsubstituted aromatic hydrocarbon group or fused aromatic hydrocarbon group having 6 to 60 ring carbon atoms, a substituted or unsubstituted pyridyl group, a substituted or unsubstituted quinolyl group, a substituted or unsubstituted alkyl group having 1 to 20 carbon atoms, or a substituted or unsubstituted alkoxy group having 1 to 20 carbon atoms.

Although a thickness of the electron injecting layer or the electron transporting layer is not specifically limited, the thickness is preferably 1 nm to 100 nm.
The electron injecting layer preferably contains an inorganic compound such as an insulator or a semiconductor in addition to the nitrogen-containing cyclic derivative. Such an insulator or a semiconductor, when contained in the electron injecting layer, can effectively prevent a current leak, thereby enhancing electron capability of the electron injecting layer.

As the insulator, it is preferable to use at least one metal compound selected from the group consisting of an alkali metal chalcogenide, an alkali earth metal chalcogenide, an alkali metal halide and an alkaline earth metal halide. By forming the electron injecting layer from the alkali metal chalcogenide or the like, the electron injecting capability can preferably be further enhanced. Specifically, preferred examples of the alkali metal chalcogenide are Li₂0, K₂O, Na₂S, Na₂Se and Na₂O, while preferable example of the alkaline earth metal chalcogenide are CaO, BaO, SrO, BeO, BaS and CaSe. Preferred examples of the alkali metal halide are LiF, NaF, KF, LiCl, KCl and NaCl. Preferred examples of the alkaline earth metal halide are fluorides such as CaF₂, BaF₂, SrF₂, MgF₂ and BeF₂, and halides other than the fluoride.

Examples of the semiconductor are one of or a combination of two or more of an oxide, a nitride or an oxidized nitride containing at least one element selected from Ba, Ca, Sr, Yb, Al, Ga, In, Li, Na, Cd, Mg, Si, Ta, Sb and Zn. An inorganic compound for forming the electron injecting layer is preferably a microcrystalline or amorphous semiconductor film. When the electron injecting layer is formed of such semiconductor film, more uniform thin film can be formed, thereby reducing pixel defects such as a dark spot. Examples of such an inorganic compound are an alkali metal chalcogenide, an alkaline earth metal chalcogenide, an alkali metal halide and an alkaline earth metal halide.
When the electron injecting layer contains such an insulator or semiconductor, a thickness thereof is preferably in a range of approximately 0.1 nm to 15 nm. The electron injecting layer according to this exemplary may preferably contain the above-described reduction-causing dopant.

### Hole Injecting Layer and Hole Transporting Layer

The hole injecting layer or the hole transporting layer (including the hole injecting/transporting layer) may contain an aromatic amine compound such as an aromatic amine derivative represented by the following formula (I).

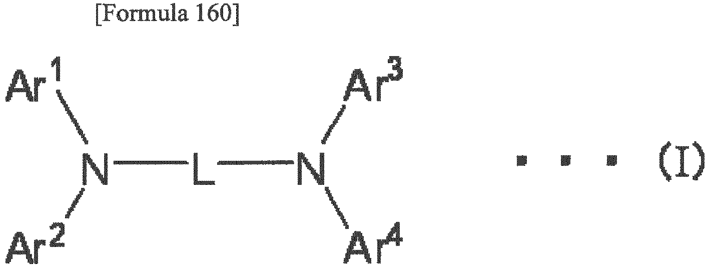

In the above (I), Ar¹ to Ar⁴ each represent a substituted or unsubstituted aromatic hydrocarbon group or fused aromatic hydrocarbon group having 6 to 50 ring carbon atoms, a substituted or unsubstituted aromatic heterocyclic group or fused aromatic heterocyclic group having 2 to 40 ring carbon atoms, or a group formed by combining the aromatic hydrocarbon group or the fused aromatic hydrocarbon group with the aromatic heterocyclic group or fused aromatic heterocyclic group.

Examples of the compound represented by the formula (I) are shown below. However, the compound represented by the formula (I) is not limited thereto.

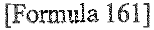

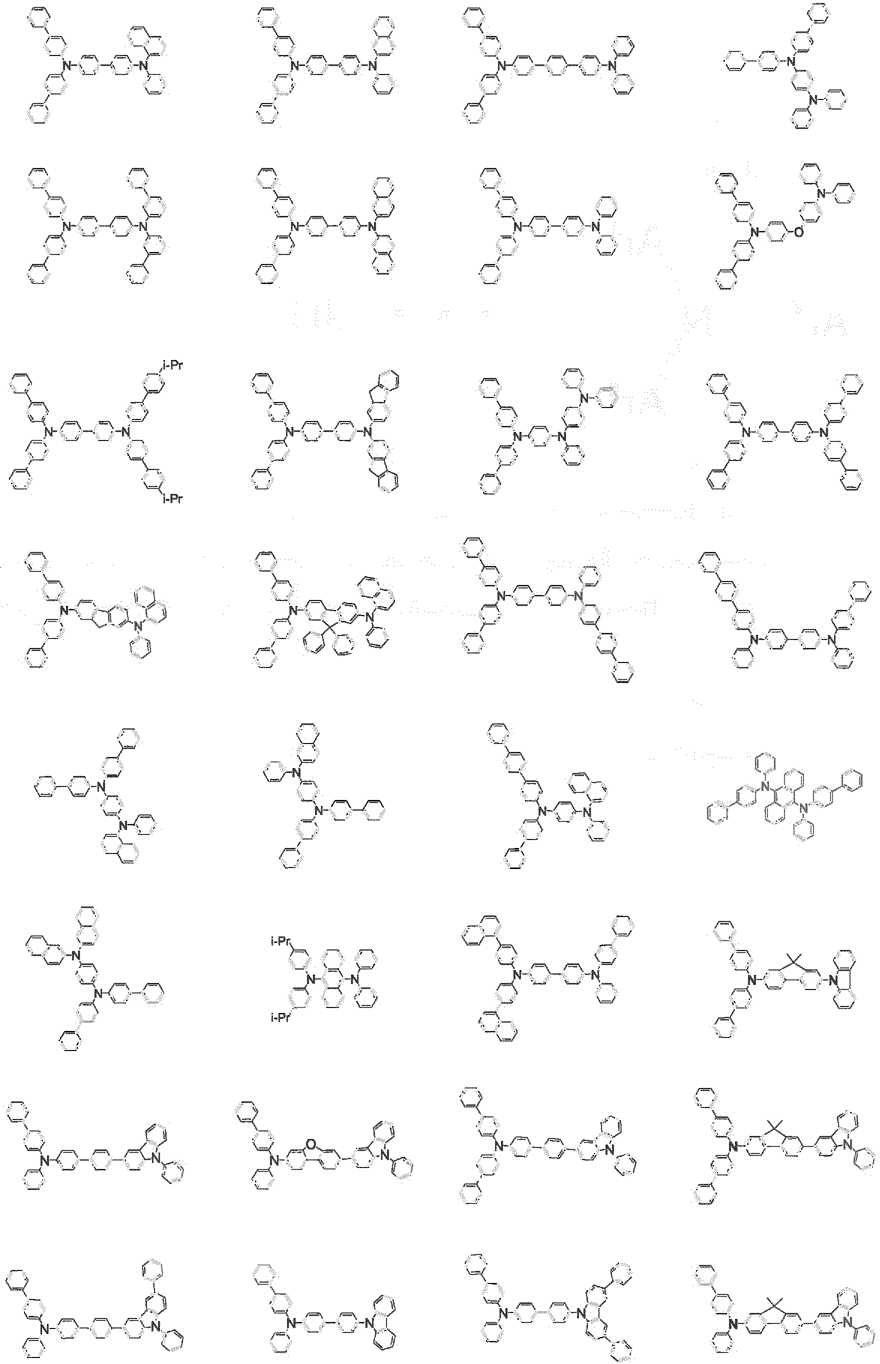

Aromatic amine represented by the following (II) can also be preferably used for forming the hole injecting layer or the hole transporting layer.

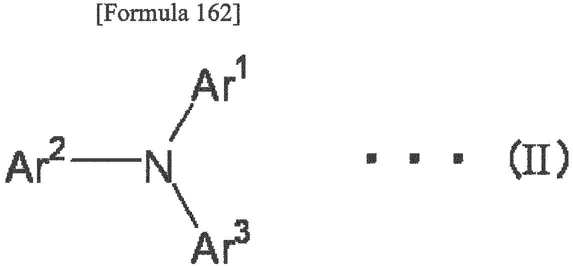

In the formula (II), Ar¹ to Ar³ each represent the same as those represented by Ar¹ to Ar⁴ of the above (I). Examples of the compound represented by the general formula (II) are shown below. However, the compound represented by the formula (II) is not limited thereto.

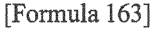

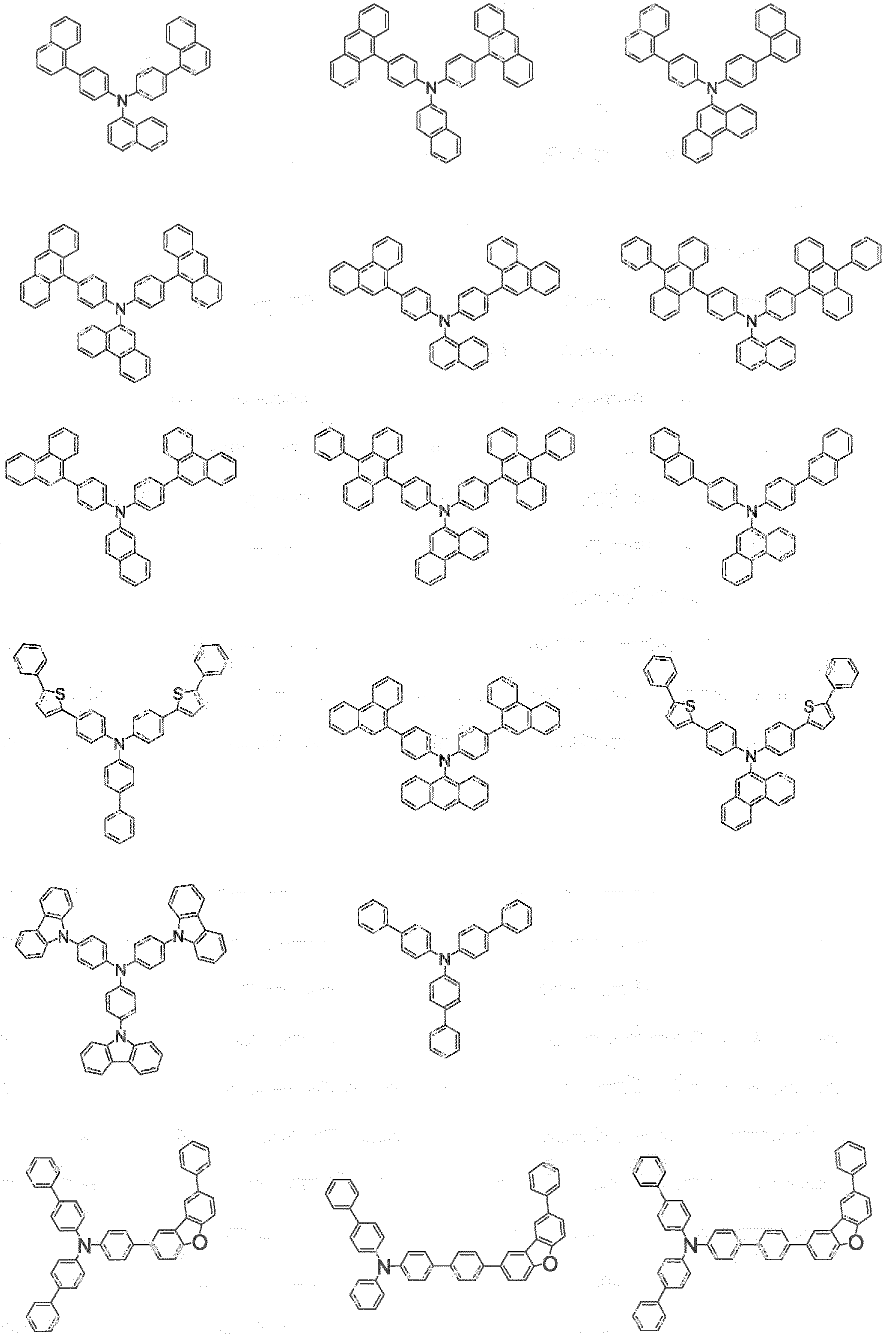

It should be noted that the invention is not limited to the above description but may include any modification as long as such modification stays within a scope and a spirit of the present invention.
For instance, the following is a preferable example of such modification made to the invention.

In the invention, the emitting layer may also preferably contain an assistance substance for assisting injection of charges.
When the emitting layer is formed of a host material having a wide energy gap, a difference in ionization potential (Ip) between the host material and the hole injecting/transporting layer etc. becomes so large that injection of the holes into the emitting layer becomes difficult, which may cause a rise in a driving voltage required for providing sufficient luminance.
In the above instance, introducing a hole-injectable or hole-transportable assistance substance for assisting injection of charges in the emitting layer can contribute to facilitation of the injection of the holes into the emitting layer and to reduction of the driving voltage.

As the assistance substance for assisting the injection of charges, for instance, a general hole injecting material, a general hole transporting material or the like can be used.
Examples of the assistance material are a triazole derivative (see, for instance, the specification of US Patent No. 3,112,197), an oxadiazole derivative (see, for instance, the specification of US Patent No. 3,189,447), an imidazole derivative (see, for instance, JP-B-37-16096), a polyarylalkane derivative (see, for instance, the specifications of US Patent No. 3,615,402, No.3,820,989 and No. 3,542,544, JP-B-45-555, JP-B-51-10983, JP-A-51-93224, JP-A-55-17105, JP-A-56-4148, JP-A-55-108667, JP-A-55-156953, and JP-A-56-36656), a pyrazoline derivative and a pyrazolone derivative (see, for instance, the specifications of US Patent No. 3,180,729 and No. 4,278,746, JP-A-55-88064, JP-A-55-88065, JP-49-105537, JP-A-55-51086, JP-A-56-80051, JP-A-56-88141, JP-A-57-45545, JP-A-54-112637 and JP-A-55-74546), a phenylenediamine derivative (see, for instance, the specification of US Patent No. 3,615,404, JP-B-51-10105, JP-B-46-3712, JP-B-47-25336, JP-A-54-53435, JP-A-54-110536 and JP-A-54-119925), an arylamine derivative (see, for instance, the specifications of US Patent No. 3,567,450, No. 3,180,703, No. 3,240,597, No. 3,658,520, No. 4,232,103, No. 4,175,961 and No. 4,012,376, JP-B-49-35702, JP-B-39-27577, JP-A-55-144250, JP-A-56-119132 and JP-A-56-22437 and the specification of West Germany Patent No. 1,110,518), an amino-substituted chalcone derivative (see, for instance, the specification of US Patent No. 3,526,501), an oxazole derivative (disclosed in, for instance, the specification of US Patent No. 3,257,203), a styrylanthracene derivative (see, for instance, JP-A-56-46234), a fluorenone derivative (see, for instance, JP-A-54-110837), a hydrazone derivative (see, for instance, the specification of US Patent No. 3,717,462 and JP-A-54-59143, JP-A-55-52063, JP-A-55-52064, JP-A-55-46760, JP-A-55-85495, JP-A-57-11350, JP-A-57-148749 and JP-A-02-311591), a stilbene derivative (see, for instance, JP-A-61-210363, JP-A-61-228451, JP-A-61-14642, JP-A-61-72255, JP-A-62-47646, JP-A-62-36674, JP-A-62-10652, JP-A-62-30255, JP-A-60-93455, JP-A-60-94462, JP-A-60-174749 and JP-A-60-175052), a silazane derivative (see the specification of US Patent No. 4,950,950), a polysilane type (see JP-A-02-204996), an aniline-based copolymer (see JP-A-02-282263), and a conductive polymer oligomer (particularly, thiophene oligomer) disclosed in JP-A-01-211399.

The hole-injectable material, examples of which are as listed above, is preferably a porphyrin compound (disclosed in JP-A-63-295695 etc.), an aromatic tertiary amine compound or a styrylamine compound (see, for instance, the specification of US Patent No. 4,127,412, JP-A-53-27033, JP-A-54-58445, JP-A-54-149634, JP-A-54-64299, JP-A-55-79450, JP-A-55-144250, JP-A-56-119132, JP-A-61-295558, JP-A-61-98353 or JP-A-63-295695), particularly preferably an aromatic tertiary amine compound.

In addition, 4,4'-bis(N-(1-naphthyl)-N-phenylamino)biphenyl (hereinafter, abbreviated as NPD) having two fused aromatic rings in the molecule as disclosed in US Patent No. 5,061,569, or 4,4',4"tris(N-(3-methylphenyl)-N-phenylamino)triphenylamine (hereinafter, abbreviated as MTDATA) in which three triphenylamine units are bonded in a starburst form as disclosed in JP-A-04-308688 and the like may also be used..
Further, a hexaazatriphenylene derivative disclosed in Japanese Patent No. 3614405 and No. 3571977 and US Patent No. 4,780,536 may also preferably be used as the hole-injectable material.
Alternatively, inorganic compounds such as p-type Si and p-type SiC can also be used as the hole-injecting material.

A method of forming each of the layers in the organic EL device of the invention is not particularly limited. A conventionally-known method such as vacuum deposition or spin coating may be employed for forming the layers. The organic thin-film layer containing the compound represented by the formula (1), which is used in the organic EL device of the invention, may be formed by a conventional coating method such as vacuum deposition, molecular beam epitaxy (MBE method) and coating methods using a solution such as a dipping, spin coating, casting, bar coating, and roll coating.

Although the thickness of each organic layer of the organic EL device is not particularly limited in the invention, the thickness is generally preferably in a range of several nanometers to 1 µm because an excessively-thinned film likely entails defects such as a pin hole while an excessively-thickened film requires high voltage to be applied and deteriorates efficiency.

### Examples

Next, the invention will be described in further detail by exemplifying Example(s) and Comparative(s). However, the invention is not limited by the description of Example(s).

### Example 1 (Manufacture of Organic EL Device 1)

A glass substrate (size: 25 mm x 75 mm x 1.1 mm) having an ITO transparent electrode (manufactured by Geomatec Co., Ltd.) was ultrasonic-cleaned in isopropyl alcohol for five minutes, and then UV (Ultraviolet)/ozone-cleaned for 30 minutes.
After the glass substrate having the transparent electrode line was cleaned, the glass substrate was mounted on a substrate holder of a vacuum deposition apparatus, and a 40-nm thick film of a compound I was initially vapor-deposited on a surface of the glass substrate where the transparent electrode line was provided so as to cover the transparent electrode, thereby obtaining a hole injecting layer. Next, a compound II was deposited onto the hole injecting layer to be 20 nm thick, and a hole transporting layer was obtained.
On the hole transporting layer, the compound No. A-1 as a phosphorescent host, a compound No. B-1 as a phosphorescent host and an Ir(Ph-ppy)₃ as a phosphorescent dopant were co-evaporated (thickness: 50 nm), thereby obtaining a phosphorescent-emitting layer. In the phosphorescent-emitting layer, the concentration of the compound A-1 was 42.5 mass%, the concentration of a compound B-1 was 42.5 mass% and the concentration of Ir(Ph-ppy)₃ was 15 mass%. Subsequently, a 30-nm thick film of a compound III, a 1-nm thick film of LiF, an 80-nm thick film of a metal A1 are sequentially laminated on the phosphorescent-emitting layer, thereby obtaining a cathode. LiF, which is an electron injectable electrode, was formed at a speed of 1 Å/min.

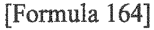

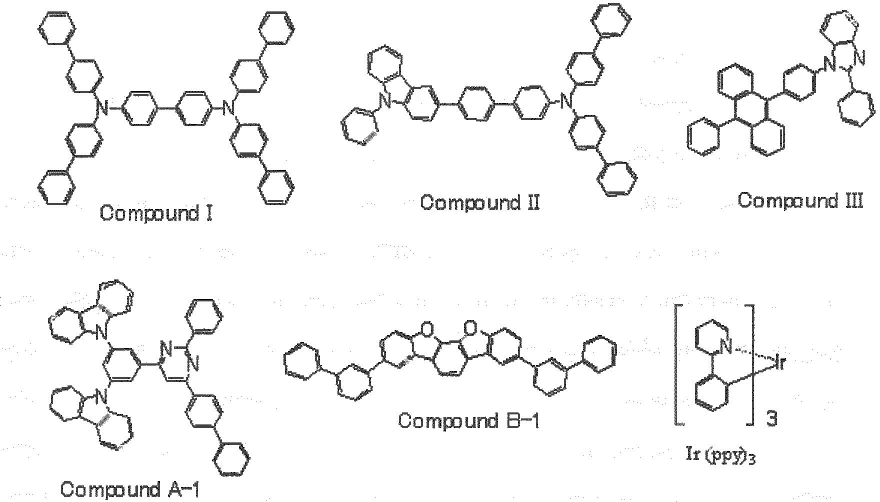

### Evaluation on Luminescent Performance of Organic EL Device

The organic EL devices each manufactured as described above were driven by direct-current electricity to emit light, so that luminance intensity and current density were measured to obtain voltage and luminous efficiency at a current density of 1 mA/cm². Further, time elapsed until the initial luminance intensity of 20,000 cd/m² was reduced to the half (i.e., time until half-life) was obtained. Table 4 shows evaluation results of luminescent performance of Example 1 and later-described Examples 2 to 7 and Comparatives 1 to 2.

### Example 2

An organic EL device in Example 2 was formed and evaluated in the same manner as in Example 1 except that the host compound B-1 was replaced by a host compound B-2.

### Example 3

An organic EL device in Example 3 was formed and evaluated in the same manner as in Example 1 except that the host compound B-1 was replaced by a host compound B-3.

### Example 4

An organic EL device in Example 4 was formed and evaluated in the same manner as in Example 1 except that the host compound A-1 was replaced by a host compound A-2.

### Example 5

An organic EL device in Example 5 was formed and evaluated in the same manner as in Example 1 except that the host compound A-1 was replaced by a host compound A-3.

### Example 6

An organic EL device in Example 6 was formed and evaluated in the same manner as in Example 1 except that the host compound A-1 and the host compound B-1 were respectively replaced by a host compound A-4 and the host compound B-2. The evaluation results of luminescent performance are shown in Table 4.

### Example 7

An organic EL device in Example 7 was formed and evaluated in the same manner as in Example 1 except that the host compound A-1 and the host compound B-1 were respectively replaced by the host compound A-4 and a host compound B-4.

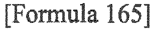

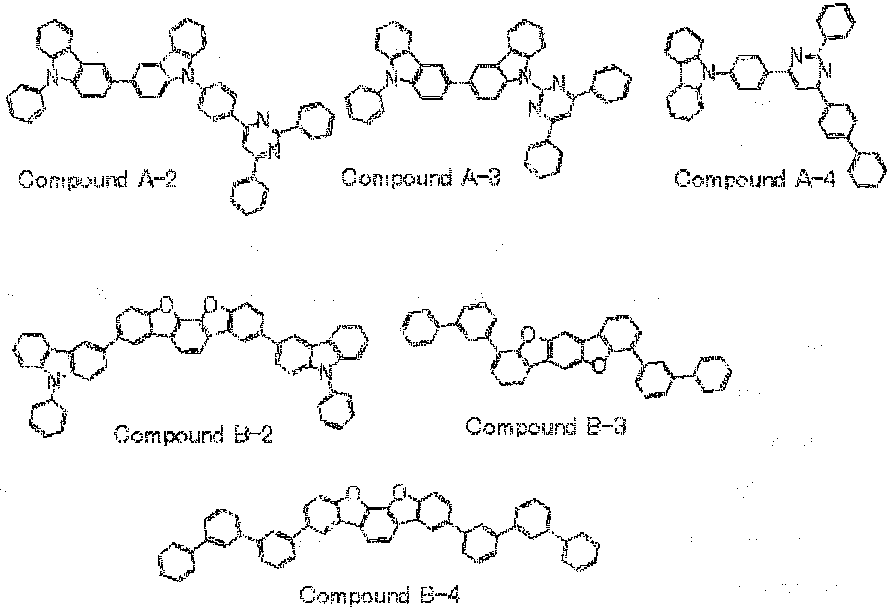

### Comparative 1

A glass substrate (size: 25 mm × 75 mm × 1.1 mm) having an ITO transparent electrode (manufactured by Geomatec Co., Ltd.) was ultrasonic-cleaned in isopropyl alcohol for five minutes, and then UV (Ultraviolet)/ozone-cleaned for 30 minutes.
After the glass substrate having the transparent electrode line was cleaned, the glass substrate was mounted on a substrate holder of a vacuum deposition apparatus, and a 40-nm thick film of the compound I was initially vapor-deposited on a surface of the glass substrate where the transparent electrode line was provided so as to cover the transparent electrode, thereby obtaining a hole injecting layer. Next, the compound II was deposited onto the hole injecting layer to be 20 nm thick, and a hole transporting layer was obtained.
On the hole transporting layer, the compound A-1 as a phosphorescent host and Ir(Ph-ppy)₃ as a phosphorescent dopant were co-evaporated (thickness: 50 nm), thereby obtaining a phosphorescent-emitting layer. In the phosphorescent-emitting layer, the concentration of the compound A-1 was 85 mass% and the concentration of Ir(Ph-ppy)₃ was 15 mass%.
Subsequently, a 30-nm thick film of the compound III, a 1-nm thick film of LiF, an 80-nm thick film of a metal A1 are sequentially laminated on the phosphorescent-emitting layer, thereby obtaining a cathode. LiF, which is an electron injectable electrode, was formed at a speed of 1 Å/min.

### Comparative 2

An organic EL device in Comparative 2 was formed and evaluated in the same manner as in Comparative 1 except that the host compound A-1 was replaced by the host compound B-1.

**Table 4**

| | Host Compound | Voltage (V) | Luminous Efficiency (cd/A) | Time Until Half-life (hrs) (@ Initial Luminance Intensity 20000 cd/m²) |
|---|---|---|---|---|
| | | (@1mA/cm²) | (@1mA/cm²) | |
| Example 1 | A-1 | 3.1 | 56 | 500 |
| | B-1 | | | |
| Example 2 | A-1 | 3.2 | 54 | 400 |
| | B-2 | | | |
| Example 3 | A-1 | 3.0 | 54 | 400 |
| | B-3 | | | |
| Example 4 | A-2 | 3.5 | 55 | 500 |
| | B-1 | | | |
| Example 5 | A-3 | 3.8 | 55 | 500 |
| | B-1 | | | |
| Example 6 | A-4 | 2.9 | 52 | 300 |
| | B-2 | | | |
| Example 7 | A-4 | 3.1 | 57 | 200 |
| | B-4 | | | |
| Comp. 1 | A-1 | 2.8 | 58 | 50 |
| Comp. 2 | B-1 | 5.2 | 31 | 300 |

As shown in Table 4, the organic EL devices of Examples had a significantly longer time until half-life than the organic EL devices of Comparative. The organic EL device in which only the compound having a benzofurano dibenzofuran structure in a molecule as described herein (e.g., the compound B-1) was used in the emitting layer required a higher drive voltage than the organic EL devices of Examples of the invention.

As described above in detail, with combined usage of the compounds according to the invention, an organic EL device exhibiting a significantly longer time until half-life is obtainable. Moreover, an organic EL device exhibiting a high luminous efficiency and being emittable at low drive voltage is obtainable. Accordingly, the organic EL device of the invention is significantly usable as a light source of various electronic devices and the like. Moreover, the compound of the invention is effectively usable as an organic electronic device material for an organic solar cell, an organic semiconductor laser, a sensor using an organic substance and an organic TFT.

### INDUSTRIAL APPLICABILITY

The invention is applicable as an organic EL device having a long lifetime and a high luminous efficiency and being capable of being driven at a low voltage, which is required for saving power consumption.

### EXPLANATION OF CODES

| | |
|---|---|
| 1 | organic electroluminescence device |
| 2 | substrate |
| 3 | anode |
| 4 | cathode |
| 5 | phosphorescent-emitting layer |
| 6 | hole injecting/transporting layer |
| 7 | electron injecting/transporting layer |
| 10 | organic thin-film layer |

## Claims

1. An organic electroluminescence device comprising:
an anode;
a cathode; and
an organic thin-film layer provided between the anode and the cathode, wherein
the organic thin-film layer comprises an emitting layer that at least comprises a first host, a second host and a luminous dopant,
the first host is a compound comprising one or more carbazolyl groups and one or more nitrogen-containing heterocyclic groups in a molecule, and
the second host is a compound represented by a formula (1) or (2) below, 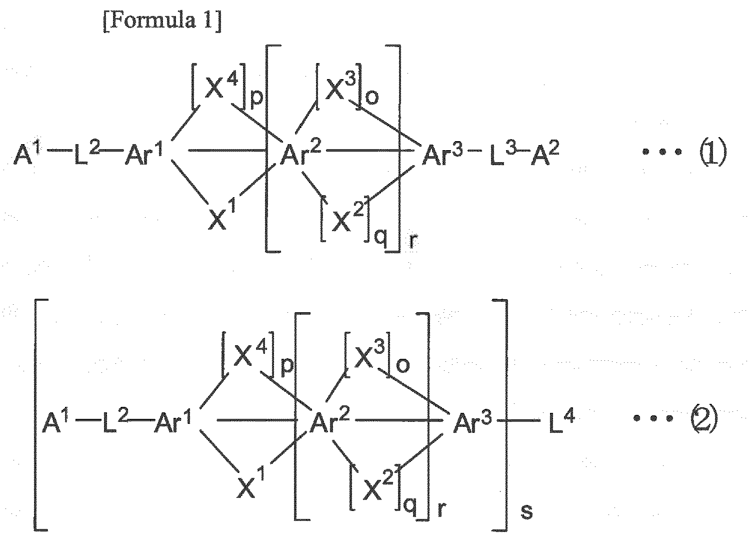 where: Ar¹, Ar² and Ar³ each independently represent a substituted or unsubstituted aromatic hydrocarbon group having 6 ring carbon atoms or a substituted or unsubstituted aromatic heterocyclic group having 6 ring atoms;
Ar¹, Ar² and Ar³ are allowed to have one or more substituents Y;
a plurality of Y are allowed to be mutually different;
Y represents an alkyl group having 1 to 20 carbon atoms, a substituted or unsubstituted cycloalkyl group having 3 to 20 ring carbon atoms, an alkoxy group having 1 to 20 carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms;
X¹, X², X³ and X⁴ each independently represent oxygen (O), sulfur (S), N-R¹ or CR₂R₃;
R¹, R² and R³ independently represent an alkyl group having 1 to 20 carbon atoms, a substituted or unsubstituted cycloalkyl group having 3 to 20 ring carbon atoms, an aralkyl group having 7 to 24 carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms;
when both of X₁ and X₂ represent N-R₁, o and p are 0, and q is 1, or when both of X₁ and X₃ represent N-R1, p and q are 0, and o is 1, at least one R¹ represents a substituted or unsubstituted monovalent fused aromatic heterocyclic group having 8 to 24 ring atoms;
o, p and q represent 0 or 1; s represents 1, 2, 3 or 4, which respectively mean a monomer, a dimer, a trimer and a tetramer, each of which uses L⁴ as a linking group;
r represents 1, 2, 3 or 4;
L² represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted monovalent or divalent aromatic heterocyclic group or fused aromatic heterocyclic group having 3 to 24 ring carbon atoms;
L³ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring carbon atoms;
when s is 2, L⁴ represents a single bond, an alkylene group having 1 to 20 carbon atoms, a substituted or unsubstituted cycloalkylene group having 3 to 20 ring carbon atoms, a divalent silyl group, a divalent substituted-silyl group having 2 to 20 carbon atoms, a substituted or unsubstituted divalent aromatic hydrocarbon group or fused aromatic hydrocarbon group having 6 to 24 ring carbon atoms, or a substituted or unsubstituted divalent aromatic heterocyclic group or fused aromatic heterocyclic group having 3 to 24 ring carbon atoms;
when s is 3, L⁴ represents a trivalent saturated hydrocarbon group having 1 to 20 carbon atoms, a substituted or unsubstituted trivalent saturated cyclic hydrocarbon group having 3 to 20 ring carbon atoms, a trivalent silyl group, a trivalent substituted-silyl group having 1 to 20 carbon atoms, a substituted or unsubstituted trivalent aromatic hydrocarbon group or fused aromatic hydrocarbon group having 6 to 24 ring carbon atoms, or a substituted or unsubstituted trivalent aromatic heterocyclic group or fused aromatic heterocyclic group having 3 to 24 ring carbon atoms;
when s is 4, L⁴ represents a tetravalent saturated hydrocarbon group having 1 to 20 carbon atoms, a substituted or unsubstituted tetravalent saturated cyclic hydrocarbon group having 3 to 20 ring carbon atoms, a silicon atom, a substituted or unsubstituted tetravalent aromatic hydrocarbon group or fused aromatic hydrocarbon group having 6 to 24 ring carbon atoms, or a substituted or unsubstituted tetravalent aromatic heterocyclic group or fused aromatic heterocyclic group having 3 to 24 ring carbon atoms;
A¹ represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms; and
A² represents a hydrogen atom, a substituted or unsubstituted cycloalkyl group having 3 to 20 ring carbon atoms, a silyl group, a substituted-silyl group having 3 to 20 carbon atoms, a substituted or unsubstituted aromatic hydrocarbon group or fused aromatic hydrocarbon group having 6 to 24 ring carbon atoms, or a substituted or unsubstituted aromatic heterocyclic group or fused aromatic heterocyclic group having 3 to 24 ring carbon atoms.

2. The organic electroluminescence device according to claim 1, wherein one of X¹ and X⁴ is an oxygen atom, or one of X² and X³ is an oxygen atom, and the compounds represented by the formulae (1) and (2) each have a dibenzofuran structure in a molecule.

3. The organic electroluminescence device according to claim 2, wherein one of X¹ and X⁴ is an oxygen atom, and one of X² and X³ is an oxygen atom, and the compounds represented by the formulae (1) and (2) each have a benzofurano dibenzofuran structure.

4. The organic electroluminescence device according to any one of claims 1 to 3, wherein the first host is represented by any one of formulae (3) to (5) below, 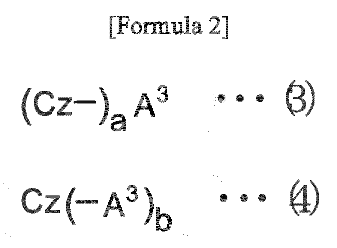 where: Cz represents a substituted or unsubstituted arylcarbazolyl group or carbazolylaryl group; A³ represents a group represented by a formula (A) below; and a and b each represent an integer of 1 to 3, 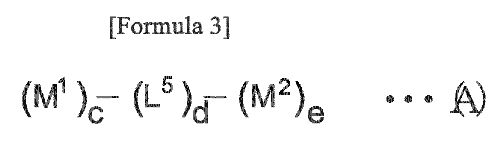 where: M¹ and M² each independently represent a substituted or unsubstituted nitrogen-containing aromatic heterocyclic ring or a nitrogen-containing fused aromatic heterocyclic ring having 2 to 40 ring carbon atoms; and M¹ and M² are allowed to be the same or different;
L⁵ represents a single bond, a substituted or unsubstituted aromatic hydrocarbon group or fused aromatic hydrocarbon group having 6 to 30 carbon atoms, a substituted or unsubstituted cycloalkylene group having 5 to 30 carbon atoms, or a substituted or unsubstituted aromatic heterocyclic group or fused aromatic heterocyclic group having 2 to 30 carbon atoms; and
c represents an integer of 0 to 2, d represents an integer of 1 or 2, and e represents an integer of 0 to 2, provided that c+e is 1 or more, 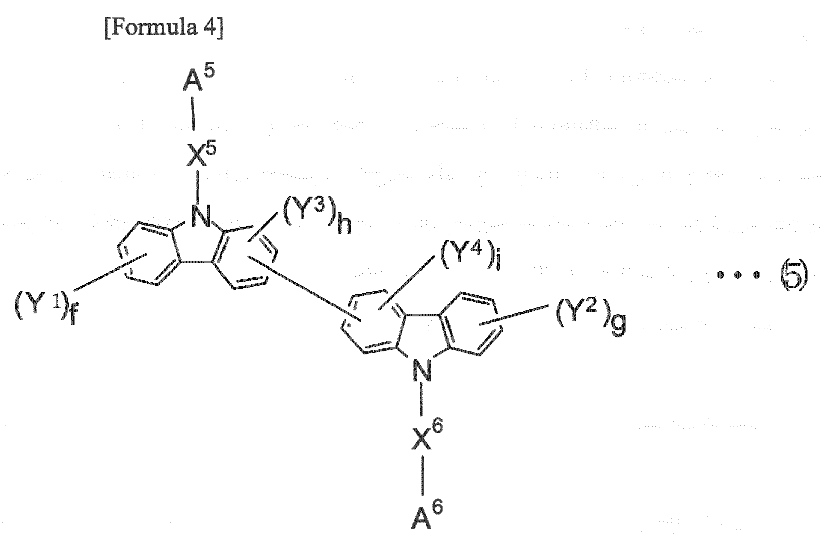 where: Ar⁵ represents a substituted or unsubstituted nitrogen-containing heterocyclic group having 1 to 30 ring carbon atoms (excluding a substituted or unsubstituted carbazolyl group and a substituted or unsubstituted indolyl group);
A⁶ represents a substituted or unsubstituted aromatic hydrocarbon group or fused aromatic hydrocarbon group having 6 to 30 ring carbon atoms, or a substituted or unsubstituted nitrogen-containing heterocyclic group having 1 to 30 ring carbon atoms;
X⁵ and X⁶ each are a linking group and independently represent a single bond, a substituted or unsubstituted aromatic hydrocarbon group having 6 to 30 ring carbon atoms, a substituted or unsubstituted fused aromatic hydrocarbon group having 6 to 30 ring carbon atoms, a substituted or unsubstituted aromatic heterocyclic group having 2 to 30 ring carbon atoms, or a substituted or unsubstituted fused aromatic heterocyclic group having 2 to 30 ring carbon atoms;
Y¹ to Y⁴ each independently represent a hydrogen atom, a fluorine atom, a cyano group, a substituted or unsubstituted alkyl group having 1 to 20 carbon atoms, a substituted or unsubstituted alkoxy group having 1 to 20 carbon atoms, a substituted or unsubstituted haloalkyl group having 1 to 20 carbon atoms, a substituted or unsubstituted haloalkoxy group having 1 to 20 carbon atoms, a substituted or unsubstituted alkylsilyl having 1 to 10 carbon atoms, a substituted or unsubstituted arylsilyl group having 6 to 30 carbon atoms, a substituted or unsubstituted aromatic hydrocarbon group having 6 to 30 ring carbon atoms, a substituted or unsubstituted fused aromatic hydrocarbon group having 6 to 30 ring carbon atoms, a substituted or unsubstituted aromatic heterocyclic group having 2 to 30 ring carbon atoms, or a substituted or unsubstituted fused aromatic heterocyclic group having 2 to 30 ring carbon atoms;
adjacent ones of Y¹ to Y⁴ are allowed to be bonded to each other to form a cyclic structure;
f and g represent an integer of 1 to 4, and h and i represent an integer of 1 to 3; and
when f and g are an integer of 2 to 4 and h and i are an integer of 2 or 3, a plurality of Y¹ to Y⁴ are allowed to be the same or different.

5. The organic electroluminescence device according to claim 4, wherein Cz in the formulae (3) and (4) is a substituted or unsubstituted arylcarbazolyl group.

6. The organic electroluminescence device according to claim 5, wherein Cz is a substituted or unsubstituted phenylcarbazolyl group.

7. The organic electroluminescence device according to claim 5, wherein an aryl portion of the arylcarbazolyl group is substituted by a carbazolyl group.

8. The organic electroluminescence device according to claim 4, wherein the formula (5) is represented by a formula (6) below, 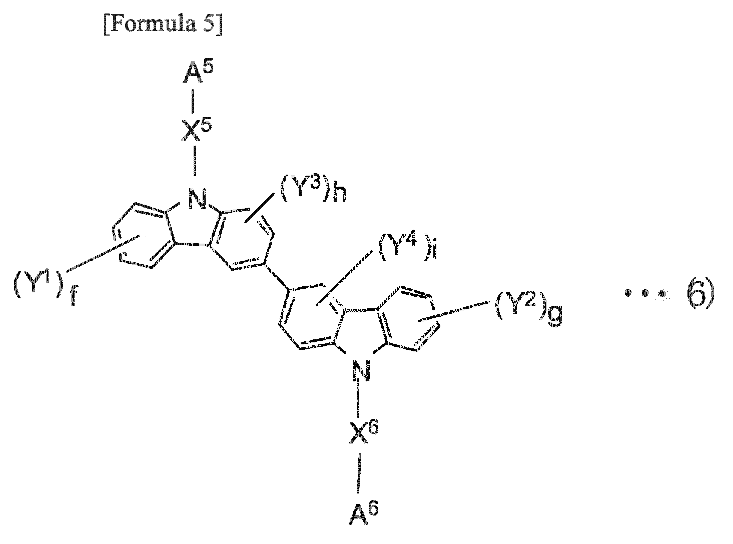 where: A⁵, A⁶, X⁵, X⁶, Y¹ to Y⁴, f, g, h and i represent the same as those in the formula (5).

9. The organic electroluminescence device according to claim 4 or claim 8, wherein A⁵ is selected from the group consisting of a substituted or unsubstituted pyridine ring, a pyrimidine ring and a triazine ring.

10. The organic electroluminescence device according to claim 9, wherein A⁵ is a substituted or unsubstituted pyrimidine ring group.

11. The organic electroluminescence device according to any one of claims 1 to 10, wherein the emitting layer comprises a phosphorescent material as the dopant.

12. The organic electroluminescence device according to claim 11, wherein the phosphorescent material is an ortho-metalated complex of a metal atom selected from iridium (Ir), osmium (Os) and platinum (Pt).

13. The organic electroluminescence device according to any one of claims 1 to 12, wherein
an electron injecting layer is provided between the cathode and the emitting layer, the electron injecting layer comprising a nitrogen-containing cyclic derivative.

14. The organic electroluminescence device according to any one of claims 1 to 13, wherein a reduction-causing dopant is added in an interfacial region between the cathode and the organic thin-film layer.
